# EUROPEAN PATENT APPLICATION

(11) **EP 2 080 795 A1**
(43) Date of publication of application: **22.07.2009**
(21) Application number: 08254193.9
(22) Date of filing: 31.12.2008
(51) Int. Cl.: C09K 11/06, C07F 3/06, C07F 5/06, H05B 33/20, H01L 51/00, C07F 3/00

(54) **Electroluminescent device using electroluminescent compounds**

(30) Priority: 31.12.2007 KR 20070141997
(71) Applicant: Gracel Display Inc., Seoul 133-833 (KR)
(72) Inventor: Kim, Hyun, Gyeonggi-do, 431-724 (KR); Eum, Sung Jin, Guro-gu Seoul 152-053 (KR); Cho, Young Jun, Seongbuk-gu Seoul 130-060 (KR); Kwon, Hyuck Joo, Dongdaemun-gu Seoul, 130-100 (KR); Kim, Bong Ok, Gangnam-gu Seoul 135-090 (KR); Kim, Sung Min, Seoul-city 157-886 (KR); Yoon, Seung Soo, Gangnam-gu Seoul 135-884 (KR)
(74) Representative: Kent, Venetia Katherine

(57) **Abstract**

The present invention relates to an electroluminescent device. More specifically, the electroluminescent device according to the present invention is comprised of a first electrode; a second electrode; and at least one organic layer(s) interposed between the first electrode and the second electrode; and the organic layer comprises one or more organic electroluminescent compound(s) represented by Chemical Formula (1) as host material:

Chemical Formula 1 L¹L²M(Q)_{y}

wherein, the ligands, L¹ and L² are independently selected from the following structures: 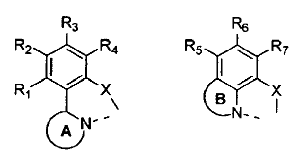 wherein, M represents a divalent or trivalent metal;
y is 0 when M is a divalent metal, while y is 1 when M is a trivalent metal;
Q represents (C6-C60)aryloxy or tri(C6-C60)arylsilyl, and the aryloxy or triarylsilyl of Q may be further substituted by (C1-C60)alkyl or (C6-C60)aryl.

The electroluminescent devices according to the invention exhibit excellent color purity and luminous efficiency.

## Description

### FIELD OF THE INVENTION

The present invention relates to an electroluminescent device comprising electroluminescent compounds.

### BACKGROUND OF THE INVENTION

Among display devices, electroluminescence devices (EL devices) are self-luminescent display devices showing the advantage of wide angle of view, excellent contrast and rapid response rate, as compared to LCD's.

EL devices are classified into inorganic EL devices and organic EL devices depending on the material for forming the emitting layer and the luminescent mechanism. Among them, organic EL devices are highly advantageous in view of luminous efficiency, color purity and operation voltage, so that full-color displays may be easily realized.

In the meanwhile, Eastman Kodak developed in 1987 an organic EL device which employs a low molecular weight aromatic diamine as a material for forming an EL layer, and an aluminum complex, for the first time [Appl. Phys. Lett. 51, 913, 1987].

EL materials can be functionally classified into host materials and dopant materials. It is generally known that a device structure having the most excellent EL properties can be fabricated with an EL layer prepared by doping a dopant on a host. Recently, development of organic EL devices with high efficiency and long life comes to the fore as an urgent subject, and particularly urgent is development of a material with far better EL properties as compared to conventional EL materials as considering EL properties required for a medium to large size OLED panel. The desired properties for the host material (serving as a solid state solvent and an energy conveyer) are high purity and appropriate molecular weight to enable vapor-deposition in vacuo. In addition, glass transition temperature and thermal decomposition temperature should be high to ensure thermal stability. Further, the host material should have high electrochemical stability for providing long life. It is to be easy to form an amorphous thin film, with high adhesiveness to other adjacent materials but without interlayer migration.

The most important factor to determine luminous efficiency in an OLED (organic light-emitting diode) is the type of electroluminescent material. Though fluorescent materials has been widely used as an electroluminescent material up to the present, development of phosphorescent materials is one of the best methods to improve the luminous efficiency theoretically up to four(4) times, in view of electroluminescent mechanism.

Up to now, iridium (III) complexes are widely known as phosphorescent material, including (acac)Ir(btp)₂, Ir(ppy)₃ and Firpic, as the red, green and blue one, respectively. In particular, a lot of phosphorescent materials have been recently investigated in Korea, Japan, Europe and America, and developments of further improved phosphorescent materials are expected.

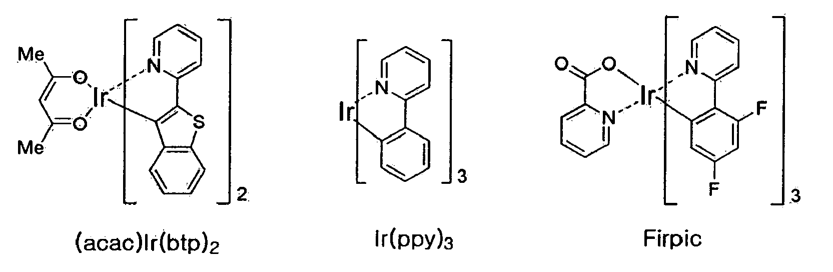

As a host material for phosphorescent light emitting material, 4,4'-N,N'-dicarbazole-biphenyl (CBP) has been most widely known up to the present, and OLED's having high efficiency to which a hole blocking layer (such as BCP and BAlq) has been applied have been developed. East-North Pioneer (Japan) or the like reported OLED's of high performances which were developed by using bis(2-methyl-8-quinolinato)(p-phenylphenolato) aluminum (III) (BAlq) and derivatives thereof as the host of phosphorescent material.

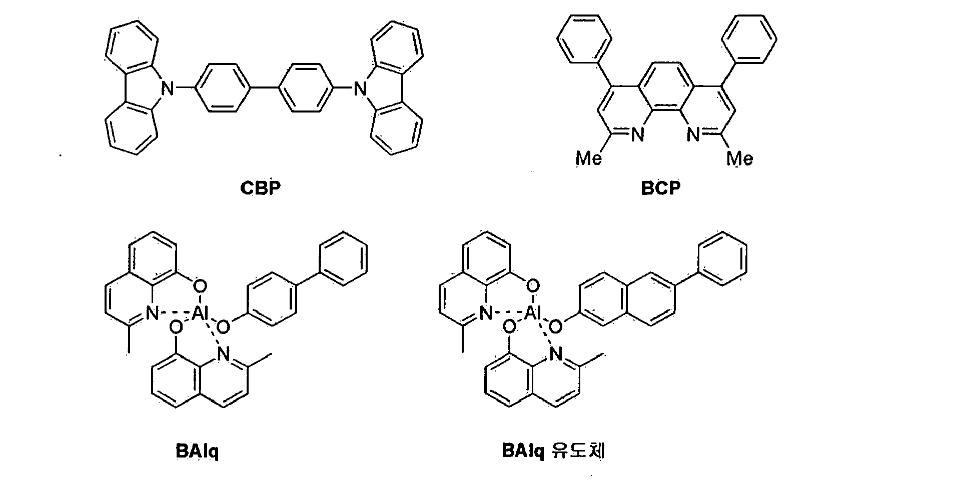

Though the materials in prior art are advantageous in view of light emitting property, they have low glass transition temperature and very poor thermal stability, so that the materials tend to be changed during the process of high temperature vapor-deposition in vacuo. In an organic electroluminescent device, it is defined that power efficiency = (π /voltage) x current efficiency. Thus, the power efficiency is inversely proportional to the voltage, and the power efficiency should be higher in order to obtain lower power consumption of an OLED. In practice, an OLED employing phosphorescent electroluminescent (EL) material shows significantly higher current efficiency (cd/A) than an OLED employing fluorescent EL material. However, in case that a conventional material such as BAlq and CBP as host material of the phosphorescent material is employed, no significant advantage can be obtained in terms of power efficiency (lm/w) because of higher operating voltage as compared to an OLED employing a fluorescent material.

In general, an organic electroluminescent device is basically established as a laminate form consisting of anode/organic EL layer/cathode, being properly equipped with a hole injection transport layer and an electron injection layer; for example, currently known are the structures of anode/hole injection layer/hole transport layer/organic EL layer/cathode; anode/hole injection layer/hole transport layer/organic EL layer/electron injection layer/cathode; and anode/hole injection layer/hole transport layer/organic EL layer/electron transport layer/electron injection layer/cathode, or the like.

Various organic compounds may be used in the electron injection layer or the electron transport layer of these laminate-type devices. These compounds include a light-metal complexes represented by tris(8-quinolinolate)aluminum (Alq₃), oxadiazole, triazole, benzimidazole, benzoxazole, benzothiazole, or the like, but they are not fully satisfactory in view of EL luminance, durability, or the like. Among them, Alq₃ is reported as the most preferable compound having excellent stability and high electron affinity. When it is employed in a blue electroluminescenct device, however, color purity is deteriorated by luminescence due to exciton diffusion.

As described above, recent progresses for commercialization of electroluminescent devices have been prominent, which are characterized by obtaining EL devices of slim-type having high luminance with low applied voltage, variety of EL wavelength and rapid response, and low power consumption is essential for devices of high efficiency and long life.

### SUMMARY OF THE INVENTION

Thus, the object of the invention is to provide electroluminescent devices comprised of a first electrode; a second electrode; and at least one organic layer(s) interposed between the first electrode and the second electrode; wherein the organic layer comprises divalent or trivalent metal complex as host material, with various electroluminescent dopants.

Another object of the invention is to provide electroluminescent devices exhibiting excellent luminous efficiency, high color purity, low operation voltage and good operation life.

Specifically, the electroluminescent device according to the present invention is comprised of a first electrode; a second electrode; and at least one organic layer(s) interposed between the first electrode and the second electrode; and the organic layer comprises one or more organic electroluminescent compound(s) represented by Chemical Formula (1) as host material:

Chemical Formula 1 L¹L²M(Q)_{y}

wherein, the ligands, L¹ and L² are independently selected from the following structures: 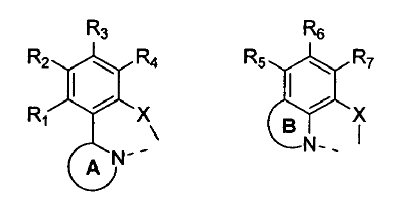 wherein, M represents a divalent or trivalent metal;
y is 0 when M is a divalent metal, while y is 1 when M is a trivalent metal;
Q represents (C6-C60)aryloxy or tri(C6-C60)arylsilyl, and the aryloxy or triarylsilyl of Q may be further substituted by (C1-C60)alkyl or (C6-C60)aryl;
X represents O, S or Se;
ring A and ring B independently represent a 5- or 6-membered heteroaromatic ring, or a 5- or 6-membered heteroaromatic ring with a (C6-C60)aromatic ring fused; ring A may form a chemical bond with R₁ to form a fused ring, and ring A or ring B may be further substituted by one or more substituent(s) selected from (C1-C60)alkyl, halogen, (C1-C60)alkyl substituted by halogen, (C6-C60)aryl, (C4-C60)heteroaryl, tri(C1-C30)alkylsilyl, di(C1-C30)alkyl(C6-C30)arylsilyl, tri(C6-C30)arylsilyl, di(C1-C30)alkylamino and di(C6-C30)arylamino;
R₁ through R₇ independently represent hydrogen, (C1-C60)alkyl, halogen, (C1-C60)alkyl with halogen substituent(s), tri(C1-C30)alkylsilyl, di(C1-C30)alkyl(C6-C30)arylsilyl, tri(C6-C30)arylsilyl, (C6-C60)aryl, (C4-C60)heteroaryl, di(C1-C30)alkylamino and di(C6-C30)arylamino; or each of them may be linked to an adjacent substituent via alkylene or alkenylene to form a fused ring; and
the aryl or heteroaryl to be substituted on ring A or ring B, or the aryl, heteroaryl of R₁ through R₇, or the fused ring formed by linkage to an adjacent substituent via alkylene or alkenylene may be further substituted by one or more substituent(s) selected from (C1-C60)alkyl, halogen, cyano, (C1-C60)alkyl with halogen substituent(s), (C3-C60)cycloalkyl, (C1-C30)alkoxy, (C6-C60)aryl, (C4-C60)heteroaryl, tri(C1-C30)alkylsilyl, di(C1-C30)alkyl(C6-C30)arylsilyl, tri(C6-C30)arylsilyl, di(C1-C30)alkylamino and di(C6-C30)arylamino.

### BRIEF DESCRIPTION OF THE DRAWINGS

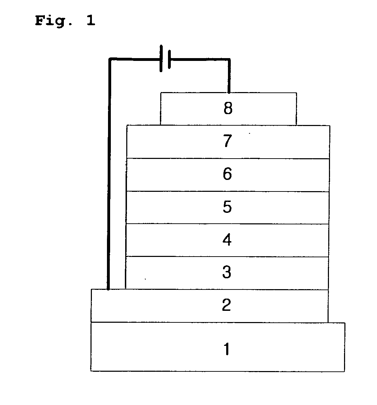

Fig. 1 is a cross-sectional view of an OLED.

### DETAILED DESCRIPTION OF THE INVENTION

Referring now to the Drawings, Fig. 1 illustrates a cross-sectional view of an OLED comprising a Glass 1, Transparent electrode 2, Hole injection layer 3, Hole transport layer 4, Electroluminescent layer 5, Electron transport layer 6, Electron injection layer 7 and an Al cathode 8.

The term 'alkyl' or 'alkoxy' described herein include both linear and branched alkyl or alkoxy groups.

The term 'heteroaromatic ring' described herein means a 5- or 6-membered aromatic group containing one or more heteroatom(s) selected from N, O and S, and include, for example, pyrrole, pyrazole, oxazole, isoxazole, thiazole, isothiazole, imidazole, oxadiazole, thiadiazole, pyridine, pyrazine, pyrimidine and pyridazine. Specific examples of 5-or 6-membered heteroaromatic rings fused with a (C6-C30)aromatic ring include indazole, benzoxazole, benzothiazole, benzimidazole, phthalazine, quinoxaline, quinazoline, cinnoline, carbazole, phenathridine, acridine, quinoline and isoquinoline. Ring A is preferably selected from oxazole, thiazole, imidazole, oxadiazole, thiadiazole, benzoxazole, benzothiazole, benzimidazole, pyridine and quinoline.

Ligand L₁ and L² are independently selected from the following structures: 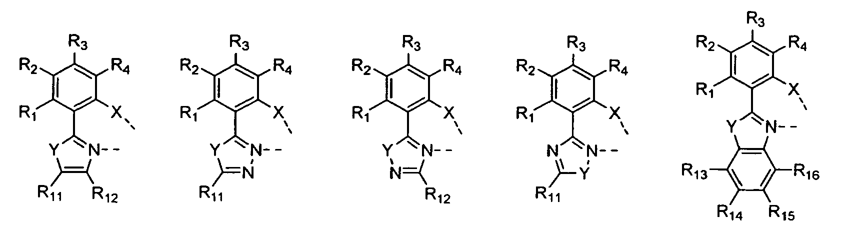 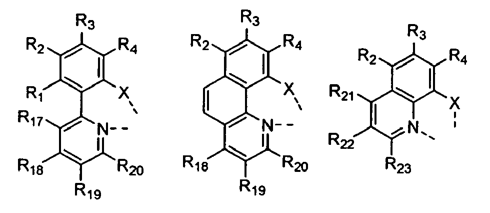 wherein, X, R₁, R₂, R₃ and R₄ are defined as in Chemical Formula (1);
Y represents O, S or NR₂₄;
R₁₁ through R₂₃ independently represent hydrogen, (C1-C60)alkyl, halogen, (C1-C60)alkyl with halogen substituent(s), (C6-C60)aryl, (C4-C60)heteroaryl, tri(C1-C30)alkylsilyl, di(C1-C30)alkyl(C6-C30)arylsilyl, tri(C6-C30)arylsilyl, di(C1-C30)alkylamino or di(C6-C30)arylamino; or each of R₁₃ through R₁₆ and R₁₇ through R₂₀ may be linked to an adjacent substituent via alkylene or alkenylene to form a fused ring; and the fused ring may be substituted by one or more substituent(s) selected from (C1-C60)alkyl, halogen, cyano, (C1-C60)alkyl with halogen substituent(s), (C3-C60)cycloalkyl, (C1-C30)alkoxy, (C6-C60)aryl, (C4-C60)heteroaryl, tri(C1-C30)alkylsilyl, di(C1-C30)alkyl(C6-C30)arylsilyl, tri(C6-C30)arylsilyl, di(C1-C30)alkylamino and di(C6-C30)arylamino;
R₂₄ represents (C1-C60)alkyl or (C6-C60)aryl; and
the aryl or heteroaryl of R₁₁ through R₂₄ may be further substituted by one or more substituent(s) selected from (C1-C60)alkyl, halogen, cyano, (C1-C60)alkyl with halogen substituent(s), (C3-C60)cycloalkyl, (C1-C30)alkoxy, (C6-C60)aryl, (C4-C60)heteroaryl, tri(C1-C30)alkylsilyl, di(C1-C30)alkyl(C6-C30)arylsilyl, tri(C6-C30)arylsilyl, di(C1-C30)alkylamino and di(C6-C30)arylamino.

Ligands, L¹ and L² may be independently selected from the following structures: 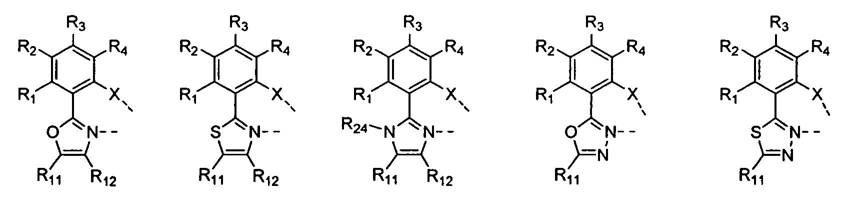 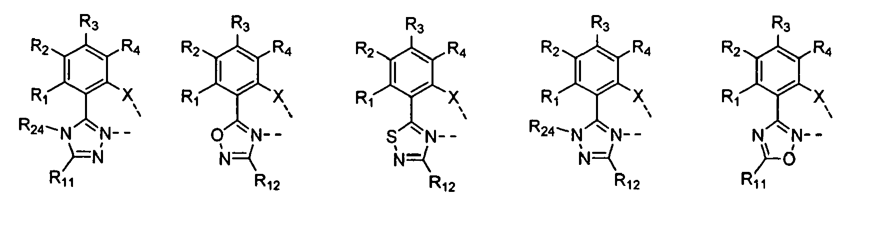 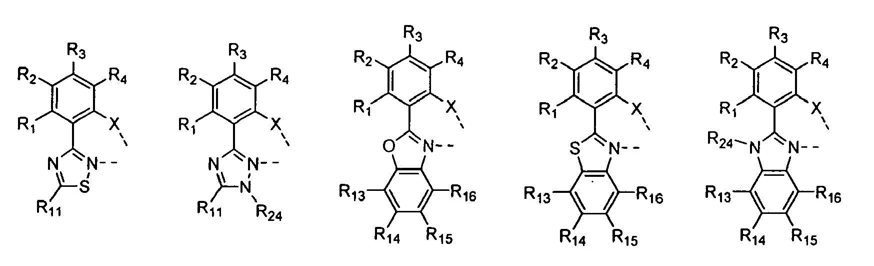 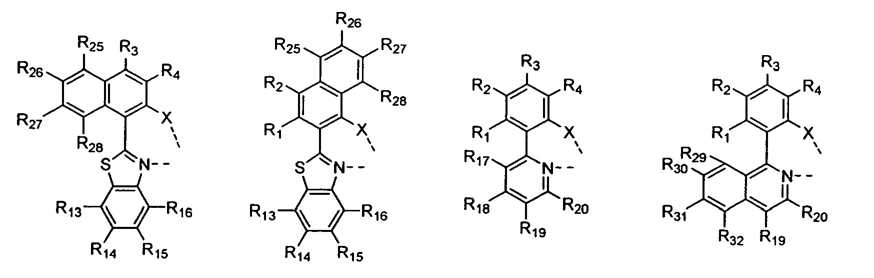 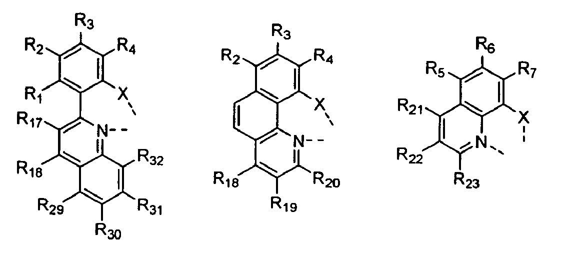 wherein, X is defined as in Chemical Formula (1);
R₁ through R₇ independently represent hydrogen, (C1-C60)alkyl, halogen, (C1-C60)alkyl with halogen substituent(s), tri(C1-C30)alkylsilyl, di(C1-C30)alkyl(C6-C30)arylsilyl, tri(C6-C30)arylsilyl, (C6-C60)aryl, (C4-C60)heteroaryl, di(C1-C30)alkylamino or di(C6-C30)arylamino;
R₁₁ through R₂₃ independently represents hydrogen, (C1-C60)alkyl, halogen, (C1-C60)alkyl with halogen substituent(s), (C6-C60)aryl, (C4-C60)heteroaryl, tri(C1-C30)alkylsilyl, di(C1-C30)alkyl(C6-C30)arylsilyl, tri(C6-C30)arylsilyl, di(C1-C30)alkylamino or di(C6-C30)arylamino;
R₂₄ represents (C1-C60)alkyl, (C6-C60)aryl or (C4-C60)heteroaryl;
R₂₅ through R₃₂ independently represent hydrogen, (C1-C60)alkyl, halogen, cyano, (C1-C60)alkyl with halogen substituent(s), (C3-C60)cycloalkyl, (C1-C30)alkoxy, (C6-C60)aryl, (C4-C60)heteroaryl, tri(C1-C30)alkylsilyl, di(C1-C30)alkyl(C6-C30)arylsilyl, tri(C6-C30)arylsilyl, di(C1-C30)alkylamino or di(C6-C30)arylamino;
the aryl or heteroaryl of R₁ through R₇, R₁₁ through R₂₃, R₂₄ and R₂₅ through R₃₂ may be further substituted by one or more substituent(s) selected from (C1-C60)alkyl, halogen, cyano, (C1-C60)alkyl with halogen substituent(s), (C3-C60)cycloalkyl, (C1-C30)alkoxy, (C6-C60)aryl, (C4-C60)heteroaryl, tri(C1-C30)alkylsilyl, di(C1-C30)alkyl(C6-C30)arylsilyl, tri(C6-C30)arylsilyl, di(C1-C30)alkylamino and di(C6-C30)arylamino; and
the alkyl may be linear or branched.

In Chemical Formula (1), M represents a bivalent metal selected from a group consisting of Be, Zn, Mg, Cu and Ni, or a trivalent metal selected from a group consisting of Al, Ga, In and B; and Q is selected from the following structures:

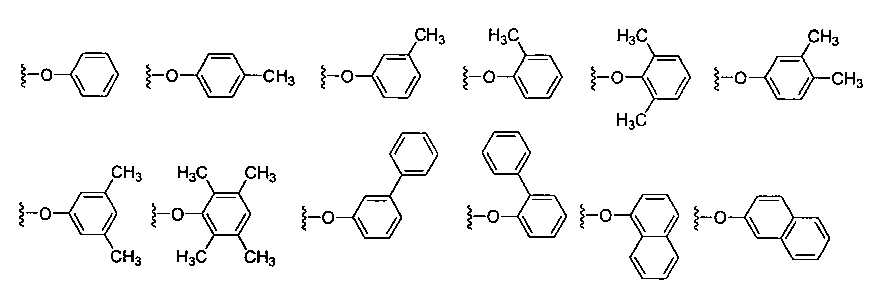

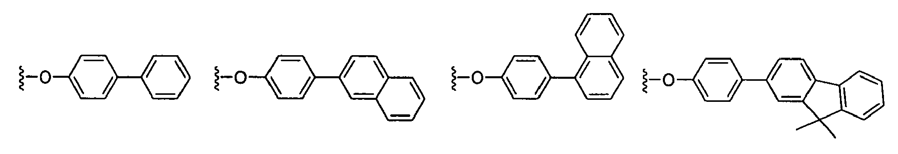

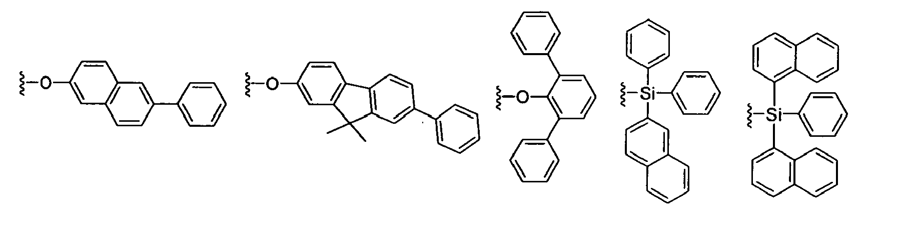

When M is a bivalent metal, the compounds represented by Chemical Formula (1) can be specifically exemplified by the following compounds, but are not restricted thereto: 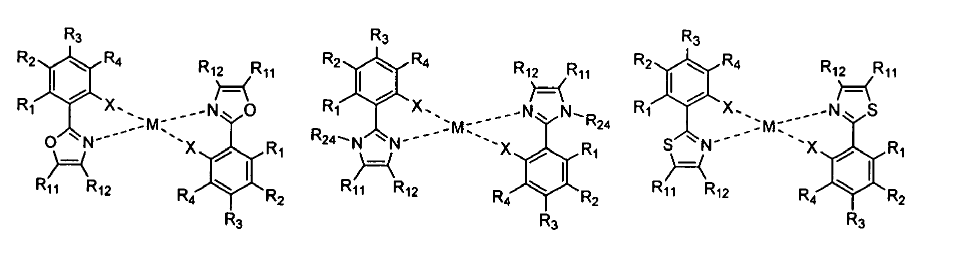 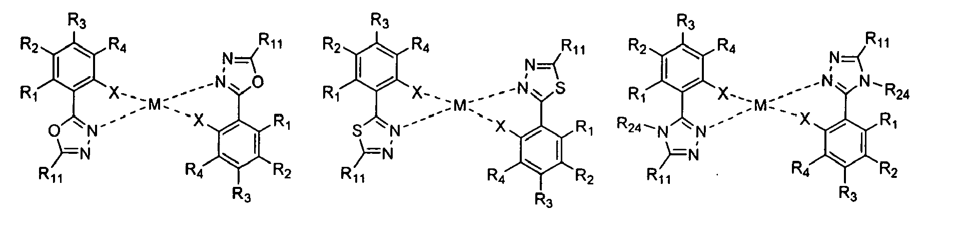 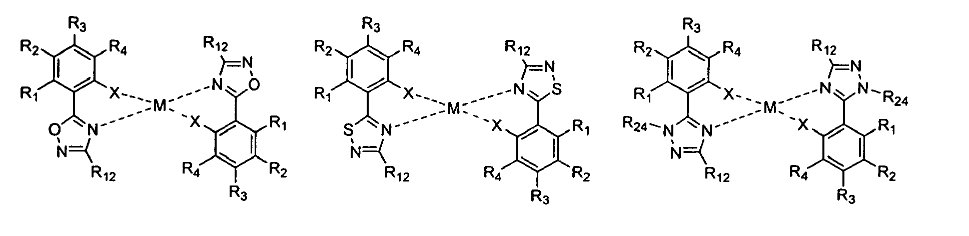 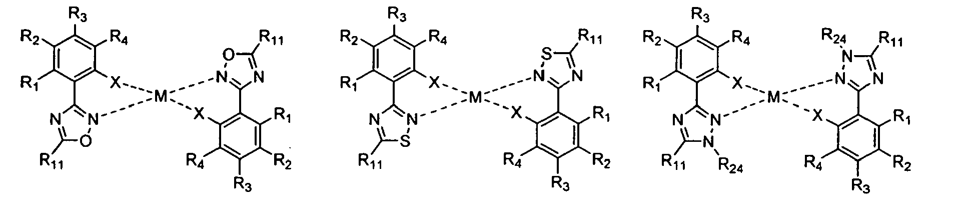 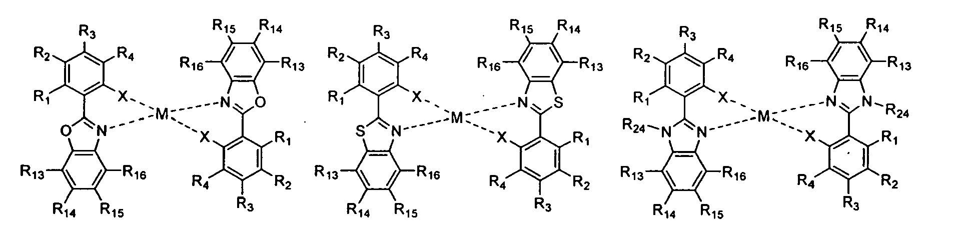 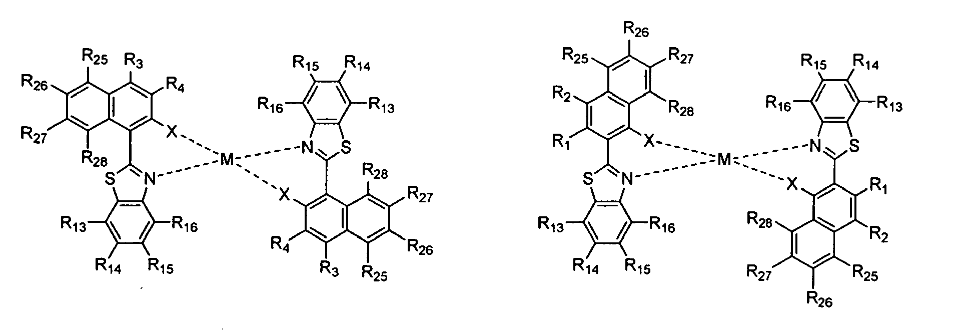 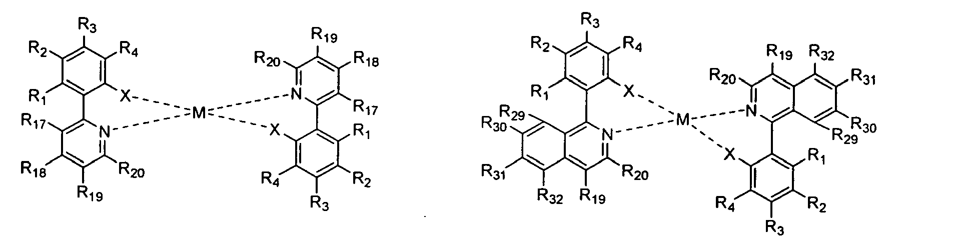 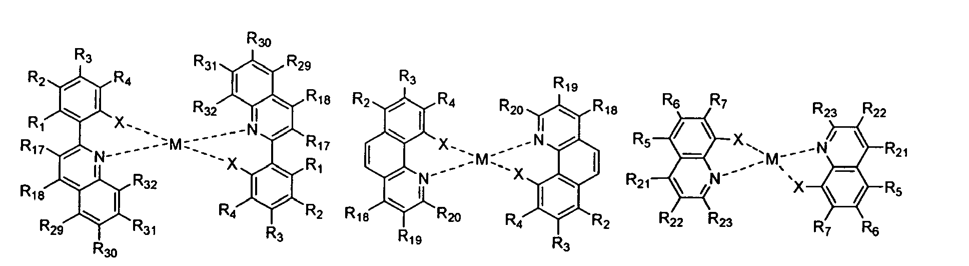 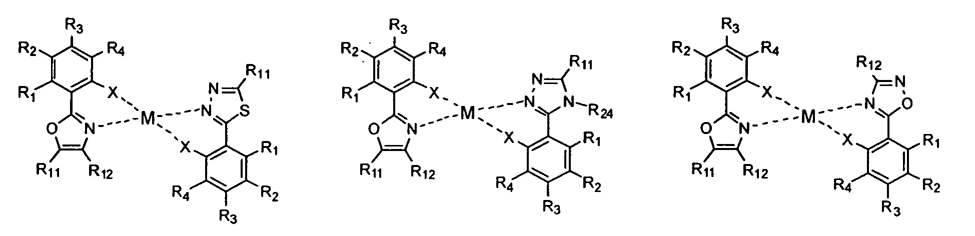 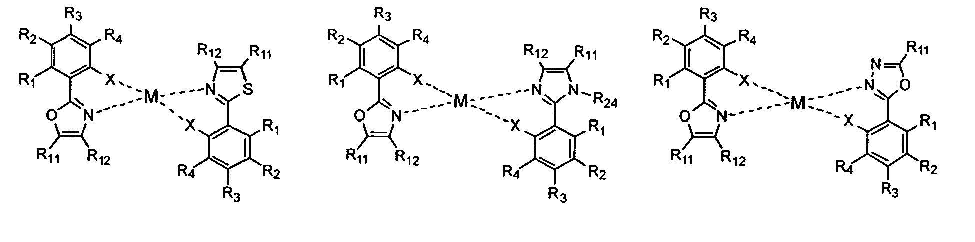 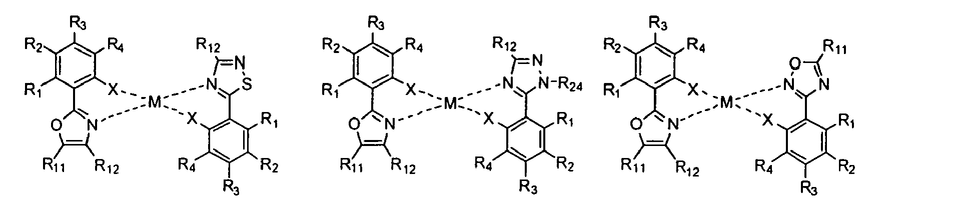 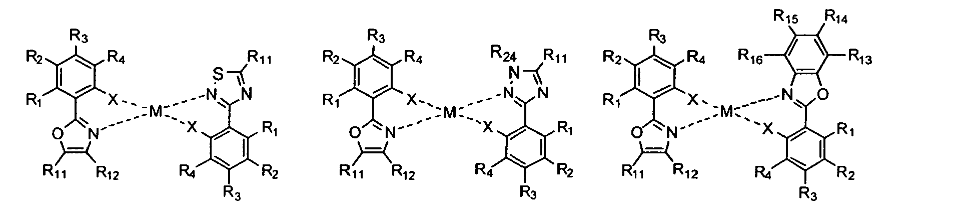 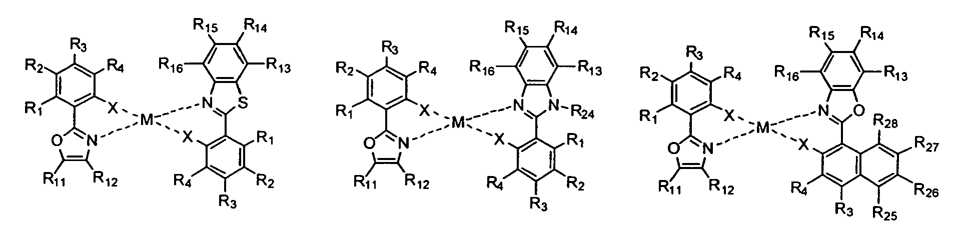 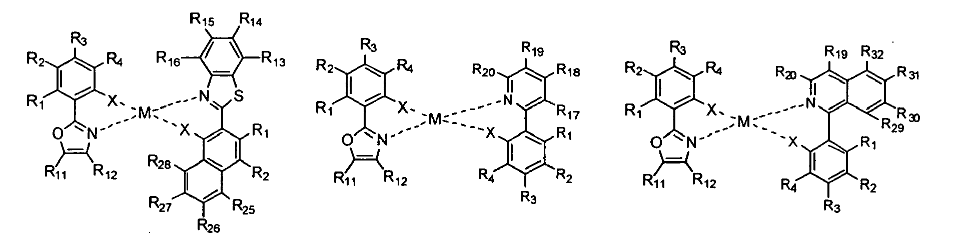 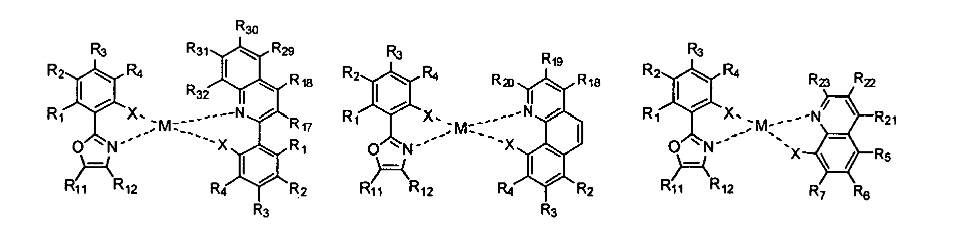 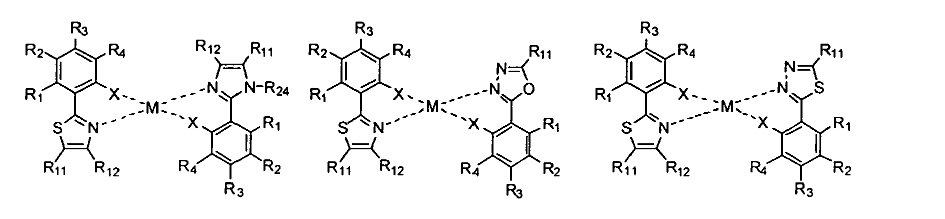 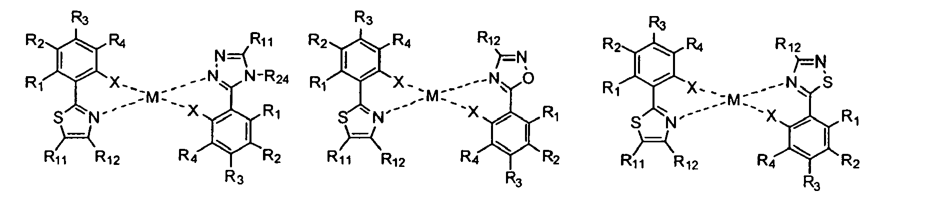 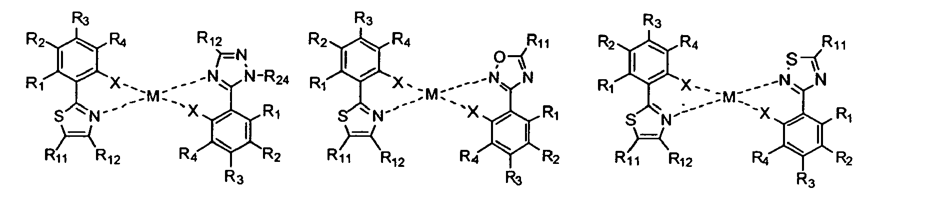 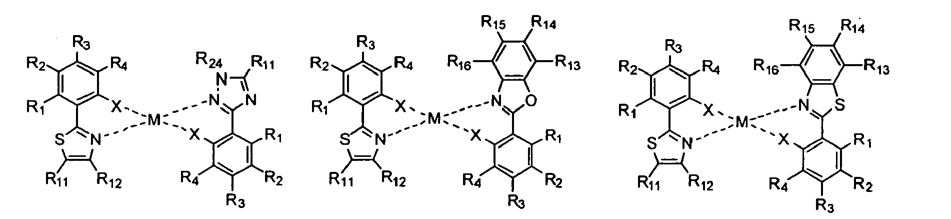 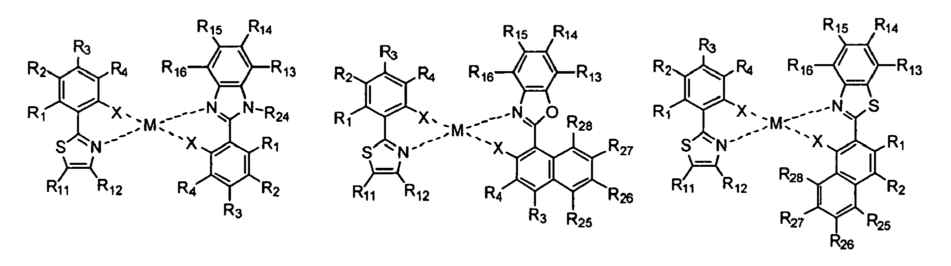 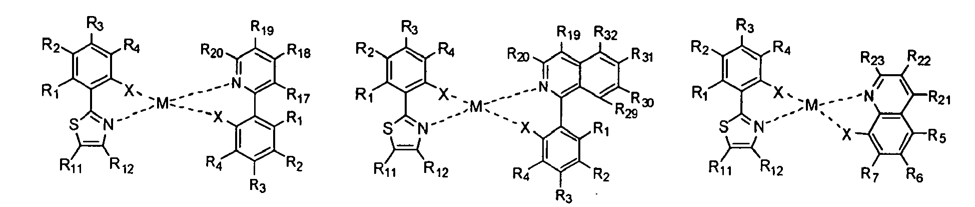 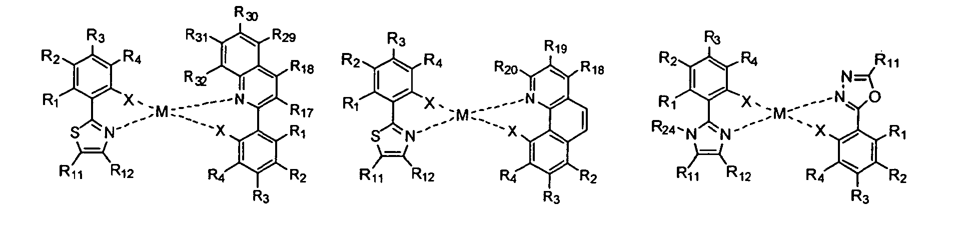 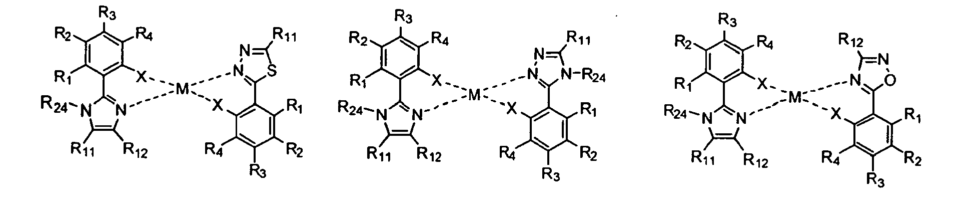 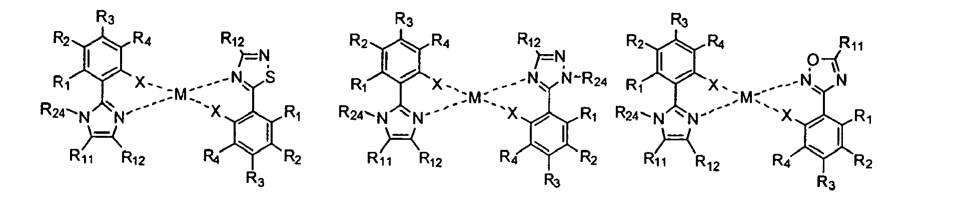 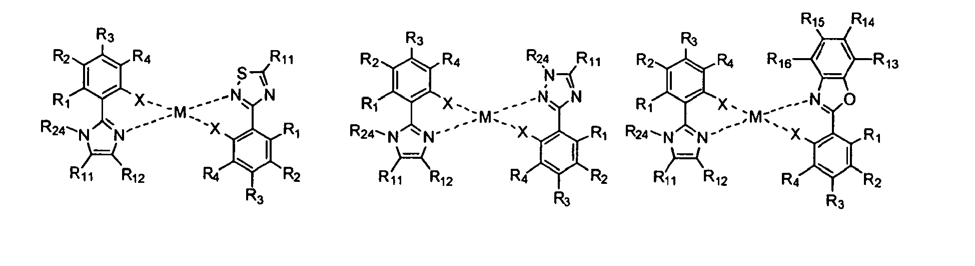 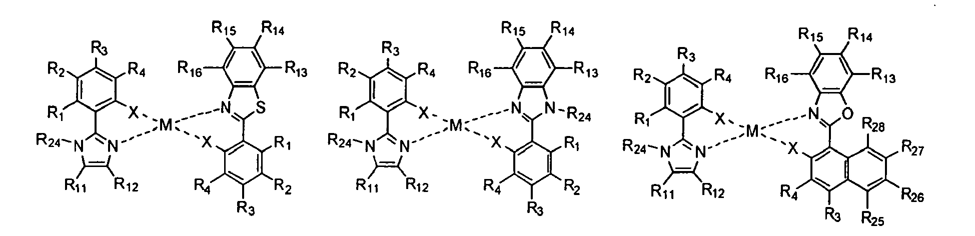 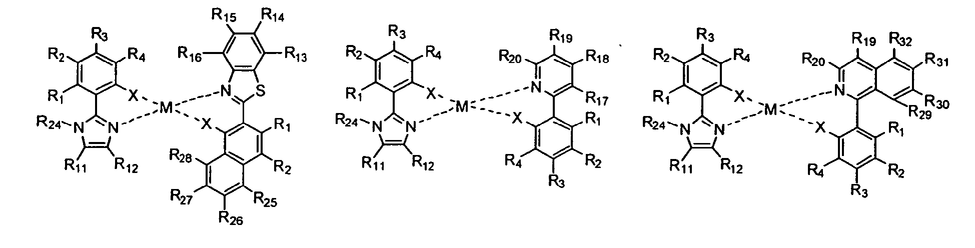 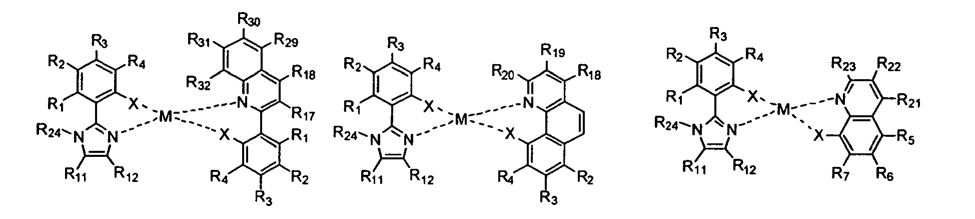 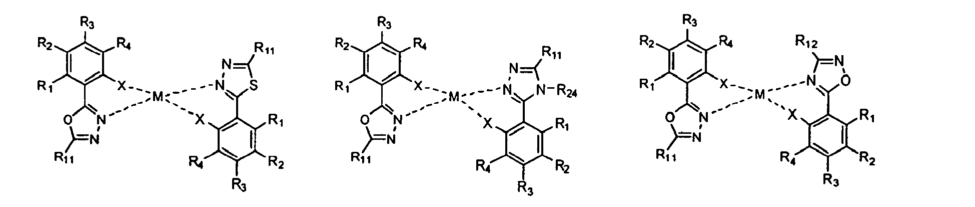 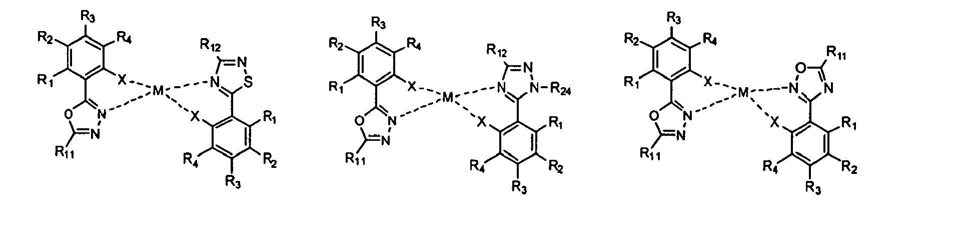 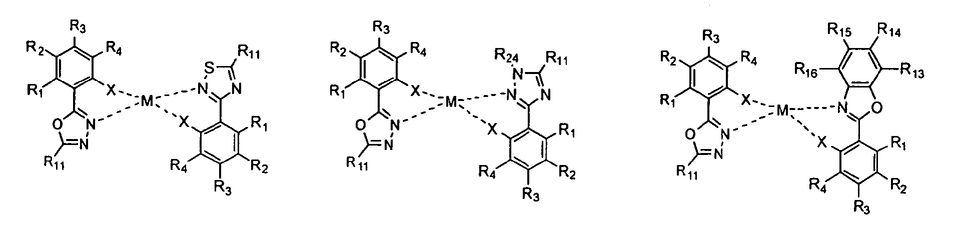 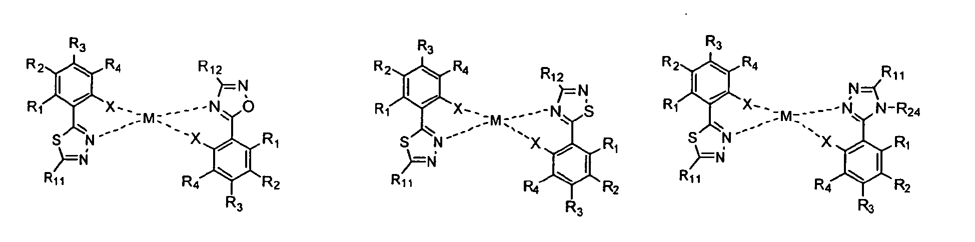 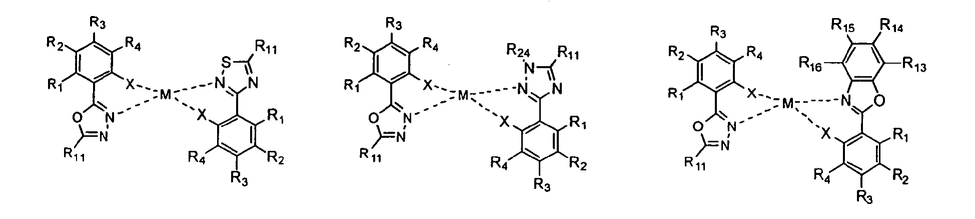 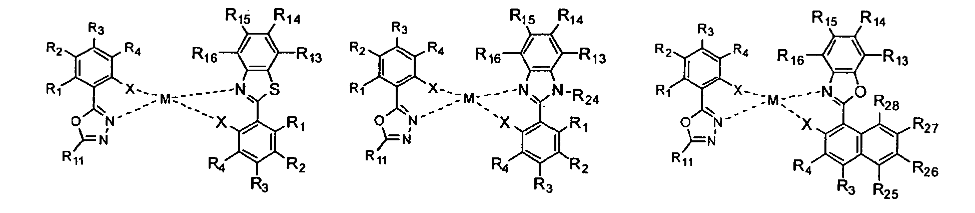 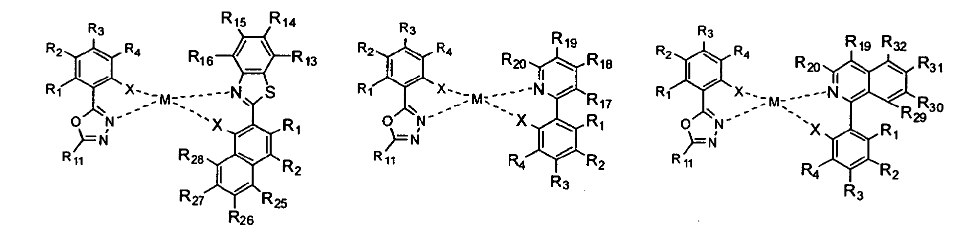 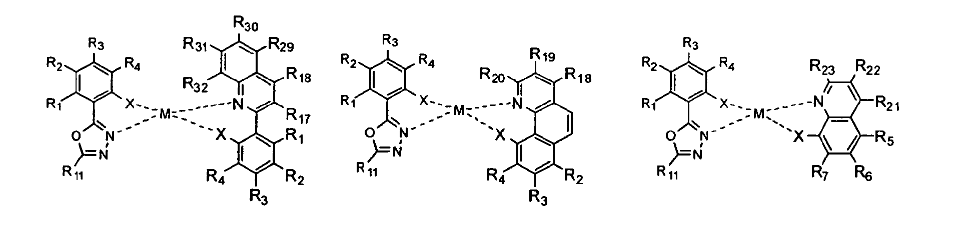 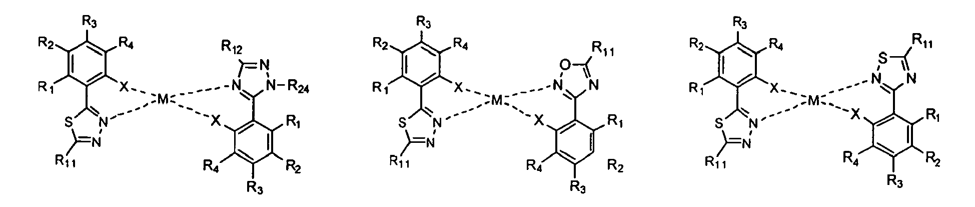 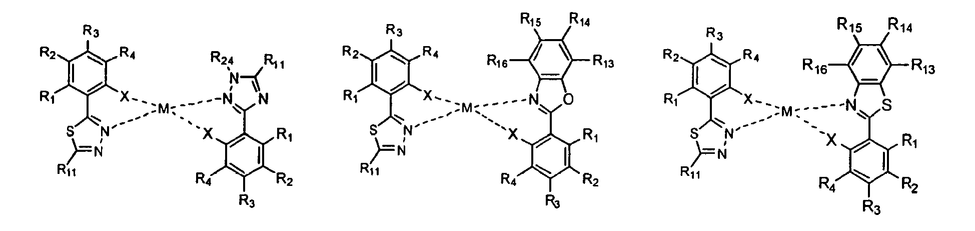 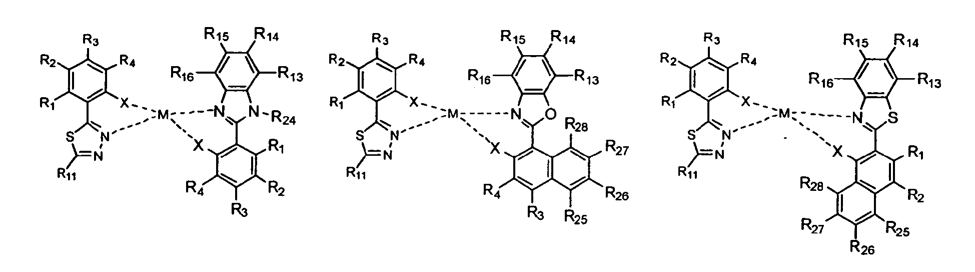 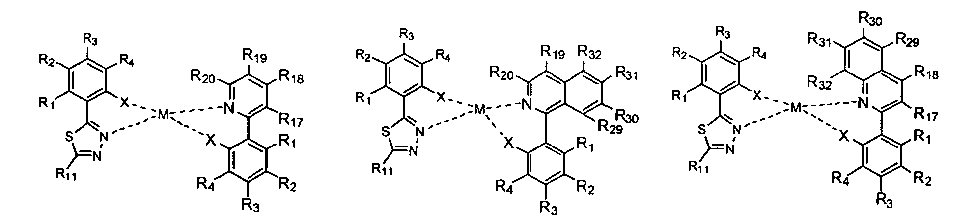 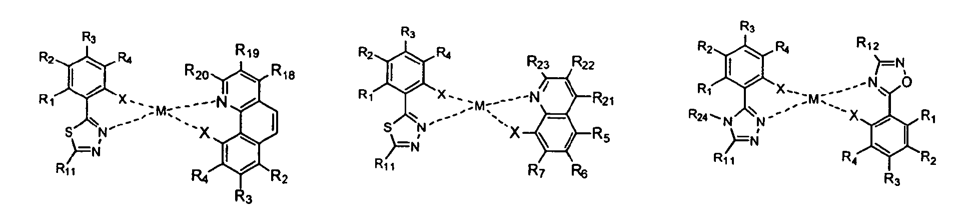 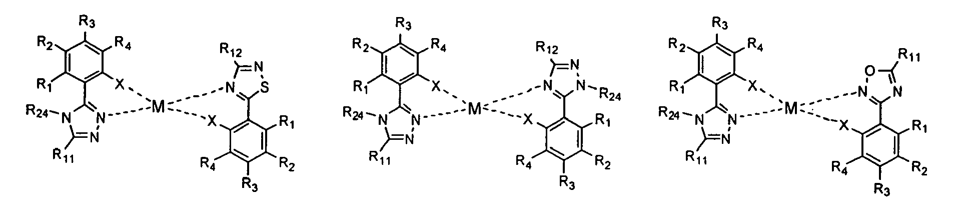 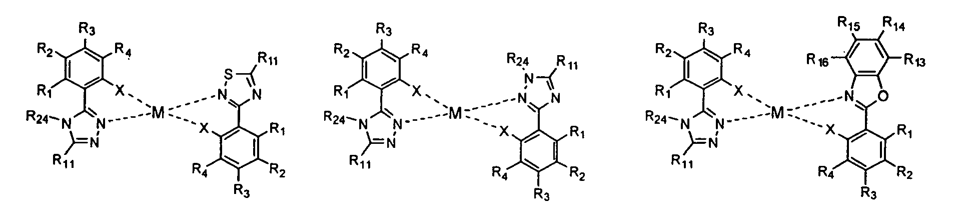 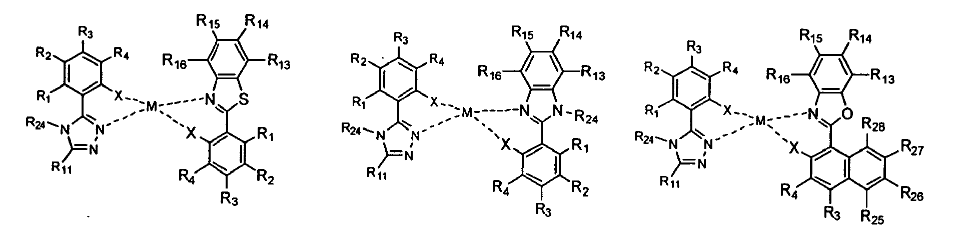 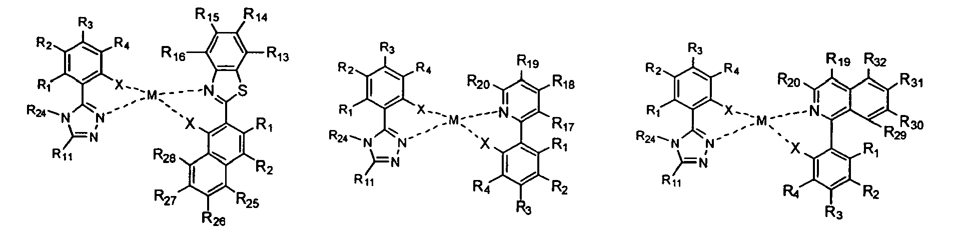 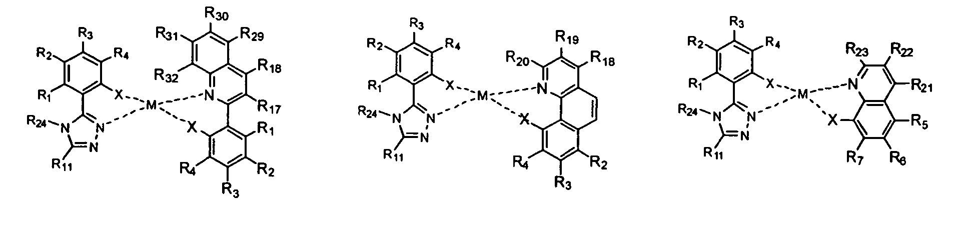 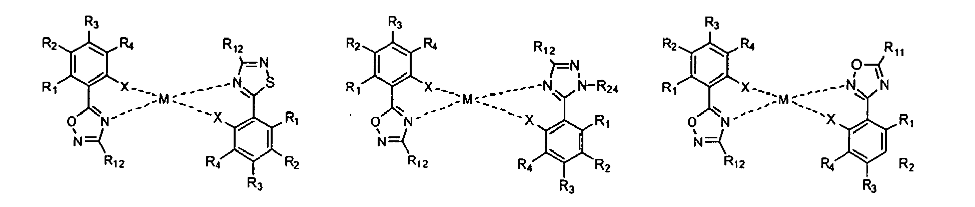 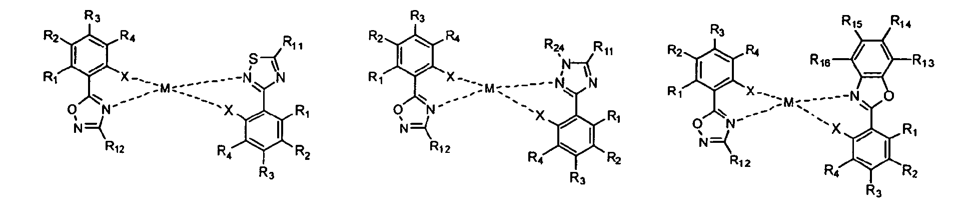 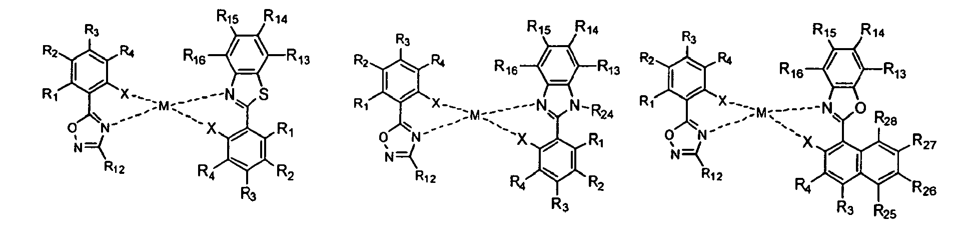 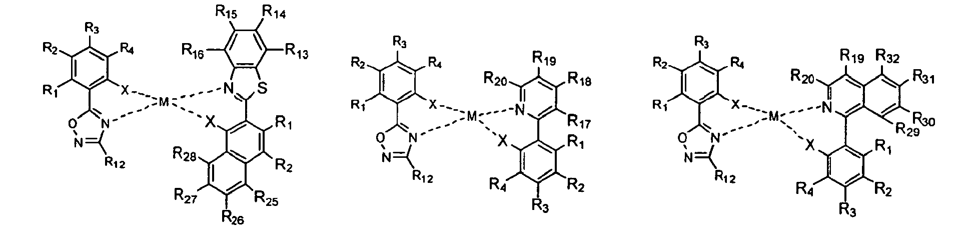 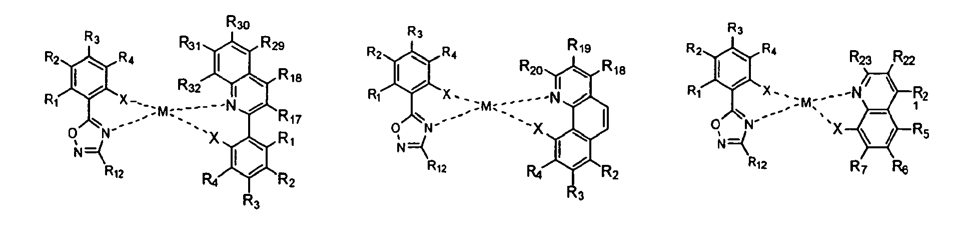 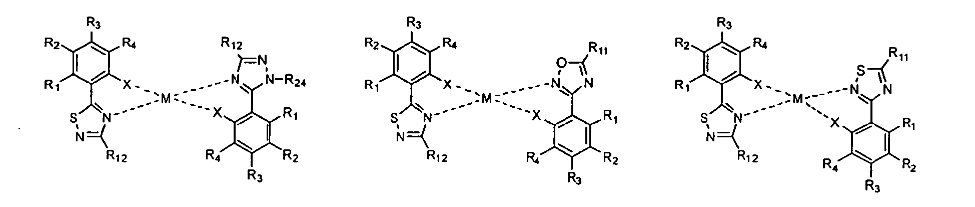 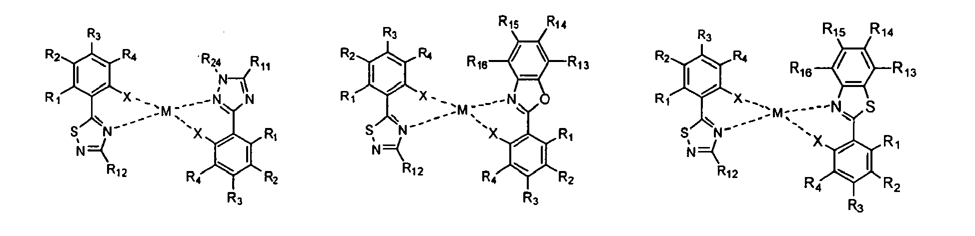 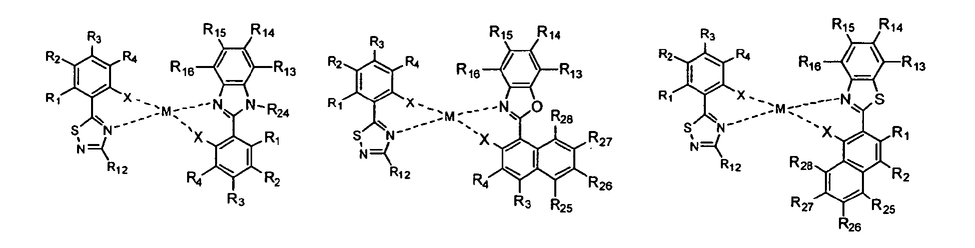 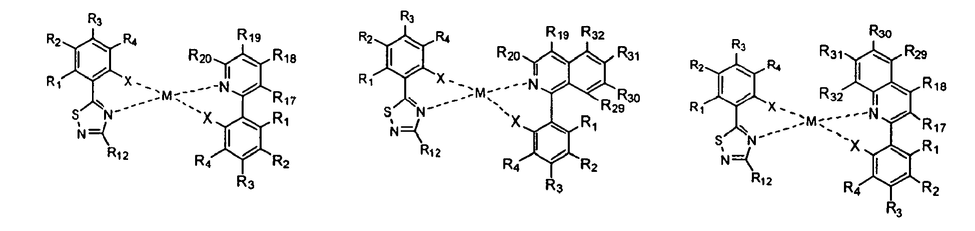 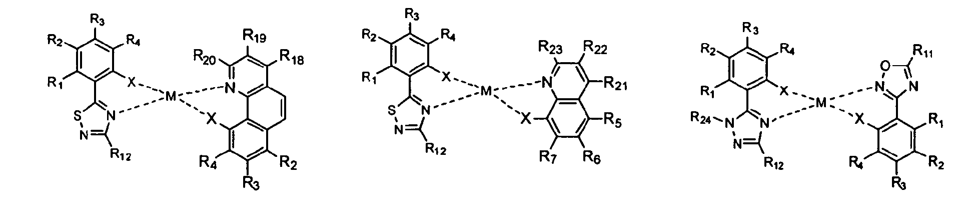 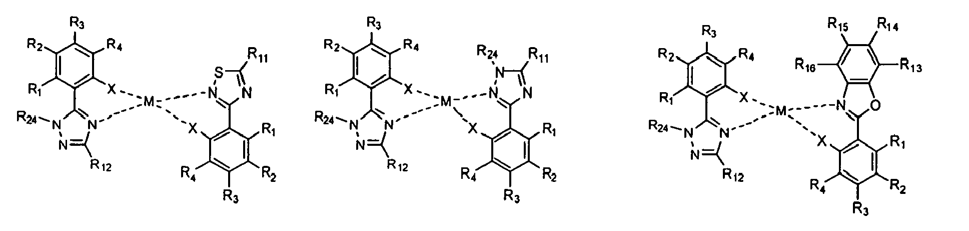 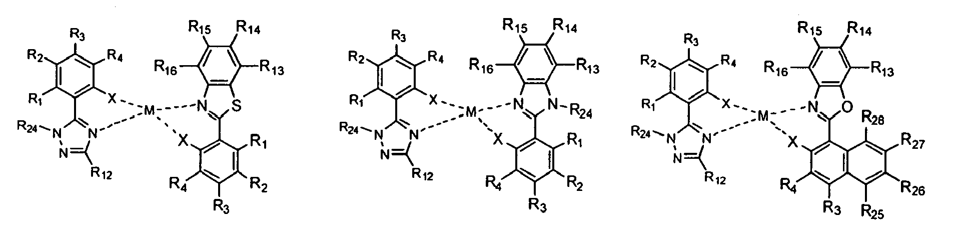 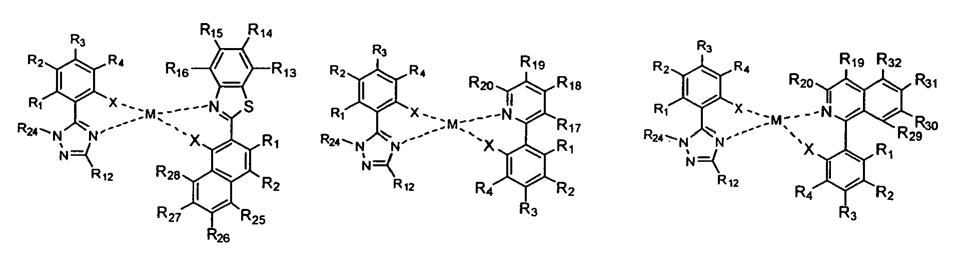 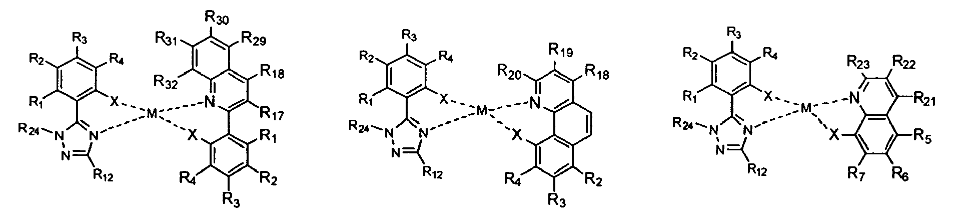 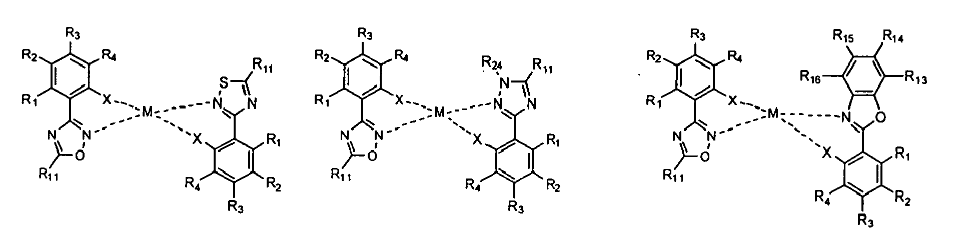 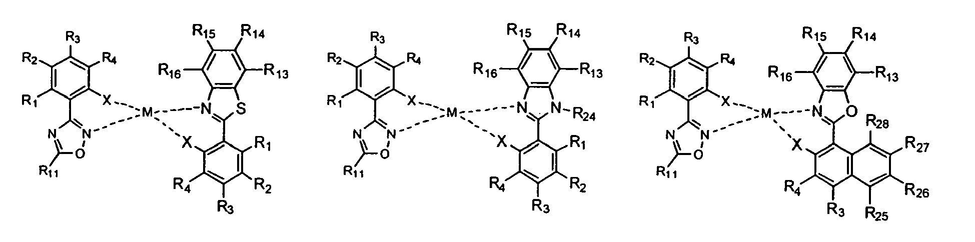 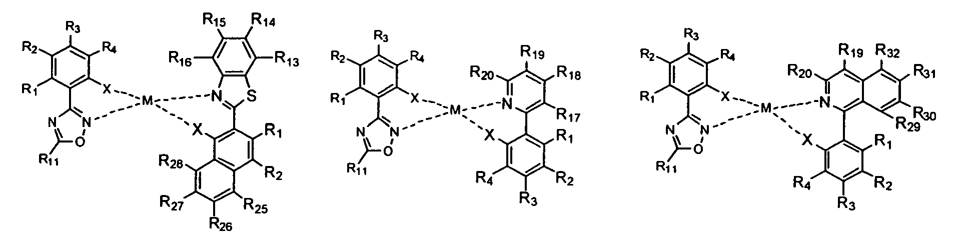 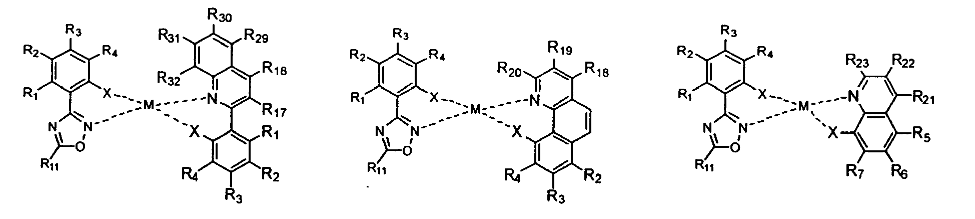 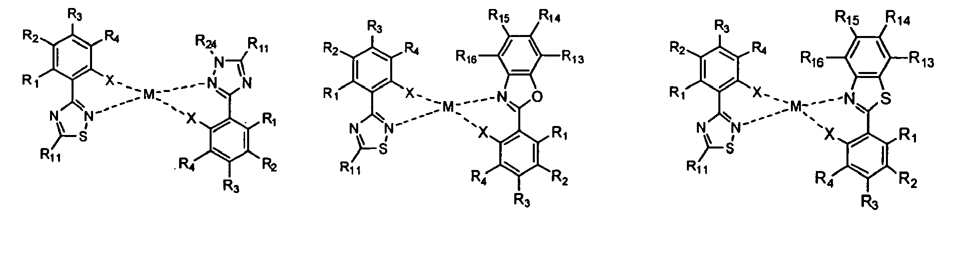 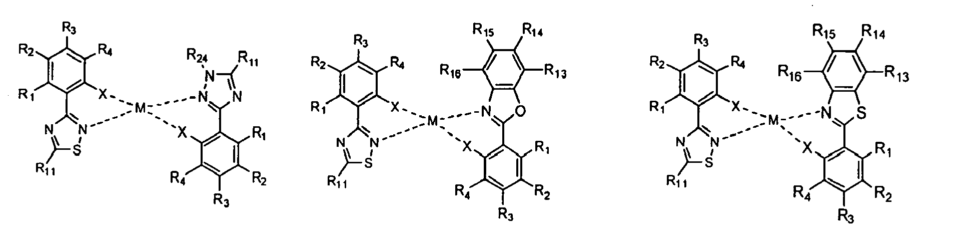 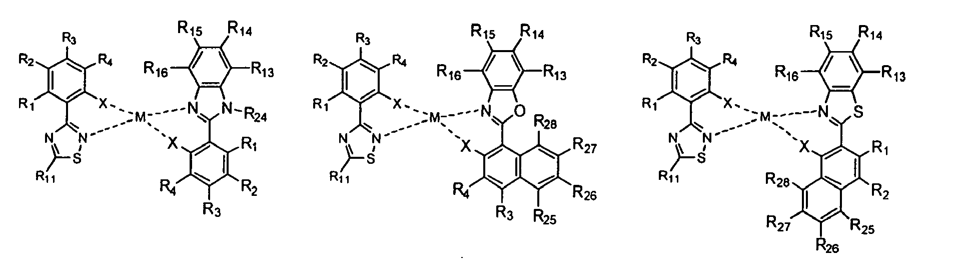 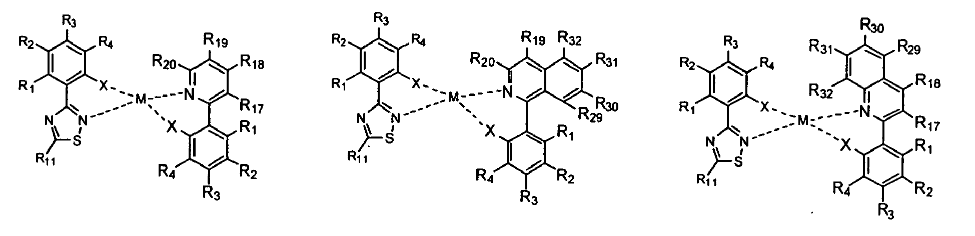 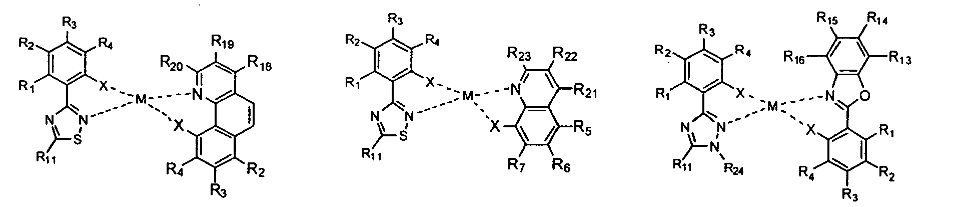 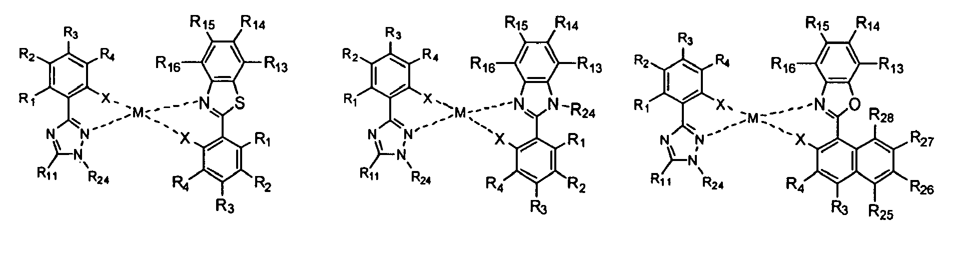 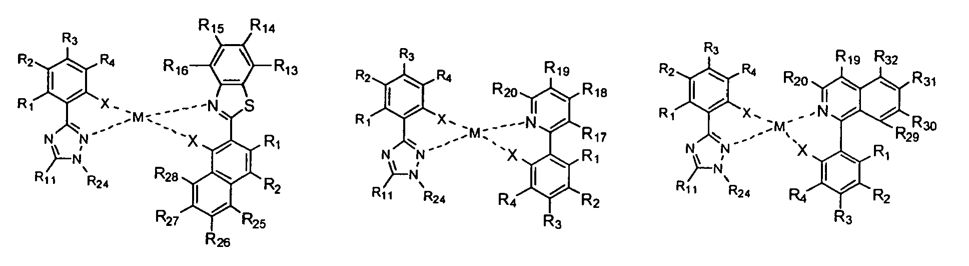 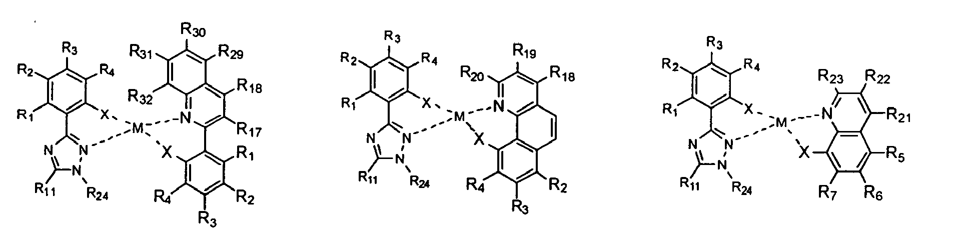 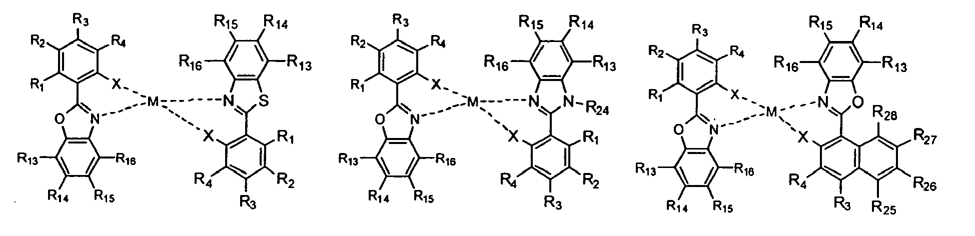 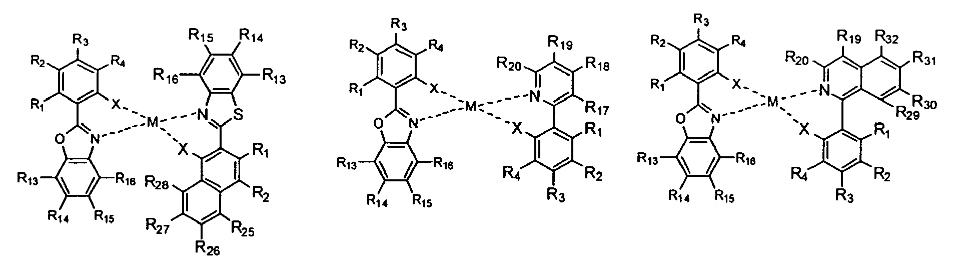 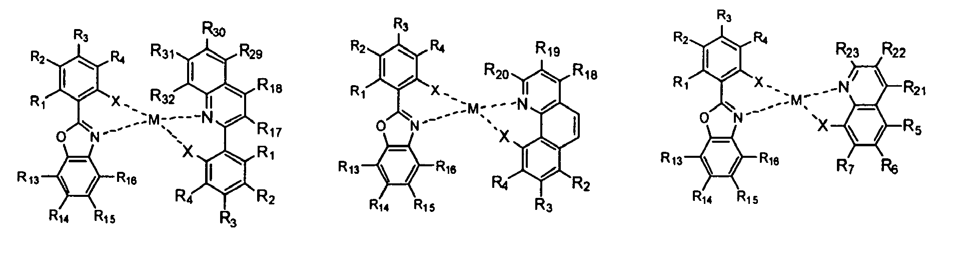 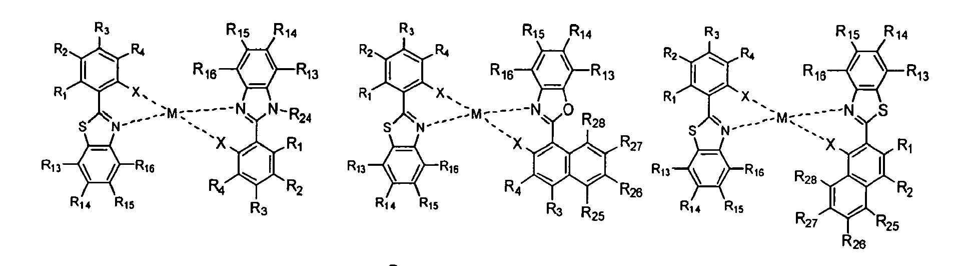 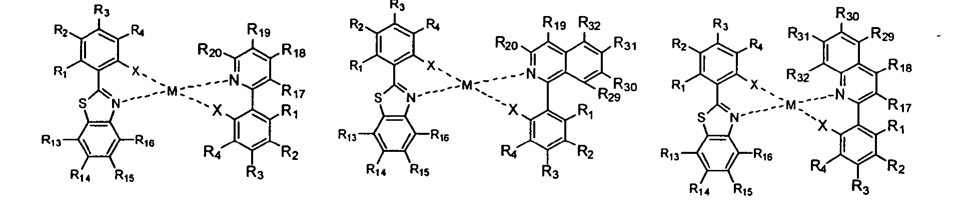 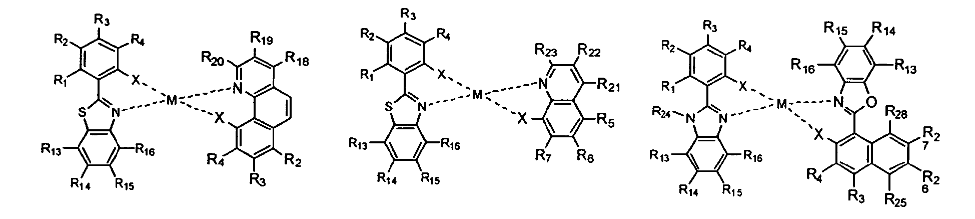 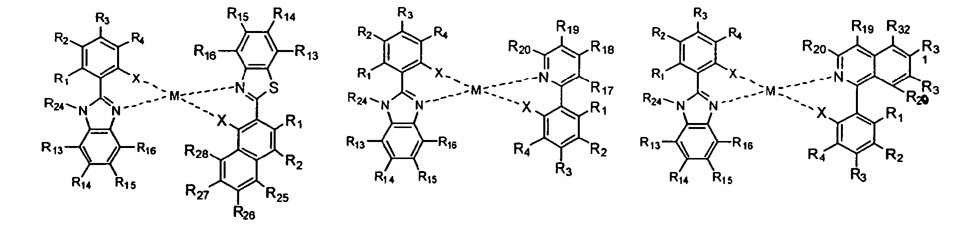 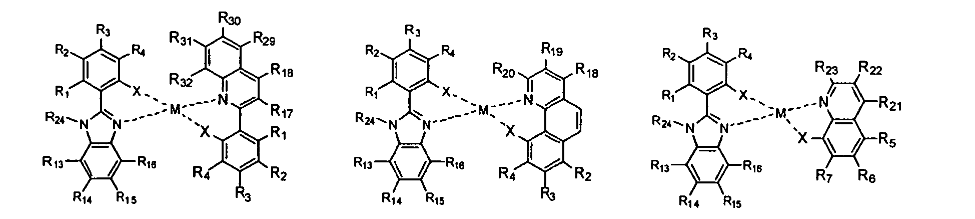 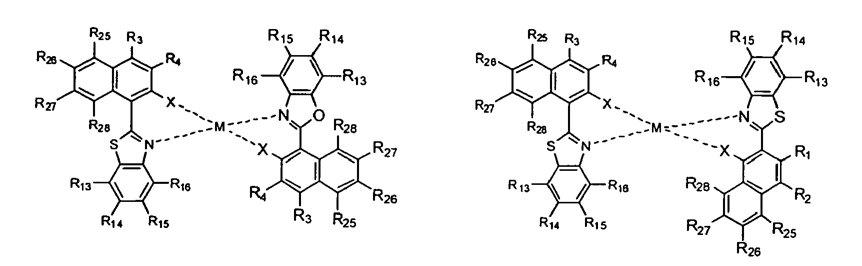 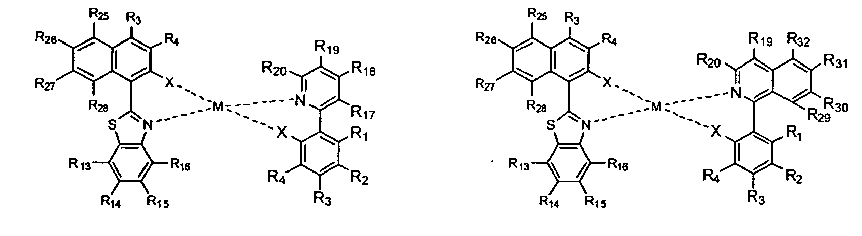 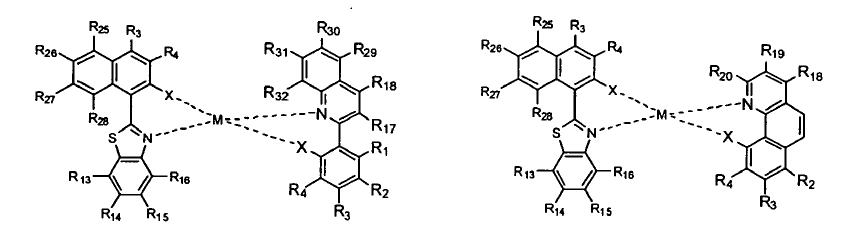 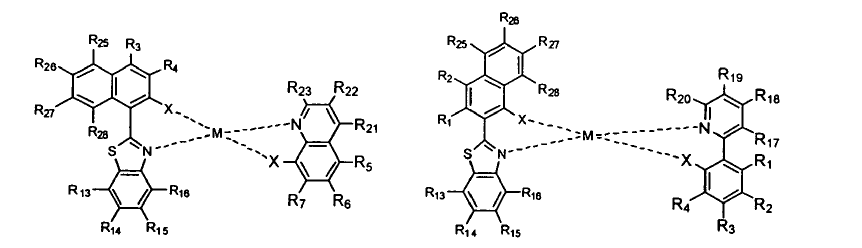 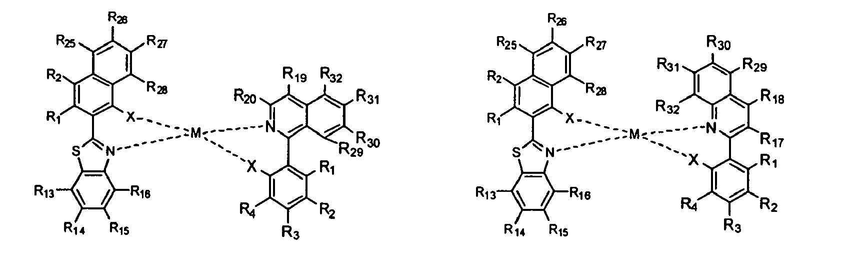 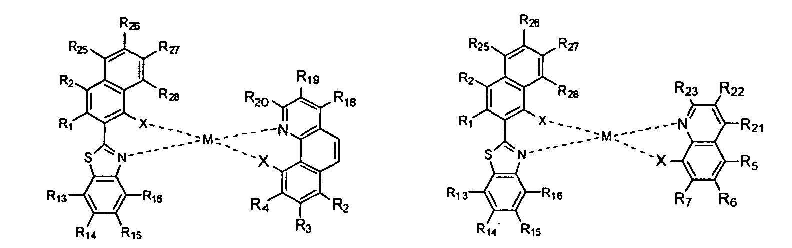 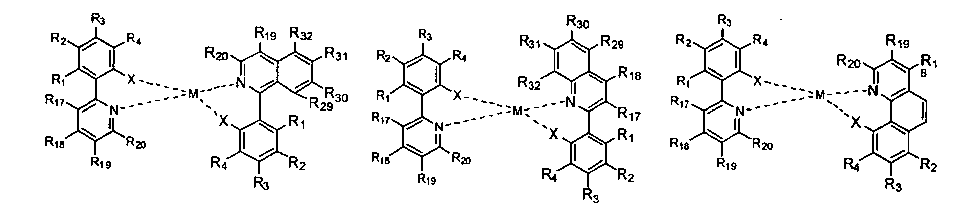 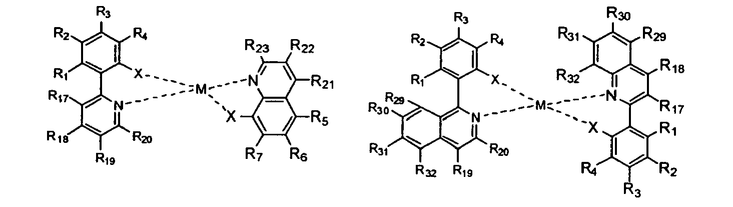 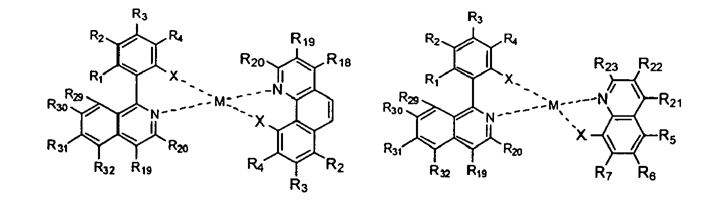 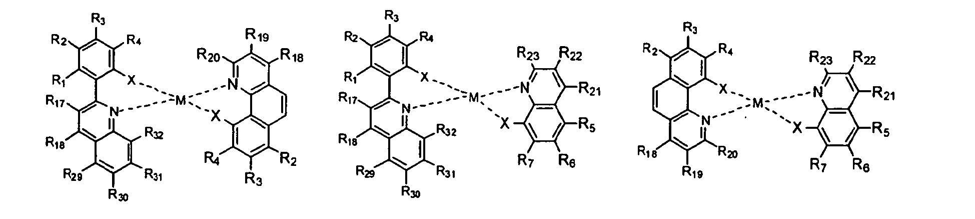 wherein, X represents O, S or Se; M represents Be, Zn, Mg, Cu or Ni;
R₁ through R₇ independently represent hydrogen, methyl, ethyl, n-propyl, i-propyl, n-butyl, i-butyl, t-butyl, n-pentyl, i-pentyl, n-hexyl, n-heptyl, n-octyl, 2-ethylhexyl, n-nonyl, decyl, dodecyl, hexadecyl, fluoro, chloro, trifluoromethyl, perfluoroethyl, trifluoroethyl, perfluoropropyl, perfluorobutyl, trimethylsilyl, triethylsilyl, tripropylsilyl, tri(t-butyl)silyl, t-butyldimethylsilyl, dimethylphenylsilyl, triphenylsilyl, phenyl, biphenyl, naphthyl, anthryl, fluorenyl, pyridyl, quinolyl, furanyl, thiophenyl, thiazolyl, imidazolyl, oxazolyl, benzofuranyl, benzothiazolyl, benzimidazolyl, benzoxazolyl, dimethylamino, diethylamino or diphenylamino;
R₁₁ through R₂₃ independently represent hydrogen, methyl, ethyl, n-propyl, i-propyl, n-butyl, i-butyl, t-butyl, n-pentyl, i-pentyl, n-hexyl, n-heptyl, n-octyl, 2-ethylhexyl, n-nonyl, decyl, dodecyl, hexadecyl, fluoro, chloro, trifluoromethyl, perfluoroethyl, trifluoroethyl, perfluoropropyl, perfluorobutyl, trimethylsilyl, triethylsilyl, tripropylsilyl, tri(t-butyl)silyl, t-butyldimethylsilyl, dimethylphenylsilyl, triphenylsilyl, phenyl, biphenyl, naphthyl, anthryl, fluorenyl, pyridyl, quinolyl, furanyl, thiophenyl, thiazolyl, imidazolyl, oxazolyl, benzofuranyl, benzothiazolyl, benzimidazolyl, benzoxazolyl, dimethylamino, diethylamino or diphenylamino;
R₂₄ represents methyl, ethyl, n-propyl, i-propyl, n-butyl, i-butyl, t-butyl, n-pentyl, i-pentyl, n-hexyl, n-heptyl, n-octyl, 2-ethylhexyl, n-nonyl, decyl, dodecyl, hexadecyl, phenyl, biphenyl, naphthyl, anthryl or fluorenyl;
R₂₅ through R₃₂ independently represent hydrogen, methyl, ethyl, n-propyl, i-propyl, n-butyl, i-butyl, t-butyl, n-pentyl, i-pentyl, n-hexyl, n-heptyl, n-octyl, 2-ethylhexyl, n-nonyl, decyl, dodecyl, hexadecyl, fluoro, chloro, cyano, trifluoromethyl, perfluoroethyl, trifluoroethyl, perfluoropropyl, perfluorobutyl, cyclopropyl, cyclobutyl, cyclopentyl, cyclohexyl, cycloheptyl, cyclooctyl, methoxy, ethoxy, butoxy, hexyloxy, phenyl, biphenyl, naphthyl, anthryl, fluorenyl, pyridyl, quinolyl, furanyl, thiophenyl, thiazolyl, imidazolyl, oxazolyl, benzofuranyl, benzothiazolyl, benzimidazolyl, benzoxazolyl, trimethylsilyl, triethylsilyl, tripropylsilyl, tri(t-butyl)silyl, t-butyldimethylsilyl, dimethylphenylsilyl, triphenylsilyl, dimethylamino, diethylamino or diphenylamino; and
the phenyl, biphenyl, naphthyl, anthryl, fluorenyl, pyridyl, quinolyl, furanyl, thiophenyl, thiazolyl, imidazolyl, oxazolyl, benzofuranyl, benzothiazolyl, benzimidazolyl or benzoxazolyl of R₁ through R₇, R₁₁ through R₂₃, R₂₄ and R₂₅ through R₃₂ may be further substituted by one or more substituent(s) selected from methyl, ethyl, n-propyl, i-propyl, n-butyl, i-butyl, t-butyl, n-pentyl, i-pentyl, n-hexyl, n-heptyl, n-octyl, 2-ethylhexyl, n-nonyl, decyl, dodecyl, hexadecyl, fluoro, chloro, cyano, trifluoromethyl, perfluoroethyl, trifluoroethyl, perfluoropropyl, perfluorobutyl, cyclopropyl, cyclobutyl, cyclopentyl, cyclohexyl, cycloheptyl, cyclooctyl, methoxy, ethoxy, butoxy, hexyloxy, phenyl, biphenyl, naphthyl, anthryl, fluorenyl, pyridyl, quinolyl, furanyl, thiophenyl, thiazolyl, imidazolyl, oxazolyl, benzofuranyl, benzothiazolyl, benzimidazolyl, benzoxazolyl, trimethylsilyl, triethylsilyl, tripropylsilyl, tri(t-butyl)silyl, t-butyldimethylsilyl, dimethylphenylsilyl, triphenylsilyl, dimethylamino, diethylamino and diphenylamino.

When M is a trivalent metal, the compounds represented by Chemical Formula (1) according to the present invention can be specifically exemplified by the following compounds, but they are not restricted thereto: 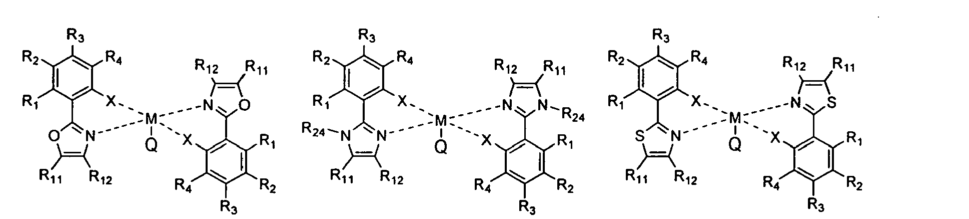 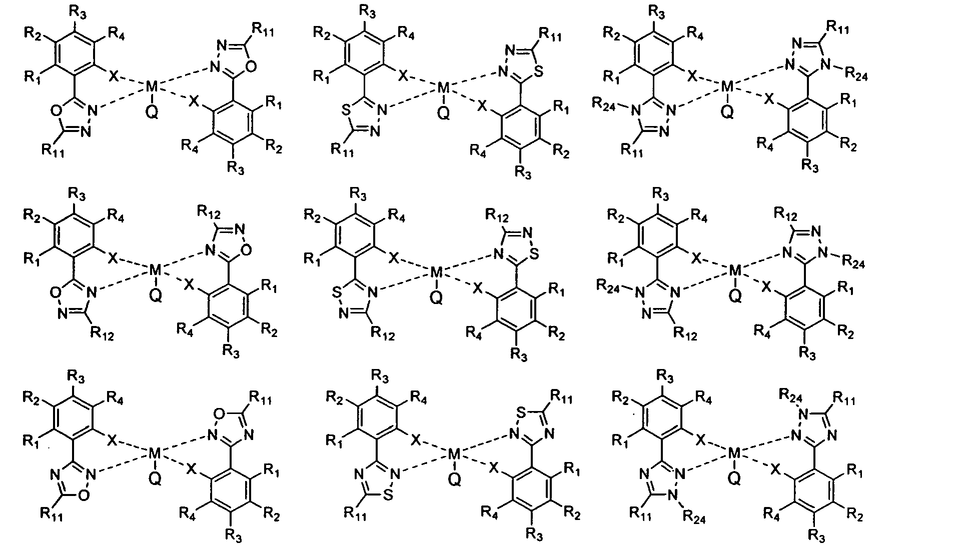 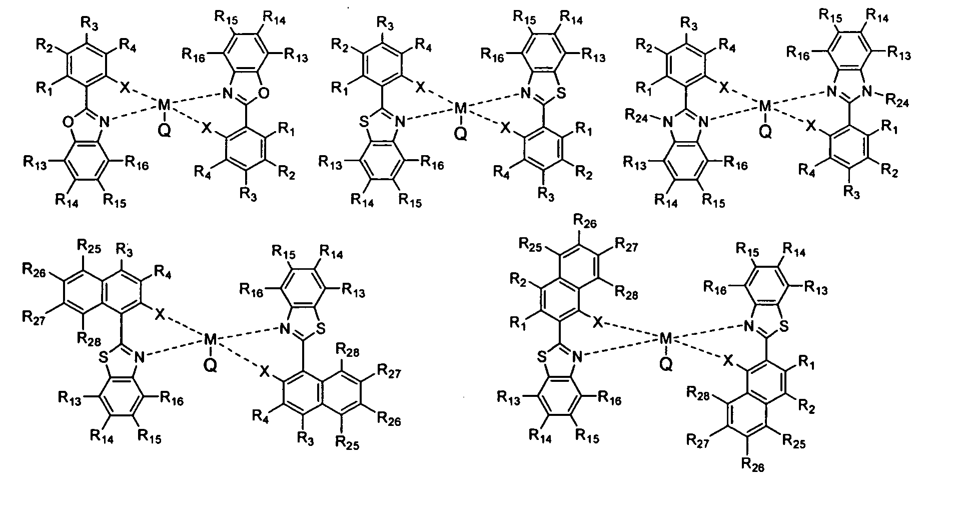 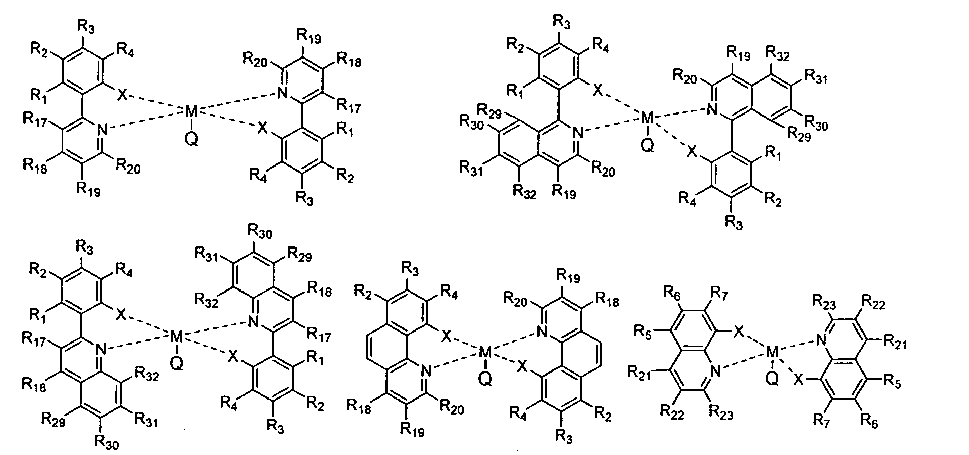 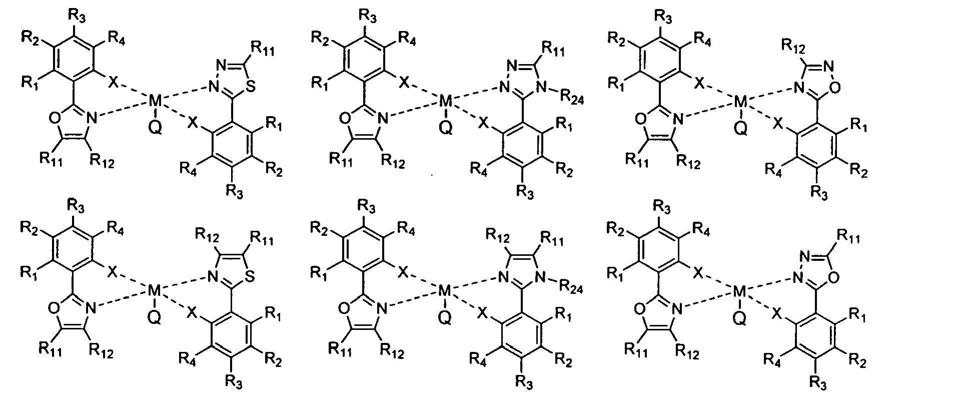 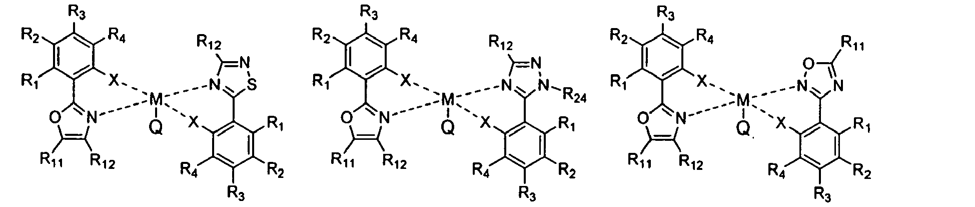 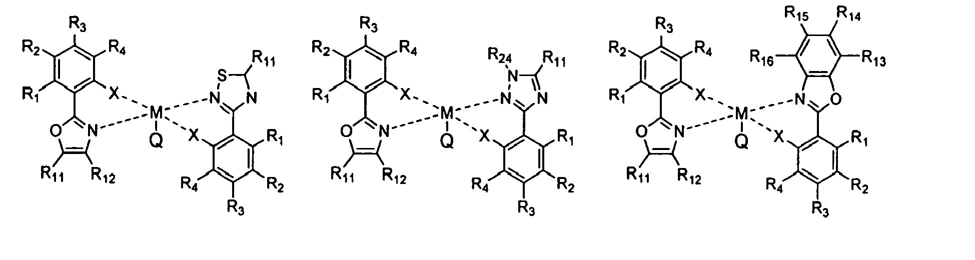 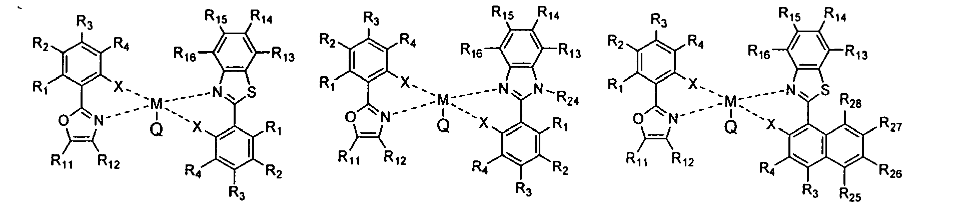 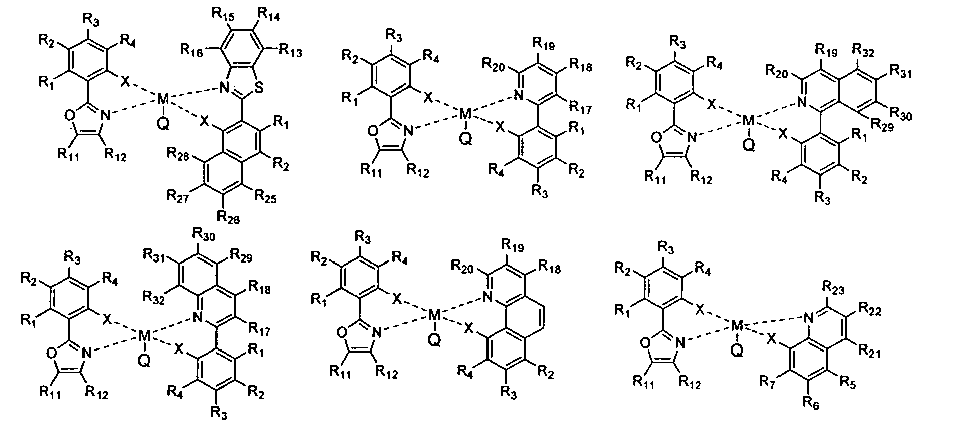 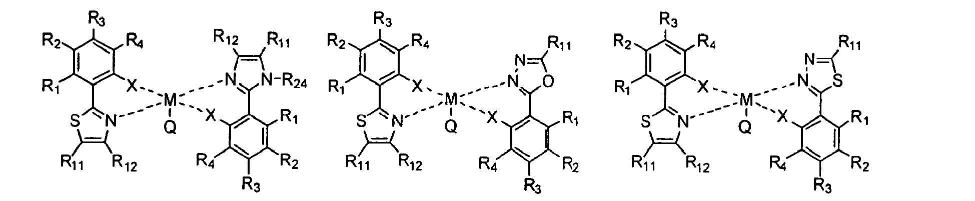 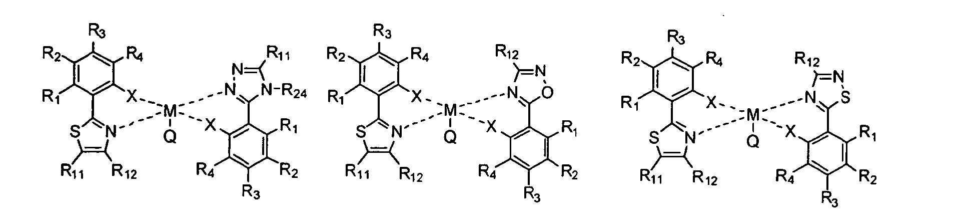 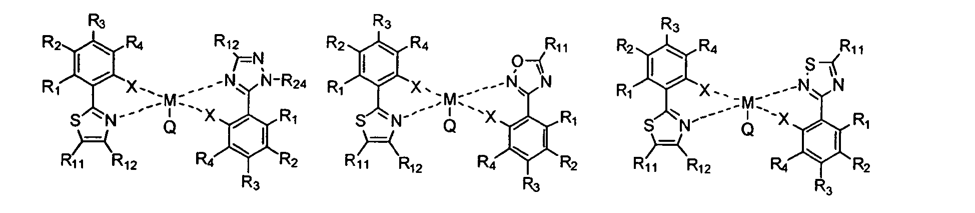 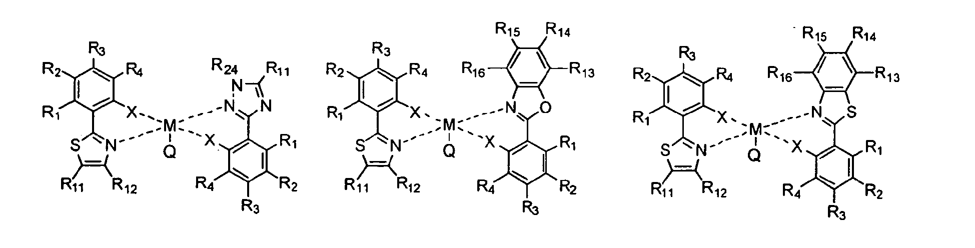 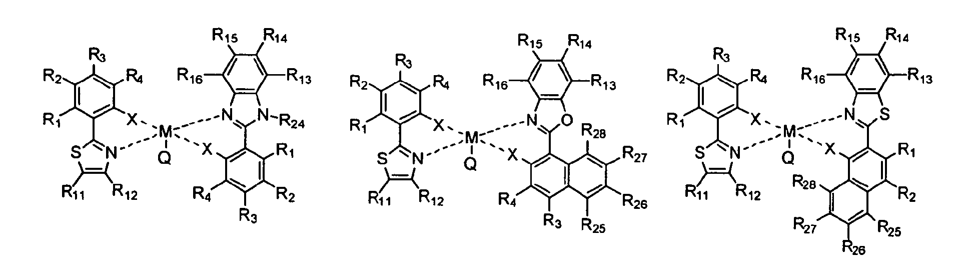 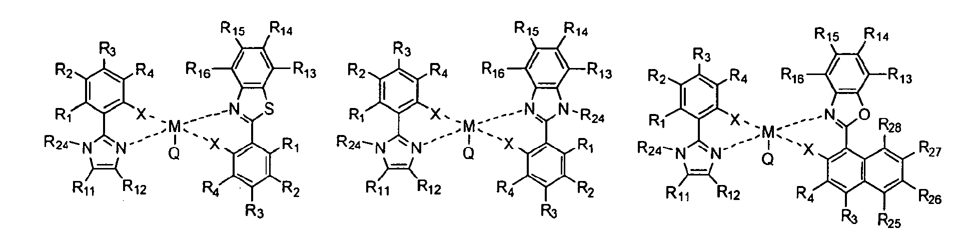 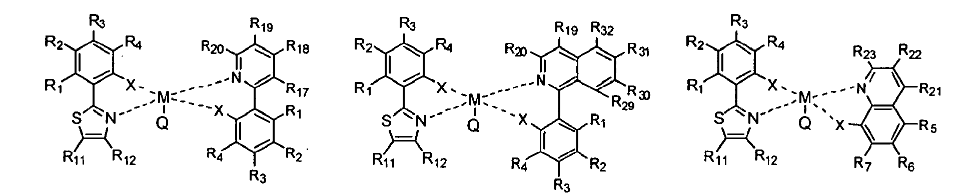 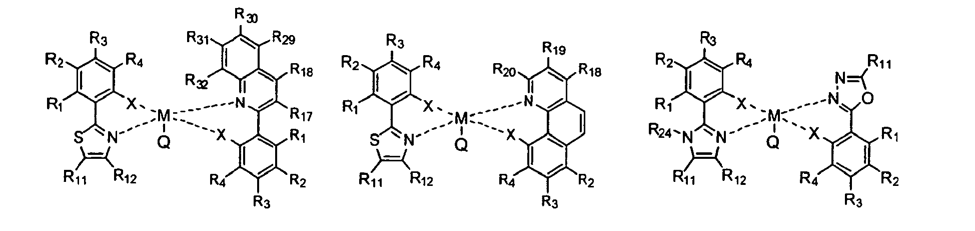 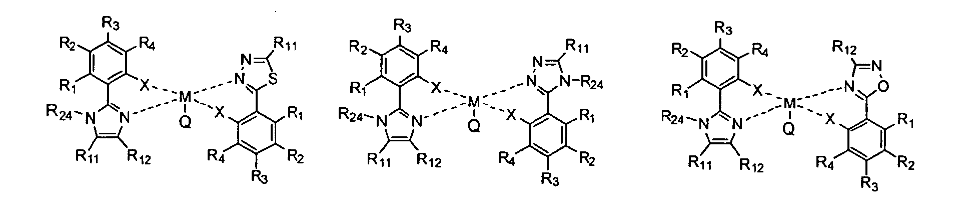 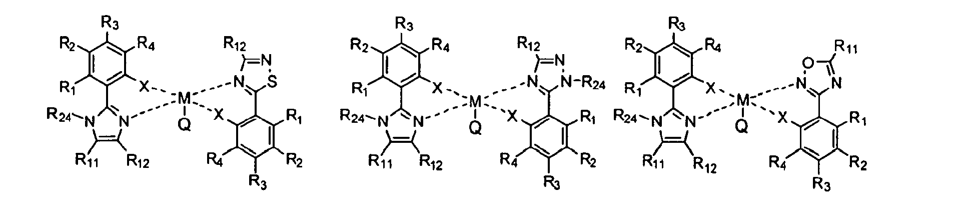 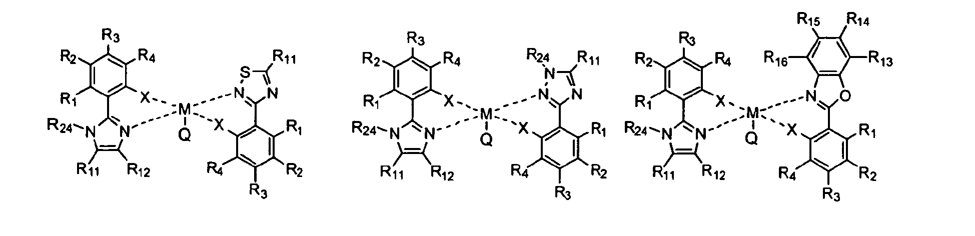 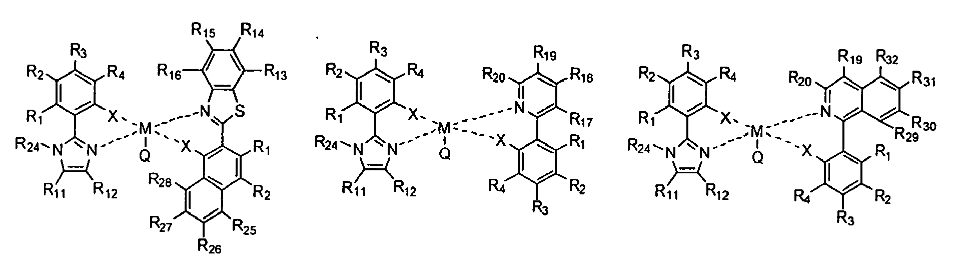 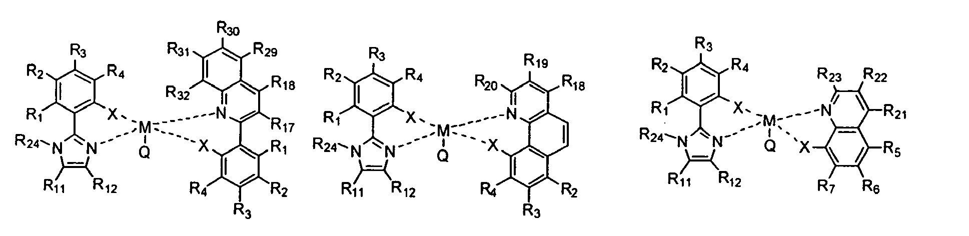 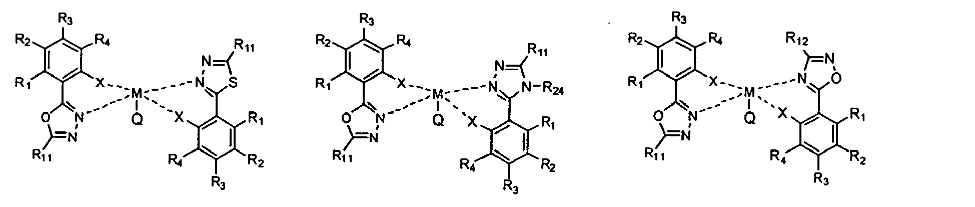 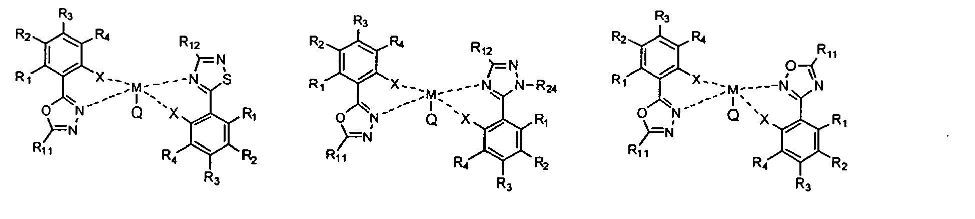 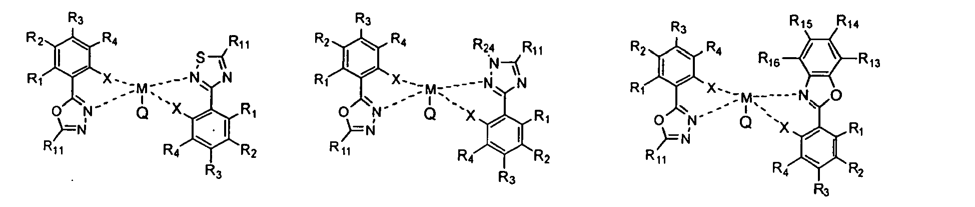 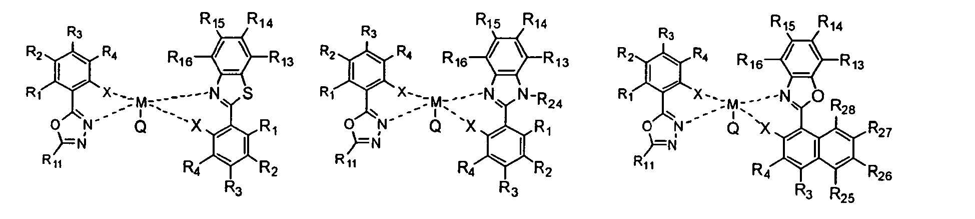 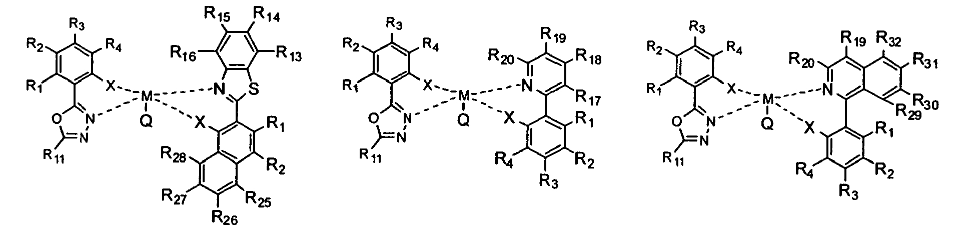 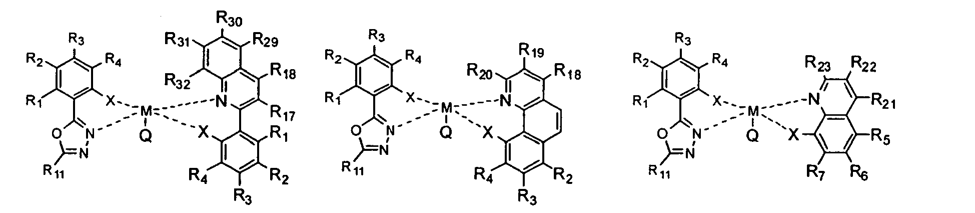 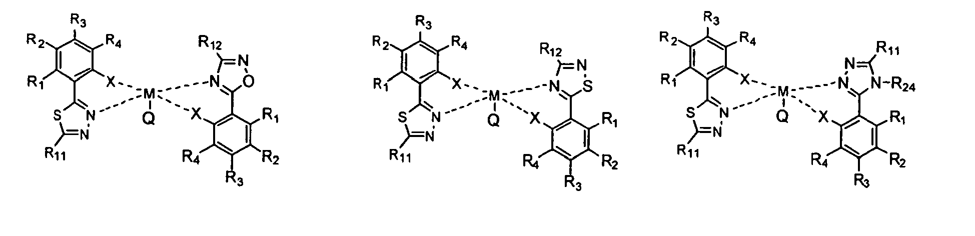 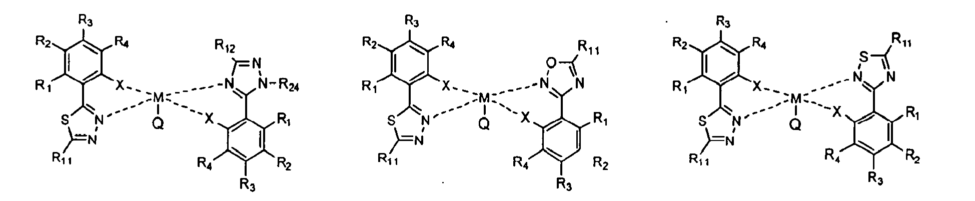 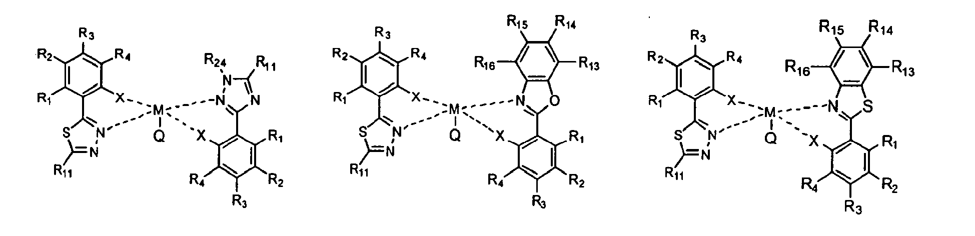 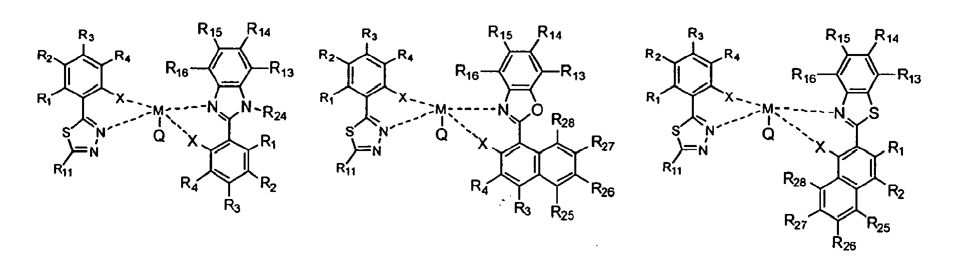 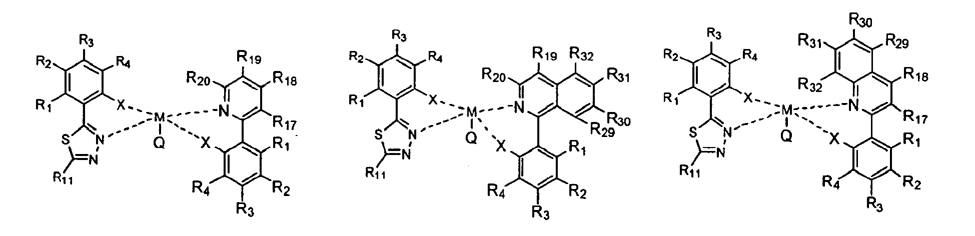 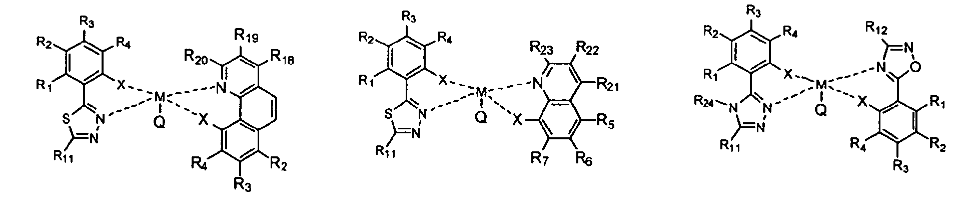 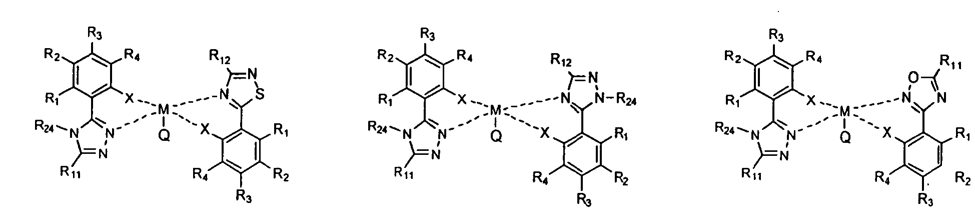 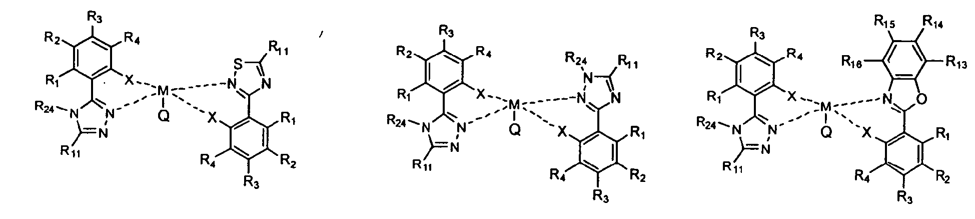 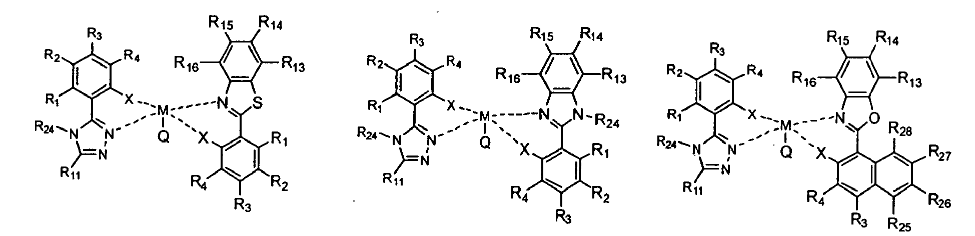 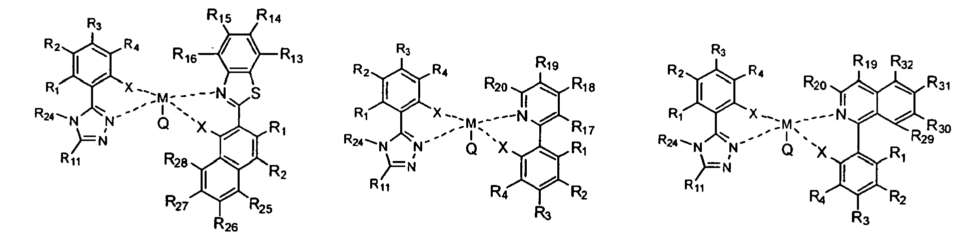 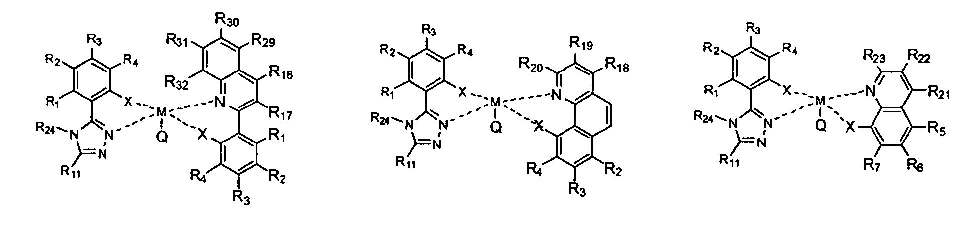 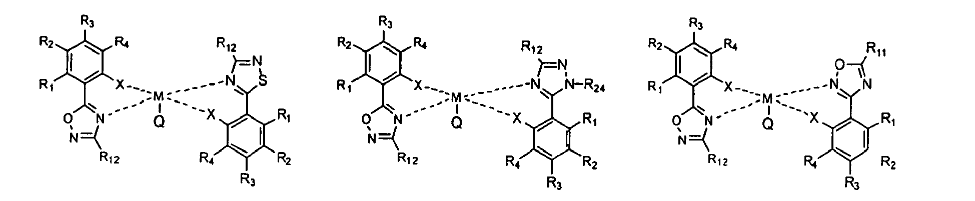 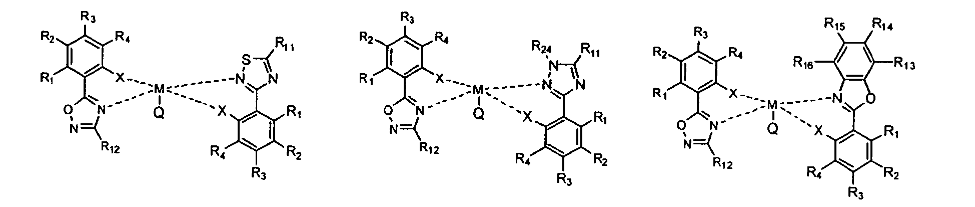 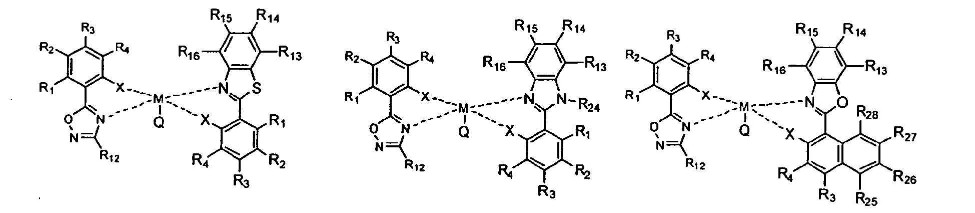 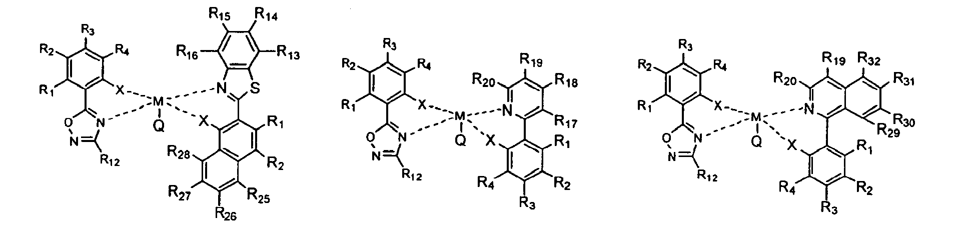 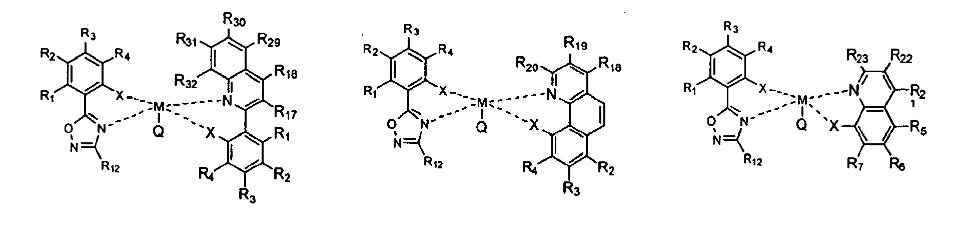 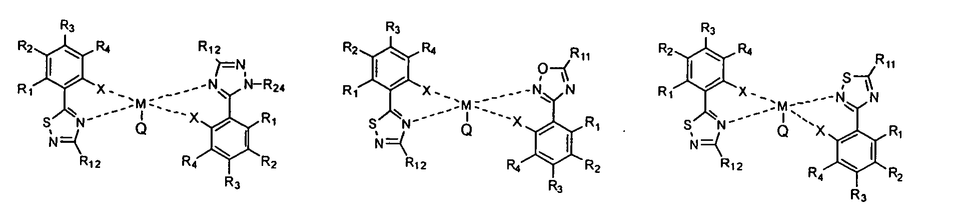 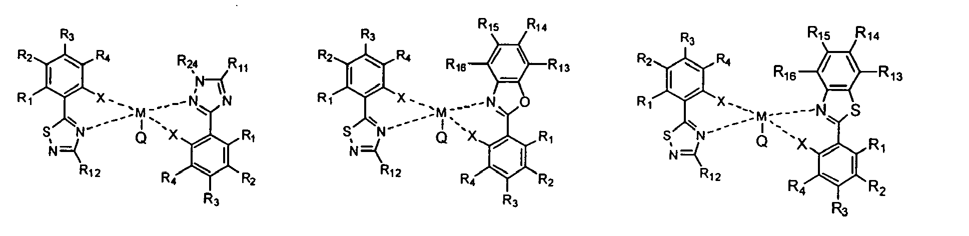 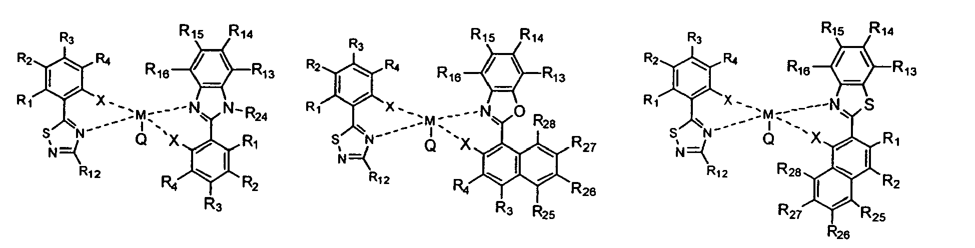 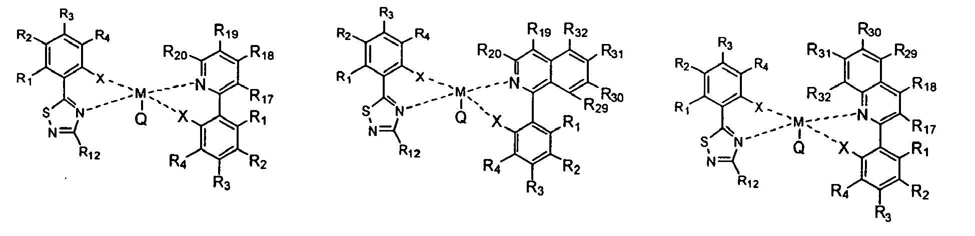 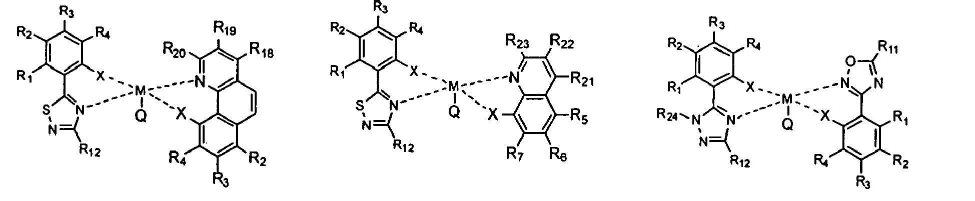 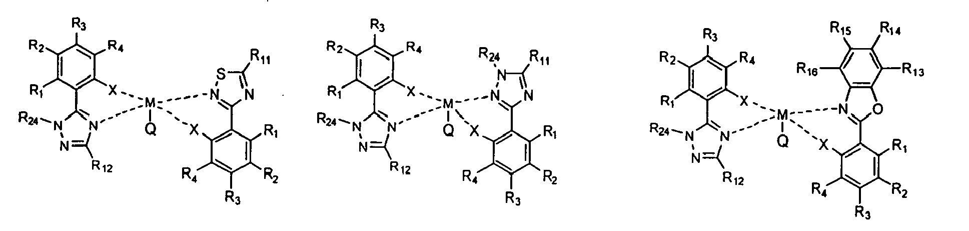 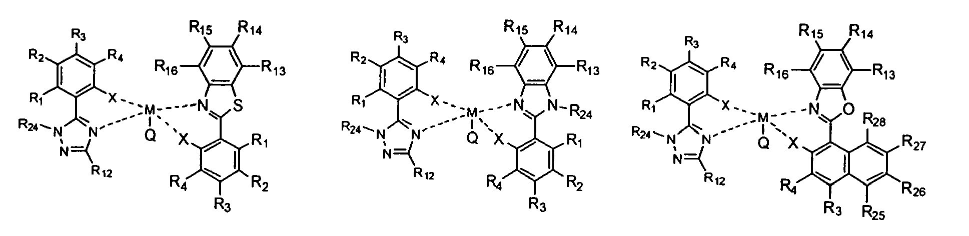 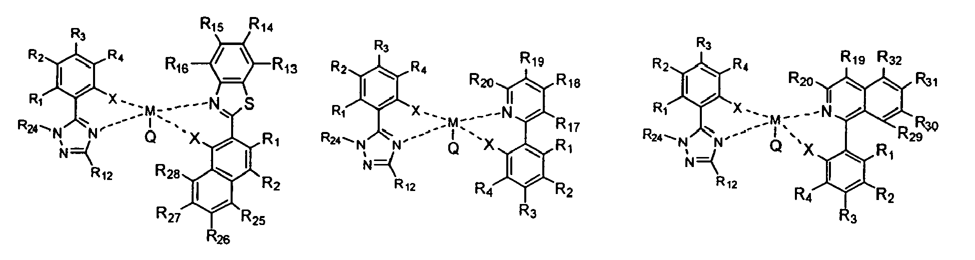 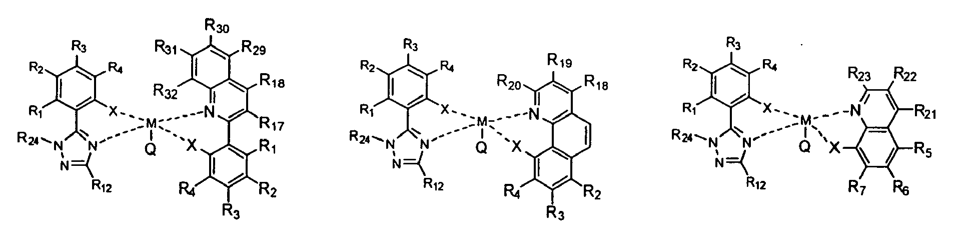 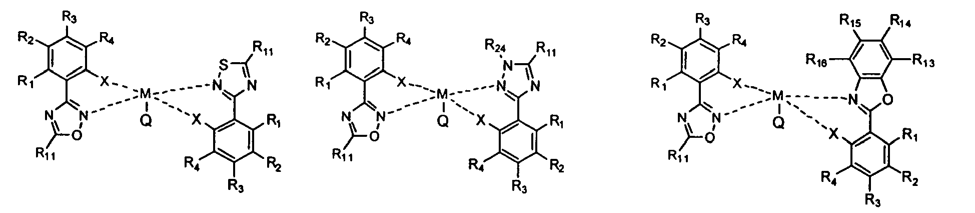 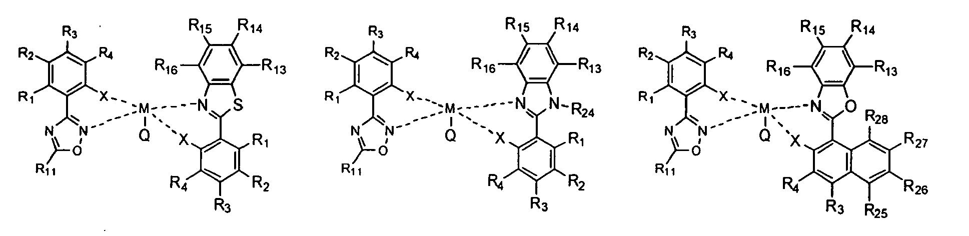 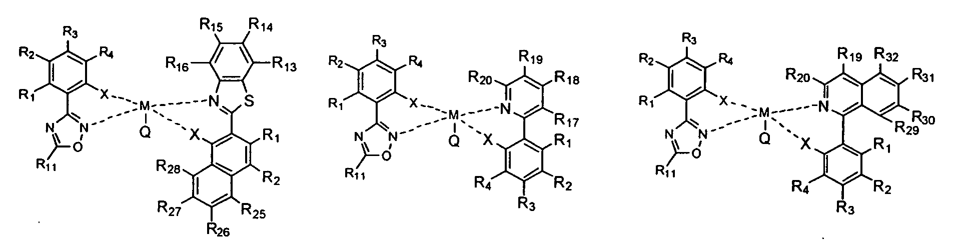 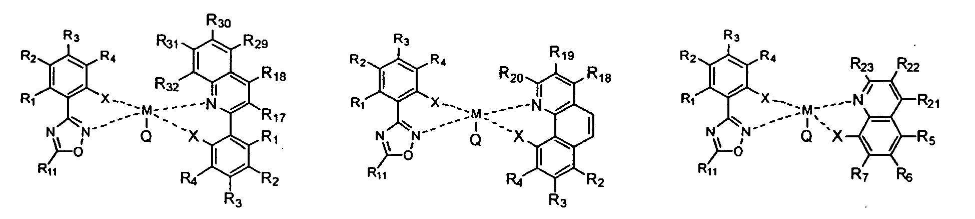 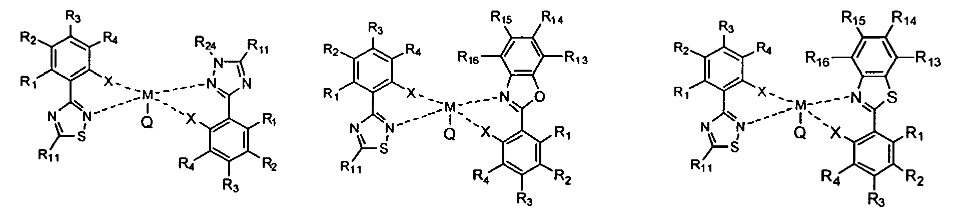 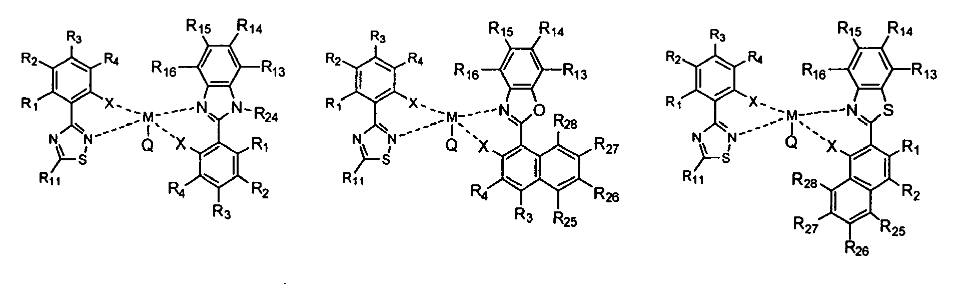 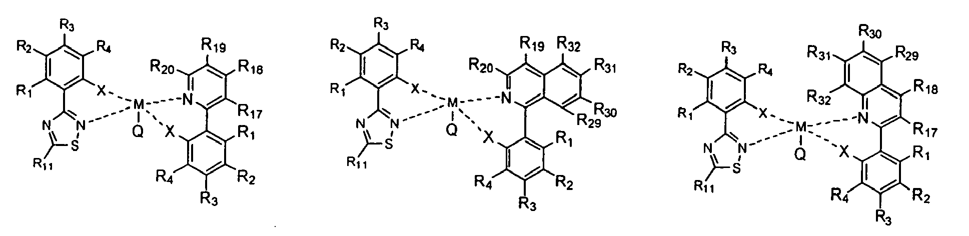 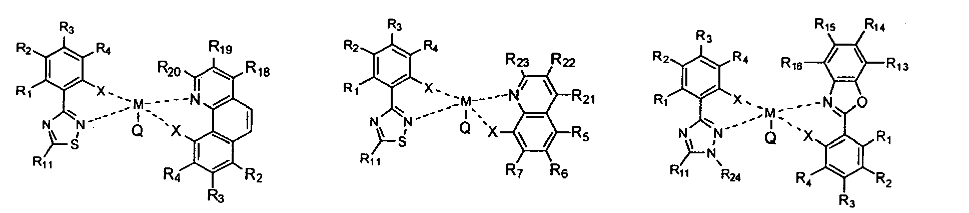 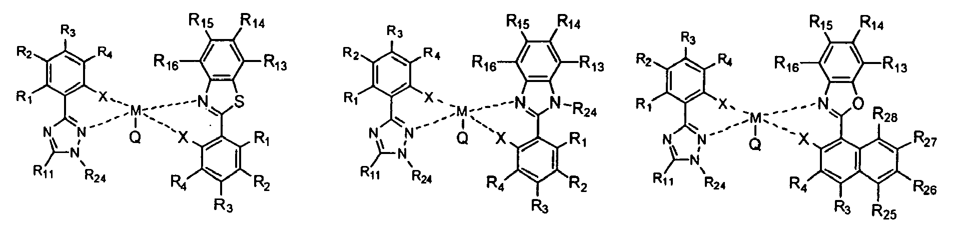 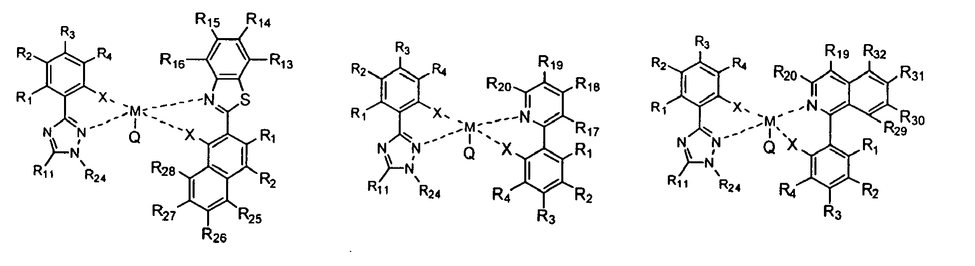 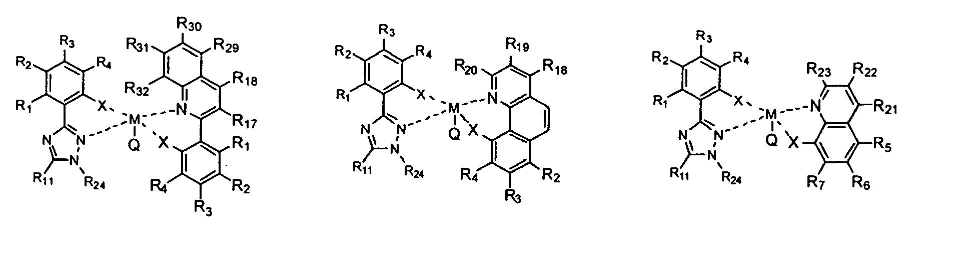 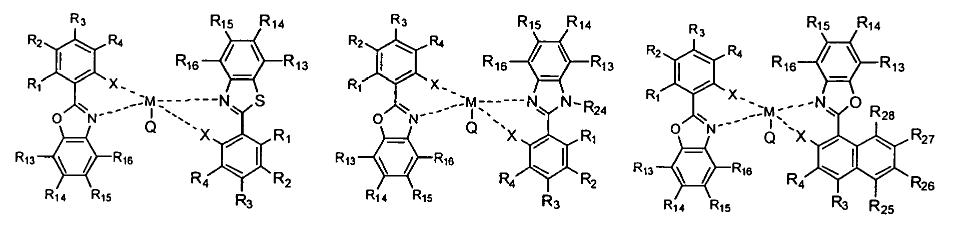 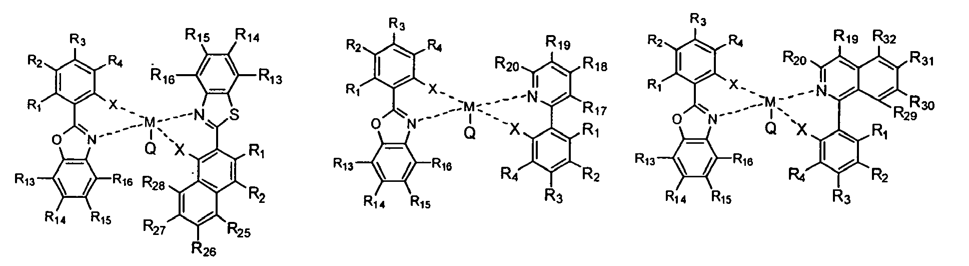 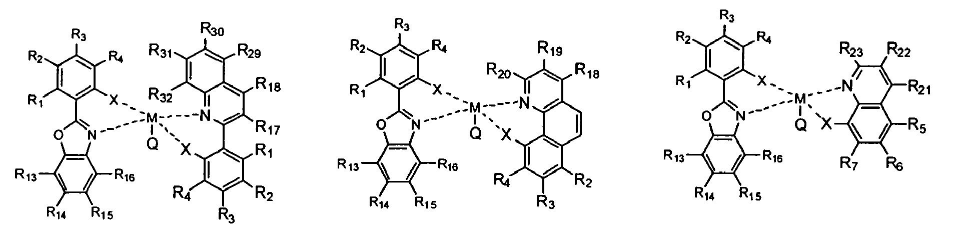 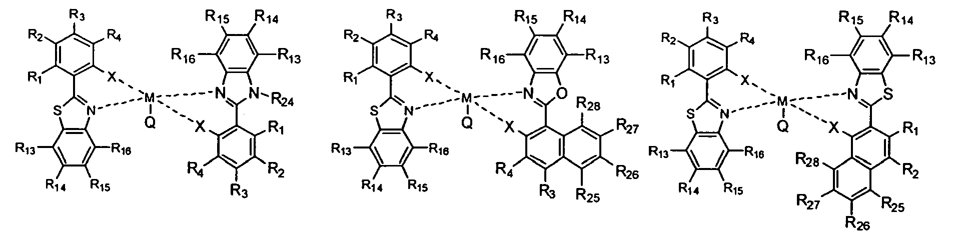 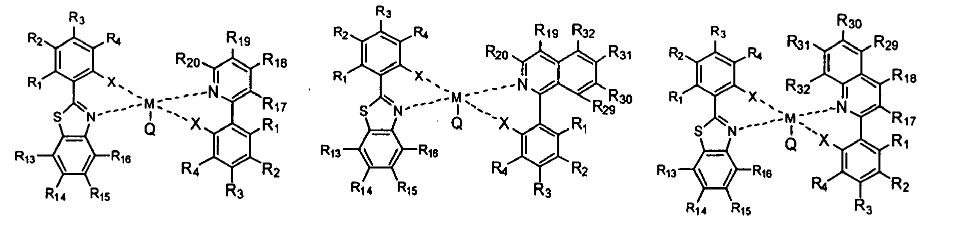 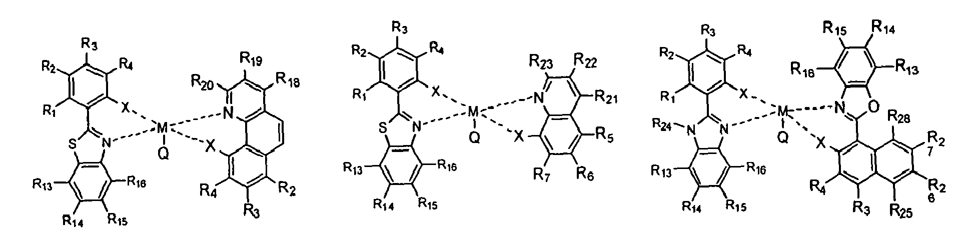 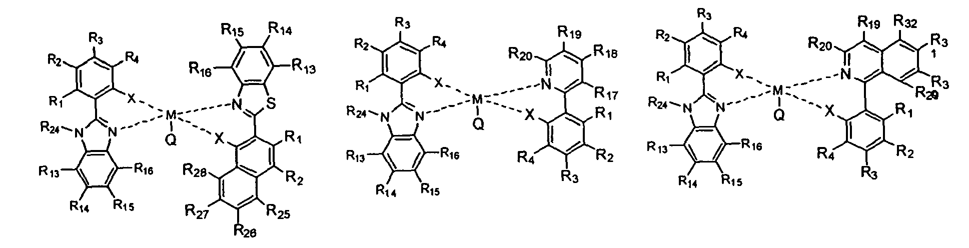 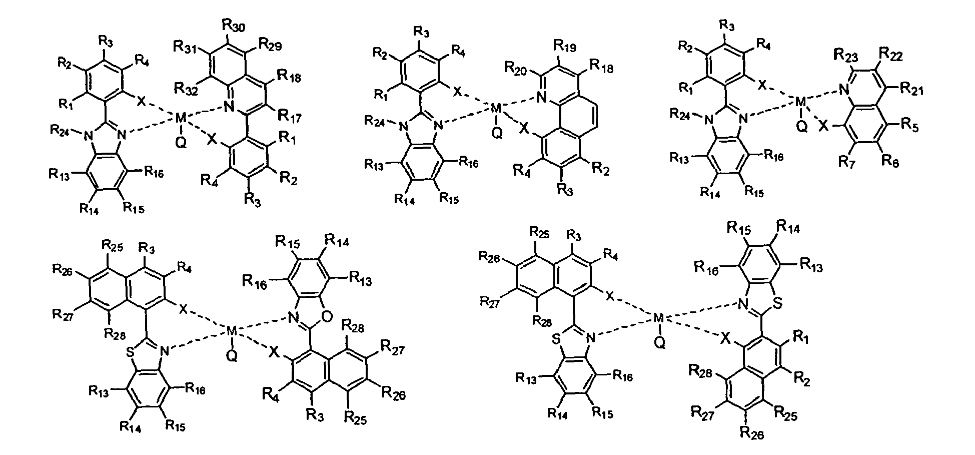 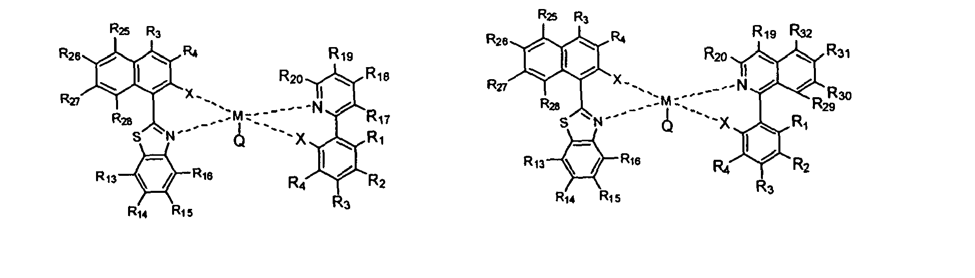 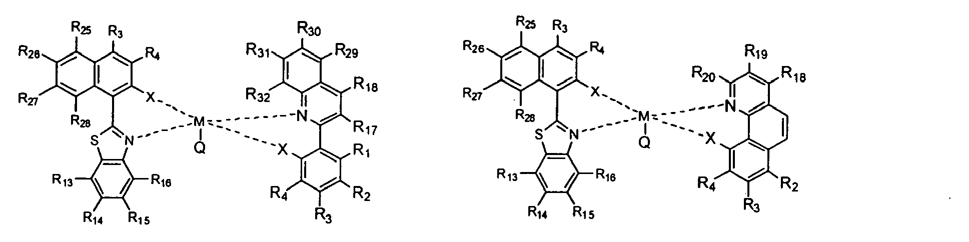 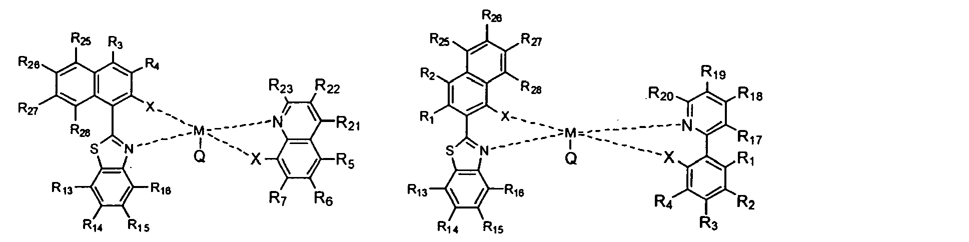 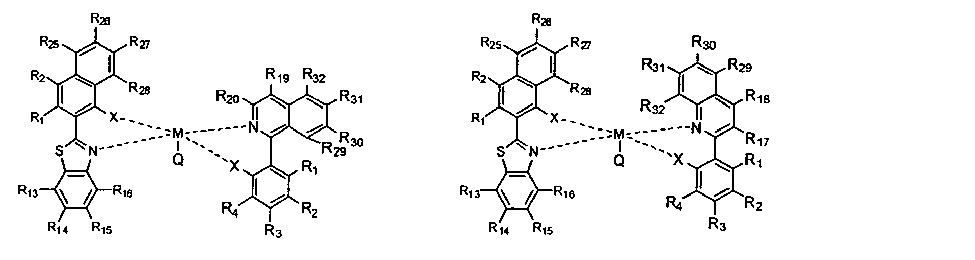 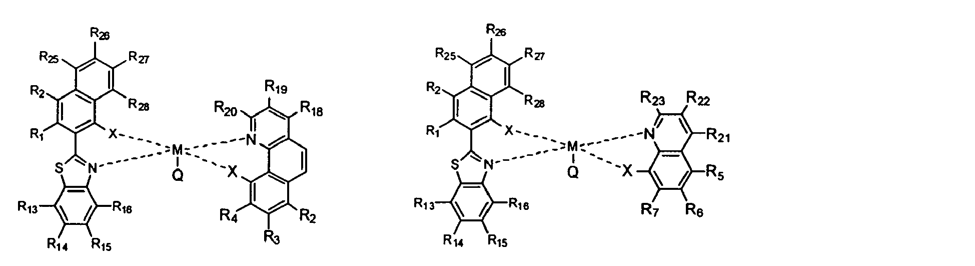 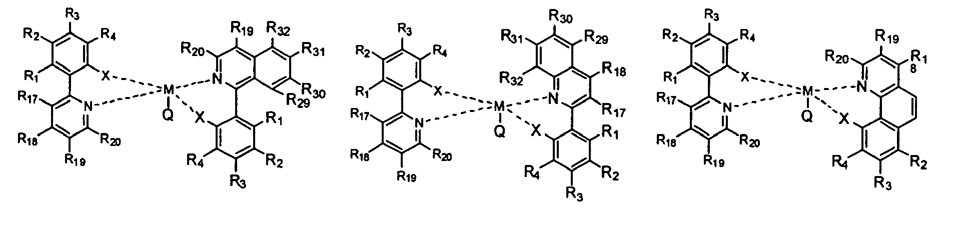 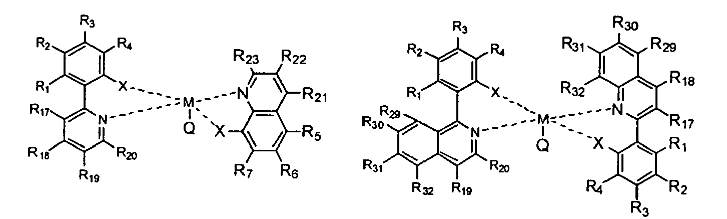 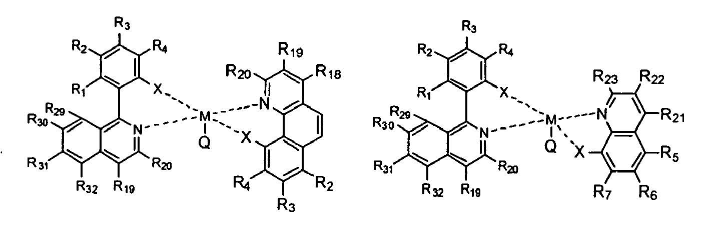 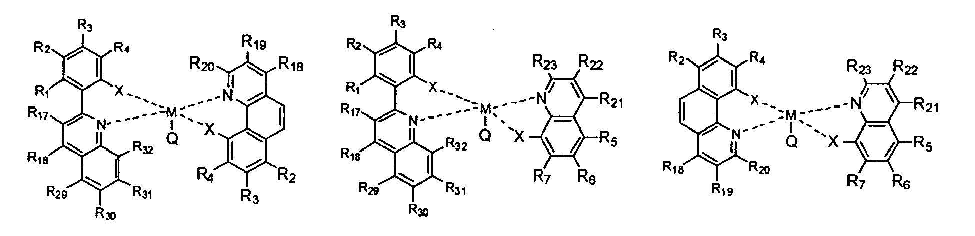 wherein, X represents O, S or Se; M represents Al, Ga, In or B; Q represents (C6-C60)aryloxy or tri(C6-C60)arylsilyl, and the aryloxy and triarylsilyl of Q may be further substituted by (C1-C60)alkyl or (C6-C60)aryl;
R₁ through R₇ independently represent hydrogen, methyl, ethyl, n-propyl, i-propyl, n-butyl, i-butyl, t-butyl, n-pentyl, i-pentyl, n-hexyl, n-heptyl, n-octyl, 2-ethylhexyl, n-nonyl, decyl, dodecyl, hexadecyl, fluoro, chloro, trifluoromethyl, perfluoroethyl, trifluoroethyl, perfluoropropyl, perfluorobutyl, trimethylsilyl, triethylsilyl, tripropylsilyl, tri(t-butyl)silyl, t-butyldimethylsilyl, dimethylphenylsilyl, triphenylsilyl, phenyl, biphenyl, naphthyl, anthryl, fluorenyl, pyridyl, quinolyl, furanyl, thiophenyl, thiazolyl, imidazolyl, oxazolyl, benzofuranyl, benzothiazolyl, benzimidazolyl, benzoxazolyl, dimethylamino, diethylamino or diphenylamino;
R₁₁ through R₂₃ independently represent hydrogen, methyl, ethyl, n-propyl, i-propyl, n-butyl, i-butyl, t-butyl, n-pentyl, i-pentyl, n-hexyl, n-heptyl, n-octyl, 2-ethylhexyl, n-nonyl, decyl, dodecyl, hexadecyl, fluoro, chloro, trifluoromethyl, perfluoroethyl, trifluoroethyl, perfluoropropyl, perfluorobutyl, trimethylsilyl, triethylsilyl, tripropylsilyl, tri(t-butyl)silyl, t-butyldimethylsilyl, dimethylphenylsilyl, triphenylsilyl, phenyl, biphenyl, naphthyl, anthryl, fluorenyl, pyridyl, quinolyl, furanyl, thiophenyl, thiazolyl, imidazolyl, oxazolyl, benzofuranyl, benzothiazolyl, benzimidazolyl, benzoxazolyl, dimethylamino, diethylamino or diphenylamino;
R₂₄ represents methyl, ethyl, n-propyl, i-propyl, n-butyl, i-butyl, t-butyl, n-pentyl, i-pentyl, n-hexyl, n-heptyl, n-octyl, 2-ethylhexyl, n-nonyl, decyl, dodecyl, hexadecyl, phenyl, biphenyl, naphthyl, anthryl or fluorenyl;
R₂₅ through R₃₂ independently represent hydrogen, methyl, ethyl, n-propyl, i-propyl, n-butyl, i-butyl, t-butyl, n-pentyl, i-pentyl, n-hexyl, n-heptyl, n-octyl, 2-ethylhexyl, n-nonyl, decyl, dodecyl, hexadecyl, fluoro, chloro, cyano, trifluoromethyl, perfluoroethyl, trifluoroethyl, perfluoropropyl, perfluorobutyl, cyclopropyl, cyclobutyl, cyclopentyl, cyclohexyl, cycloheptyl, cyclooctyl, methoxy, ethoxy, butoxy, hexyloxy, phenyl, biphenyl, naphthyl, anthryl, fluorenyl, pyridyl, quinolyl, furanyl, thiophenyl, thiazolyl, imidazolyl, oxazolyl, benzofuranyl, benzothiazolyl, benzimidazolyl, benzoxazolyl, trimethylsilyl, triethylsilyl, tripropylsilyl, tri(t-butyl)silyl, t-butyldimethylsilyl, dimethylphenylsilyl, triphenylsilyl, dimethylamino, diethylamino or diphenylamino; and
the phenyl, biphenyl, naphthyl, anthryl, fluorenyl, pyridyl, quinolyl, furanyl, thiophenyl, thiazolyl, imidazolyl, oxazolyl, benzofuranyl, benzothiazolyl, benzimidazolyl or benzoxazolyl of R₁ through R₇, R₁₁ through R₂₃, R₂₄ and R₂₅ through R₃₂ may be further substituted by one or more substituent(s) selected from methyl, ethyl, n-propyl, i-propyl, n-butyl, i-butyl, t-butyl, n-pentyl, i-pentyl, n-hexyl, n-heptyl, n-octyl, 2-ethylhexyl, n-nonyl, decyl, dodecyl, hexadecyl, fluoro, chloro, cyano, trifluoromethyl, perfluoroethyl, trifluoroethyl, perfluoropropyl, perfluorobutyl, cyclopropyl, cyclobutyl, cyclopentyl, cyclohexyl, cycloheptyl, cyclooctyl, methoxy, ethoxy, butoxy, hexyloxy, phenyl, biphenyl, naphthyl, anthryl, fluorenyl, pyridyl, quinolyl, furanyl, thiophenyl, thiazolyl, imidazolyl, oxazolyl, benzofuranyl, benzothiazolyl, benzimidazolyl, benzoxazolyl, trimethylsilyl, triethylsilyl, tripropylsilyl, tri(t-butyl)silyl, t-butyldimethylsilyl, dimethylphenylsilyl, triphenylsilyl, dimethylamino, diethylamino and diphenylamino.

The compound represented by Chemical Formula (1) according to the present invention is preferably selected from the following compounds, but they are not restricted thereto:

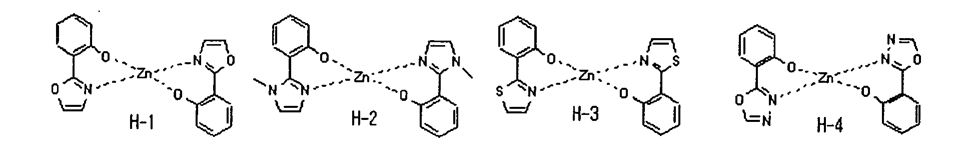

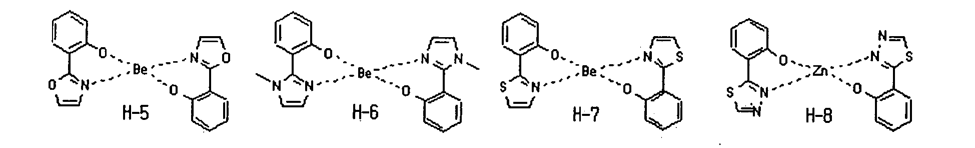

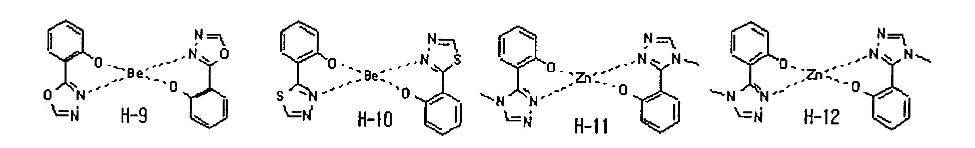

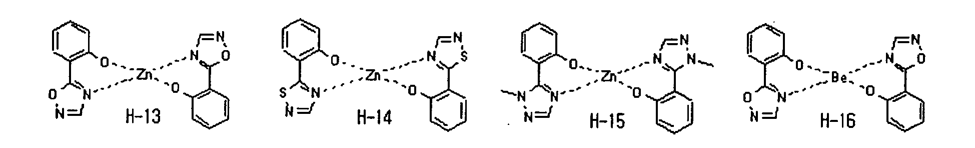

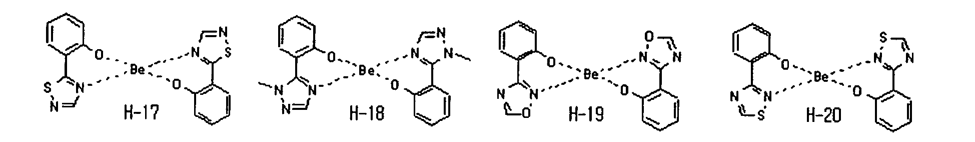

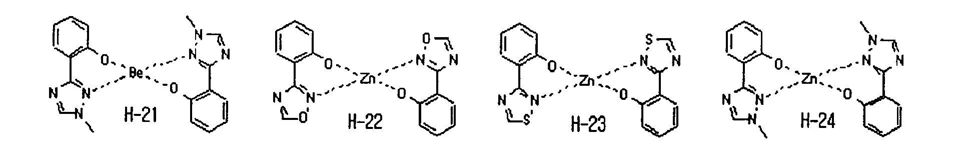

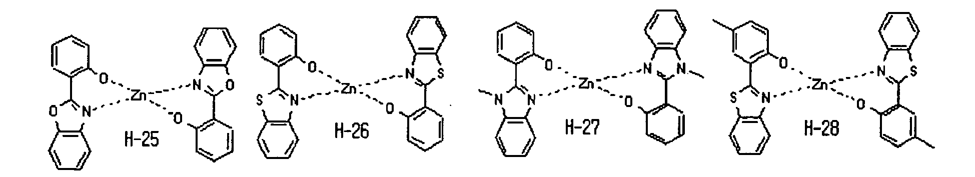

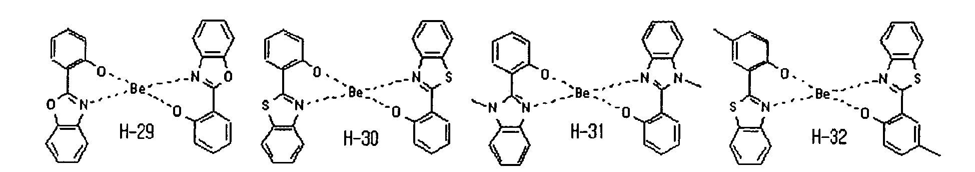

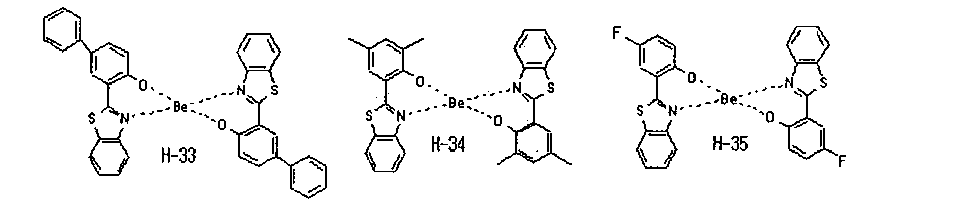

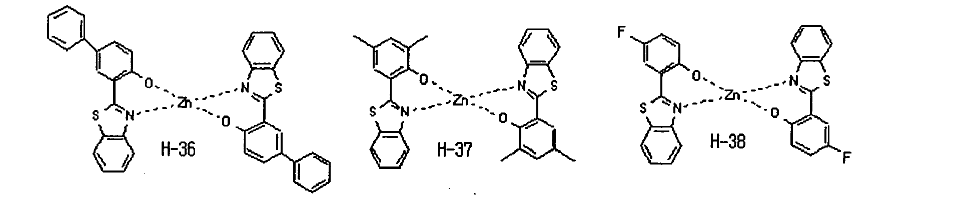

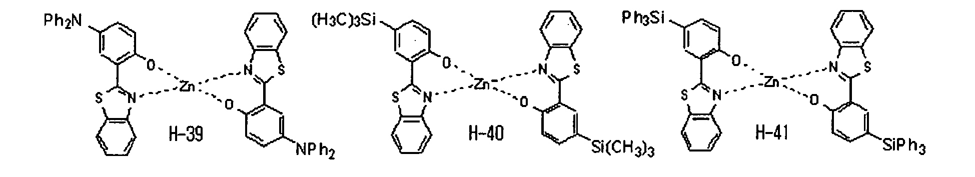

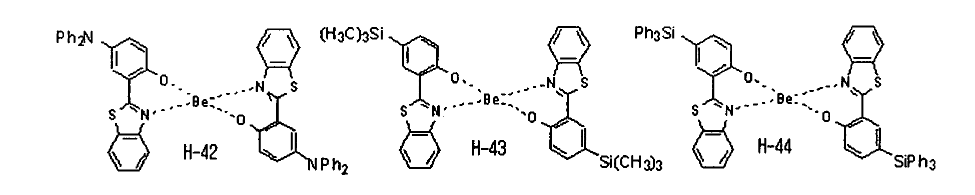

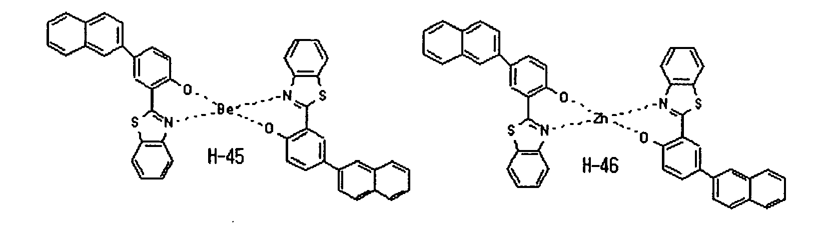

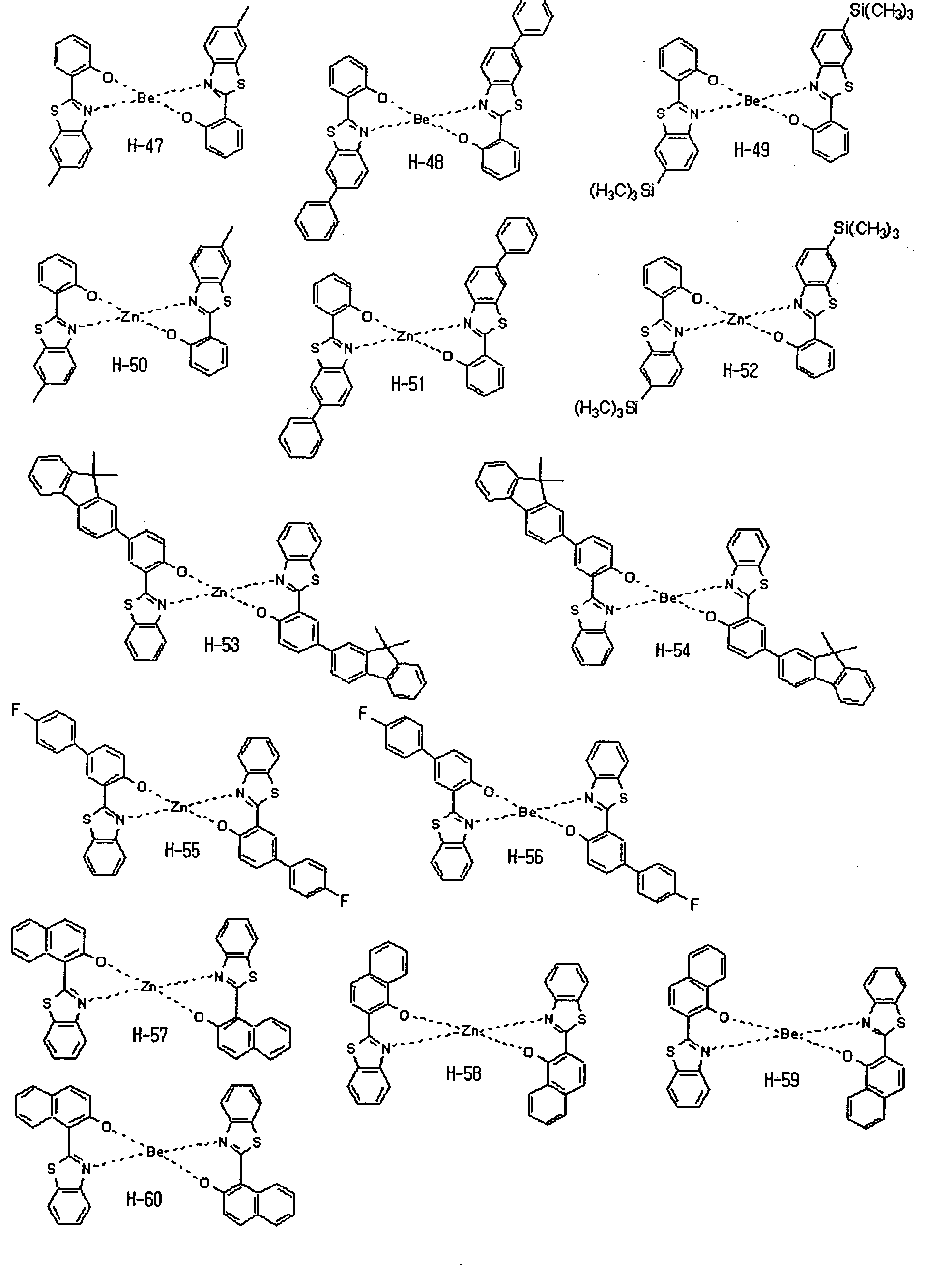

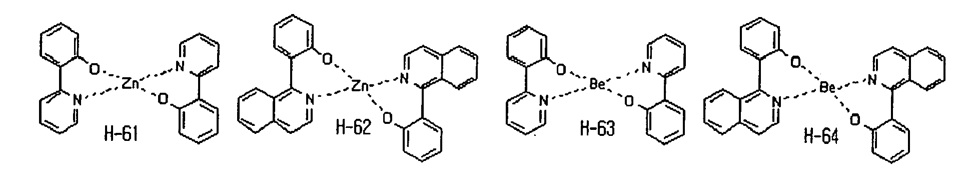

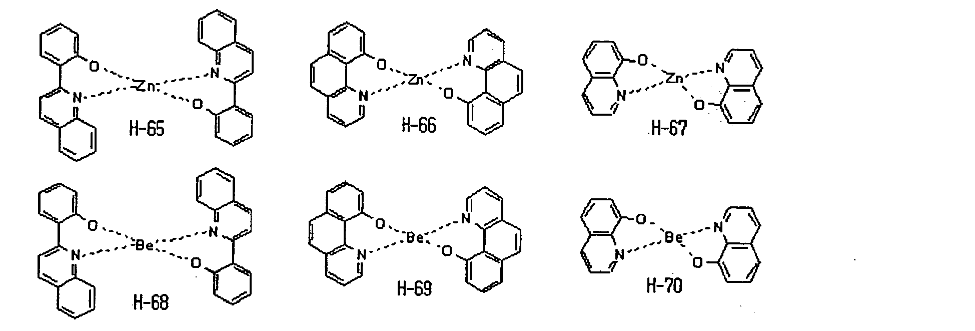

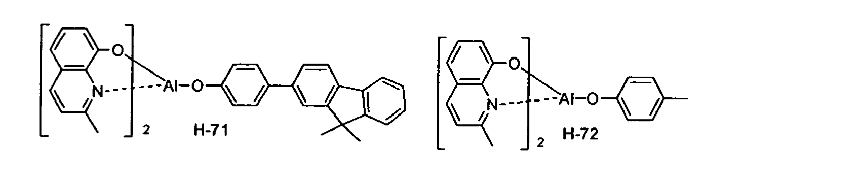

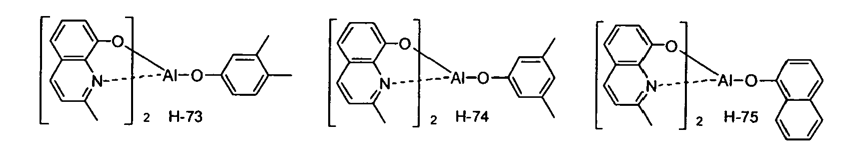

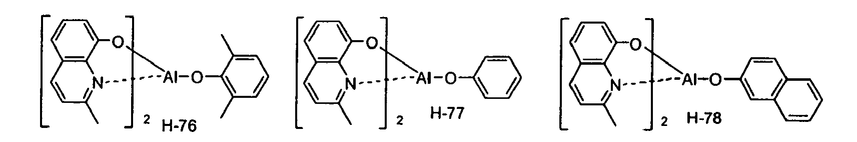

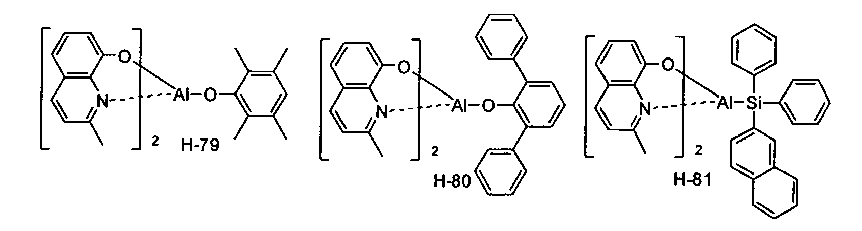

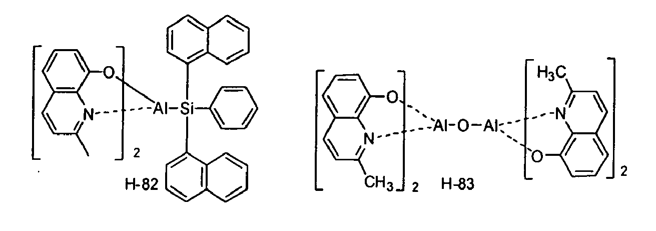

The electroluminescent device according to the present invention is **characterized in that** the organic layer comprises an electroluminescent layer, which comprises one or more electroluminescent compound(s) represented by Chemical Formula (1) as electroluminescent host, and one or more electroluminescent dopant(s) in an amount from 1 to 20% by weight. The electroluminescent dopant applied to the electroluminescent device according to the invention is not particularly restricted, but may be exemplified by the compounds represented by Chemical Formula (2):

Chemical Formula 2 M¹L³L⁴L⁵

wherein, M¹ is selected from a group consisting of Group 7, 8, 9, 10, 11, 13, 14, 15 and 16 in the Periodic Table, and ligands L³, L⁴ and L⁵ are independently selected from the following structures: 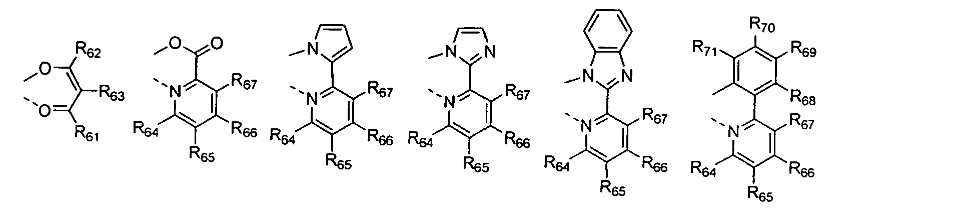 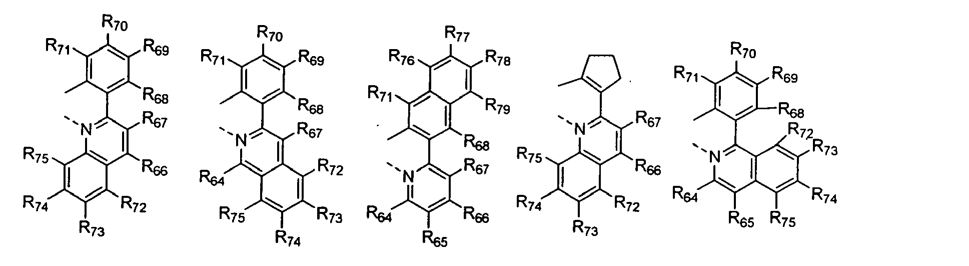 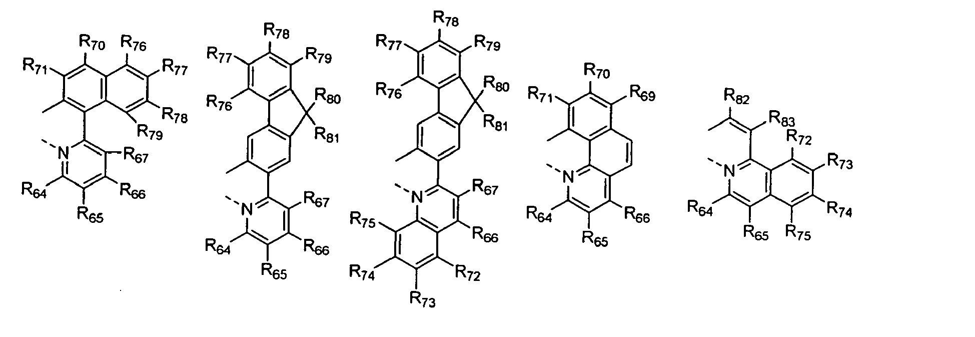 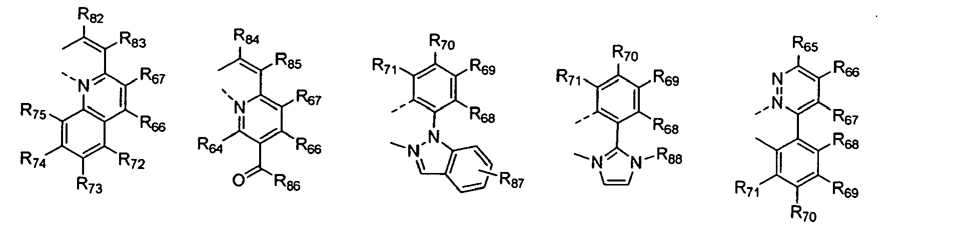 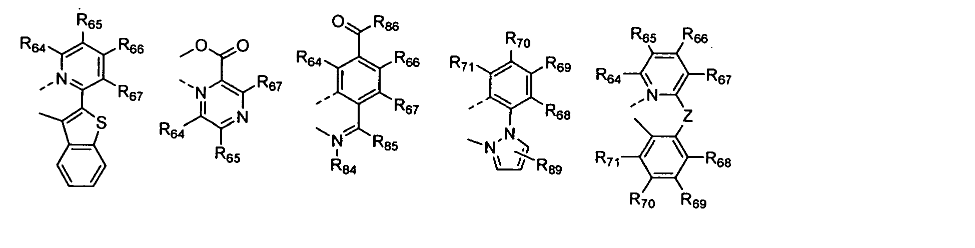 wherein, R₆₁ through R₆₃ independently represent hydrogen, (C1-C60)alkyl with or without halogen substituent(s), (C6-C60)aryl with or without (C1-C60)alkyl substituent(s), or halogen;
R₆₄ through R₇₉ independently represent hydrogen, (C1-C60)alkyl, (C1-C30)alkoxy, (C3-C60)cycloalkyl, (C2-C30)alkenyl, (C6-C60)aryl, mono or di(C1-C30)alkylamino, mono or di(C6-C30)arylamino, SF₅, tri(C1-C30)alkylsilyl, di(C1-C30)alkyl(C6-C30)arylsilyl, tri(C6-C30)arylsilyl, cyano or halogen; or each of R₇₀ through R₇₆ may be linked to an adjacent substituent via (C2-C12)alkylene or (C2-C12)alkenylene to form a fused ring or a multi-fused ring; and the alkyl, cycloalkyl, alkenyl or aryl of R₆₄ through R₇₉, or the fused ring or multi-fused ring formed from R₇₀ and R₇₆ by linkage via alkylene or alkenylene may be further substituted by one or more substituent(s) selected from (C1-C60)alkyl, (C6-C60)aryl and halogen;
R₈₀ through R₈₃ independently represent hydrogen, (C1-C60)alkyl with or without halogen substituent(s), or (C6-C60)aryl with or without (C1-C60)alkyl substituent(s);
R₈₄ and R₈₅ independently represents hydrogen, linear or branched (C1-C60)alkyl, (C6-C60)aryl or halogen, or R₈₄ and R₈₅ may be linked via (C3-C12)alkylene or (C3-C12)alkenylene with or without a fused ring to form an alicyclic ring or a monocyclic or polycyclic aromatic ring; and the alkyl, aryl or the alicyclic ring or the monocyclic or polycyclic aromatic ring formed therefrom by linkage via (C3-C12)alkylene or (C3-C12)alkenylene may be further substituted by one or more substituent(s) selected from linear or branched (C1-C60)alkyl with or without halogen substituent(s), (C1-C30)alkoxy, halogen, tri(C1-C30)alkylsilyl, tri(C6-C30)arylsilyl and (C6-C60)aryl;
R₈₆ represents (C1-C60)alkyl, (C6-C60)aryl, (C5-C60)heteroaryl or halogen;
R₈₇ through R₈₉ independently represent hydrogen, (C1-C60)alkyl, (C6-C60)aryl or halogen, and the alkyl or aryl of R₈₆ through R₈₉ may be further substituted by halogen or (C1-C60)alkyl; and
Z represents 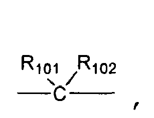 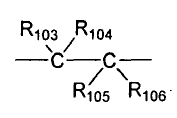 or 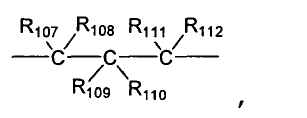 wherein R₁₀₁ through R₁₁₂ independently represent hydrogen, (C1-C60) alkyl with or without halogen substituent(s), (C1-C30)alkoxy, halogen, (C6-C60)aryl, cyano or (C5-C60) cycloalkyl, or each of R₁₀₁ through R₁₁₂ may be linked to an adjacent substituent via alkylene or alkenylene to form a (C5-C7) spiro ring or a (C5-C9) fused ring, or they may be linked to R₆₇ or R₆₈ via alkylene or alkenylene to form a (C5-C7) fused ring.

In Chemical Formula (2), M¹ may be selected from Ir, Pt, Pd, Rh, Re, Os, Tl, Pb, Bi, In, Sn, Sb, Te, Au and Ag, and the ligands, L³, L⁴ and L⁵ of the compound of Chemical Formula (2) may be independently selected from the following structures, but they are not restricted thereto. 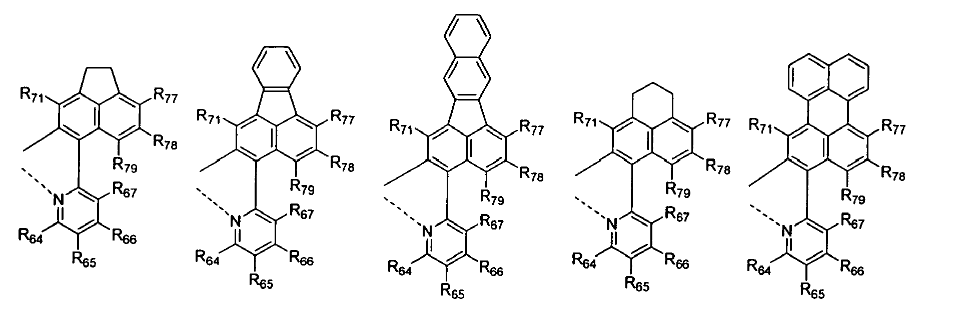 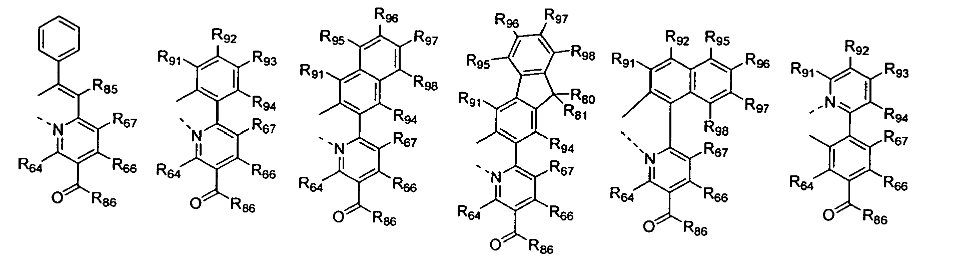 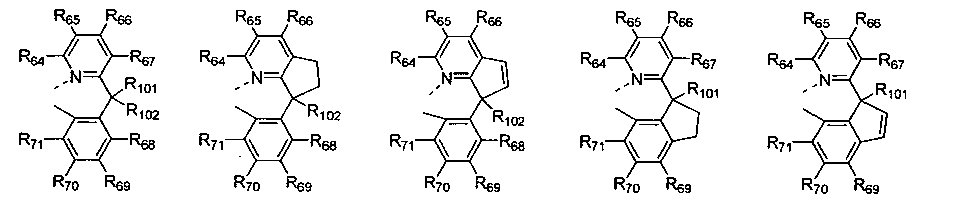 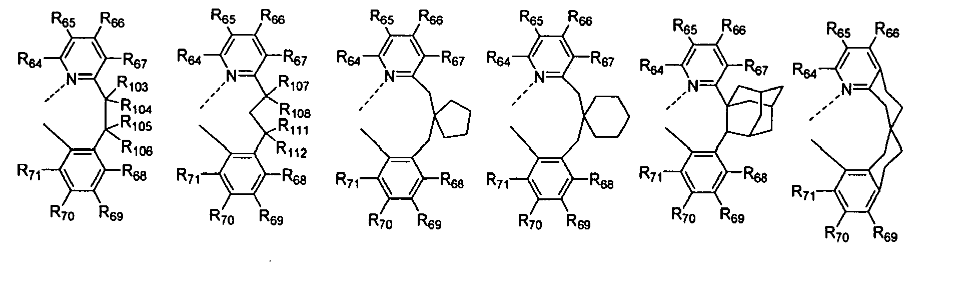 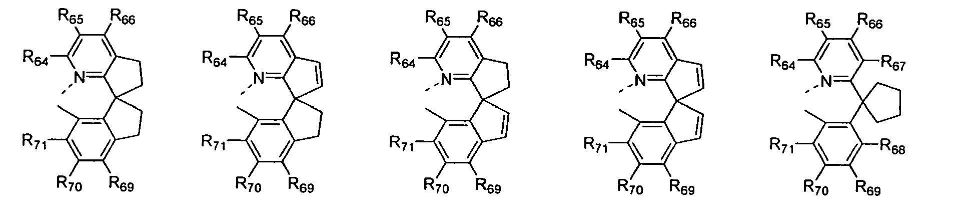 wherein, R₆₄ through R₇₉ independently represent hydrogen, (C1-C60)alkyl, (C1-C30)alkoxy, (C3-C60)cycloalkyl, (C2-C30)alkenyl, (C6-C60)aryl, mono or di(C1-C30)alkylamino, mono or di(C6-C30)arylamino, SF₅, tri(C1-C30)alkylsilyl, di(C1-C30)alkyl(C6-C30)arylsilyl, tri(C6-C30)arylsilyl, cyano or halogen;
the alkyl, cycloalkyl, alkenyl or aryl of R₆₄ through R₇₉ may be further substituted by one or more substituent(s) selected from (C1-C60)alkyl, (C6-C60)aryl and halogen;
R₈₀ and R₈₁ independently represent hydrogen, (C1-C60)alkyl with or without halogen substituent(s), or (C6-C60)aryl with or without (C1-C60)alkyl substituent(s);
R₈₅ independently represents hydrogen, linear or branched (C1-C60)alkyl, (C6-C60)aryl or halogen; and the alkyl or aryl of R₈₅ may be further substituted by one or more substituent(s) selected from linear or branched (C1-C60)alkyl with or without halogen substituent(s), (C1-C30)alkoxy, halogen, tri(C1-C30)alkylsilyl, tri(C6-C30)arylsilyl and (C6-C60)aryl;
R₈₆ represents (C1-C60)alkyl, (C6-C60)aryl or halogen; and the alkyl or aryl of R₈₆ may be further substituted by halogen or (C1-C60)alkyl;
R₉₁ through R₉₈ independently represent hydrogen, linear or branched (C1-C60)alkyl with or without halogen substituent(s), (C1-C30)alkoxy, halogen, tri(C1-C30)alkylsilyl, tri(C6-C30)arylsilyl or (C6-C60)aryl; and
R₁₀₁ through R₁₀₈, R₁₁₁ and R₁₁₂ independently represent hydrogen, (C1-C60)alkyl with or without halogen substituent(s), (C1-C30)alkoxy, halogen, (C6-C60)aryl, cyano or (C5-C60)cycloalkyl.

The dopant compounds represented by Chemical Formula (2) may be exemplified by the compounds represented by one of the following structural formulas, but they are not restricted thereto.

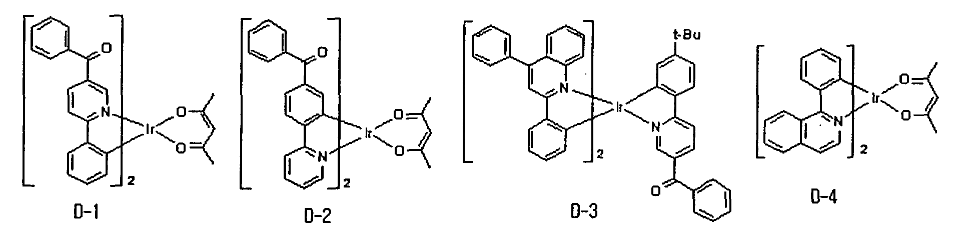

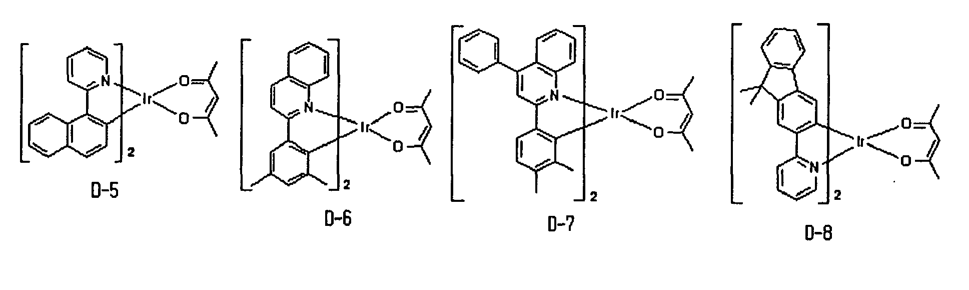

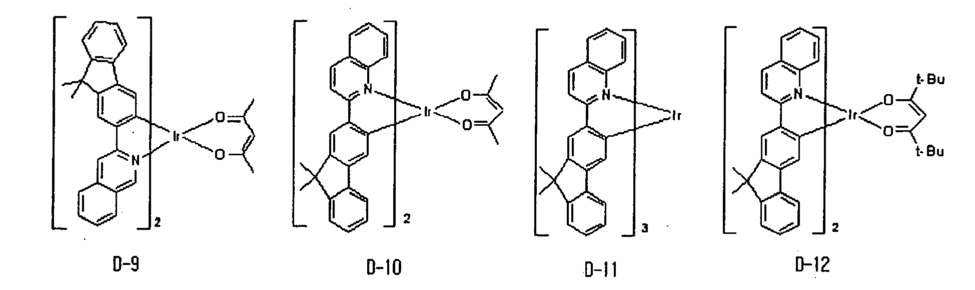

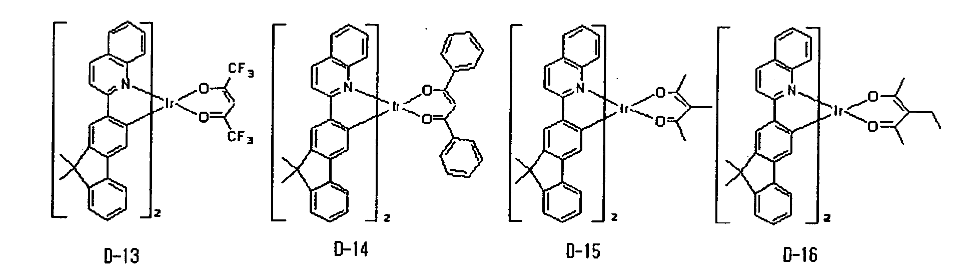

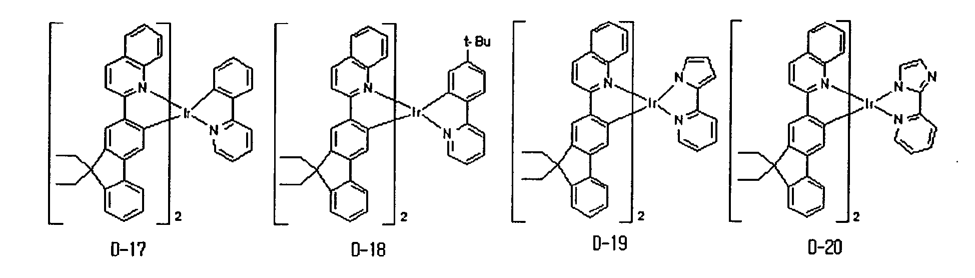

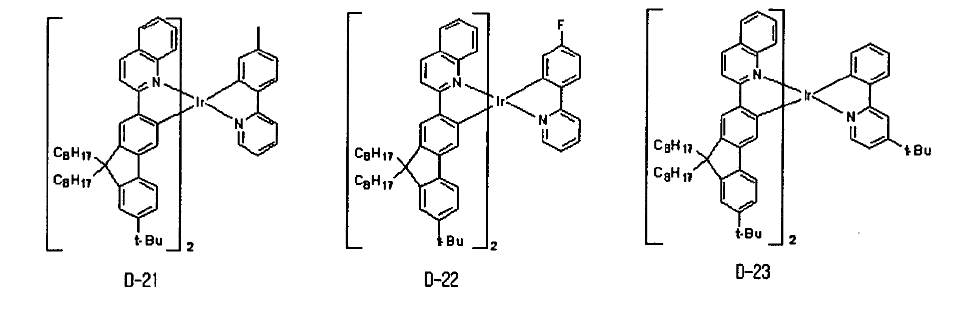

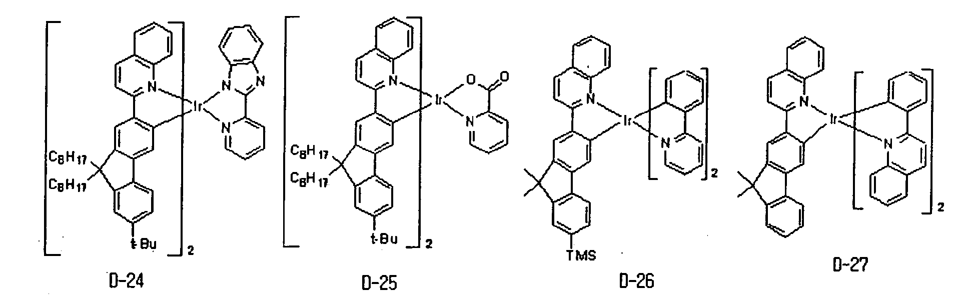

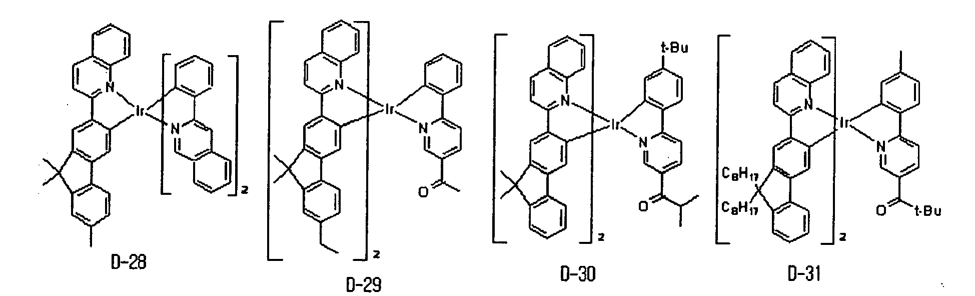

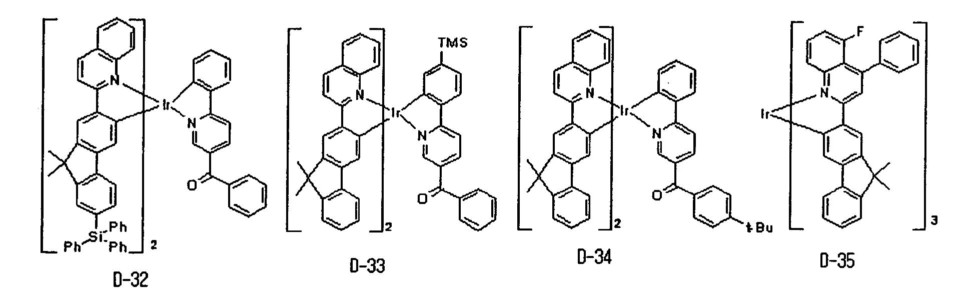

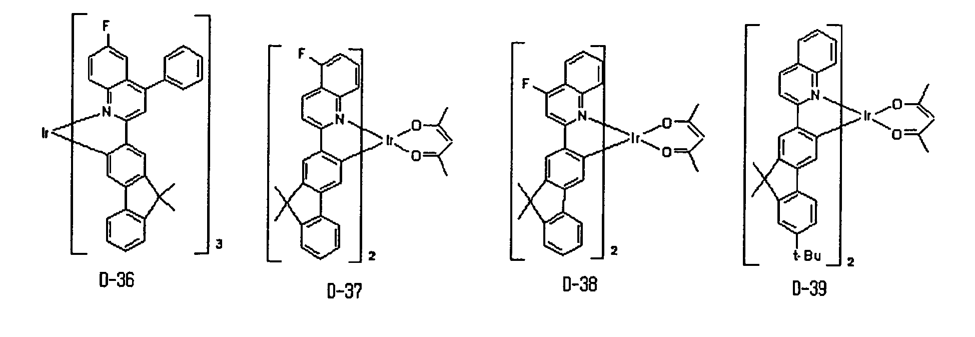

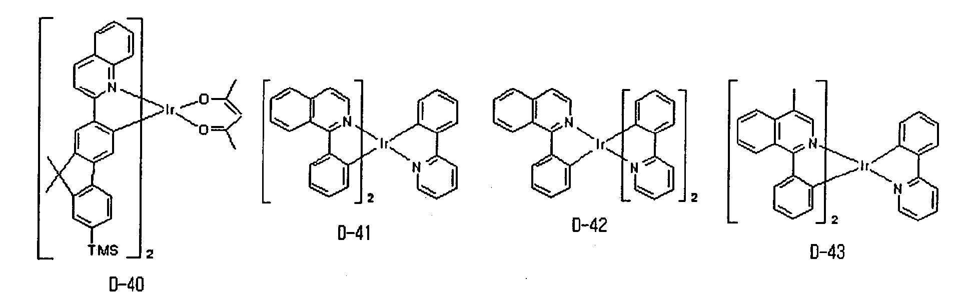

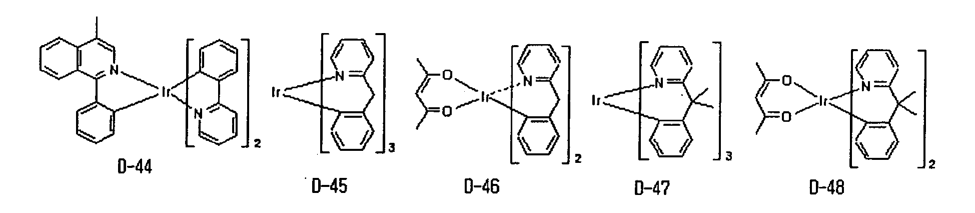

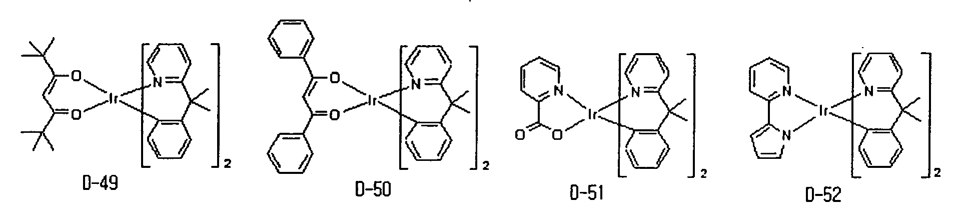

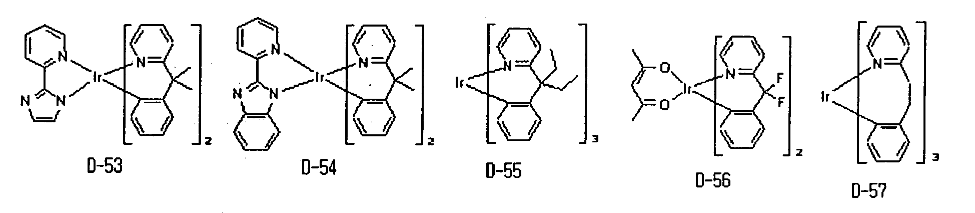

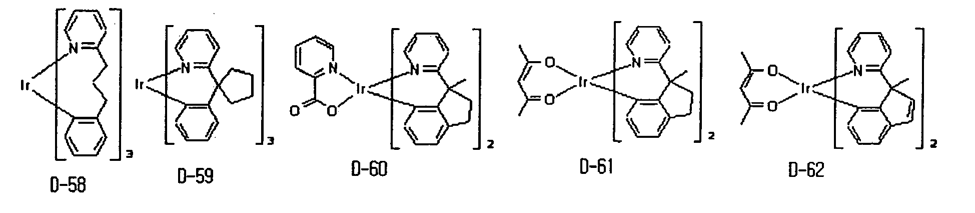

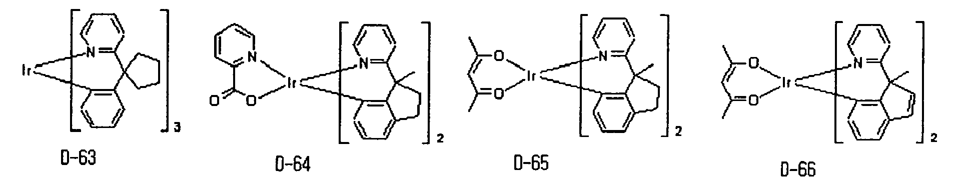

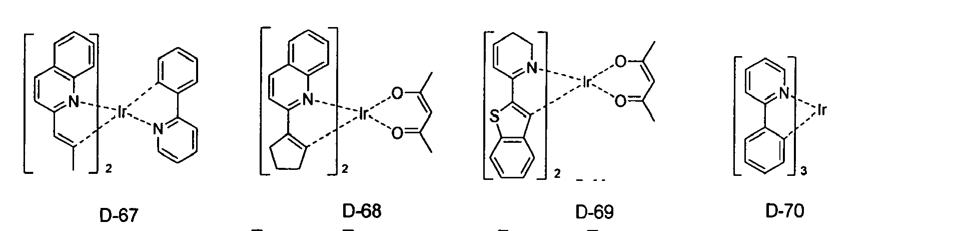

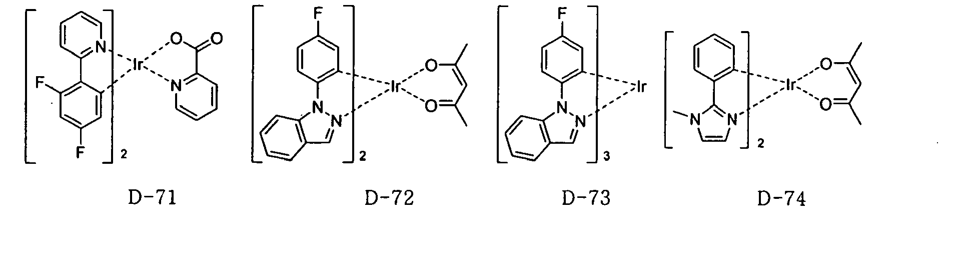

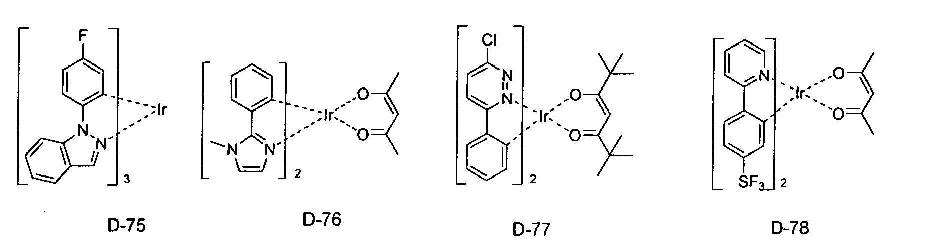

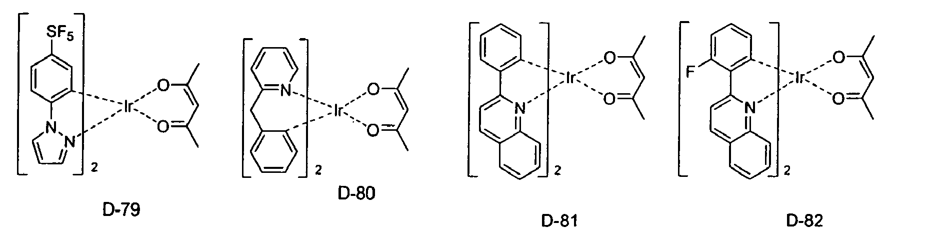

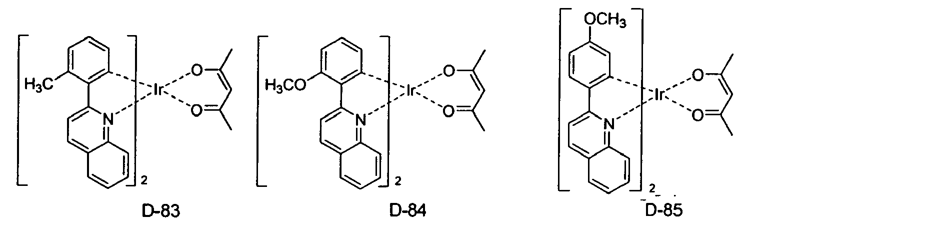

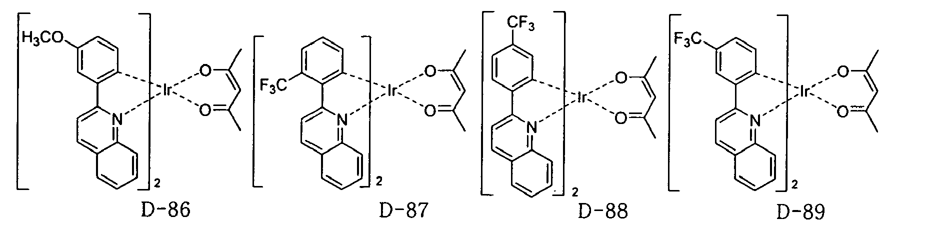

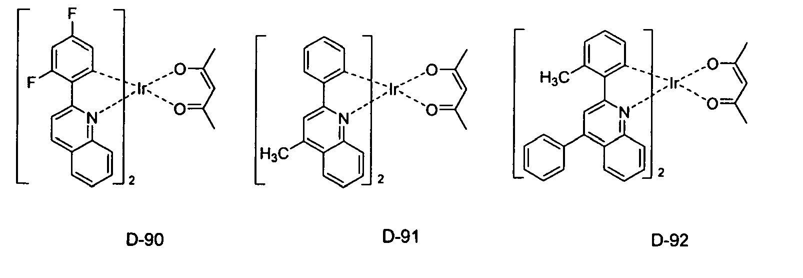

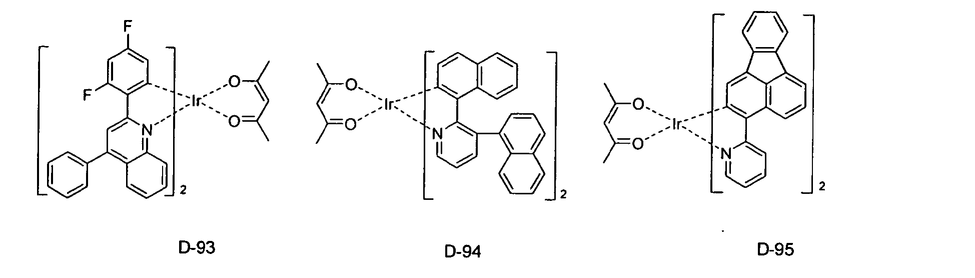

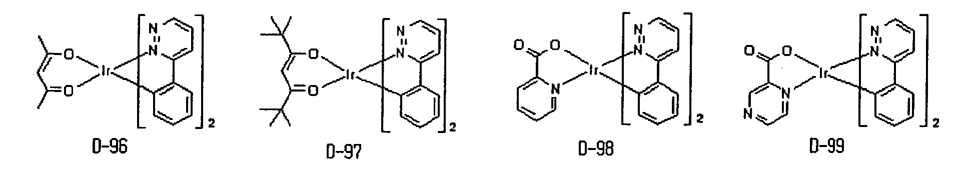

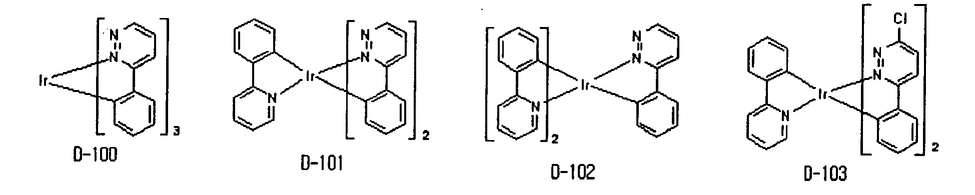

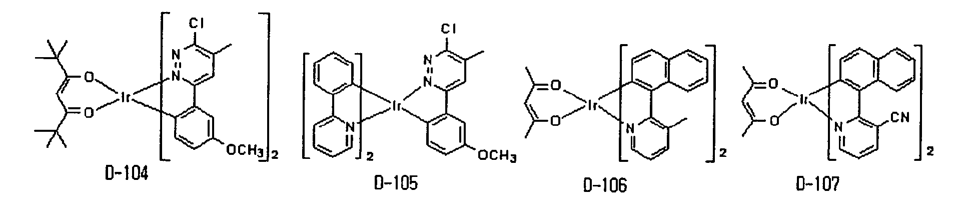

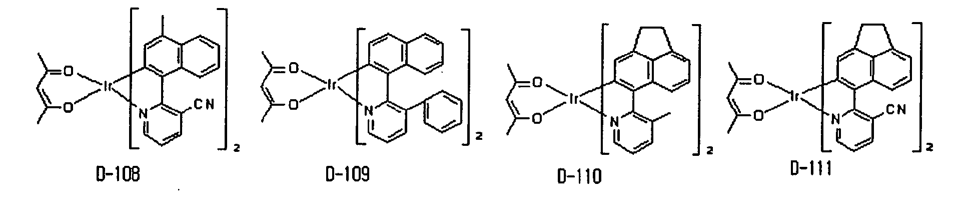

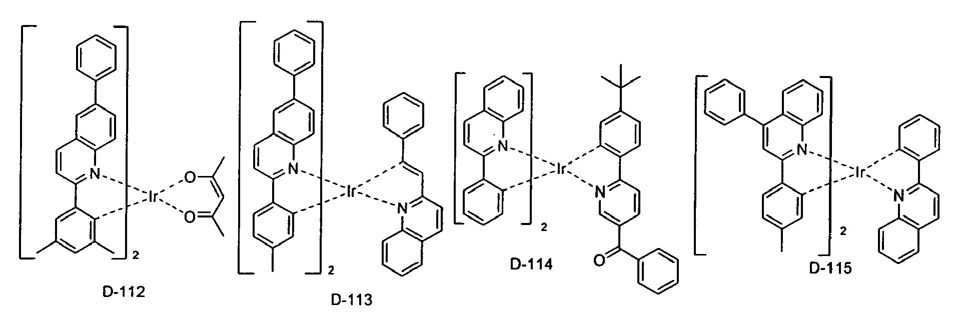

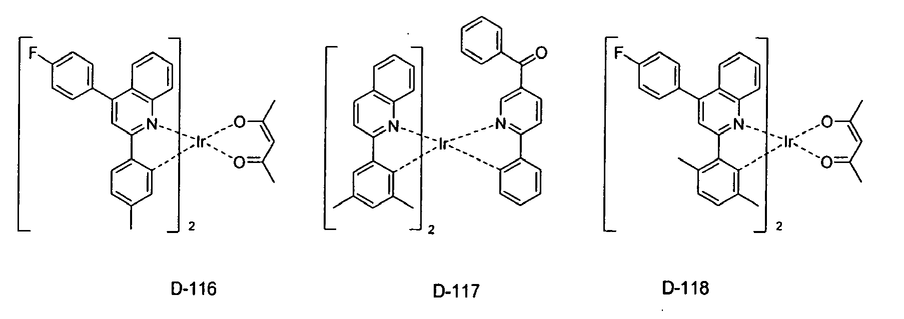

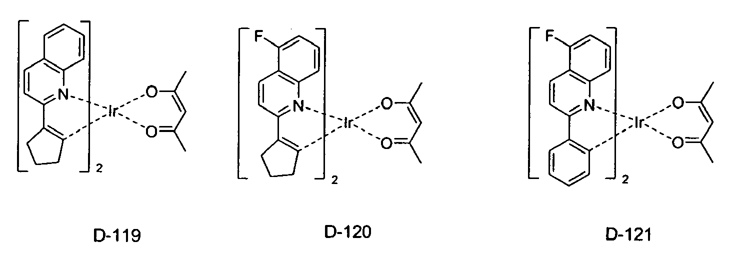

The organic electroluminescent device according to the invention may further comprise one or more compound(s) selected from arylamine compounds and styrylarylamine compounds, as well as the organic electroluminescent compound represented by Chemical Formula (1). Examples of arylamine or styrylarylamine compounds include the compounds represented by Chemical Formula (3), but they are not restricted thereto: 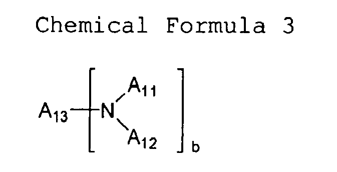 wherein, Ar₁₁ and Ar₁₂ independently represent (C1-C60)alkyl, (C6-C60)aryl, (C4-C60)heteroaryl, (C6-C60)arylamino, (C1-C60)alkylamino, a 5- or 6-membered heterocycloalkyl containing one or more heteroatom(s) selected from N, O and S, or (C3-C60)cycloalkyl, or Ar₁₁ and Ar₁₂ may be linked via (C3-C60)alkylene or (C3-C60)alkenylene with or without a fused ring to form an alicyclic ring, or a monocyclic or polycyclic aromatic ring;
when b is 1, Ar₁₃ represents (C6-C60)aryl, (C4-C60)heteroaryl, or a substituent represented by one of the following structural formulas: 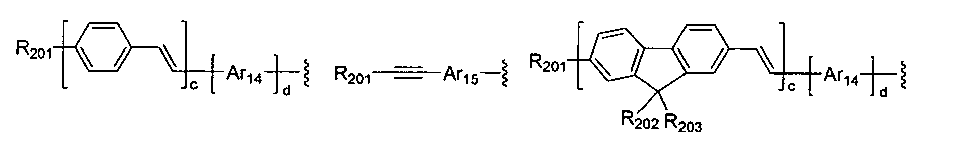 when b is 2, Ar₁₃ represents (C6-C60) arylene, (C4-C60)heteroarylene, or a substituent represented by one of the following structural formulas: 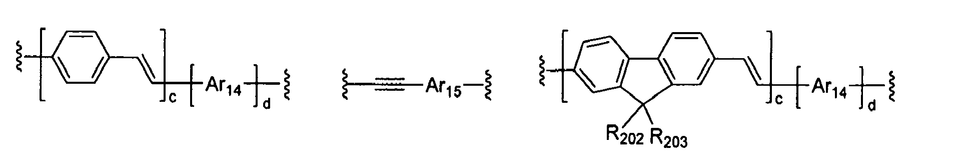 wherein Ar₁₄ and Ar₁₅ independently represent (C6-C60)arylene or (C4-C60)heteroarylene;
R₂₀₁ through R₂₀₃ independently represent hydrogen, deuterium, (C1-C60)alkyl or (C6-C60)aryl;
c is an integer from 1 to 4, d is an integer of 0 or 1; and
the alkyl, aryl, heteroaryl, arylamino, alkylamino, cycloalkyl or heterocycloalkyl of Ar₁₁ and Ar₁₂, or the aryl, heteroaryl, arylene or heteroarylene of Ar₁₃, or the arylene or heteroarylene of Ar₁₄ and Ar₁₅, or the alkyl or aryl of R₂₀₁ through R₂₀₃ may be further substituted by one or more substituent(s) selected from a group consisting of deuterium, halogen, (C1-C60)alkyl, (C6-C60)aryl, (C4-C60)heteroaryl, a 5-or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, cyano, (C1-C60)alkylamino, (C6-C60)arylamino, (C6-C60)ar(C1-C60)alkyl, (C6-C60)aryloxy, (C1-C60)alkyloxy, (C6-C60)arylthio, (C1-C60)alkylthio, (C1-C60)alkoxycarbonyl, (C1-C60)alkylcarbonyl, (C6-C60)arylcarbonyl, carboxyl, nitro and hydroxyl.

The arylamine compounds and styrylarylamine compounds may be more specifically exemplified by the following compounds, but are not restricted thereto.

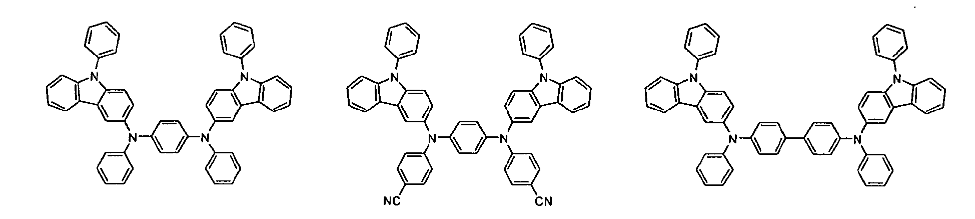

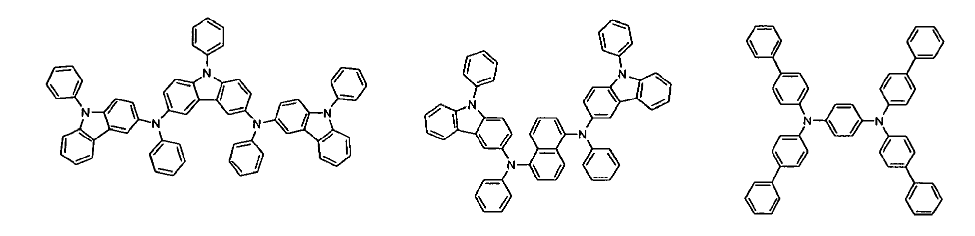

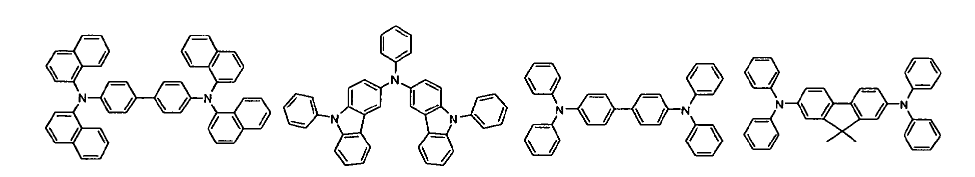

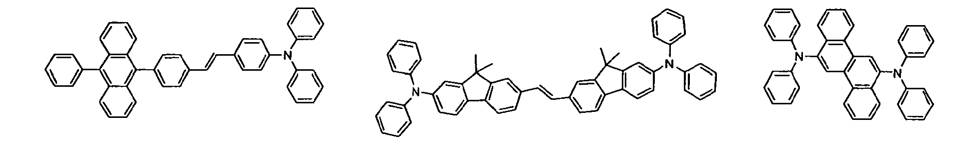

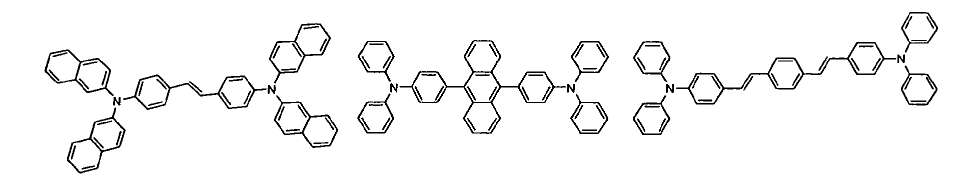

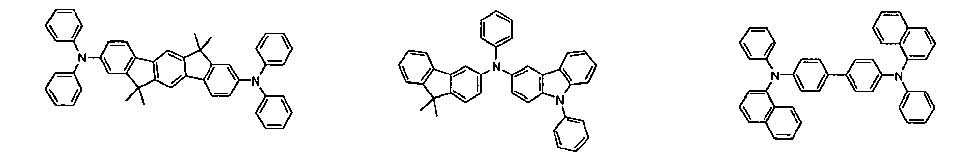

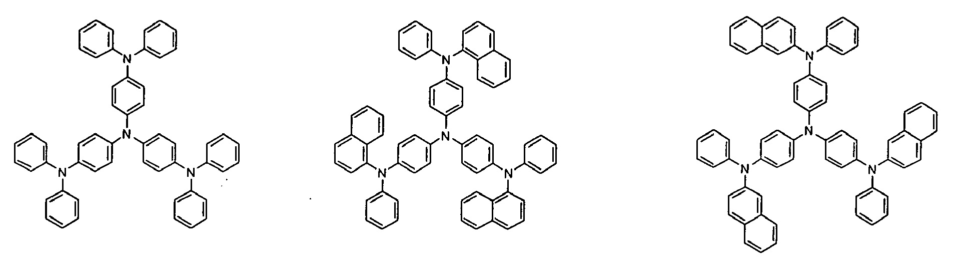

In an organic electroluminescent device according to the present invention, the organic layer may further comprise one or more metal(s) selected from a group consisting of organic metals of Group 1, Group 2, 4^{th} period and 5^{th} period transition metals, lanthanide metals and d-transition elements, as well as the organic electroluminescent compound represented by Chemical Formula (1). The organic layer may comprise an electroluminescent layer and a charge generating layer at the same time.

The present invention can realize an electroluminescent device having a pixel structure of independent light-emitting mode, which comprises an organic electroluminescent device containing the compound of Chemical Formula (1) as a sub-pixel, and one or more sub-pixel(s) comprising one or more metal compounds selected from a group consisting of Ir, Pt, Pd, Rh, Re, Os, Tl, Pb, Bi, In, Sn, Sb, Te, Au and Ag, patterned in parallel at the same time.

Further, an organic display can be formed, which also comprises one or more compound(s) selected from compounds having electroluminescent peak of wavelength of not more than 560 nm, as well as the organic electroluminescent compound described above, in the organic layer. The compounds having electroluminescent peak of wavelength of not more than 560 nm may be exemplified by the compounds represented by one of Chemical Formulas (4) to (9), but they are not restricted thereto.

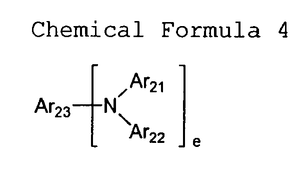

In Chemical Formula (4), Ar₂₁ and Ar₂₂ independently represent (C1-C60)alkyl, (C6-C60)aryl, (C4-C60)heteroaryl, (C6-C60)arylamino, (C1-C60)alkylamino, a 5- or 6-membered heterocycloalkyl containing one or more heteroatom(s) selected from N, O and S, or (C3-C60)cycloalkyl, or Ar₂₁ and Ar₂₂ may be linked via (C3-C60)alkylene or (C3-C60)alkenylene with or without a fused ring to form an alicyclic ring, or a monocyclic or polycyclic aromatic ring;
when e is 1, Ar₂₃ represents (C6-C60)aryl, (C4-C60)heteroaryl, or a substituent represented by one of the following structural formulas: 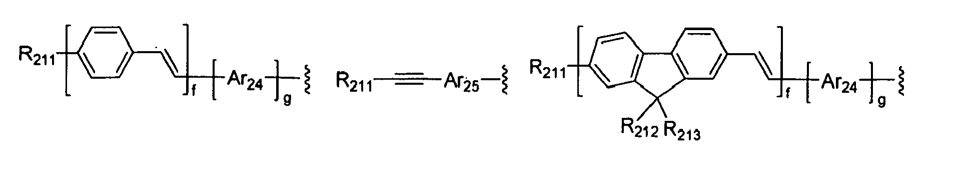 when e is 2, Ar₂₃ represents (C6-C60)arylene, (C4-C60)heteroarylene, or a substituent represented by one of the following structural formulas: 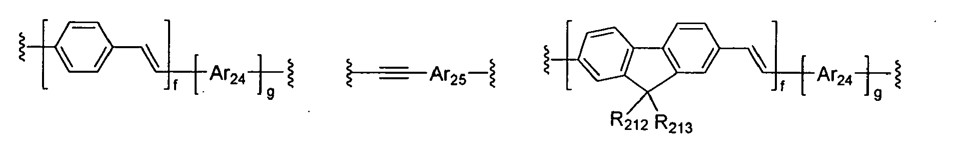 wherein Ar₂₄ and Ar₂₅ independently represent (C6-C60)arylene or (C4-C60)heteroarylene;
R₂₁₁ through R₂₁₃ independently represent hydrogen, deuterium, (C1-C60)alkyl or (C6-C60)aryl;
f is an integer from 1 to 4, g is an integer of 0 or 1; and
the alkyl, aryl, heteroaryl, arylamino, alkylamino, cycloalkyl or heterocycloalkyl of Ar₂₁ and Ar₂₂, or the aryl, heteroaryl, arylene or heteroarylene of Ar₂₃, or the arylene or heteroarylene of Ar₂₄ and Ar₂₅, or the alkyl or aryl of R₂₁₁ through R₂₁₃ may be further substituted by one or more substituent(s) selected from a group consisting of deuterium, halogen, (C1-C60)alkyl, (C6-C60)aryl, (C4-C60)heteroaryl, a 5-or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, cyano, (C1-C60)alkylamino, (C6-C60)arylamino, (C6-C60)ar(C1-C60)alkyl, (C6-C60)aryloxy, (C1-C60)alkyloxy, (C6-C60)arylthio, (C1-C60)alkylthio, (C1-C60)alkoxycarbonyl, (C1-C60)alkylcarbonyl, (C6-C60)arylcarbonyl, carboxyl, nitro and hydroxyl.

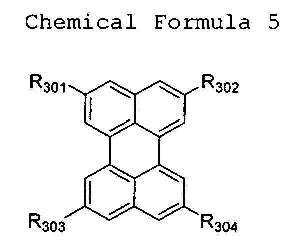

In Chemical Formula (5), R₃₀₁ through R₃₀₄ independently represent hydrogen, deuterium, halogen, (C1-C60)alkyl, (C6-C60)aryl, (C4-C60)heteroaryl, a 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, (C1-C60)alkoxy, cyano, (C1-C60)alkylamino, (C6-C60)arylamino, (C6-C60)ar(C1-C60)alkyl, (C6-C60)aryloxy, (C6-C60)arylthio, (C1-C60)alkoxycarbonyl, carboxyl, nitro or hydroxyl, or each of R₃₀₁ through R₃₀₄ may be linked to an adjacent substituent via (C3-C60)alkylene or (C3-C60)alkenylene with or without a fused ring to form an alicyclic ring, or a monocyclic or polycyclic aromatic ring;
the alkyl, alkenyl, alkynyl, cycloalkyl, heterocycloalkyl, aryl, heteroaryl, arylsilyl, alkylsilyl, alkylamino or arylamino of R₃₀₁ through R₃₀₄, or the alicyclic ring, or the monocyclic or polycyclic aromatic ring formed therefrom by linkage to an adjacent substituent via (C3-C60)alkylene or (C3-C60)alkenylene with or without a fused ring may be further substituted by one or more substituent(s) selected from deuterium, halogen, (C1-C60)alkyl, (C6-C60)aryl, (C4-C60)heteroaryl, a 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, (C1-C60)alkoxy, cyano, (C1-C60)alkylamino, (C6-C60)arylamino, (C6-C60)ar(C1-C60)alkyl, (C6-C60)aryloxy, (C6-C60)arylthio, (C1-C60)alkoxycarbonyl, carboxyl, nitro and hydroxyl.

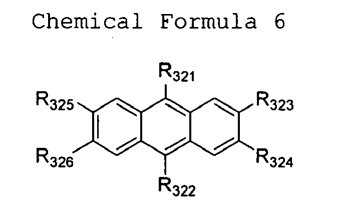

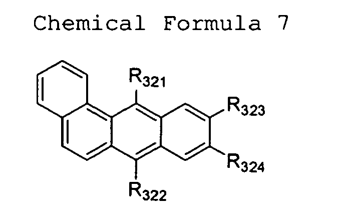

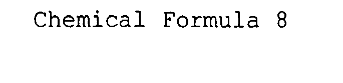

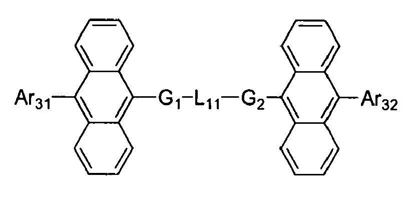

In Chemical Formulas (6) to (8), R₃₂₁ and R₃₂₂ independently represent (C6-C60)aryl, (C4-C60)heteroaryl or a 5- or 6-membered heterocycloalkyl containing one or more heteroatom(s) selected from N, O and S, or (C3-C60)cycloalkyl, and the aryl or heteroaryl of R₃₂₁ and R₃₂₂ may be further substituted by one or more substituent(s) selected from a group consisting of deuterium, (C1-C60)alkyl, halo(C1-C60)alkyl, (C1-C60)alkoxy, (C3-C60)cycloalkyl, (C6-C60)aryl, (C4-C60)heteroaryl, halogen, cyano, tri(C1-C60)alkylsilyl, di(C1-C60)alkyl(C6-C60)arylsilyl and tri(C6-C60)arylsilyl;
R₃₂₃ through R₃₂₆ independently represent hydrogen, deuterium, (C1-C60)alkyl, (C1-C60)alkoxy, halogen, (C4-C60)heteroaryl, (C5-C60)cycloalkyl or (C6-C60)aryl, and the heteroaryl, cycloalkyl or aryl of R₃₂₃ through R₃₂₆ may be further substituted by one or more substituent(s) selected from a group consisting of deuterium, (C1-C60)alkyl with or without halogen substituent(s), (C1-C60)alkoxy, (C3-C60)cycloalkyl, halogen, cyano, tri(C1-C60)alkylsilyl, di(C1-C60)alkyl(C6-C60)arylsilyl and tri(C6-C60)arylsilyl;
G₁ and G₂ independently represent a chemical bond or (C6-C60)arylene with or without one or more substituent(s) selected from (C1-C60)alkyl, (C1-C60)alkoxy, (C6-C60)aryl, (C4-C60)heteroaryl and halogen;
Ar₃₁ and Ar₃₂ represent (C4-C60)heterorayl or an aryl selected from the following structures: 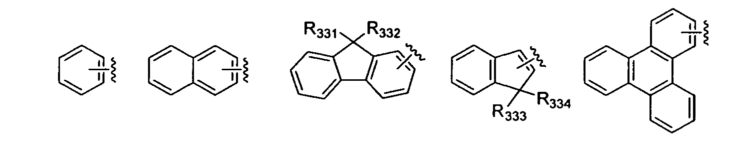 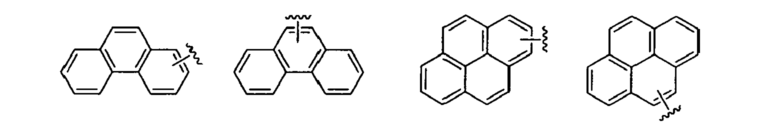 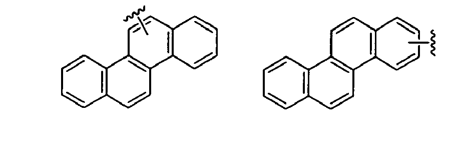
the aryl or heteroaryl of Ar₃₁ and Ar₃₂ may be substituted by one or more substituent(s) selected from deuterium, (C1-C60)alkyl, (C1-C60)alkoxy, (C6-C60)aryl and (C4-C60)heteroaryl;
L₁₁ represents (C6-C60)arylene, (C4-C60)heteroarylene or a compound represented by the following structure: 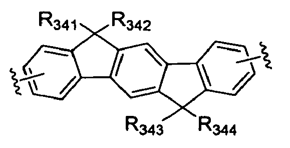
the arylene or heteroarylene of L₁₁ may be substituted by one or more substituent(s) selected from deuterium, (C1-C60)alkyl, (C1-C60)alkoxy, (C6-C60)aryl, (C4-C60)heteroaryl and halogen;
R₃₃₁ through R₃₃₄ independently represent hydrogen, deuterium, halogen, (C1-C60)alkyl or (C6-C60)aryl, or each of them may be linked to an adjacent substituent via (C3-C60)alkylene or (C3-C60)alkenylene with or without a fused ring to form an alicyclic ring, or a monocyclic or polycyclic aromatic ring;
R₃₄₁ through R₃₄₄ independently represent hydrogen, deuterium, (C1-C60)alkyl, (C1-C60)alkoxy, (C6-C60)aryl, (C4-C60)heteroaryl or halogen, or each of them may be linked to an adjacent substituent via (C3-C60)alkylene or (C3-C60)alkenylene with or without a fused ring to form an alicyclic ring, or a monocyclic or polycyclic aromatic ring.

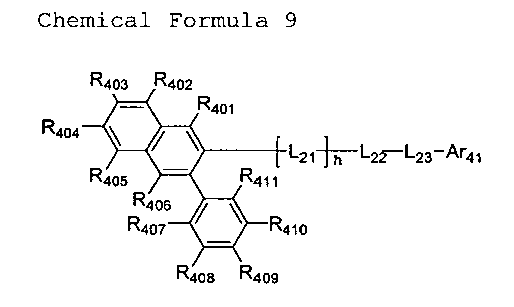

In Chemical Formula 9,
L₂₁ represents (C6-C60)arylene, (C3-C60)heteroarylene containing one or more heteroatom(s) selected from N, O and S, or a divalent group selected from the following structures: 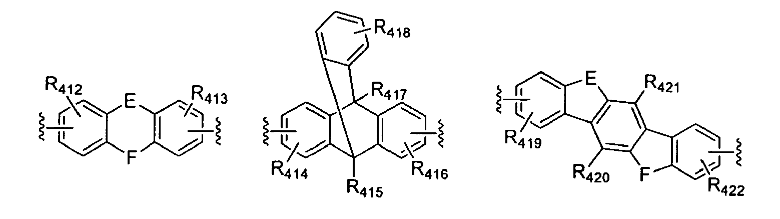
L₂₂ and L₂₃ independently represent a chemical bond, (C1-C60)alkyleneoxy, (C1-C60)alkylenethio, (C6-C60)aryleneoxy, (C6-C60)arylenethio, (C6-C60)arylene, or (C3-C60)heteroarylene containing one or more heteroatom(s) selected from N, O and S;
Ar₄₁ represents NR₄₂₃R₄₂₄, (C6-C60)aryl, (C3-C60)heteroaryl containing one or more heteroatom(s) selected from N, O and S, 5- or 6-membered heterocycloalkyl containing one or more heteroatom(s) selected from N, O and S, (C3-C60)cycloalkyl, adamantyl, (C7-C60)bicycloalkyl, or a substituent selected from the following structures: 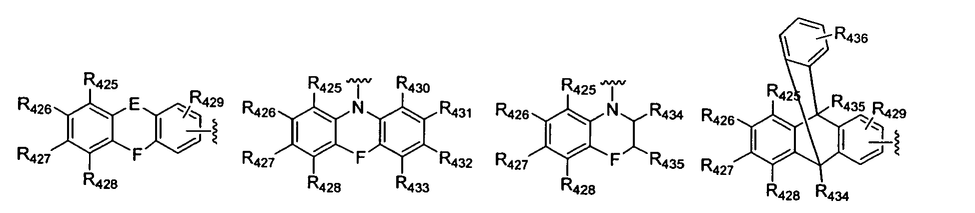
wherein, R₄₀₁ through R₄₁₁ independently represent hydrogen, deuterium, halogen, (C1-C60)alkyl, (C6-C60)aryl, (C3-C60)heteroaryl containing one or more heteroatom(s) selected from N, O and S, morpholino, thiomorpholino, 5- or 6-membered heterocyloalkyl containing one or more heteroatom(s) selected from N, O and S, (C3-C60)cycloalkyl, tri(C1-C60)alkylsilyl, di(C1-C60)alkyl(C6-C60)aryls tri(C6-C60)arylsilyl, adamantyl, (C7-C60)bicycloalkyl, (C2-C60)alkenyl, (C2-C60)alkynyl, cyano, (C1-C60)alkylamino, (C6-C60)arylamino, (C6-C60)ar(C1-C60)alkyl, (C1-C60)alkyloxy, (C1-C60)alkylthio, (C6-C60)aryloxy, (C6-C60)arylthio, (C1-C60)alkoxycarbonyl, (C1-C60)alkylcarbonyl, (C6-C60)arylcarbonyl, carboxyl, nitro or hydroxyl, or each of R₄₀₁ through R₄₁₁ may be linked to an adjacent substituent via (C3-C60)alkylene or (C3-C60)alkenylene with or without a fused ring to form an alicyclic ring, or a monocyclic or polycyclic aromatic ring;
R₄₁₂ through R₄₂₂ independently represent hydrogen, deuterium, halogen, (C1-C60)alkyl, (C6-C60)aryl, (C3-C60)heteroaryl containing one or more heteroatom(s) selected from N, O and S, morpholino, thiomorpholino, 5- or 6-membered heterocyloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, cyano, (C1-C60)alkylamino, (C6-C60)arylamino, (C6-C60)ar(C1-C60)alkyl, (C1-C60)alkyloxy, (C1-C60)alkylthio, (C6-C60)aryloxy, (C6-C60)arylthio, (C1-C60)alkoxycarbonyl, (C1-C60)alkylcarbonyl, (C6-C60)arylcarbonyl, carboxyl, nitro or hydroxyl, or each of R₄₁₂ through R₄₂₂ may be linked to an adjacent substituent via (C3-C60)alkylene or (C3-C60)alkenylene with or without a fused ring to form an alicyclic ring, or a monocyclic or polycyclic aromatic ring;
R₄₂₃ and R₄₂₄ independently represent hydrogen, deuterium, halogen, (C1-C60)alkyl, (C6-C60)aryl, (C3-C60)heteroaryl containing one or more heteroatom(s) selected from N, O and S, morpholino, thiomorpholino, 5- or 6-membered heterocyloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, cyano, (C1-C60)alkylamino, (C6-C60)arylamino, (C6-C60)ar(C1-C60)alkyl, (C1-C60)alkyloxy, (C1-C60)alkylthio, (C6-C60)aryloxy, (C6-C60)arylthio, (C1-C60)alkoxycarbonyl, (C1-C60)alkylcarbonyl, (C6-C60)arylcarbonyl, carboxyl, nitro or hydroxyl, or R₄₂₃ and R₄₂₄ may be linked via (C3-C60)alkylene or (C3-C60)alkenylene with or without a fused ring to form an alicyclic ring, or a monocyclic or polycyclic aromatic ring;
R₄₂₅ through R₄₃₆ independently represent hydrogen, deuterium, halogen, (C1-C60)alkyl, (C6-C60)aryl, (C3-C60)heteroaryl containing one or more heteroatom(s) selected from N, O and S, morpholino, thiomorpholino, 5- or 6-membered heterocyloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, cyano, (C1-C60)alkylamino, (C6-C60)arylamino, (C6-C60)ar(C1-C60)alkyl, (C1-C60)alkyloxy, (C1-C60)alkylthio, (C6-C60)aryloxy, (C6-C60)arylthio, (C1-C60)alkoxycarbonyl, (C1-C60)alkylcarbonyl, (C6-C60)arylcarbonyl, carboxyl, nitro or hydroxyl, or each of R₄₂₅ through R₄₃₆ may be linked to an adjacent substituent via (C3-C60)alkylene or (C3-C60)alkenylene with or without a fused ring to form an alicyclic ring, or a monocyclic or polycyclic aromatic ring;
E and F independently represent a chemical bond, - (CR₄₃₇R₄₃₈)ᵢ-, -N(R₄₃₉)-, -S-, -O-, -Si(R₄₄₀)(R₄₄₁)-, -P(R₄₄₂)-,-C(=O)-, -B(R₄₄₃)-, -In(R₄₄₄)-, -Se-, -Ge(R₄₄₅)(R₄₄₆)-,-Sn(R₄₄₇)(R₄₄₈)-, -Ga(R₄₄₉)- or -(R₄₅₀)C=C(R₄₅₁)-;
R₄₃₇ through R₄₅₁ independently represent hydrogen, deuterium, halogen, (C1-C60)alkyl, (C6-C60)aryl, (C3-C60)heteroaryl containing one or more heteroatom(s) selected from N, O and S, morpholino, thiomorpholino, 5- or 6-membered heterocyloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, cyano, (C1-C60)alkylamino, (C6-C60)arylamino, (C6-C60)ar(C1-C60)alkyl, (C1-C60)alkyloxy, (C1-C60)alkylthio, (C6-C60)aryloxy, (C6-C60)arylthio, (C1-C60)alkoxycarbonyl, (C1-C60)alkylcarbonyl, (C6-C60)arylcarbonyl, carboxyl, nitro or hydroxyl, or R₄₃₇ and R₄₃₈, R₄₄₀ and R₄₄₁, R₄₄₅ and R₄₄₆, R₄₄₇ and R₄₄₈, and R₄₅₀ and R₄₅₁ may be linked via (C3-C60)alkylene or (C3-C60)alkenylene with or without a fused ring to form an alicyclic ring, or a monocyclic or polycyclic aromatic ring;
the arylene or heteroarylene of L₂₁ through L₂₃, the aryl or heteroaryl of Ar₄₁, or the alkyl, aryl, heteroaryl, heterocycloalkyl, cycloalkyl, trialkylsilyl, dialkylarylsilyl, triarylsilyl, alkenyl, alkynyl, alkylamino or arylamino of R₄₀₁ through R₄₁₁, R₄₁₂ through R₄₂₂, R₄₂₃, R₄₂₄, R₄₂₅ through R₄₃₆, and R₄₃₇ through R₄₅₁ may be further substituted independently by one or more substituent(s) selected from deuterium, halogen, (C1-C60)alkyl, halo(C1-C60)alkyl, (C6-C60)aryl, (C3-C60)heteroaryl containing one or more heteroatom(s) selected from N, O and S with or without (C6-C60)aryl substituent, morpholino, thiomorpholino, 5- or 6-membered heterocycloalkyl containing one or more heteroatom(s) selected from N, O and S, (C3-C60)cycloalkyl, tri(C1-C60)alkylsilyl, di(C1-C60)alkyl(C6-C60)arylsilyl, tri(C6-C60)arylsilyl, adamantyl, (C7-C60)bicycloalkyl, (C2-C60)alkenyl, (C2-C60)alkynyl, cyano, (C1-C60)alkylamino, (C6-C60)arylamino, (C6-C60)ar(C1-C60)alkyl, (C1-C60)alkyloxy, (C1-C60)alkylthio, (C6-C60)aryloxy, (C6-C60)arylthio, (C1-C60)alkoxycarbonyl, (C1-C60)alkylcarbonyl, (C6-C60)arylcarbonyl, carboxyl, nitro, hydroxyl, 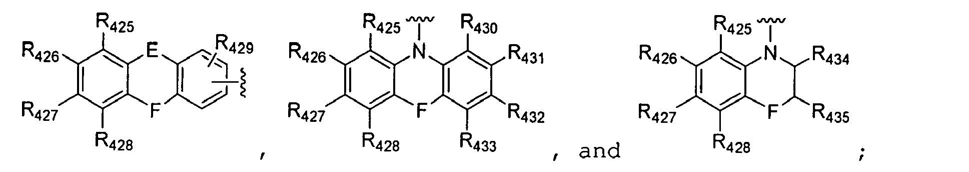
h is an integer from 1 to 4; and
i is an integer from 1 to 4.

The compounds having the electroluminescent peak of the wavelength of not more than 560 nm can be exemplified by the following compounds, but they are not restricted thereto.

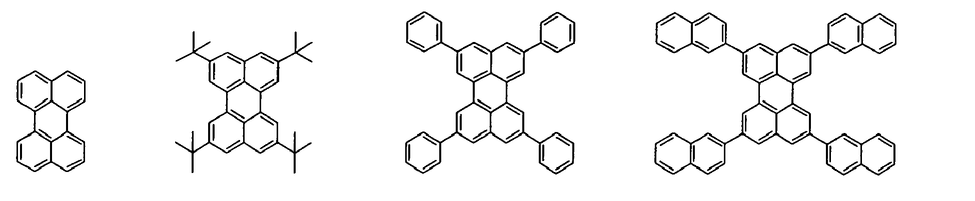

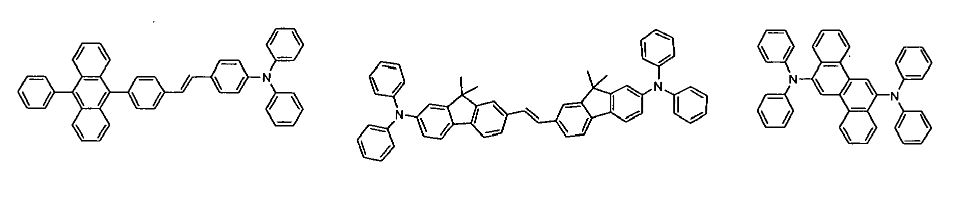

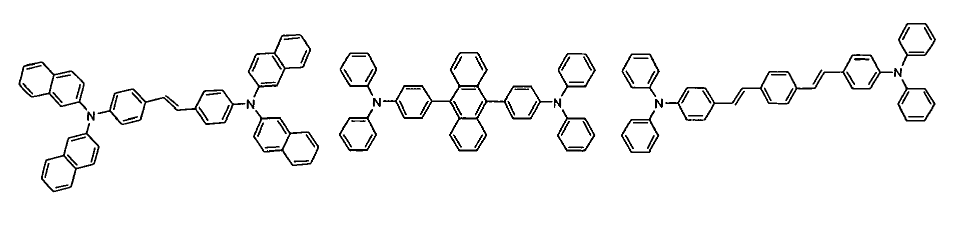

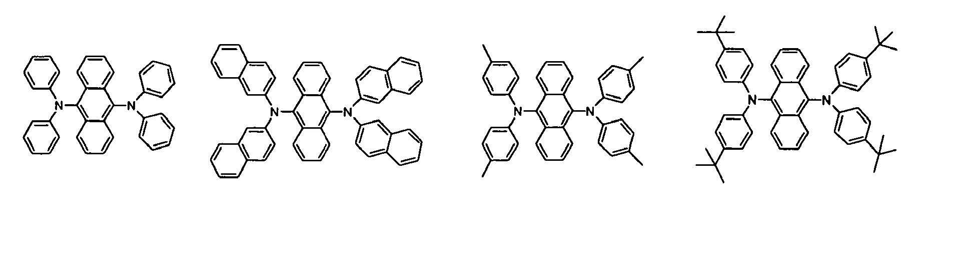

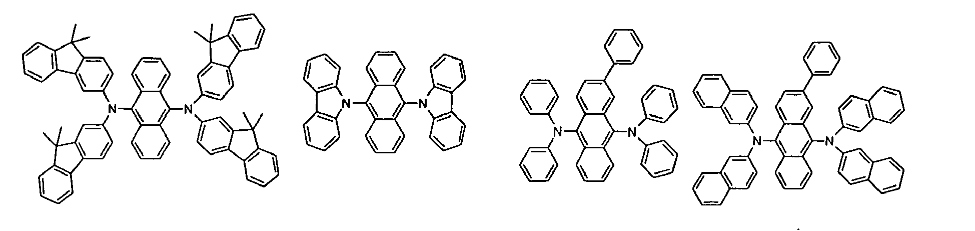

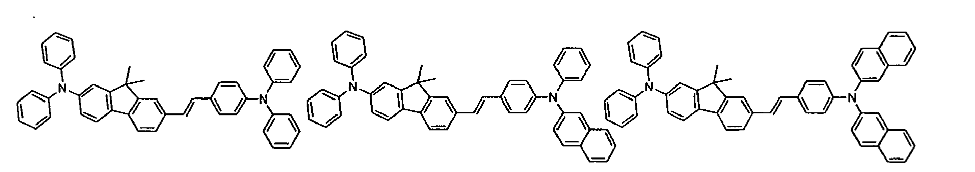

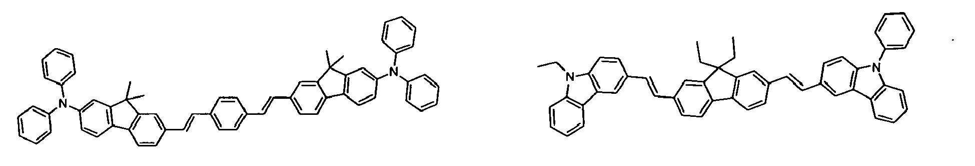

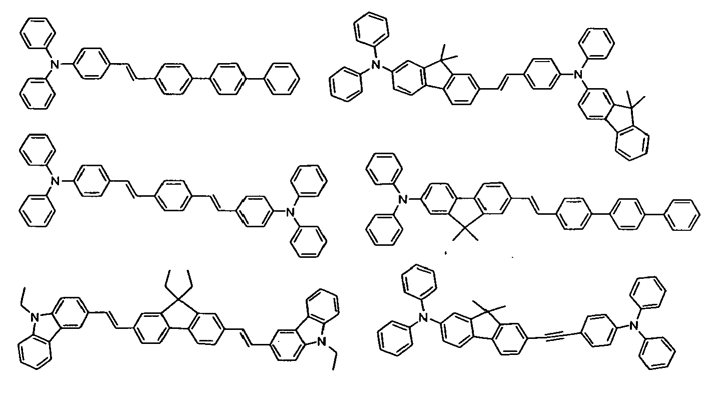

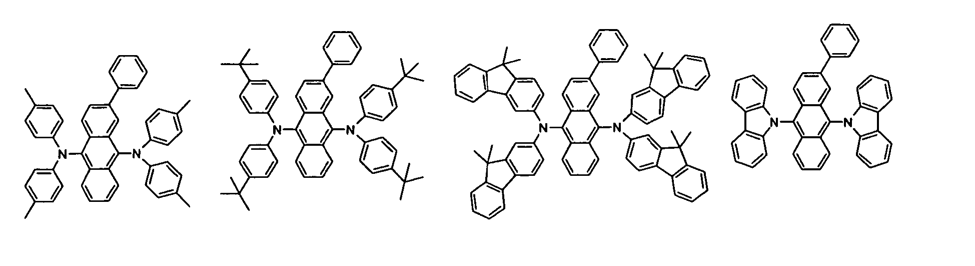

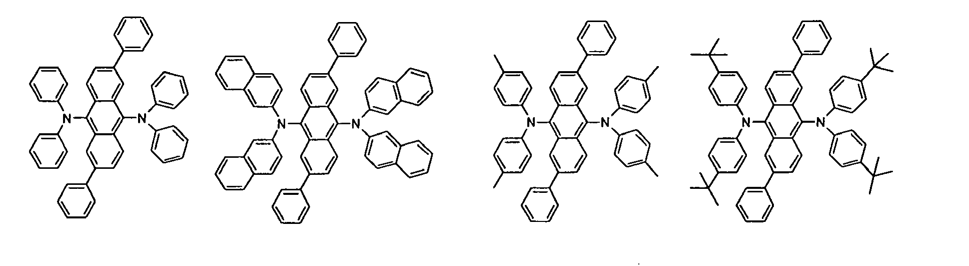

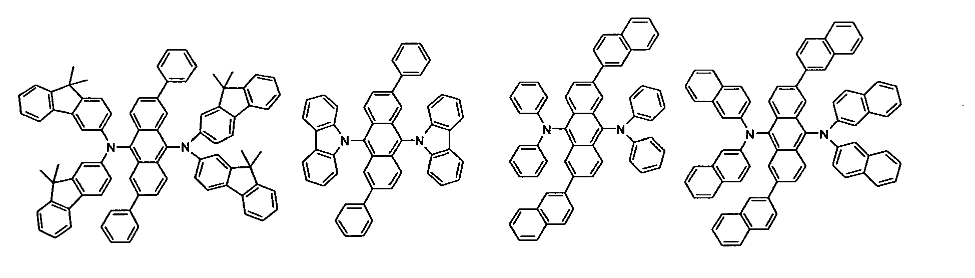

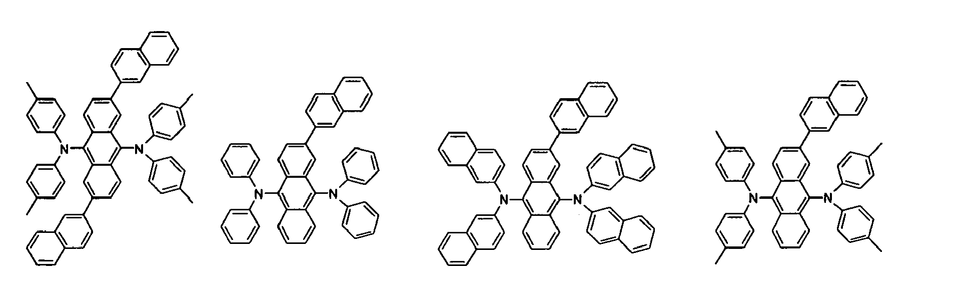

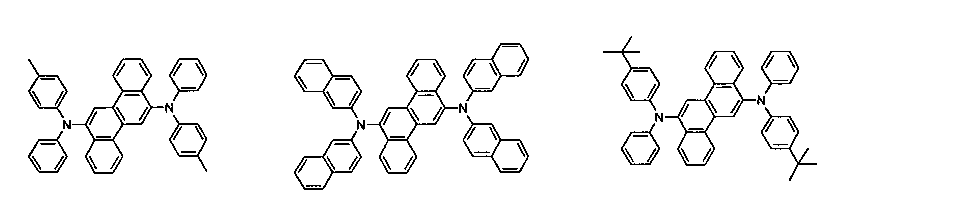

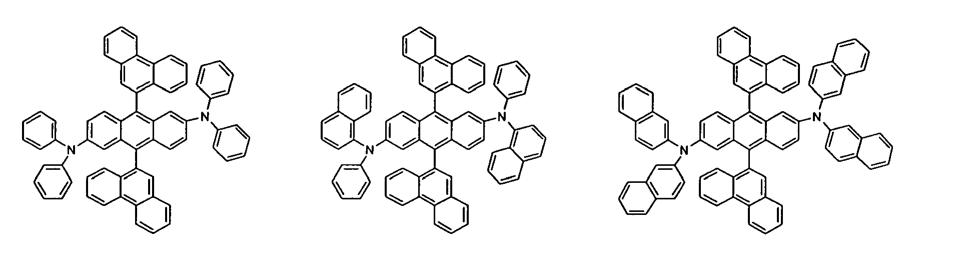

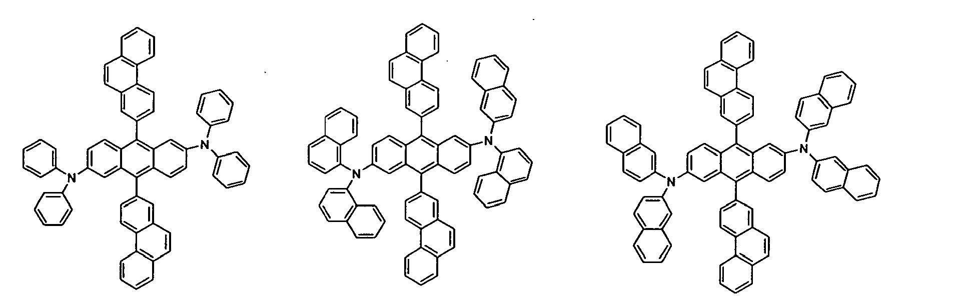

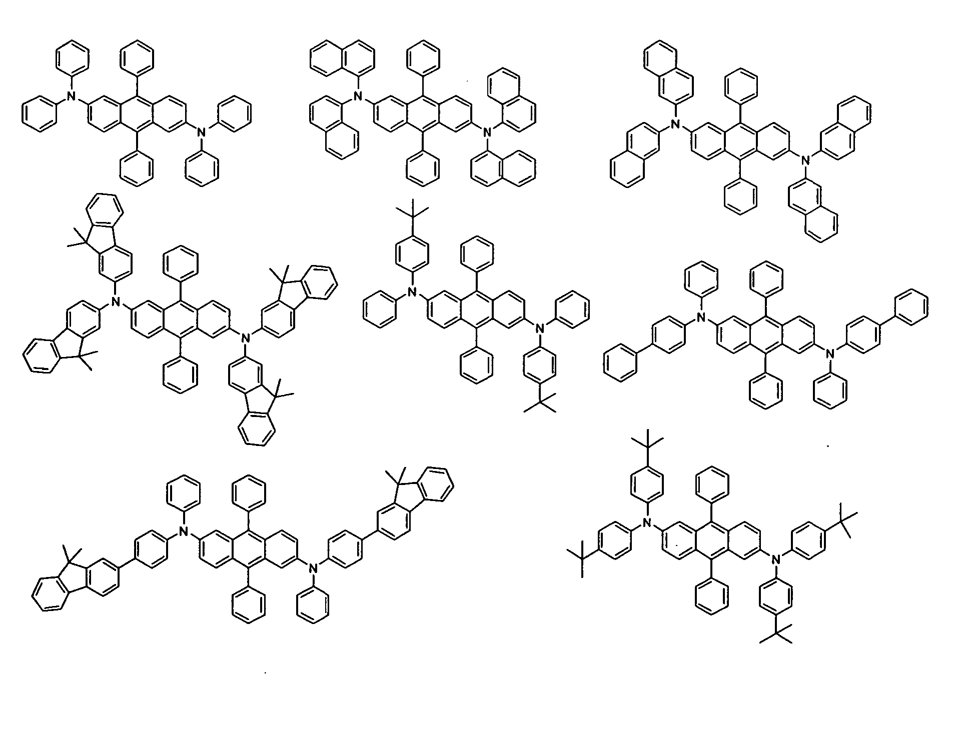

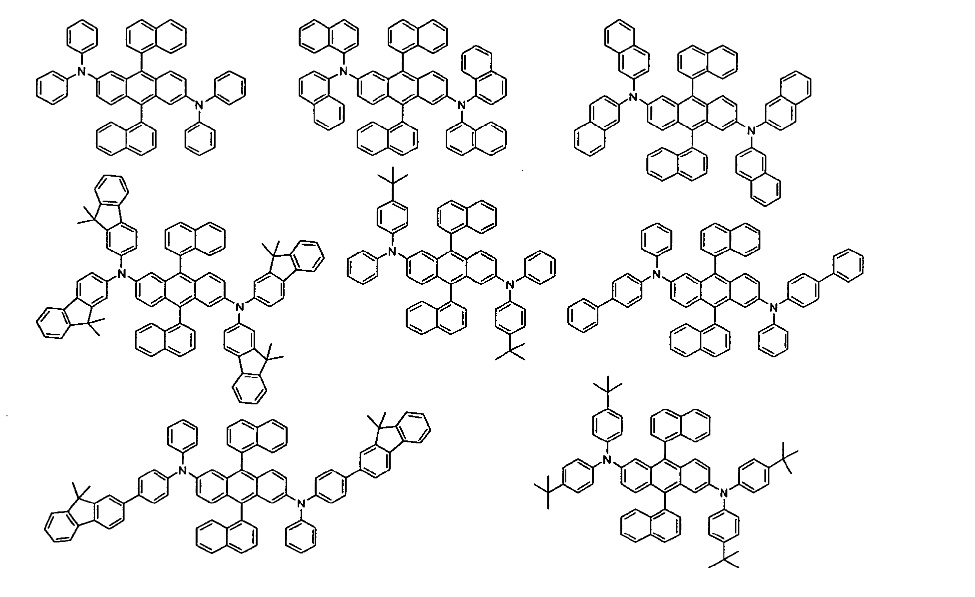

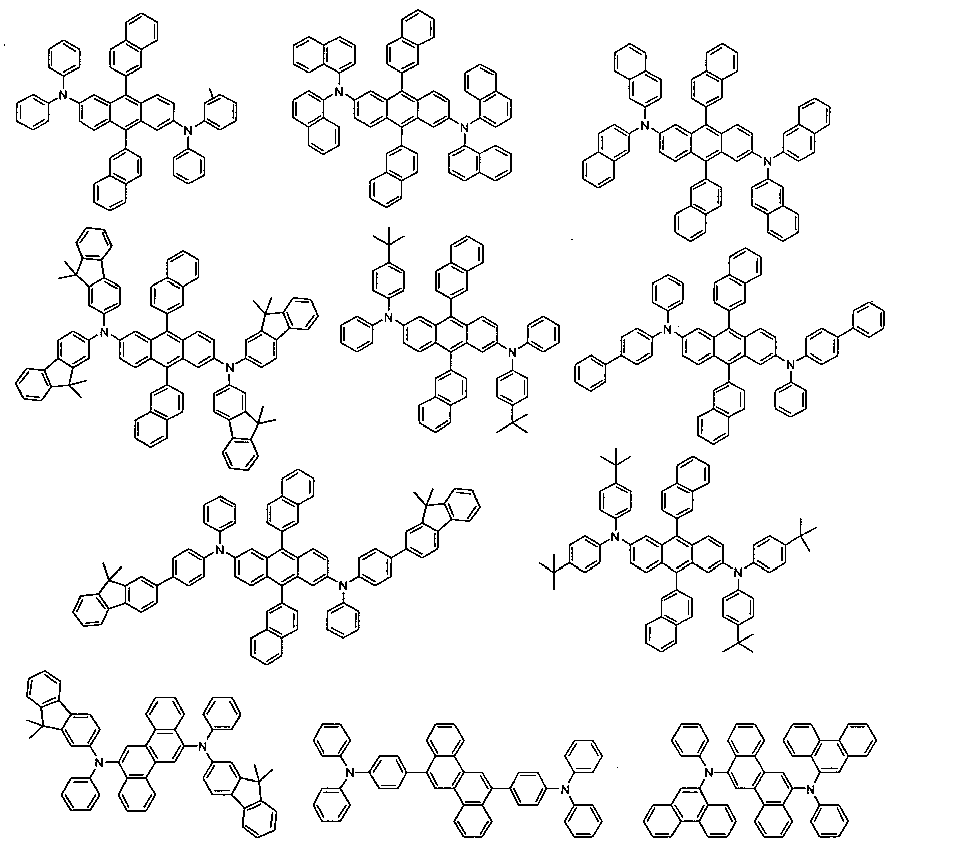

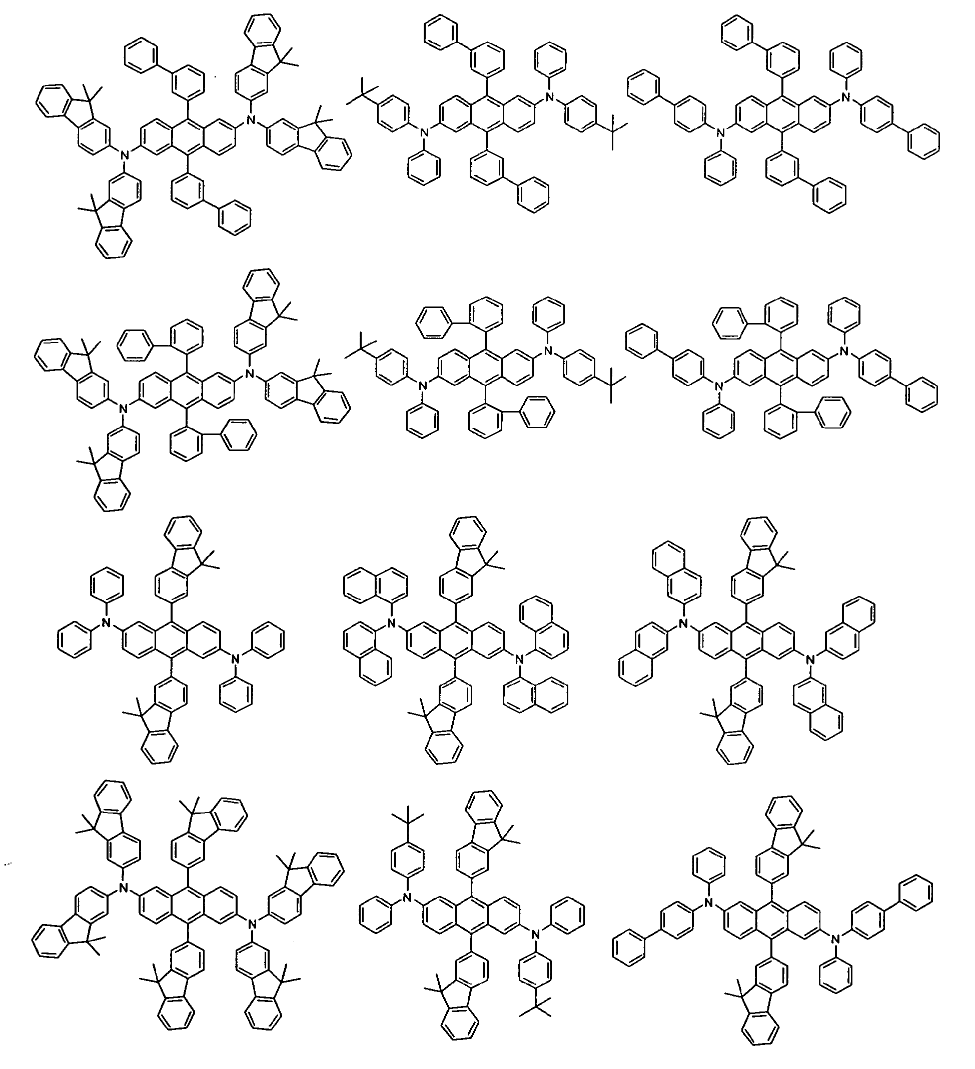

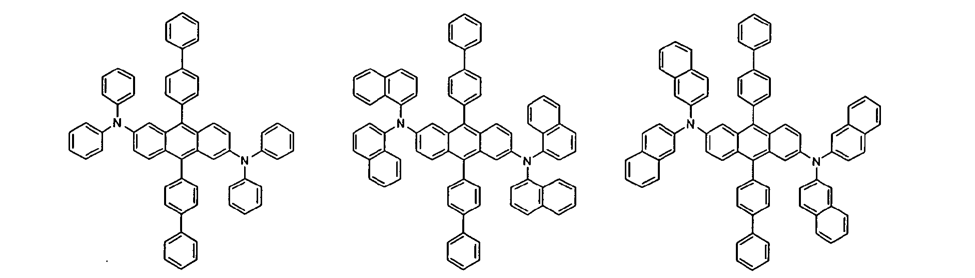

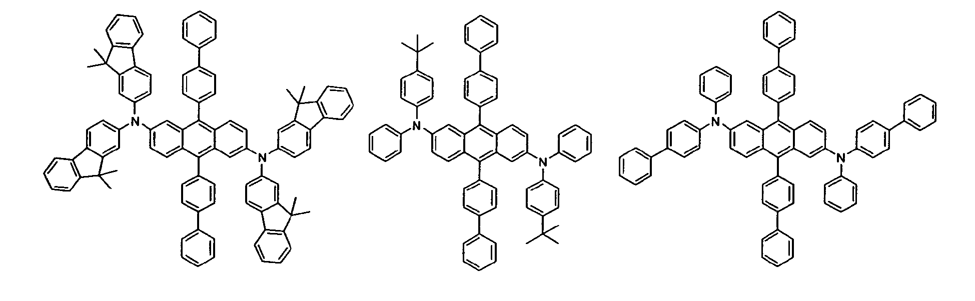

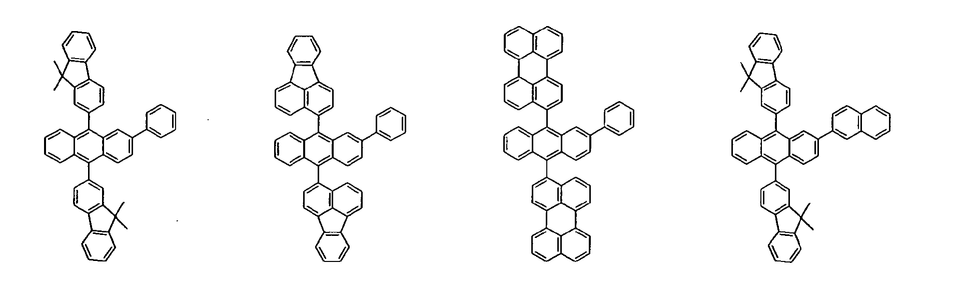

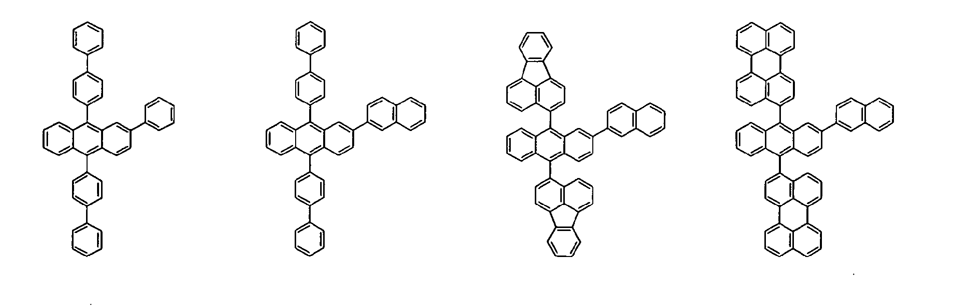

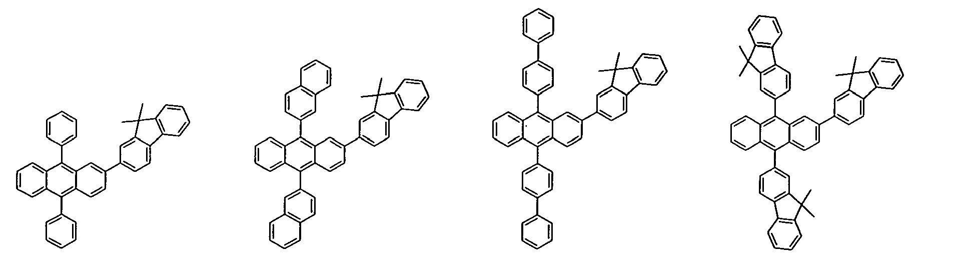

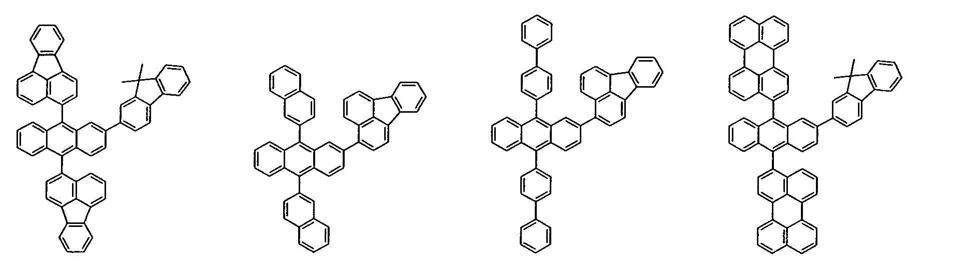

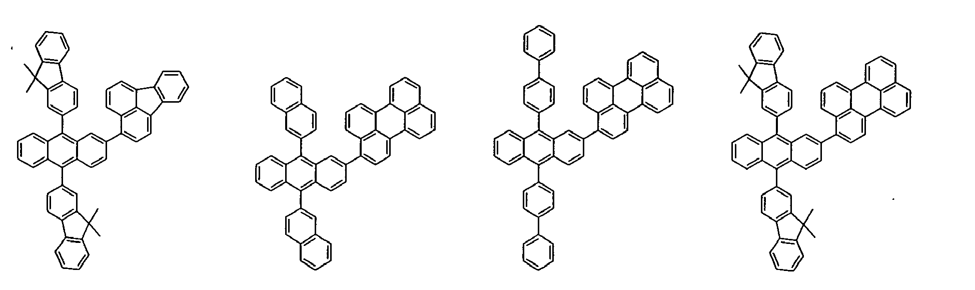

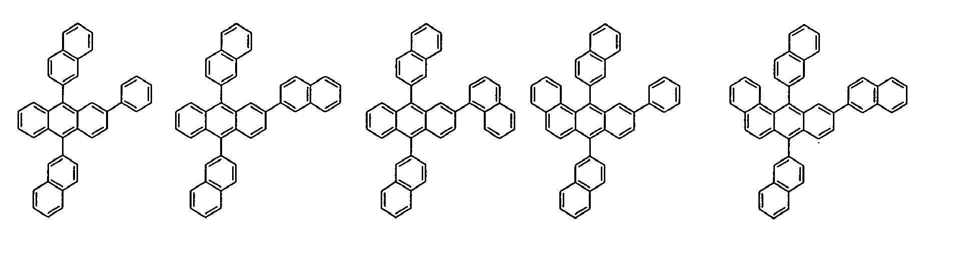

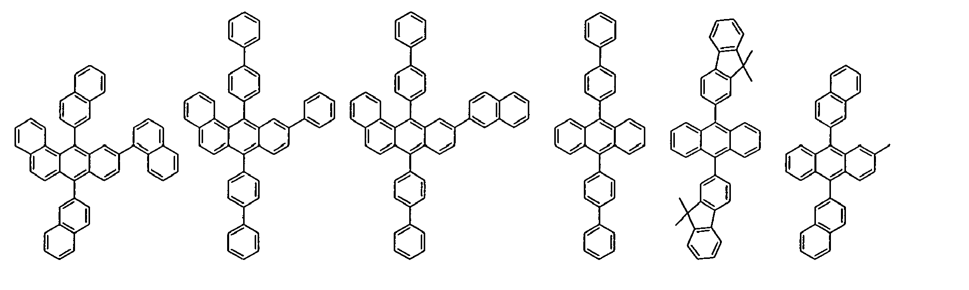

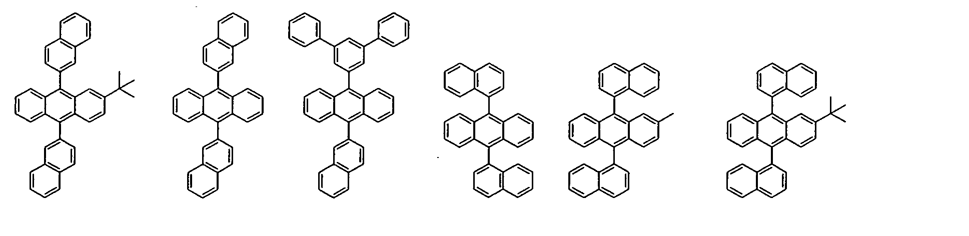

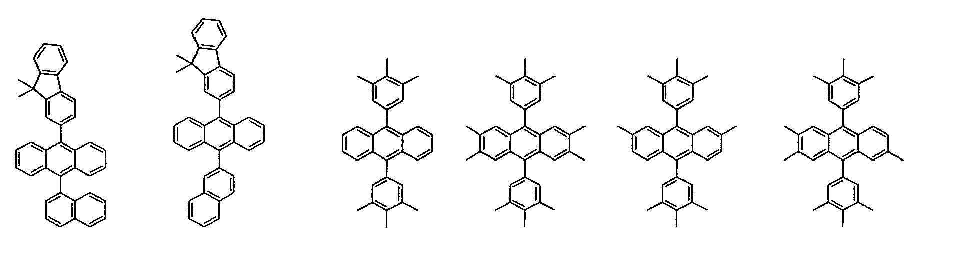

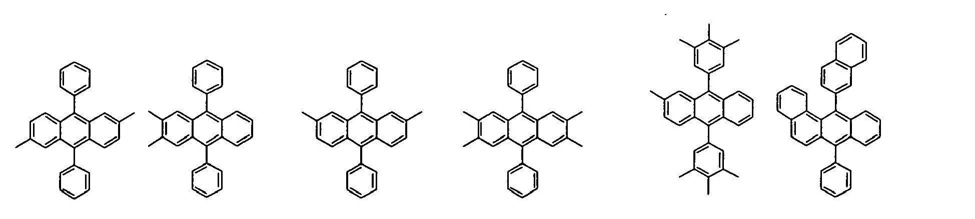

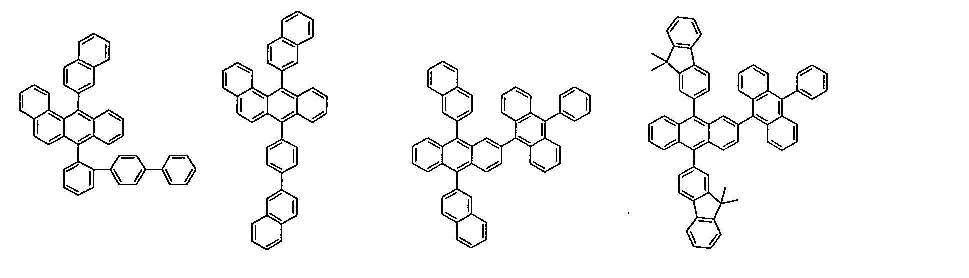

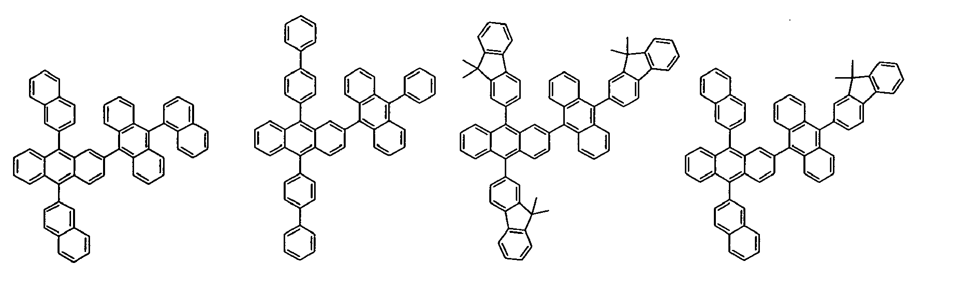

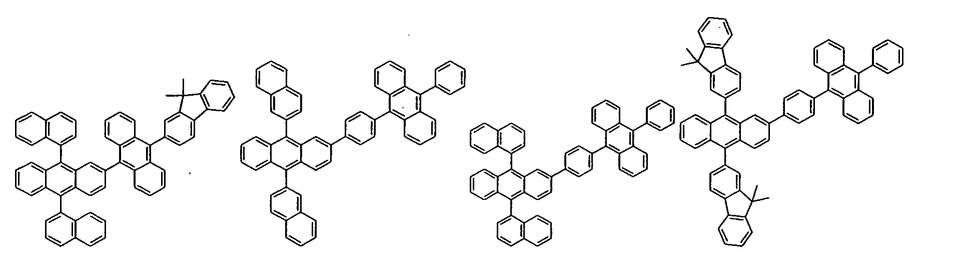

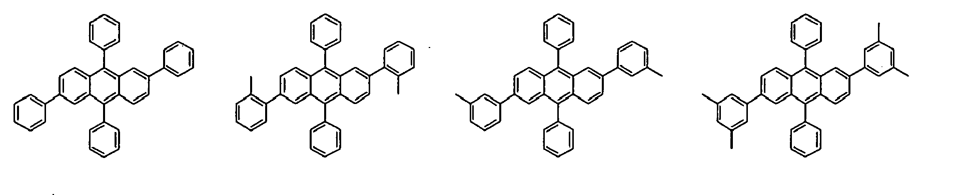

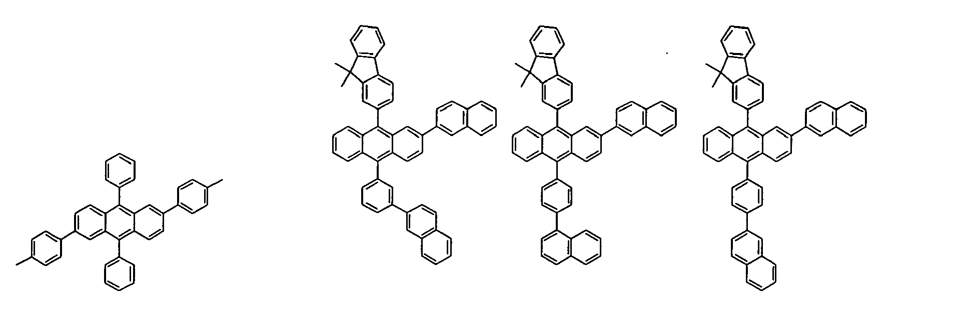

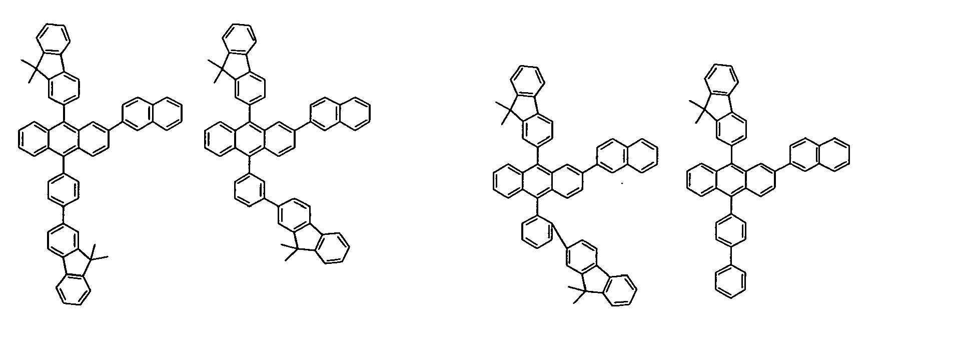

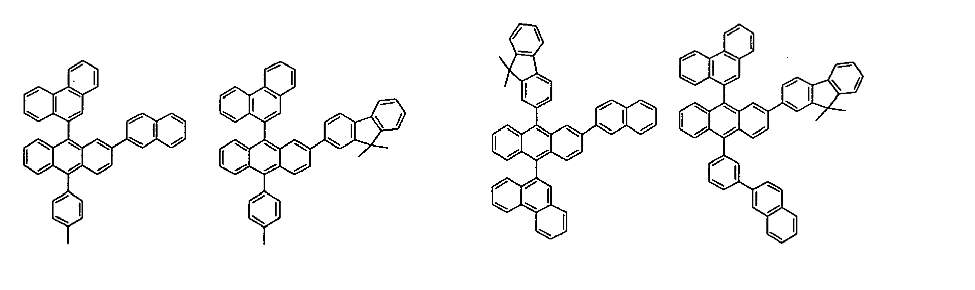

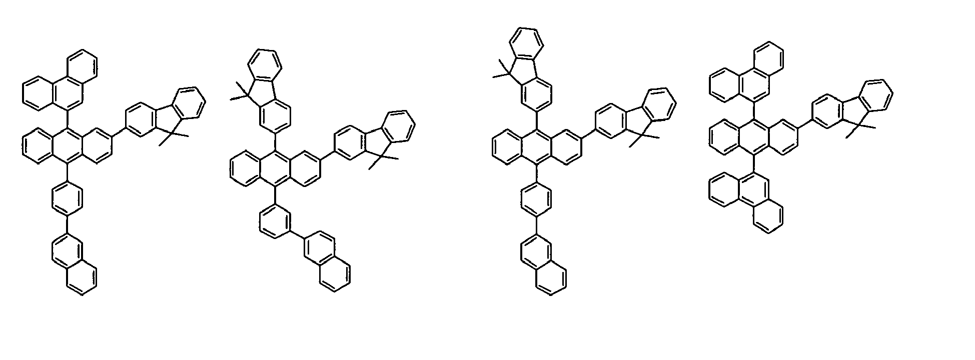

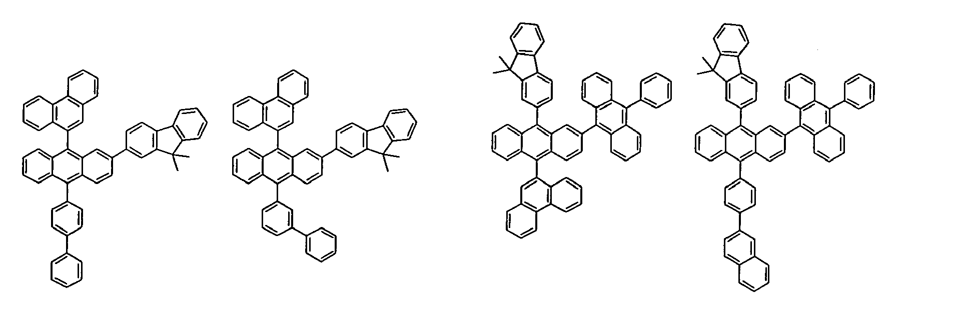

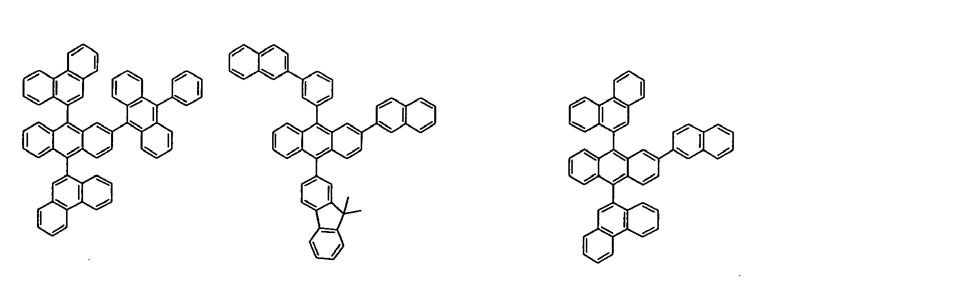

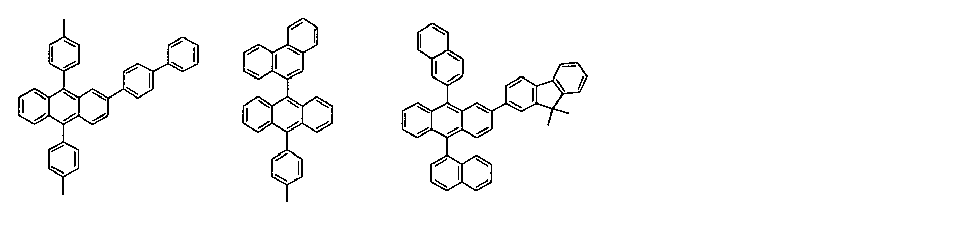

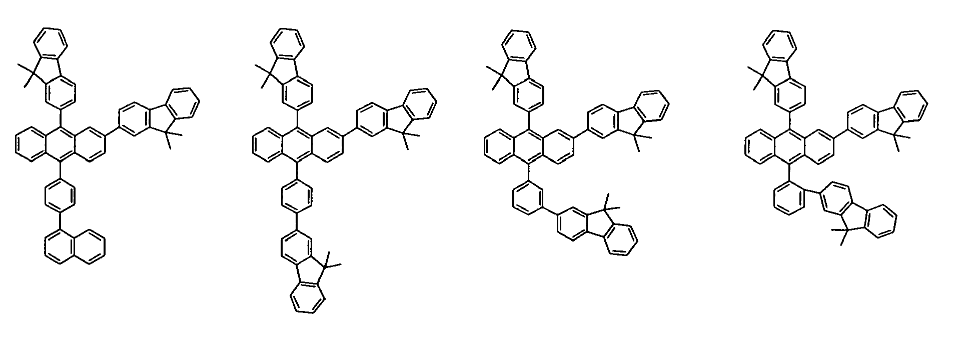

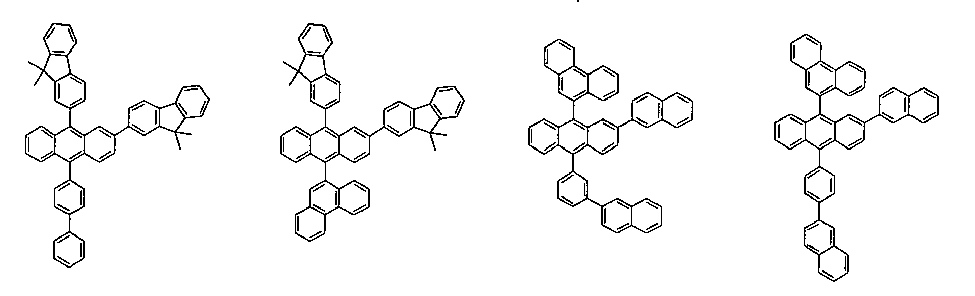

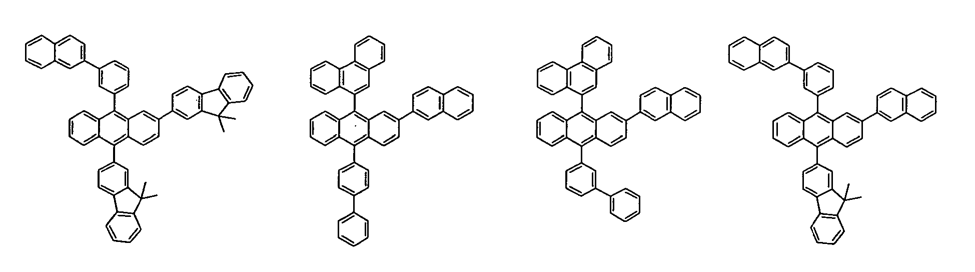

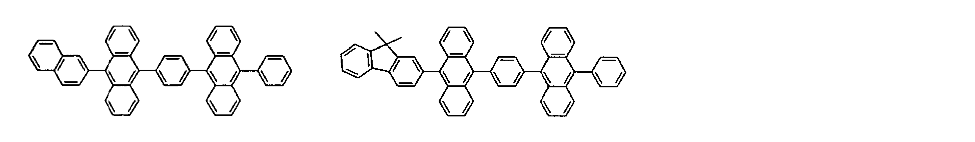

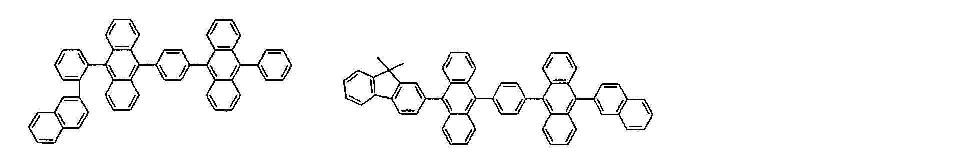

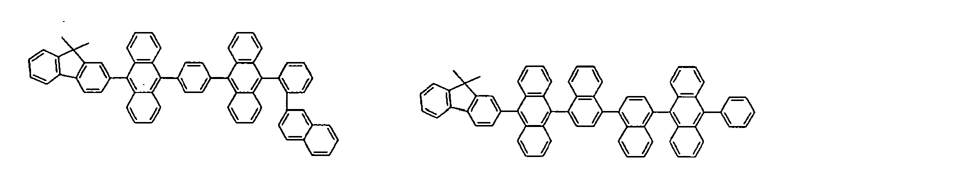

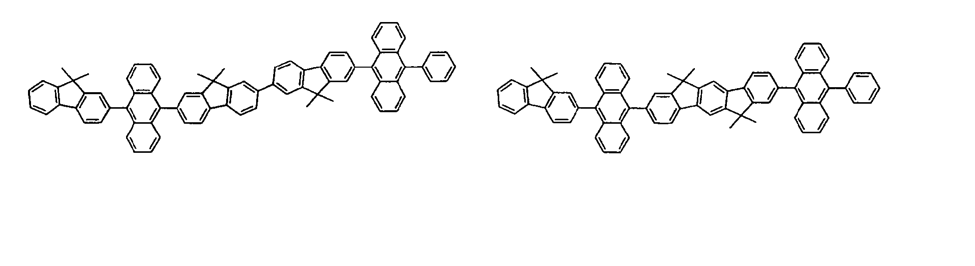

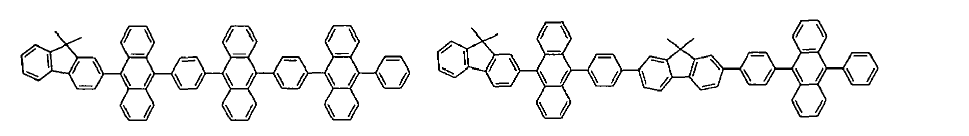

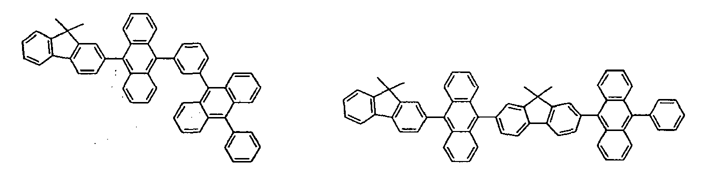

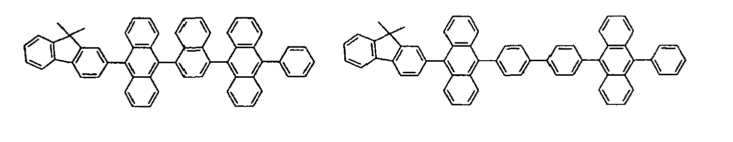

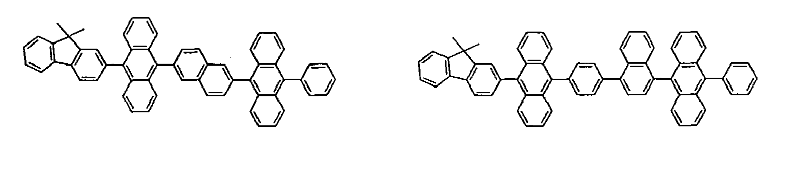

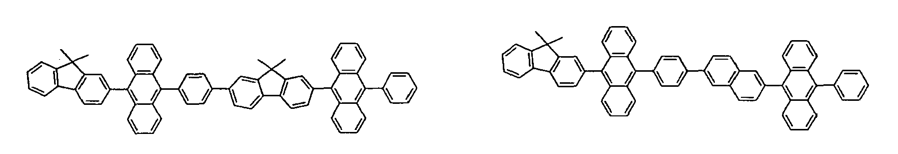

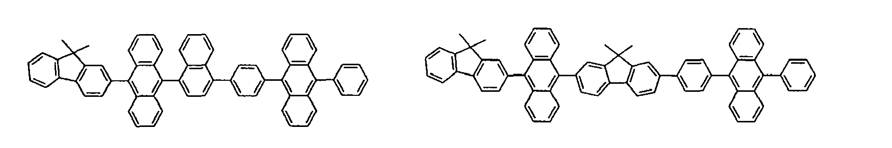

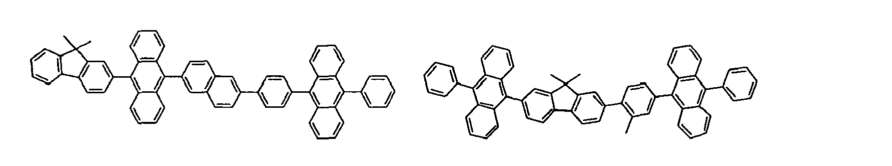

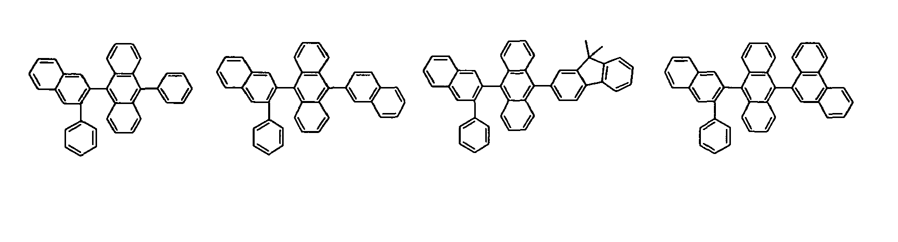

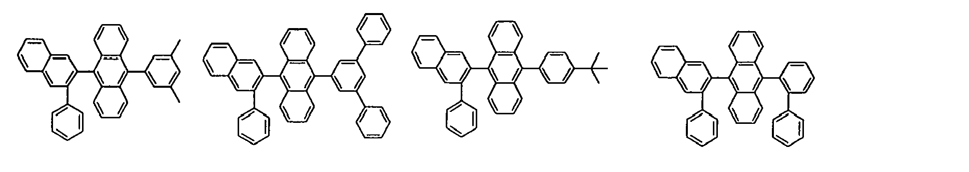

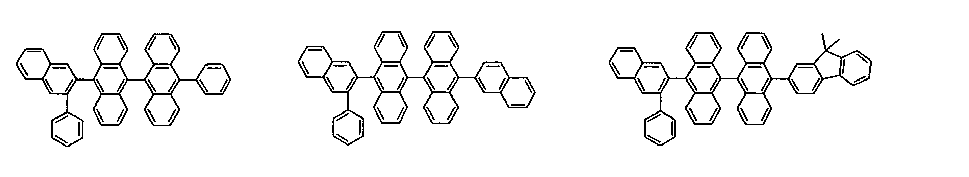

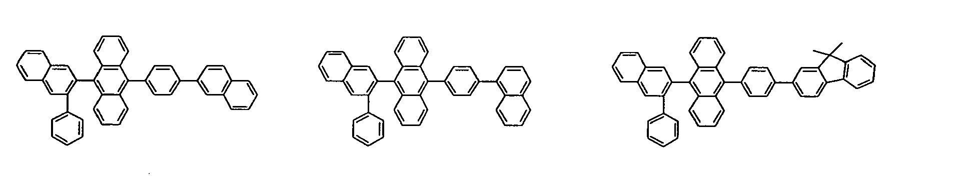

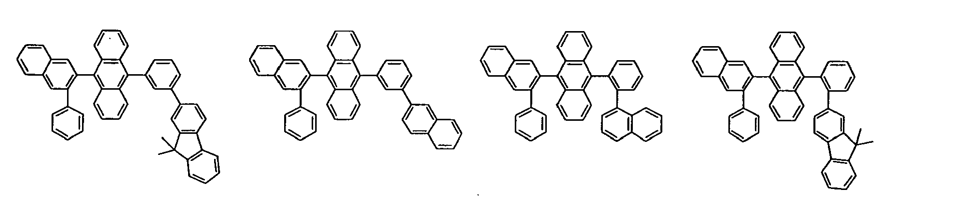

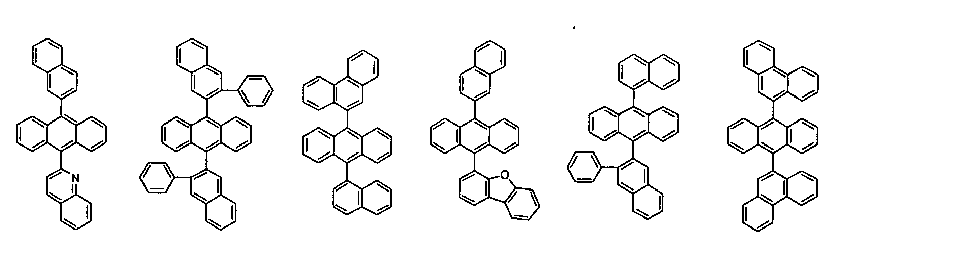

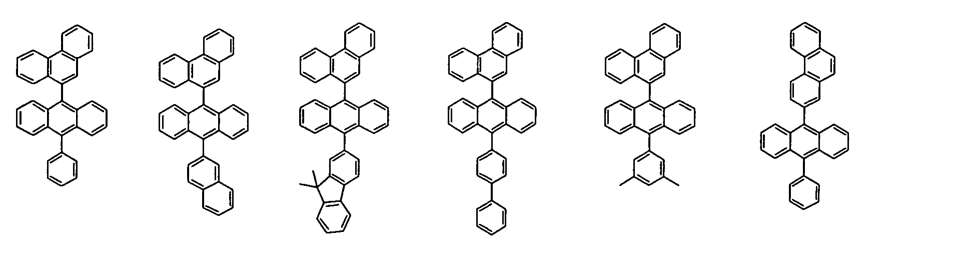

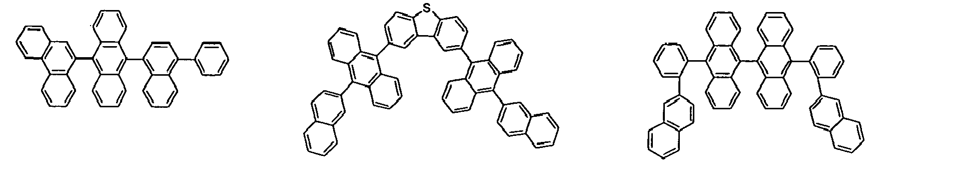

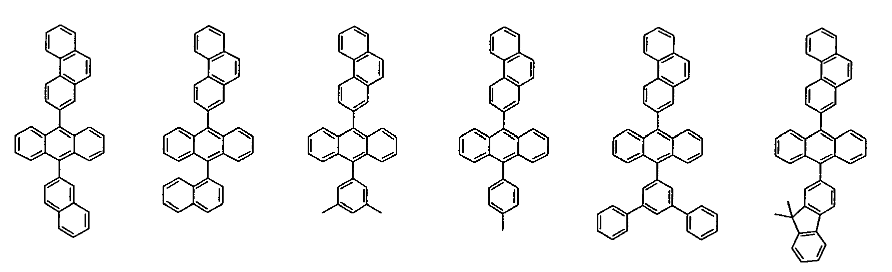

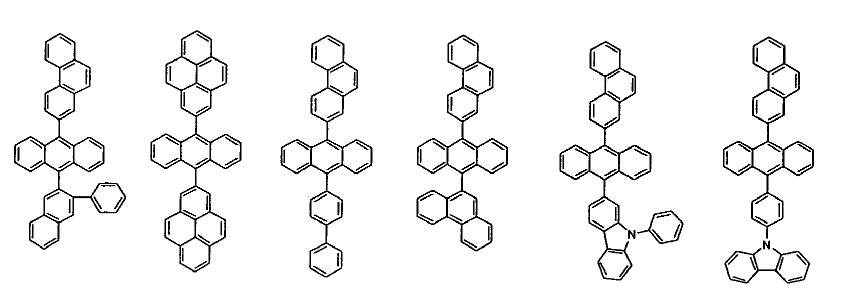

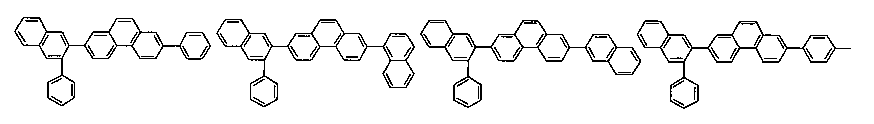

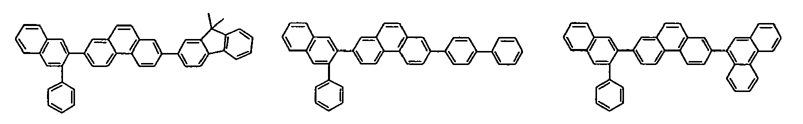

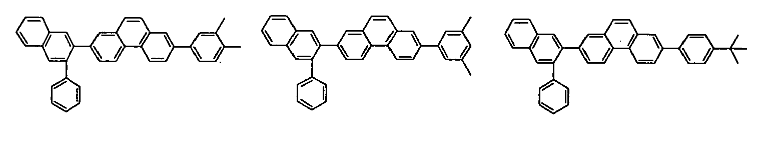

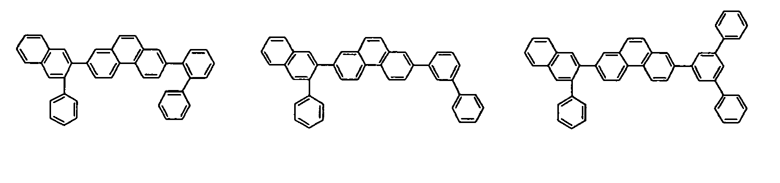

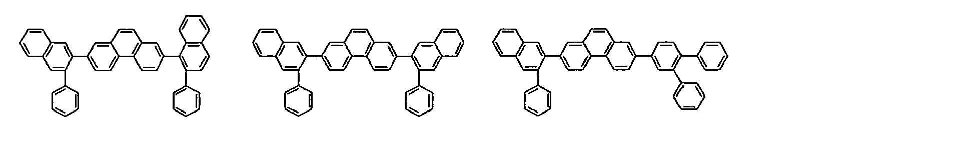

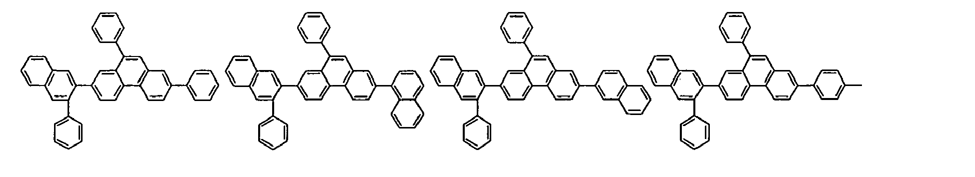

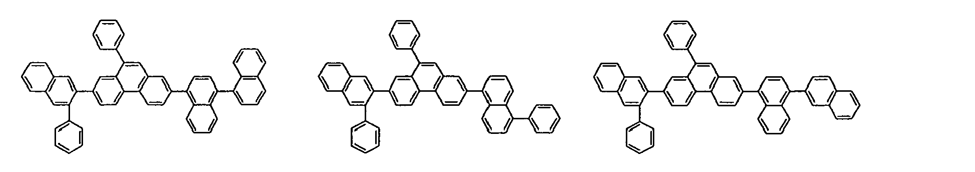

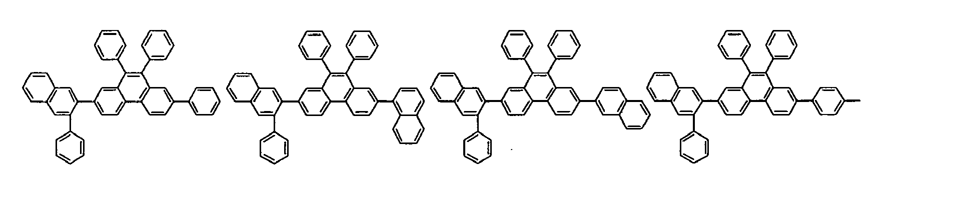

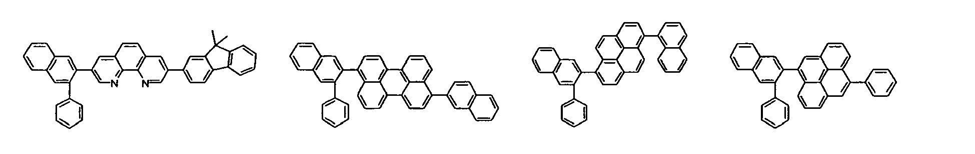

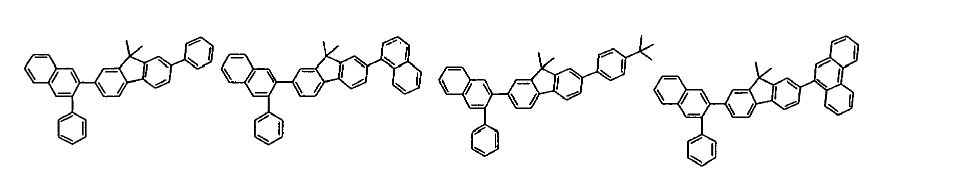

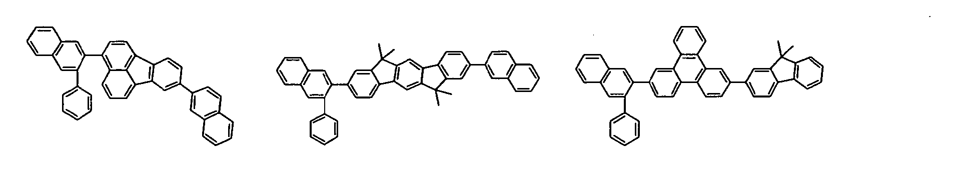

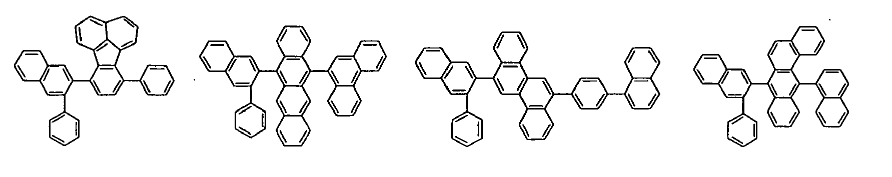

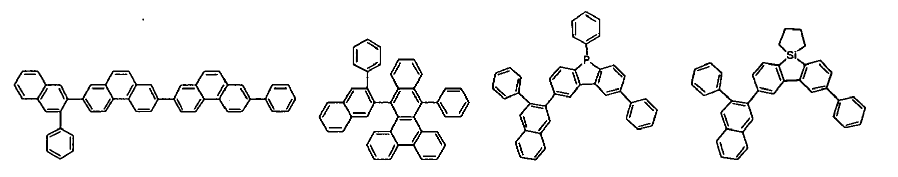

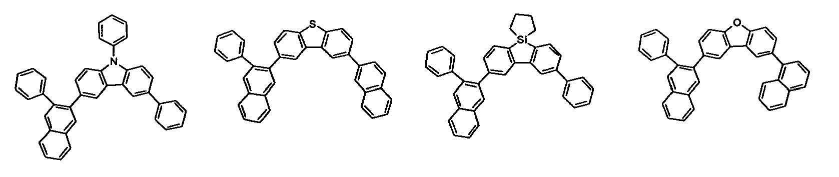

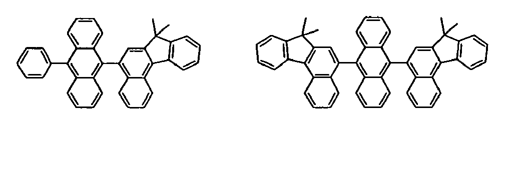

In an organic electroluminescent device according to the present invention, it is preferable to displace one or more layer(s) (here-in-below, referred to as the "surface layer") selected from chalcogenide layers, metal halide layers and metal oxide layers, on the inner surface of at least one side of the pair of electrodes. Specifically, it is preferable to arrange a chalcogenide layer of silicon and aluminum metal (including oxides) on the anode surface of the EL medium layer, and a metal halide layer or a metal oxide layer on the cathode surface of the EL medium layer. As the result, stability in operation can be obtained.

Examples of chalcogenides preferably include SiOₓ (1≤X≤2), AlOₓ (1≤X≤1.5), SiON, SiAlON, or the like. Examples of metal halides preferably include LiF, MgF₂, CaF₂, fluorides of rare earth metals or the like. Examples of metal oxides preferably include Cs₂O, Li₂O, MgO, SrO, BaO, CaO, or the like.

In an organic electroluminescent device according to the present invention, it is also preferable to arrange, on at least one surface of the pair of electrodes thus manufactured, a mixed region of electron transport compound and a reductive dopant, or a mixed region of a hole transport compound with an oxidative dopant. Accordingly, the electron transport compound is reduced to an anion, so that injection and transportation of electrons from the mixed region to an EL medium are facilitated. In addition, since the hole transport compound is oxidized to form a cation, injection and transportation of holes from the mixed region to an EL medium are facilitated. Preferable oxidative dopants include various Lewis acids and acceptor compounds. Preferable reductive dopants include alkali metals, alkali metal compounds, alkaline earth metals, rare-earth metals, and mixtures thereof.

The electroluminescent devices according to the invention exhibit excellent luminous efficiency, good color purity, and very good operation life with lowered operation voltage.

### Best Mode

The present invention is further described by referring to Preparation Examples and Examples in order to illustrate luminescent properties of the novel electroluminescent devices according to the present invention, but those examples are provided for better understanding of the present invention only but are not intended to limit the scope of the invention by any means.

### Preparation Example

Preparation Examples 1 to 18 are described in Korean Patent Registration No. 0684109.

### [Preparation Example 1] Preparation of Compound (1)

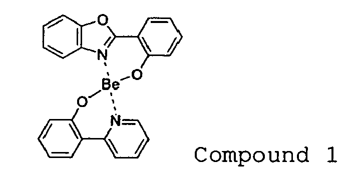

In methanol (50 mL), dissolved was 2-pyridin-2-yl-phenol (1.0 g, 5.84 mmol), and aqueous 1 M sodium hydroxide solution (10 mL) was added thereto. To the mixture, a solution of beryllium sulfate tetrahydrate (1.05 g, 5.93 mmol) dissolved in aqueous methanol (methanol 7 mL : water 3 mL) was added, and the resultant mixture was stirred at ambient temperature for 2 hours. Thereafter, 2-hydroxy-phenyl benzoxazole (1.54 g, 7.30 mmol) dissolved in methanol (50 mL) was slowly added thereto. The reaction mixture was stirred at ambient temperature for additional 2 hours, and warmed to 50°C. After stirring 10 hours, the precipitate produced was filtered, washed with water (50 mL) and acetone (50 mL), and dried to obtain the title compound, Compound (1) (0.80 g, 2.04 mmol, yield: 34%).
MS/FAB: 391 (found), 391.43 (calculated)
EA: C 73.55%, H 4.59%, N 7.05%, O 12.41%

### [Preparation Example 2] Preparation of Compound (2)

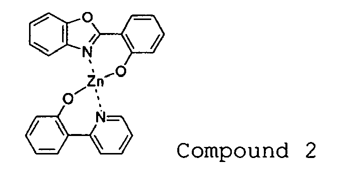

In methanol (50 mL), dissolved was 2-pyridin-2-yl-phenol (1.0 g, 5.84 mmol), and aqueous 1 M sodium hydroxide solution (10 mL) was added thereto. To the mixture, a solution of zinc acetate (0.95 g, 5.18 mmol) dissolved in methanol (10 mL) was added dropwise, and the resultant mixture was stirred at ambient temperature for 2 hours. Thereafter, 2-hydroxy-phenyl benzoxazole (1.50 g, 7.10 mmol) dissolved in methanol (50 mL) was slowly added thereto. The reaction mixture was further stirred at ambient temperature for 10 hours. The precipitate produced then was filtered, washed with water (50 mL) and acetone (50 mL), and dried to obtain the title compound, Compound (2) (0.72 g, 1.61 mmol, yield: 27%).
MS/FAB: 447 (found), 447.79 (calculated)
EA: C 64.22%, H 4.01%, N 6.05%, O 10.95%

### [Preparation Example 3] Preparation of Compound (3)

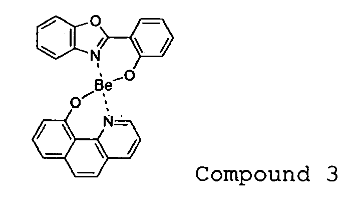

By using 2-hydroxy-phenyl benzoxazole (1.23 g, 5.82 mmol), 10-hydroxybenzo[h]quinoline (1.48 g, 7.58 mmol) and beryllium sulfate tetrahydrate (1.05 g, 5.93 mmol), the same procedure as described in Preparation Example 1 was repeated to obtain the title compound, Compound (3) (0.35 g, 0.84 mmol, yield 14%).
MS/FAB: 415 (found), 415.46 (calculated)
EA: C 75.02%, H 4.27%, N 6.64%, O 11.65%

### [Preparation Example 4] Preparation of Compound (4)

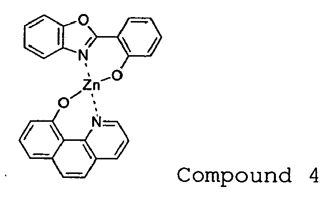

By using 2-hydroxy-phenyl benzoxazole (1.23 g, 5.82 mmol), 10-hydroxybenzo[h]quinoline (1.48 g, 7.58 mmol) and zinc acetate (0.95 g, 5.18 mmol), the same procedure as described in Preparation Example 2 was repeated to obtain the title compound, Compound (104) (0.52 g, 1.10 mmol, yield 19%).
MS/FAB: 471 (found), 471.81 (calculated)
EA: C 66.08%, H 3.79%, N 5.84%, O 10.30%

### [Preparation Example 5] Preparation of Compound (5)

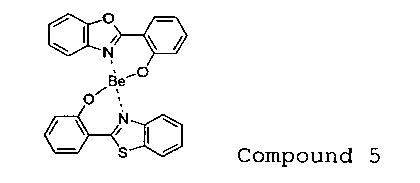

By using 2-hydroxy-phenyl benzoxazole (1.23 g, 5.82 mmol), 2-hydroxy-phenyl benzothiazole (1.72 g, 7.57 mmol) and beryllium sulfate tetrahydrate (1.05 g, 5.93 mmol), the same procedure as described in Preparation Example 1 was repeated to obtain the title compound, Compound (5) (0.96 g, 2.15 mmol, yield 37%).
MS/FAB: 447 (found), 447.52 (calculated)
EA: C 69.68%, H 4.01%, N 6.16%, O 10.85%, S 7.05%

### [Preparation Example 6] Preparation of Compound (6)

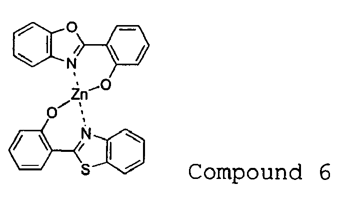

By using 2-hydroxy-phenyl benzoxazole (1.23 g, 5.82 mmol), 2-hydroxy-phenyl benzothiazole (1.72 g, 7.57 mmol) and zinc acetate (0.95 g, 5.18 mmol), the same procedure as described in Preparation Example 2 was repeated to obtain the title compound, Compound (6) (1.36 g, 2.70 mmol, yield 46%).
MS/FAB: 503 (found), 503.88 (calculated)
EA: C 61.88%, H 3.54%, N 5.46%, O 9.73%, S 6.26%

### [Preparation Example 7] Preparation of Compound (7)

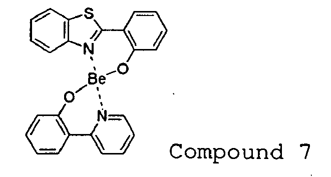

By using 2-hydroxy-phenyl benzothiazole (1.32 g, 5.80 mmol), 2-pyridin-2-yl-phenol (1.30 g, 7.59 mmol) and beryllium sulfate tetrahydrate (1.05 g, 5.93 mmol), the same procedure as described in Preparation Example 1 was repeated to obtain the title compound, Compound (107) (0.59 g, 1.45 mmol, yield 25%).
MS/FAB: 407 (found), 407.50 (calculated)
EA: C 70.64%, H 4.35%, N 6.76%, O 7.96%, S 7.75%

### [Preparation Example 8] Preparation of Compound (8)

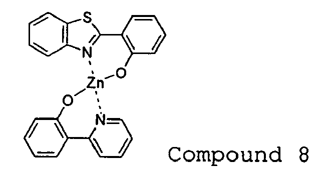

By using 2-hydroxy-phenyl benzothiazole (1.32 g, 5.80 mmol), 2-pyridin-2-yl-phenol (1.30 g, 7.59 mmol) and zinc acetate (0.95 g, 5.18 mmol), the same procedure as described in Preparation Example 2 was repeated to obtain the title compound, Compound (8) (0.83 g, 1.79 mmol, yield 31%).
MS/FAB: 463 (found), 463.86 (calculated)
EA: C 62.04%, H 3.82%, N 5.98%, O 7.02%, S 6.83%

### [Preparation Example 9] Preparation of Compound (9)

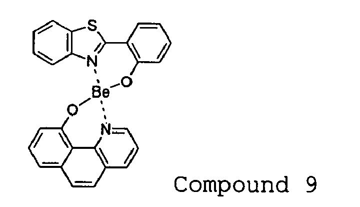

By using 2-hydroxy-phenyl benzothiazole (1.32 g, 5.80 mmol), 2-hydroxybenzo[h]quinoline (1.48 g, 7.58 mmol) instead of 2-hydroxy-phenyl benzoxazole, and beryllium sulfate tetrahydrate (1.05 g, 5.93 mmol), the same procedure as described in Preparation Example 1 was repeated to obtain the title compound, Compound (9) (0.98 g, 2.27 mmol, yield 39%).
MS/FAB: 431 (found), 431.52 (calculated)
EA: C 72.22%, H 4.10%, N 6.40%, O 7.62%, S 7.33%

### [Preparation Example 10] Preparation of Compound (10)

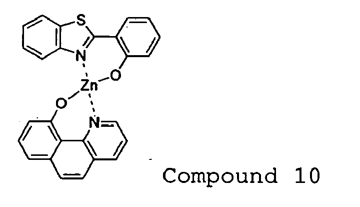

By using 2-hydroxy-phenyl benzothiazole (1.32 g, 5.80 mmol), 10-hydroxybenzo[h]quinoline (1.48 g, 7.58 mmol) and zinc acetate (0.95 g, 5.18 mmol), the same procedure as described in Preparation Example 4 was repeated to obtain the title compound, Compound (10) (1.22 g, 2.50 mmol, yield 43%).
MS/FAB: 487 (found), 487.88 (calculated)
EA: C 63.93%, H 3.65%, N 5.64%, O 6.70%, S 6.44%

### [Preparation Example 11] Preparation of Compound (11)

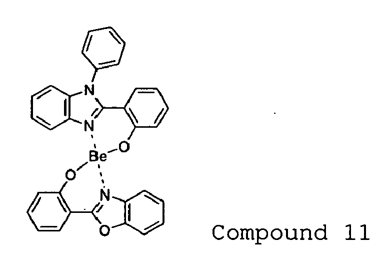

By using 2-hydroxy-phenyl benzoxazole (1.23 g, 5.82 mmol), 2-(1-phenyl-1H-benzimidazol-2-yl)-phenol (2.17 g, 7.58 mmol) and beryllium sulfate tetrahydrate (1.05 g, 5.93 mmol), the same procedure as described in Preparation Example 1 was repeated to obtain the title compound, Compound (11) (0.56 g, 1.11 mmol, yield 19%).
MS/FAB: 506 (found), 506.57 (calculated)
EA: C 75.67%, H 4.50%, N 8.20%, O 9.68%

### [Preparation Example 12] Preparation of Compound (12)

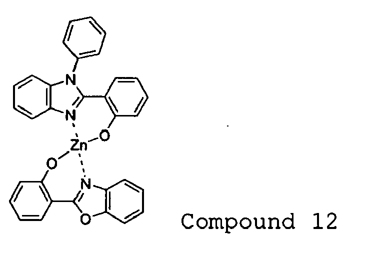

By using 2-hydroxy-phenyl benzoxazole (1.23 g, 5.82 mmol), 2-(1-phenyl-1H-benzimidazole-2-yl)-phenol (2.17 g, 7.58 mmol) and zinc acetate (0.95 g, 5.18 mmol), the same procedure as described in Preparation Example 2 was repeated to obtain the title compound, Compound (12) (0.72 g, 1.28 mmol, yield 22%).
MS/FAB: 562 (found), 562.93 (calculated)
EA: C 68.16%, H 4.05%, N 7.36%, O 8.68%

### [Preparation Example 13] Preparation of Compound (13)

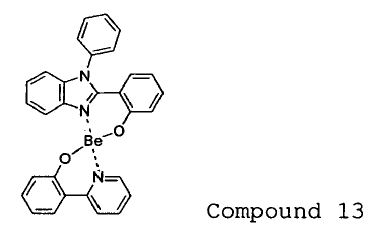

By using 2-(1-phenyl-1H-benzimidazol-2-yl)-phenol (1.67 g, 5.83 mmol), 2-pyridin-2-yl-phenol (1.30 g, 7.59 mmol) and beryllium sulfate tetrahydrate (1.05 g, 5.93 mmol), the same procedure as described in Preparation Example 1 was repeated to obtain the title compound, Compound (13) (0.84 g, 1.80 mmol, yield 31%).
MS/FAB: 466 (found), 466.55 (calculated)
EA: C 77.08%, H 4.87%, N 8.90%, O 6.98%

### [Preparation Example 14] Preparation of Compound (14)

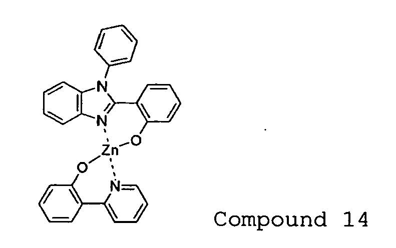

By using 2-(1-phenyl-1H-benzimidazol-2-yl)-phenol (1.67 g, 5.83 mmol), 2-pyridin-2-yl-phenol (1.30 g, 7.59 mmol) and zinc acetate (0.95 g, 5.18 mmol), the same procedure as described in Preparation Example 2 was repeated to obtain the title compound, Compound (14) (0.88 g, 1.68 mmol, yield 29%).
MS/FAB: 522 (found), 522.91 (calculated)
EA: C 68.81%, H 4.33%, N 7.92%, O 6.32%

### [Preparation Example 15] Preparation of Compound (15)

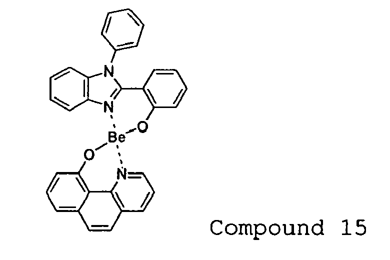

By using 2-(1-phenyl-1H-benzimidazol-2-yl)-phenol (1.67 g, 5.83 mmol), 10-hydroxybenzo[h]quinoline (1.50 g, 7.68 mmol) and beryllium sulfate tetrahydrate (1.05 g, 5.93 mmol), the same procedure as described in Preparation Example 1 was repeated to obtain the title compound, Compound (15) (0.53 g, yield 9%).
MS/FAB: 490 (found), 490.57 (calculated)
EA: C 78.20%, H 4.68%, N 8.42%, O 6.70%

### [Preparation Example 16] Preparation of Compound (16)

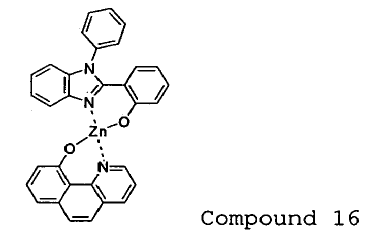

By using 2-(1-phenyl-1H-benzimidazol-2-yl)-phenol (1.67 g, 5.83 mmol), 10-hydroxybenzo[h]quinoline (1.50 g, 7.68 mmol) and zinc acetate (0.95 g, 5.18 mmol), the same procedure as described in Preparation Example 2 was repeated to obtain the title compound, Compound (16) (0.42 g, 0.77 mmol, yield 13%).
MS/FAB: 546 (found), 546.93 (calculated)
EA: C 70.13%, H 4.16%, N 7.58%, O 5.98%

### [Preparation Example 17] Preparation of Compound (17)

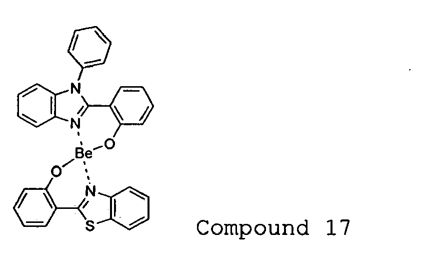

By using 2-hydroxy-phenyl benzothiazole (1.32 g, 5.80 mmol), 2-(1-phenyl-1H-benzimidazol-2-yl)-phenol (2.17 g, 7.58 mmol) and beryllium sulfate tetrahydrate (1.05 g, 5.93 mmol), the same procedure as described in Preparation Example 1 was repeated to obtain the title compound, Compound (17) (0.64 g, 1.22 mmol, yield 21%).
MS/FAB: 522 (found), 522.64 (calculated)
EA: C 73.42%, H 4.34%, N 7.97%, O 6.25%, S 6.04%

### [Preparation Example 18] Preparation of Compound (18)

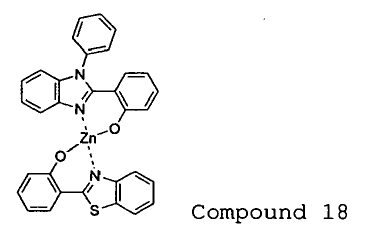

By using 2-hydroxy-phenyl benzothiazole (1.32 g, 5.80 mmol), 2-(1-phenyl-1H-benzimidazol-2-yl)-phenol (2.17 g, 7.58 mmol), and zinc acetate (0.95 g, 5.18 mmol), the same procedure as described in Preparation Example 2 was repeated to obtain the title compound, Compound (18) (0.94 g, 1.62 mmol, yield 28%).
MS/FAB: 578 (found), 578.99 (calculated)
EA: C 66.22%, H 3.94%, N 7.16%, O 5.70%, S 5.49%

### [Preparation Example 19] Preparation of Compound (19)

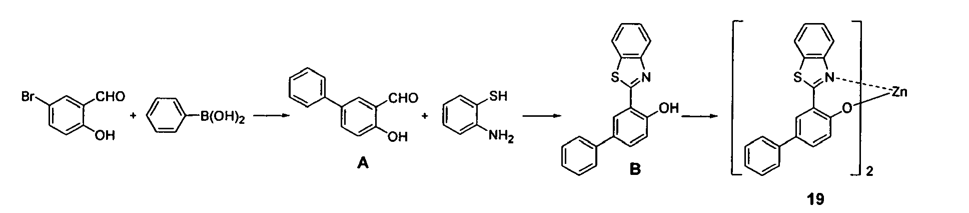

### Preparation of Compound A

In dimethylethylene glycol (200 mL) and ethanol (100 mL), dissolved were 5-bromo-2-hydroxybenzaldehyde (20.0 g, 99.5 mmol), phenylboronic acid (13.4 g, 109.5 mmol) and tetrakis palladium (0) triphenylphosphine (Pd(PPh₃)₄) (5.8 g, 5.0 mmol). Aqueous 2M potassium carbonate solution (132 mL) was added thereto, and the resultant mixture was stirred under reflux at 90°C for 4 hours. When the reaction was completed, water (100 mL) was added to the reaction mixture to quench the reaction. The mixture was then extracted with ethyl acetate (200 mL), and the extract was dried under reduced pressure. Purification via silica gel column chromatography (n-hexane:MC = 1:5) gave Compound (A) (12.0 g, 61.0 mmol).

### Preparation of Compound (B)

In 1,4-dioxane (12 mL), dissolved were 2-aminobenzenethiol (3.8 g, 30.2 mmol) and Compound (A) (5.0 g, 25.2 mmol), and the mixture was stirred at 100°C under pressure for 12 hours. When the reaction was completed, the reaction mixture was cooled to room temperature, and extracted with dichloromethane (100 mL) and water (100 mL). The extract was then dried under reduced pressure and the residue was purified via silica gel column chromatography (n-hexane:MC = 3:1) to obtain Compound (B) (4.5 g, 4.8 mmol).

### Preparation of Compound (19)

Compound (B) (4.5 g, 14.8 mmol) and sodium hydroxide (0.6 g, 14.8 mmol) were dissolved in ethanol (100 mL). After stirring the solution for 30 minutes, slowly added was Zn(CH₃COO)₂·2H₂O (1.8 g, 8.2 mmol), and the resultant mixture was stirred at room temperature for 12 hours. When the reaction was completed, the reaction mixture was washed sequentially with water (200 mL), ethanol (200 mL) and hexane (200 mL), and dried under reduced pressure to obtain the title compound (19) (4.5 g, 6.7 mmol, 45%).

### [Preparation Example 20] Preparation of Compound (178)

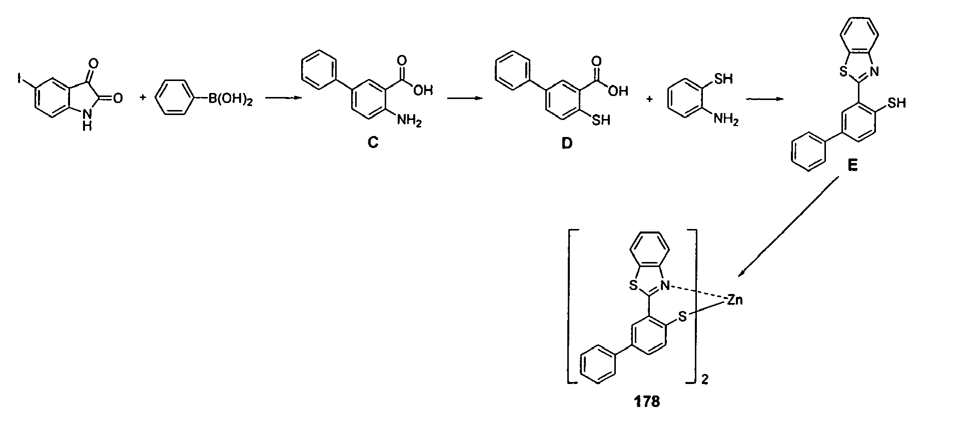

### Preparation of Compound (C)

In dimethylene glycol (600 mL), dissolved was 5-iodoindoline-2,3-dione (10.0 g, 36.6 mmol) and phenylboronic acid (5.4 g, 43.9 mmol). To the solution, added were tetrakis palladium (0) triphenylphosphine (Pd(PPh₃)₄) (2.1 g, 1.8 mmol) and aqueous 2M sodium hydrocarbonate solution (120 mL). The mixture was stirred under reflux for 12 hours, and the solvent was removed when the reaction was completed. Aqueous 5% sodium hydroxide solution (120 mL) was added to the residue, and the resultant mixture was stirred at room temperature. The aqueous solution was extracted with dichloromethane, and the aqueous layer was collected. After adding aqueous 30% hydrogen peroxide (120 mL), the temperature was raised to 50°C, and stirring was conducted for 30 minutes. After cooling to room temperature, slowly added was aqueous 1N hydrochloric acid to the aqueous solution to adjust the pH 4. The solid produced then was filtered under reduced pressure and dried to obtain Compound (C) (5.5 g, 26.0 mmol).

### Preparation of Compound (D)

Compound (C) (7.1 g, 33.3 mmol) was dissolved in water (18 mL) and concentrated hydrochloric acid (7 mL), and the solution was stirred at room temperature. After 10 minutes, the temperature was lowered to 0°C, and sodium nitrate (NaNO₃) (2.3 g, 33.3 mmol) dissolved in water (10 mL) was slowly added thereto. Then, the resultant mixture was stirred while maintaining the temperature at 0°C. In a separate reaction vessel, sodium sulfide nonahydrate (Na₂S· 9H₂O) (9.6 g, 39.9 mmol) and sulfur (1.3 g, 39.9 mmol) were dissolved in water (10 mL), and aqueous 10M sodium hydroxide (4 mL) was added thereto. This mixture was added to the reaction mixture at 0°C, and the resultant mixture was warmed to room temperature and stirred until the gas was not generated any more. When the reaction was completed, concentrated hydrochloric acid was added until the solid occurred, and the mixture was filtered under reduced pressure. The solid obtained was added to aqueous sodium hydrocarbonate (NaHCO₃) solution (85 mL), and the mixture was stirred under reflux for 20 minutes and cooled to room temperature. After removing insoluble solid (impurities), concentrated hydrochloric acid was added to the aqueous solution to form solid again. The solid obtained by filtration under reduced pressure was added to ethanol (30 mL), and the mixture was stirred under reflux for 20 minutes. The insoluble solid (impurities) was removed, and the filtrate was concentrated. Zinc (2.2 g, 33.3 mmol) and glacial acetic acid (30 mL) was added thereto, and the resultant mixture was stirred under reflux for 48 hours. When the reaction was completed, the reaction mixture was cooled to room temperature, and the solid collected was added to aqueous 5M sodium hydroxide solution (63 mL), and the mixture was stirred under reflux for 30 minutes. After removing insoluble solid (impurities), concentrated hydrochloric acid was added in small portions to acidify the aqueous solution. The solid produced then was collected, and added to ethanol (20 mL). After stirring under reflux for 30 minutes, insoluble solid (impurities) was removed and the filtrate was concentrated to obtain Compound (D) (1.8 g, 7.6 mmol).

### Preparation of Compound (E)

Compound (D) (5.0 g, 21.7 mmol), 2-aminobenzenethiol (2.1 mL, 19.5 mmol) and polyphosphoric acid (20 g) were stirred in a reaction vessel under reflux at 140°C for 24 hours. When the reaction was completed, the reaction mixture was cooled to room temperature, and aqueous saturated sodium hydroxide solution was slowly added to adjust the pH neutral. The solid produced then was filtered under reduced pressure to obtain the solid product. Washing with ethanol and drying the solid gave Compound (E) (5.4 g, 17.1 mmol).

### Preparation of Compound (178)

Compound (E) (5.0 g, 15.6 mmol) and sodium hydroxide (0.6 g, 15.6 mmol) were dissolved in ethanol (100 mL), and the solution was stirred for 30 minutes. After slowly adding Zn(CH₃COO)₂· 2H₂O (1.9 g, 8.7 mmol) thereto, the resultant mixture was stirred at room temperature for 12 hours. Thereafter, the mixture was sequentially washed with water (200 mL), ethanol (200 mL) and hexane (200 mL), and dried under reduced pressure to obtain the title compound, Compound (178) (7.1 g, 10.1 mmol, 65%).

According to the same procedure as Preparation Examples 19 and 20, Compounds 19 through 336 listed in Table 1 were prepared, of which the ¹H NMR and MS/FAB data are listed in Table 2. The compounds listed in Table 1 are those containing divalent metal M.

**Table 1**

| L¹L²M | | | | | | | |
|---|---|---|---|---|---|---|---|
| 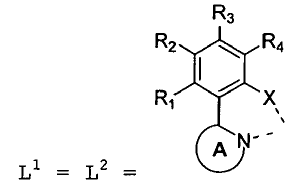 | | | | | | | M |

| Comp. No. | R₁ | R₂ | R₃ | R₄ | 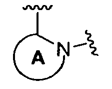 | X | |
|---|---|---|---|---|---|---|---|
| **19** | H | 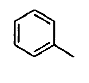 | H | H | 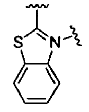 | O | Zn |
| **20** | 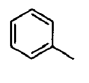 | H | H | H | 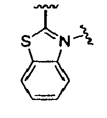 | O | Zn |
| **21** | H | H | 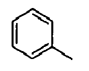 | H | 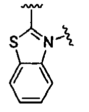 | O | Zn |
| **22** | H | H | H | 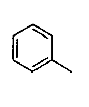 | 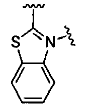 | O | Zn |
| **23** | H | 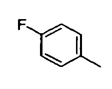 | H | H | 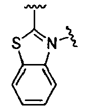 | O | Zn |
| **24** | H | H | 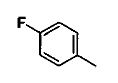 | H | 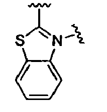 | O | Zn |
| **25** | H | H | H | 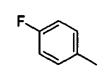 | 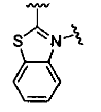 | O | Zn |
| **26** | 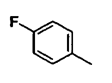 | H | H | H | 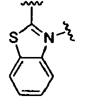 | O | Zn |
| **27** | H | 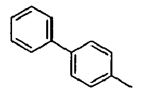 | H | H | 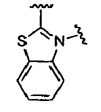 | O | Zn |
| **28** | 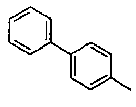 | H | H | H | 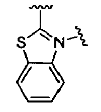 | O | Zn |
| **29** | H | H | 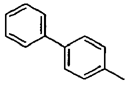 | H | 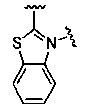 | O | Zn |
| **30** | H | H | H | 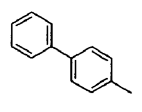 | 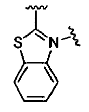 | O | Zn |
| **31** | H | H | 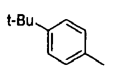 | H | 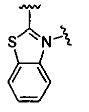 | O | Zn |
| **32** | H | 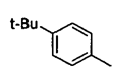 | H | H | 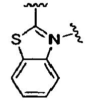 | O | Zn |
| **33** | H | H | 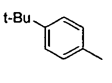 | H | 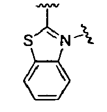 | O | Zn |
| **34** | 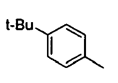 | H | H | H | 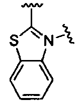 | O | Zn |
| **35** | H | H | 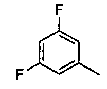 | H | 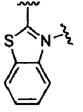 | O | Zn |
| **36** | H | 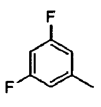 | H | H | 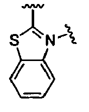 | O | Zn |
| **37** | H | H | H | 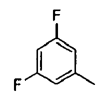 | 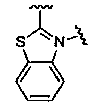 | O | Zn |
| **38** | 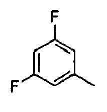 | H | H | H | 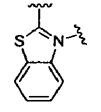 | O | Zn |
| **39** | H | 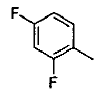 | H | H | 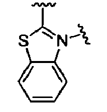 | O | Zn |
| **40** | H | H | H | 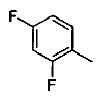 | 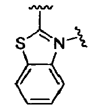 | O | Zn |
| **41** | H | H | 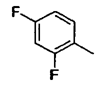 | H | 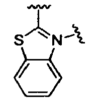 | O | Zn |
| **42** | 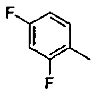 | H | H | H | 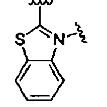 | O | Zn |
| **43** | 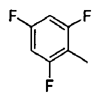 | H | H | H | 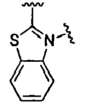 | O | Zn |
| **44** | H | 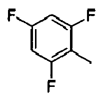 | H | H | 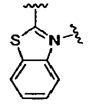 | O | Zn |
| **45** | H | H | H | 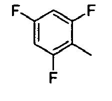 | 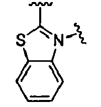 | O | Zn |
| **46** | H | H | 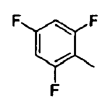 | H | 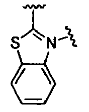 | O | Zn |
| **47** | 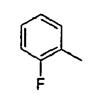 | H | H | H | 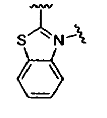 | O | Zn |
| **48** | H | 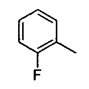 | H | H | 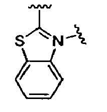 | O | Zn |
| **49** | H | H | 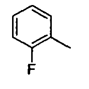 | H | 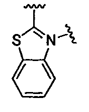 | O | Zn |
| **50** | H | H | H | 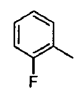 | 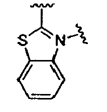 | O | Zn |
| **51** | H | 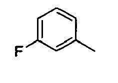 | H | H | 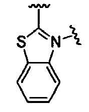 | O | Zn |
| **52** | H | H | 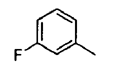 | H | 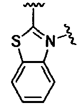 | O | Zn |
| **53** | H | H | H | 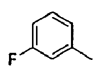 | 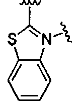 | O | Zn |
| **54** | 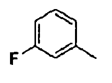 | H | H | H | 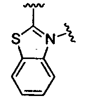 | O | Zn |
| **55** | H | 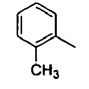 | H | H | 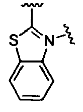 | O | Zn |
| **56** | H | H | 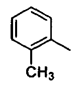 | H | 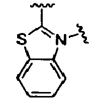 | O | Zn |
| **57** | 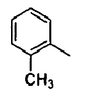 | H | H | H | 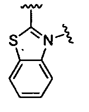 | O | Zn |
| **58** | H | H | H | 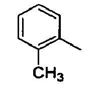 | 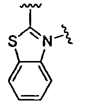 | O | Zn |
| **59** | H | 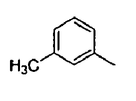 | H | H | 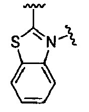 | O | Zn |
| **60** | H | H | 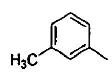 | H | 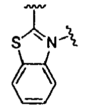 | O | Zn |
| **61** | H | H | H | 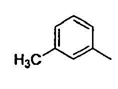 | 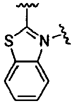 | O | Zn |
| **62** | 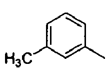 | H | H | H | 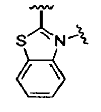 | O | Zn |
| **63** | 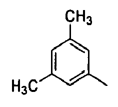 | H | H | H | 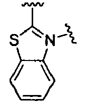 | O | Zn |
| **64** | H | 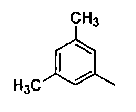 | H | H | 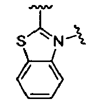 | O | Zn |
| **65** | H | H | 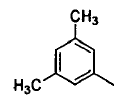 | H | 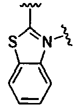 | O | Zn |
| **66** | H | H | H | 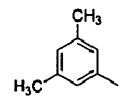 | 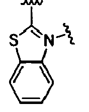 | O | Zn |
| **67** | H | 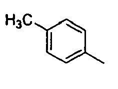 | H | H | 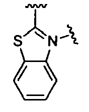 | O | Zn |
| **68** | H | H | 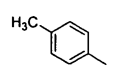 | H | 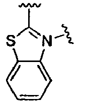 | O | Zn |
| **69** | 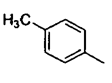 | H | H | H | 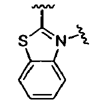 | O | Zn |
| **70** | H | H | H | 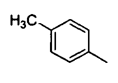 | 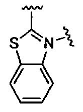 | O | Zn |
| **71** | H | H | 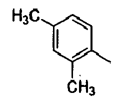 | H | 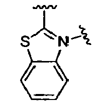 | O | Zn |
| **72** | H | 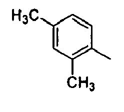 | H | H | 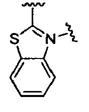 | O | Zn |
| **73** | 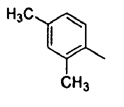 | H | H | H | 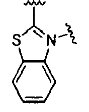 | O | Zn |
| **74** | H | H | H | 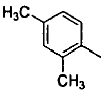 | 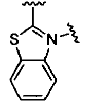 | O | Zn |
| **75** | H | 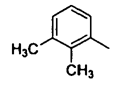 | H | H | 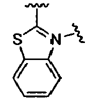 | O | Zn |
| **76** | H | H | 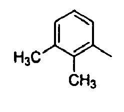 | H | 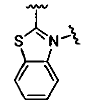 | O | Zn |
| **77** | 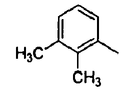 | H | H | H | 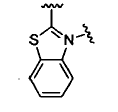 | O | Zn |
| **78** | H | H | H | 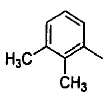 | 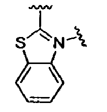 | O | Zn |
| **79** | 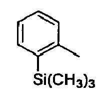 | H | H | H | 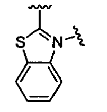 | O | Zn |
| **80** | H | H | 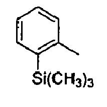 | H | 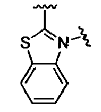 | O | Zn |
| **81** | H | 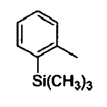 | H | H | 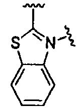 | O | Zn |
| **82** | H | H | H | 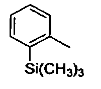 | 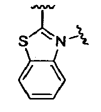 | O | Zn |
| **83** | H | 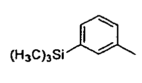 | H | H | 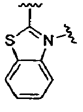 | O | Zn |
| **84** | H | H | 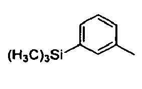 | H | 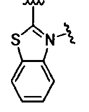 | O | Zn |
| **85** | H | H | H | 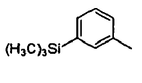 | 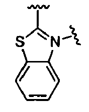 | O | Zn |
| **86** | 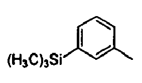 | H | H | H | 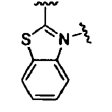 | O | Zn |
| **87** | H | 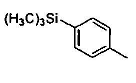 | H | H | 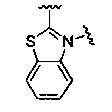 | O | Zn |
| **88** | 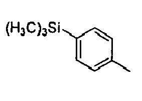 | H | H | H | 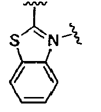 | O | Zn |
| **89** | H | H | 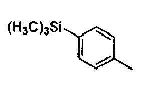 | H | 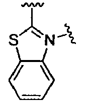 | O | Zn |
| **90** | H | H | H | 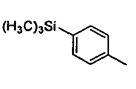 | 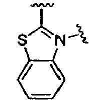 | O | Zn |
| **91** | H | H | 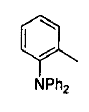 | H | 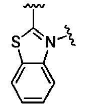 | O | OZn |
| **92** | H | 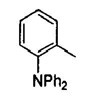 | H | H | 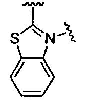 | O | OZn |
| **93** | H | H | H | 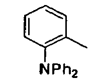 | 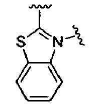 | O | Zn |
| **94** | 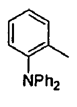 | H | H | H | 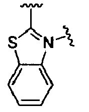 | O | Zn |
| **95** | 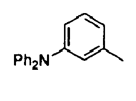 | H | H | H | 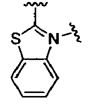 | O | Zn |
| **96** | H | 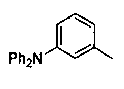 | H | H | 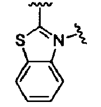 | O | Zn |
| **97** | H | H | 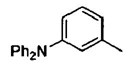 | H | 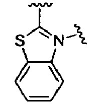 | O | Zn |
| **98** | H | H | H | 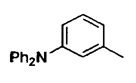 | 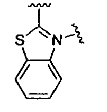 | O | Zn |
| **99** | H | H | 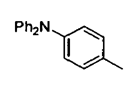 | H | 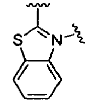 | O | Zn |
| **100** | H | 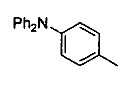 | H | H | 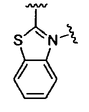 | O | Zn |
| **101** | H | H | H | 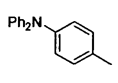 | 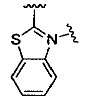 | O | Zn |
| **102** | 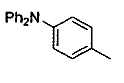 | H | H | H | 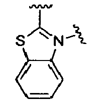 | O | Zn |
| **103** | H | 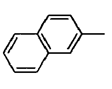 | H | H | 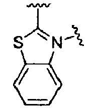 | O | Zn |
| **104** | H | H | 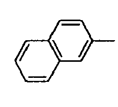 | H | 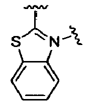 | O | Zn |
| **105** | 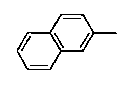 | H | H | H | 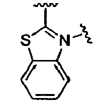 | O | Zn |
| **106** | H | H | H | 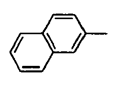 | 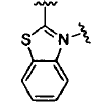 | O | Zn |
| **107** | H | H | 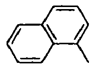 | H | 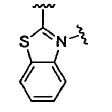 | O | Zn |
| **108** | H | H | H | 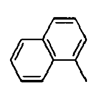 | 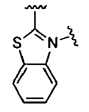 | O | Zn |
| **109** | H | 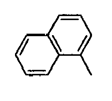 | H | H | 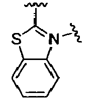 | O | Zn |
| **110** | 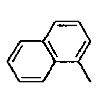 | H | H | H | 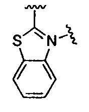 | O | Zn |
| **111** | H | 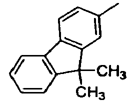 | H | H | 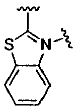 | O | Zn |
| **112** | H | H | 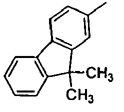 | H | 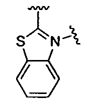 | O | Zn |
| **113** | 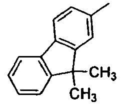 | H | H | H | 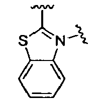 | O | Zn |
| **114** | H | H | H | 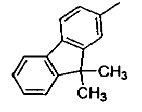 | 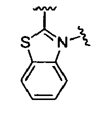 | O | Zn |
| **115** | H | 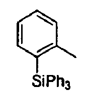 | H | H | 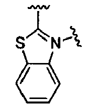 | O | Zn |
| **116** | H | H | 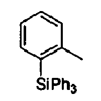 | H | 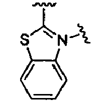 | O | Zn |
| **117** | 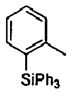 | H | H | H | 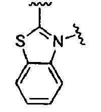 | O | Zn |
| **118** | H | H | H | 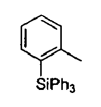 | 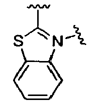 | O | Zn |
| **119** | H | H | 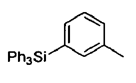 | H | 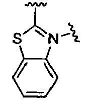 | O | Zn |
| **120** | H | H | H | 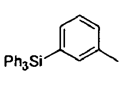 | 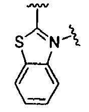 | O | Zn |
| **121** | H | 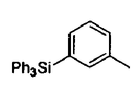 | H | H | 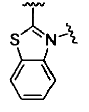 | O | Zn |
| **122** | 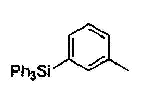 | H | H | H | 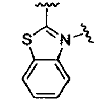 | O | Zn |
| **123** | 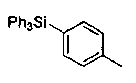 | H | H | H | 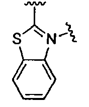 | O | Zn |
| **124** | H | 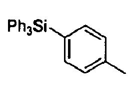 | H | H | 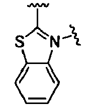 | O | Zn |
| **125** | H | H | 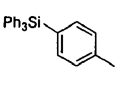 | H | 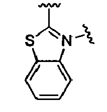 | O | Zn |
| **126** | H | H | H | 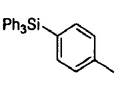 | 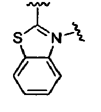 | O | Zn |
| **127** | H | H | -CH₃ | H | 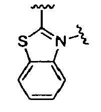 | O | Zn |
| **128** | H | -CH₃ | H | H | 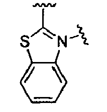 | O | Zn |
| **129** | H | H | H | -CH₃ | 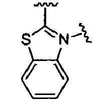 | O | Zn |
| **130** | -CH₃ | H | H | H | 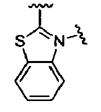 | O | Zn |
| **131** | H | -CH₃ | H | -CH₃ | 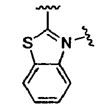 | O | Zn |
| **132** | -CH₃ | H | -CH₃ | H | 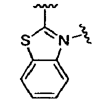 | O | Zn |
| **133** | H | -CH₃ | -CH₃ | H | 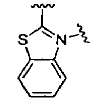 | O | Zn |
| **134** | H | H | -CH₃ | -CH₃ | 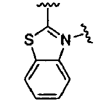 | O | Zn |
| **135** | -CH₃ | -CH₃ | H | H | 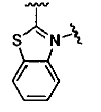 | O | Zn |
| **136** | -CH₃ | H | H | -CH₃ | 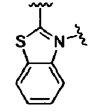 | O | Zn |
| **137** | -C(CH₃)₃ | H | H | H | 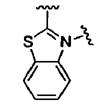 | O | Zn |
| **138** | H | -C(CH₃)₃ | H | H | 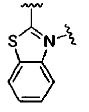 | O | Zn |
| **139** | H | H | -C (CH₃)₃ | H | 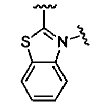 | O | Zn |
| **140** | H | H | H | -C(CH₃)₃ | 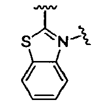 | O | Zn |
| **141** | 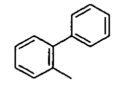 | H | H | H | 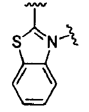 | O | Zn |
| **142** | H | H | 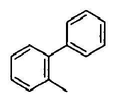 | H | 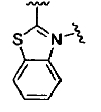 | O | Zn |
| **143** | H | H | H | 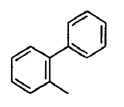 | 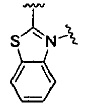 | O | Zn |
| **144** | H | 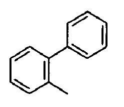 | H | H | 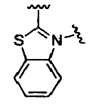 | O | Zn |
| **145** | H | -C(CH₃)₃ | H | -CH3 | 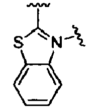 | O | Zn |
| **146** | H | -CH₃ | H | -C(CH₃)₃ | 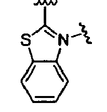 | O | Zn |
| **147** | H | 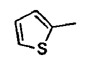 | H | H | 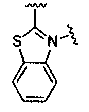 | O | Zn |
| **148** | H | H | 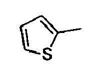 | H | 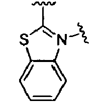 | O | Zn |
| **149** | H | 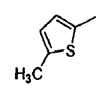 | H | H | 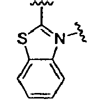 | O | Zn |
| **150** | H | H | 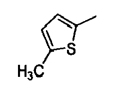 | H | 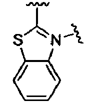 | O | Zn |
| **151** | H | 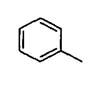 | H | -CH₃ | 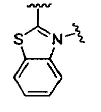 | O | Zn |
| **152** | H | -CH₃ | H | 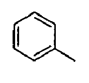 | 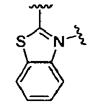 | O | Zn |
| **153** | 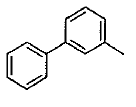 | H | H | H | 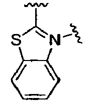 | O | Zn |
| **154** | H | 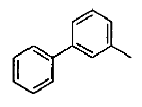 | H | H | 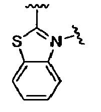 | O | Zn |
| **155** | H | H | 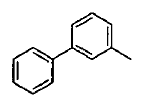 | H | 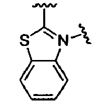 | O | Zn |
| **156** | H | H | H | 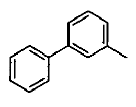 | 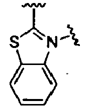 | O | Zn |
| **157** | H | H | 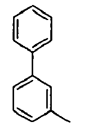 | H | 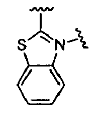 | O | Zn |
| **158** | H | 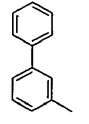 | H | H | 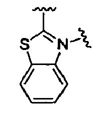 | O | Zn |
| **159** | H | H | H | 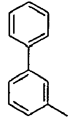 | 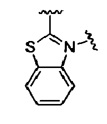 | O | Zn |
| **160** | 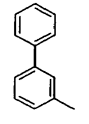 | H | H | H | 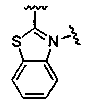 | O | Zn |
| **161** | H | H | H | H | 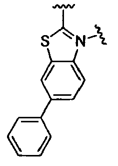 | O | Zn |
| **162** | H | H | H | H | 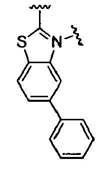 | O | Zn |
| **163** | H | H | H | H | 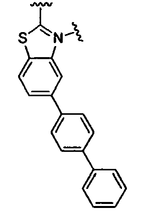 | O | Zn |
| **164** | H | H | H | H | 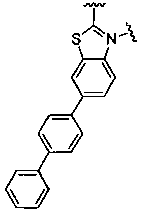 | O | Zn |
| **165** | H | H | H | H | 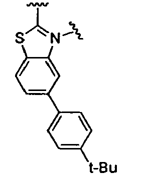 | O | Zn |
| **166** | H | H | H | H | 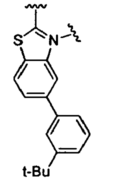 | O | Zn |
| **167** | H | H | H | H | 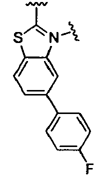 | O | Zn |
| **168** | H | H | H | H | 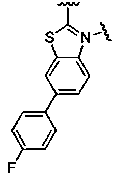 | O | Zn |
| **169** | H | H | H | H | 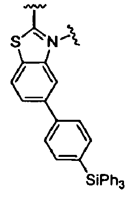 | O | Zn |
| **170** | H | H | H | H | 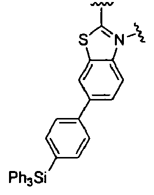 | O | Zn |
| **171** | H | H | H | H | 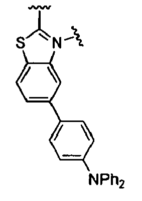 | O | Zn |
| **172** | H | H | H | H | 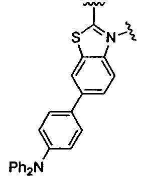 | O | Zn |
| **173** | H | H | H | H | 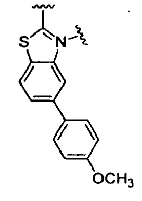 | O | Zn |
| **174** | H | H | H | H | 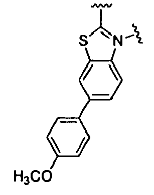 | O | Zn |
| **175** | H | H | H | H | 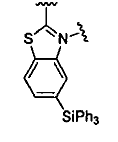 | O | Zn |
| **176** | H | H | H | H | 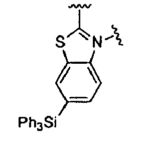 | O | Zn |
| **177** | H | H | H | H | 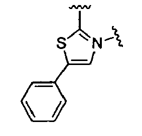 | O | Zn |
| **178** | H | 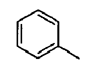 | H | H | 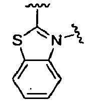 | S | Zn |
| **179** | 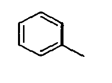 | H | H | H | 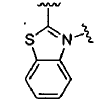 | S | Zn |
| **180** | H | H | 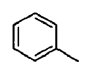 | H | 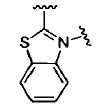 | S | Zn |
| **181** | H | H | H | 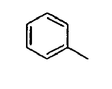 | 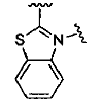 | S | Zn |
| **182** | H | 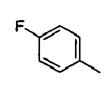 | H | H | 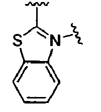 | S | Zn |
| **183** | H | H | 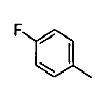 | H | 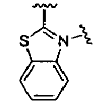 | S | Zn |
| **184** | H | H | H | 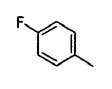 | 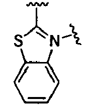 | S | Zn |
| **185** | 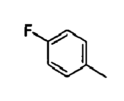 | H | H | H | 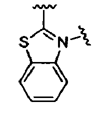 | S | Zn |
| **186** | H | 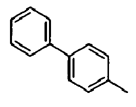 | H | H | 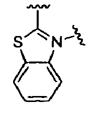 | S | Zn |
| **187** | 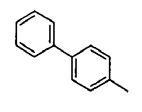 | H | H | H | 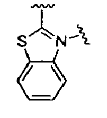 | S | Zn |
| **188** | H | H | 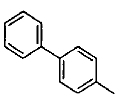 | H | 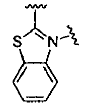 | S | Zn |
| **189** | H | H | H | 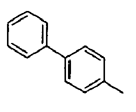 | 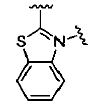 | S | Zn |
| **190** | H | H | 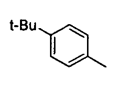 | H | 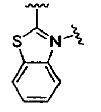 | S | Zn |
| **191** | H | 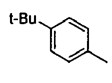 | H | H | 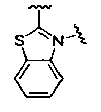 | S | Zn |
| **192** | H | H | 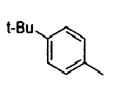 | H | 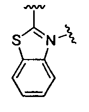 | S | Zn |
| **193** | 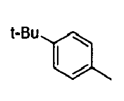 | H | H | H | 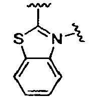 | S | Zn |
| **194** | H | H | 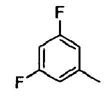 | H | 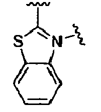 | S | Zn |
| **195** | H | 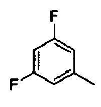 | H | H | 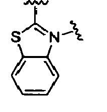 | S | Zn |
| **196** | H | H | H | 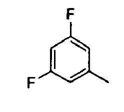 | 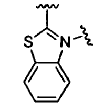 | S | Zn |
| **197** | 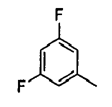 | H | H | H | 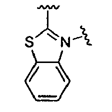 | S | Zn |
| **198** | H | 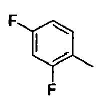 | H | H | 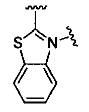 | S | Zn |
| **199** | H | H | H | 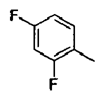 | 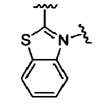 | S | Zn |
| **200** | H | H | 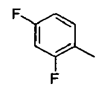 | H | 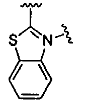 | S | Zn |
| **201** | 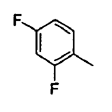 | H | H | H | 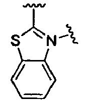 | S | Zn |
| **202** | 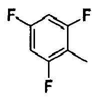 | H | H | H | 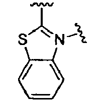 | S | Zn |
| **203** | H | 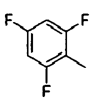 | H | H | 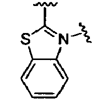 | S | Zn |
| **204** | H | H | H | 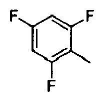 | 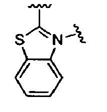 | S | Zn |
| **205** | H | H | 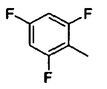 | H | 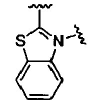 | S | Zn |
| **206** | 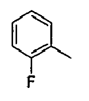 | H | H | H | 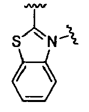 | S | Zn |
| **207** | H | 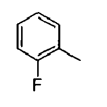 | H | H | 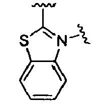 | S | Zn |
| **208** | H | H | 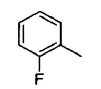 | H | 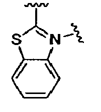 | S | Zn |
| **209** | H | H | H | 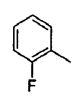 | 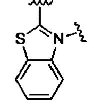 | S | Zn |
| **210** | H | 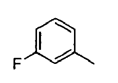 | H | H | 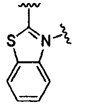 | S | Zn |
| **211** | H | H | 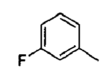 | H | 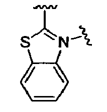 | S | Zn |
| **212** | H | H | H | 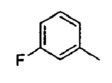 | 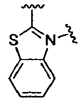 | S | Zn |
| **213** | 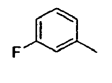 | H | H | H | 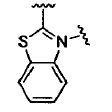 | S | Zn |
| **214** | H | 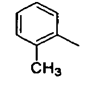 | H | H | 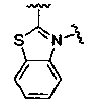 | S | Zn |
| **215** | H | H | 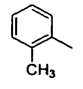 | H | 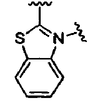 | S | Zn |
| **216** | 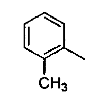 | H | H | H | 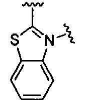 | S | Zn |
| **217** | H | H | H | 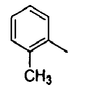 | 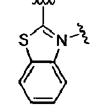 | S | Zn |
| **218** | H | 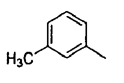 | H | H | 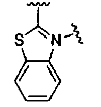 | S | Zn |
| **219** | H | H | 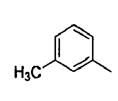 | H | 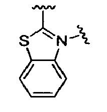 | S | Zn |
| **220** | H | H | H | 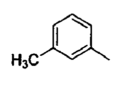 | 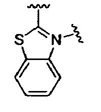 | S | Zn |
| **221** | 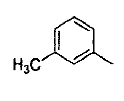 | H | H | H | 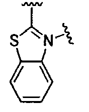 | S | Zn |
| **222** | 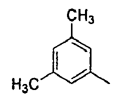 | H | H | H | 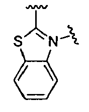 | S | Zn |
| **223** | H | 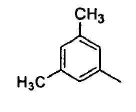 | H | H | 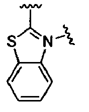 | S | Zn |
| **224** | H | H | 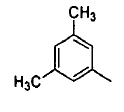 | H | 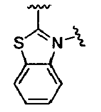 | S | Zn |
| **225** | H | H | H | 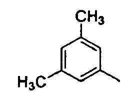 | 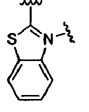 | S | Zn |
| **226** | H | 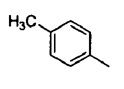 | H | H | 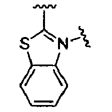 | S | Zn |
| **227** | H | H | 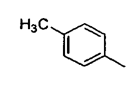 | H | 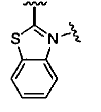 | S | Zn |
| **228** | 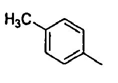 | H | H | H | 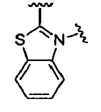 | S | Zn |
| **229** | H | H | H | 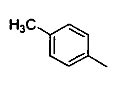 | 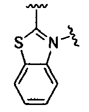 | S | Zn |
| **230** | H | H | 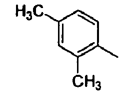 | H | 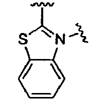 | S | Zn |
| **231** | H | 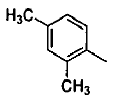 | H | H | 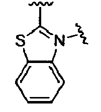 | S | Zn |
| **232** | 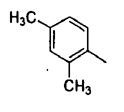 | H | H | H | 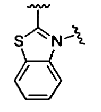 | S | Zn |
| **233** | H | H | H | 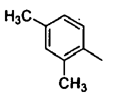 | 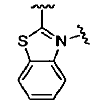 | S | Zn |
| **234** | H | 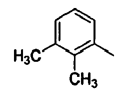 | H | H | 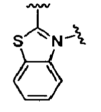 | S | Zn |
| **235** | H | H | 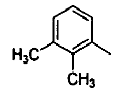 | H | 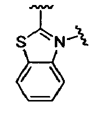 | S | Zn |
| **236** | 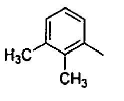 | H | H | H | 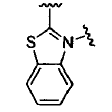 | S | Zn |
| **237** | H | H | H | 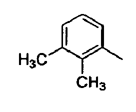 | 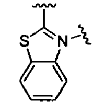 | S | Zn |
| **238** | 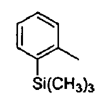 | H | H | H | 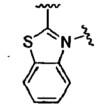 | S | Zn |
| **239** | H | H | 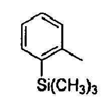 | H | 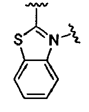 | S | Zn |
| **240** | H | 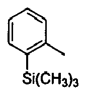 | H | H | 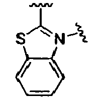 | S | Zn |
| **241** | H | H | H | 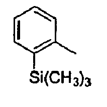 | 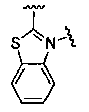 | S | Zn |
| **242** | H | 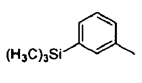 | H | H | 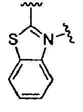 | S | Zn |
| **243** | H | H | 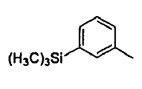 | H | 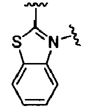 | S | Zn |
| **244** | H | H | H | 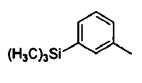 | 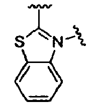 | S | Zn |
| **245** | 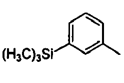 | H | H | H | 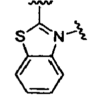 | S | Zn |
| **246** | H | 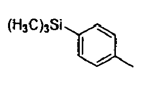 | H | H | 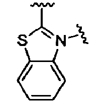 | S | Zn |
| **247** | 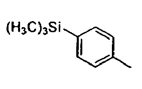 | H | H | H | 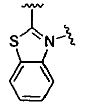 | S | Zn |
| **248** | H | H | 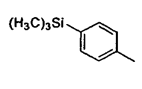 | H | 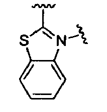 | S | Zn |
| **249** | H | H | H | 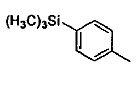 | 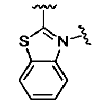 | S | Zn |
| **250** | H | H | 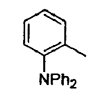 | H | 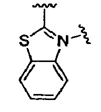 | S | Zn |
| **251** | H | 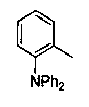 | H | H | 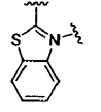 | S | Zn |
| **252** | H | H | H | 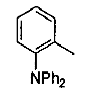 | 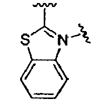 | S | Zn |
| **253** | 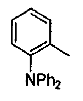 | H | H | H | 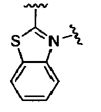 | S | Zn |
| **254** | 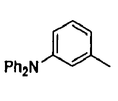 | H | H | H | 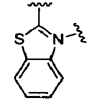 | S | Zn |
| **255** | H | 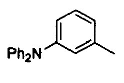 | H | H | 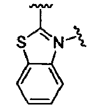 | S | Zn |
| **256** | H | H | 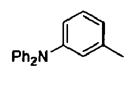 | H | 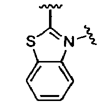 | S | Zn |
| **257** | H | H | H | 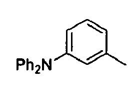 | 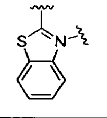 | S | Zn |
| **258** | H | H | 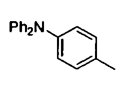 | H | 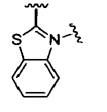 | S | Zn |
| **259** | H | 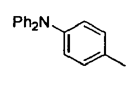 | H | H | 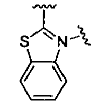 | S | Zn |
| **260** | H | H | H | 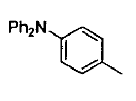 | 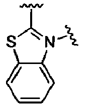 | S | Zn |
| **261** | 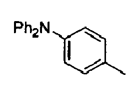 | H | H | H | 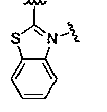 | S | Zn |
| **262** | H | 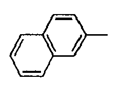 | H | H | 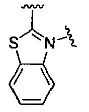 | S | Zn |
| **263** | H | H | 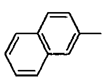 | H | 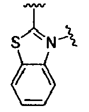 | S | Zn |
| **264** | 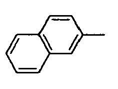 | H | H | H | 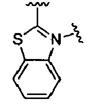 | S | Zn |
| **265** | H | H | H | 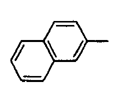 | 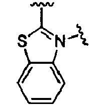 | S | Zn |
| **266** | H | H | 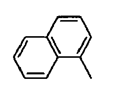 | H | 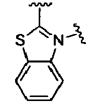 | S | Zn |
| **267** | H | H | H | 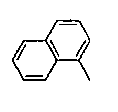 | 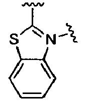 | S | Zn |
| **268** | H | 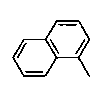 | H | H | 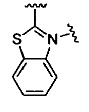 | S | Zn |
| **269** | 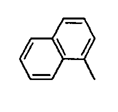 | H | H | H | 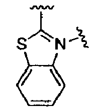 | S | Zn |
| **270** | H | 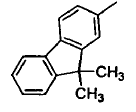 | H | H | 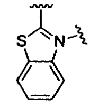 | S | Zn |
| **271** | H | H | 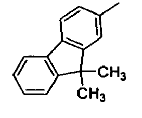 | H | 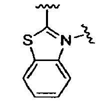 | S | Zn |
| **272** | 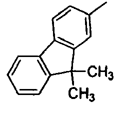 | H | H | H | 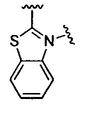 | S | Zn |
| **273** | H | H | H | 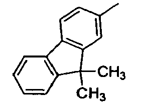 | 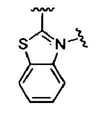 | S | Zn |
| **274** | H | 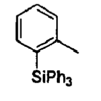 | H | H | 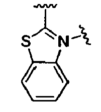 | S | Zn |
| **275** | H | H | 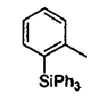 | H | 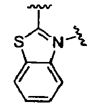 | S | Zn |
| **276** | 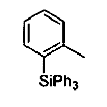 | H | H | H | 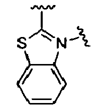 | S | Zn |
| **277** | H | H | H | 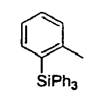 | 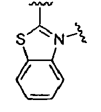 | S | Zn |
| **278** | H | H | 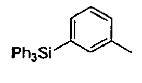 | H | 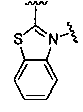 | S | Zn |
| **279** | H | H | H | 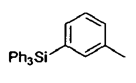 | 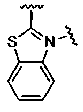 | S | Zn |
| **280** | H | 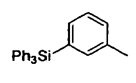 | H | H | 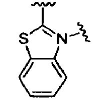 | S | Zn |
| **281** | 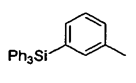 | H | H | H | 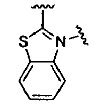 | S | Zn |
| **282** | 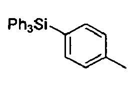 | H | H | H | 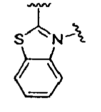 | S | Zn |
| **283** | H | 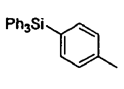 | H | H | 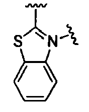 | S | Zn |
| **284** | H | H | 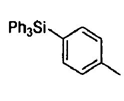 | H | 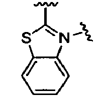 | S | Zn |
| **285** | H | H | H | 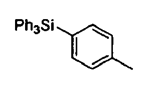 | 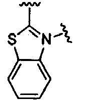 | S | Zn |
| **286** | H | H | -CH₃ | H | 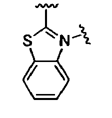 | S | Zn |
| **287** | H | -CH₃ | H | H | 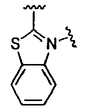 | S | Zn |
| **288** | H | H | H | -CH₃ | 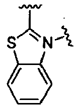 | S | Zn |
| **289** | -CH₃ | H | H | H | 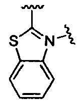 | S | Zn |
| **290** | H | -CH₃ | H | -CH₃ | 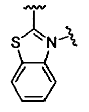 | S | Zn |
| **291** | -CH₃ | H | -CH₃ | H | 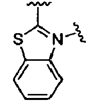 | S | Zn |
| **292** | H | -CH₃ | -CH₃ | H | 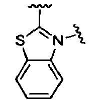 | S | Zn |
| **293** | H | H | -CH₃ | -CH₃ | 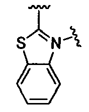 | S | Zn |
| **294** | -CH₃ | -CH₃ | H | H | 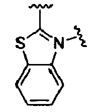 | S | Zn |
| **295** | -CH₃ | H | H | -CH₃ | 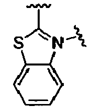 | S | Zn |
| **296** | -C(CH₃)₃ | H | H | H | 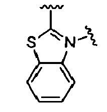 | S | Zn |
| **297** | H | -C(CH₃)₃ | H | H | 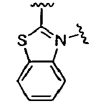 | S | Zn |
| **298** | H | H | -C(CH₃)₃ | H | 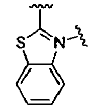 | S | Zn |
| **299** | H | H | H | -C(CH₃)₃ | 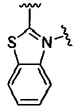 | S | Zn |
| **300** | 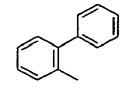 | H | H | H | 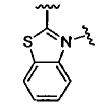 | S | Zn |
| **301** | H | H | 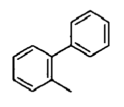 | H | 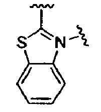 | S | Zn |
| **302** | H | H | H | 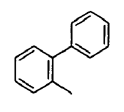 | 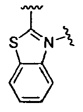 | S | Zn |
| **303** | H | 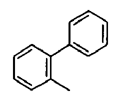 | H | H | 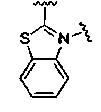 | S | Zn |
| **304** | H | -C(CH₃)₃ | H | -CH₃ | 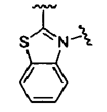 | S | Zn |
| **305** | H | -CH₃ | H | -C(CH₃)₃ | 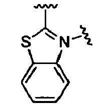 | S | Zn |
| **306** | H | 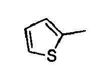 | H | H | 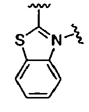 | S | Zn |
| **307** | H | H | 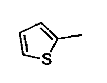 | H | 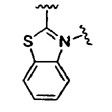 | S | Zn |
| **308** | H | 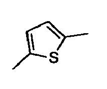 | H | H | 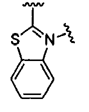 | S | Zn |
| **309** | H | H | 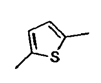 | H | 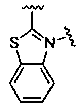 | S | Zn |
| **310** | H | 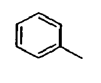 | H | -CH₃ | 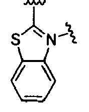 | S | Zn |
| **311** | H | -CH₃ | H | 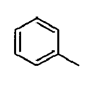 | 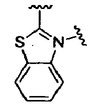 | S | Zn |
| **312** | 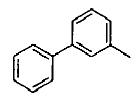 | H | H | H | 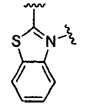 | S | Zn |
| **313** | H | 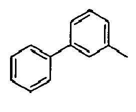 | H | H | 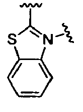 | S | Zn |
| **314** | H | H | 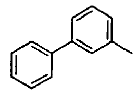 | H | 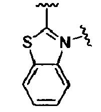 | S | Zn |
| **315** | H | H | H | 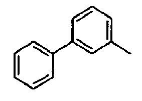 | 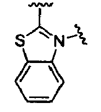 | S | Zn |
| **316** | H | H | 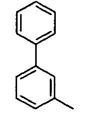 | H | 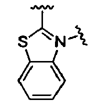 | S | Zn |
| **317** | H | 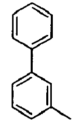 | H | H | 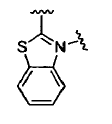 | S | Zn |
| **318** | H | H | H | 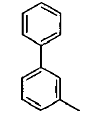 | 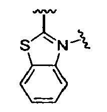 | S | Zn |
| **319** | 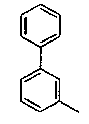 | H | H | H | 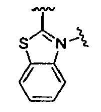 | S | Zn |
| **320** | H | H | H | H | 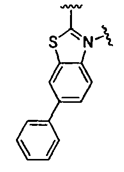 | S | Zn |
| **321** | H | H | H | H | 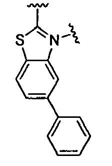 | S | Zn |
| **322** | H | H | H | H | 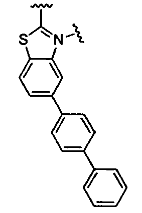 | S | Zn |
| **323** | H | H | H | H | 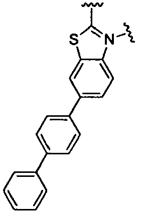 | S | Zn |
| **324** | H | H | H | H | 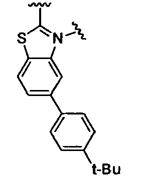 | S | Zn |
| **325** | H | H | H | H | 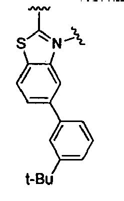 | S | Zn |
| **326** | H | H | H | H | 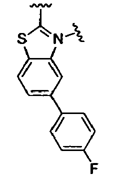 | S | Zn |
| **327** | H | H | H | H | 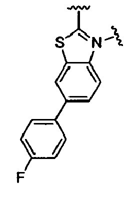 | S | Zn |
| **328** | H | H | H | H | 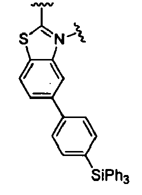 | S | Zn |
| **329** | H | H | H | H | 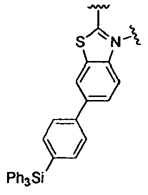 | S | Zn |
| **330** | H | H | H | H | 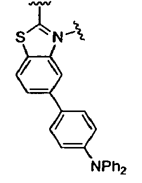 | S | Zn |
| **331** | H | H | H | H | 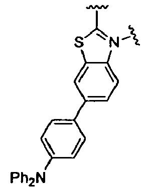 | S | Zn |
| **332** | H | H | H | H | 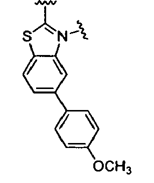 | S | Zn |
| **333** | H | H | H | H | 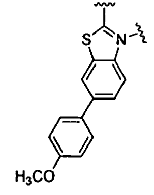 | S | Zn |
| **334** | H | H | H | H | 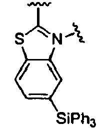 | S | Zn |
| **335** | H | H | H | H | 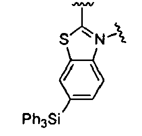 | S | Zn |
| **336** | H | H | H | H | 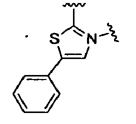 | S | Zn |

**Table 2**

| Comp. No. | ¹H NMR(CDCl₃, 200 MHz) | MS/FAB | |
|---|---|---|---|
| | | found | calculated |
| **19** | δ = 6.85(d, 2H), 7.22-7.32(m, 8H), 7.48-7.55(m, 10H), 8.12-8.23(dd, 4H) | 668.1 | 670.1 |
| **21** | δ = 6.85(m, 2H), 7.27-7.38(m, 8H), 7.54-7.67(m, 14H), 8.13-8.25(m, 4H) | 668.1 | 670.1 |
| **23** | δ = 6.85(m, 2H), 7.27-7.32(m, 8H), 7.48-7.55(m, 18H), 8.12-8.23(m, 4H) | 704.0 | 706.1 |
| **25** | δ = 7.03-7.10(m, 8H), 7.37(m, 2H), 7.46-7.55(m, 8H), 8.12-8.25(m, 4H) | 704.0 | 706.1 |
| **27** | δ = 6.85(m, 2H), 7.27-7.32(m, 8H), 7.48-7.55(m, 18H), 8.12-8.23(m, 4H) | 820.1 | 822.3 |
| **29** | δ = 7.05(m, 2H), 7.10(m, 2H), 7.22(m, 2H), 7.32-7.37(m, 6H), 7.46-7.56(m, 16H), 8.12(d, 2H), 8.23(d, 2H) | 820.1 | 822.3 |
| **32** | δ = 1.34(s, 18H), 6.85(m, 2H), 7.27(m, 2H), 7.35-7.40(m, 8H), 7.53-7.56(m, 6H), 8.12-8.23(dd, 4H) | 780.2 | 782.3 |
| **33** | δ = 1.34(s, 18H), 7.01-7.10(m, 4H), 7.35-7.40(m, 10H), 7.55(m, 4H), 8.14-8.25(m, 4H) | 780.2 | 782.3 |
| **36** | δ = 6.64(m, 2H), 6.85(m, 2H), 6.96(m, 4H), 7.27(m, 2H), 7.53-7.55(m, 6H), 8.24-8.25(m, 4H) | 740.0 | 742.1 |
| **39** | δ = 6.74-6.85(m, 6H), 7.27(m, 2H), 7.44(m, 2H), 7.53-7.55(m, 6H), 8.12-8.23(m, 4H) | 740.0 | 742.1 |
| **44** | δ = 6.51(m, 4H), 6.85(m, 2H), 7.27(m, 2H), 7.52-7.54(m, 6H), 8.12(m, 2H), 8.24(m, 2H) | 776.0 | 778.1 |
| **99** | δ = 6.46-6.52(m, 12H), 6.62(m, 4H), 7.01(m, 12H), 7.23(m, 4H), 7.37(m, 2H), 7.55(m, 4H), 8.12(m, 2H), 8.23(m, 2H) | 1002.2 | 1004.5 |
| **100** | δ = 6.46-6.52(m, 12H), 6.62(m, 4H), 6.85(m, 2H), 7.01(m, 8H), 7.23-7.27(m, 6H), 7.53-7.55(m, 6H), 8.23-8.25(m, 4H) | 1002.2 | 1004.5 |
| **103** | δ = 6.85(m, 2H), 7.27-7.32(m, 6H), 7.52-7.56(m, 8H), 7.67-7.73(m, 6H), 7.89(m, 2H), 8.12-8.23(m, 4H) | 768.1 | 770.2 |
| **109** | δ = 6.85(m, 2H), 7.27-7.38(m, 8H), 7.54-7.67(m, 14H), 8.13-8.25(m, 4H) | 768.1 | 770.2 |
| **111** | δ = 1.67(s, 12H), 7.27-7.28(m, 4H), 7.38(m, 2H), 7.55-7.60(m, 10H), 7.77(m, 2H), 7.84-7.90(m, 4H), 8.13-8.25(m, 4H) | 900.2 | 902.4 |
| **124** | δ = 6.85(m, 2H), 7.27(m, 2H), 7.36(m, 18H), 7.53-7.60(m, 26H), 8.15-8.25(m, 4H) | 1184.2 | 1186.9 |
| **125** | δ = 7.01(s, 2H), 7.10(m, 2H), 7.36-7.37(m, 20H), 7.54-7.60(m, 24H), 8.12(d, 2H), 8.24(d, 2H) | 1184.2 | 1186.9 |
| **161** | δ = 6.79-6.88(m, 4H), 7.05(m, 2H), 7.22-7.32(m, 8H), 7.48(m, 4H), 7.77(m, 2H), 8.29-8.34(m, 4H) | 668.1 | 670.1 |
| **162** | δ = 6.79-6.88(m, 4H), 7.05(m, 2H), 7.22-7.32(m, 8H), 7.48(m, 4H), 7.77(m, 2H), 8.18(m, 2H), 8.45(m, 2H) | 668.1 | 670.1 |
| **163** | δ = 7.79(m, 2H), 6.88(m, 2H), 7.05(m, 2H), 7.31-7.32(m, 8H), 7.48-7.54(m, 12H), 7.77(m, 2H), 8.18(m, 2H), 8.43(m, 2H) | 820.1 | 822.3 |
| **164** | δ = 6.78-6.80(m, 4H), 7.04(m, 2H), 7.22(m, 2H), 7.31-7.32(m, 6H), 7.48-7.54(m, 12H), 7.77(m, 2H), 8.30-8.33(m, 4H) | 820.1 | 822.3 |
| **165** | δ = 1.36(s, 18H), 6.78-6.89(m, 4H), 7.05(m, 2H), 7.31-7.40(m, 10H), 7.78(m, 2H), 8.20(m, 2H), 8.50(m, 2H) | 780.2 | 782.3 |
| **166** | δ = 1.34(s, 18H), 6.70(m, 2H), 6.88(m, 2H), 7.07(m, 2H), 7.31-7.40(m, 10H), 7.77(m, 2H), 8.28-8.32(m, 4H) | 780.2 | 782.3 |
| **167** | δ = 6.80-6.90(m, 4H), 7.03-7.05(m, 6H), 7.31(m, 2H), 7.46(m, 4H), 7.77(m, 2H), 8.18(m, 2H), 8.45(m, 2H) | 704.0 | 706.1 |
| **168** | δ = 6.80-6.90(m, 4H), 7.03-7.08(m, 6H), 7.31(m, 2H), 7.46(m, 4H), 7.77(m, 2H), 8.29-8.34(m, 4H) | 704.0 | 706.1 |
| **169** | δ = 6.79(m, 2H), 6.88(m, 2H), 7.05(m, 2H), 7.31-7.36(m, 20H), 7.54-7.60(m, 20H), 7.77(m, 2H), 8.18(m, 2H), 8.46(m, 2H) | 1184.2 | 1186.9 |
| **170** | δ = 6.79(m, 2H), 6.88(m, 2H), 7.05(m, 2H), 7.31-7.36(m, 20H), 7.54-7.60(m, 20H), 7.77(m, 2H), 8.30-8.34(m, 4H) | 1184.2 | 1186.9 |
| **171** | δ = 6.46-6.52(m, 12H), 6.62(m, 4H), 6.79(m, 2H), 6.88(m, 2H), 7.01-7.05(m, 10H), 7.23-7.31(m, 6H), 7.77(m, 2H), 8.18(m, 2H), 8.46(m, 2H) | 1002.2 | 1004.5 |
| **172** | δ = 6.46-6.52(m, 12H), 6.62(m, 4H), 6.79-6.88(m, 4H), 7.01-7.05(m, 10H), 7.23(m, 4H), 7.31(m, 2H), 7.77(m, 2H), 8.30-8.34(m, 4H) | 1002.2 | 1004.5 |
| **178** | δ = 8.23 (d, 2H), 8.13(d, 2H), 7.55-7.20(m, 20H) | 700.1 | 700.0 |
| **191** | δ =1.34(s, 18H), 7.28-7.30(m, 4H), 7.35-7.40(m, 4H), 7.54(m, 6H), 8.12(m, 2H), 8.23(m, 2H) | 814.1 | 812.1 |
| **194** | δ =6.64(m, 2H), 6.96(m, 4H), 7.32-7.38(m, 4H), 7.55(m, 4H), 8.12(m, 2H), 8.23(m, 2H) | 773.9 | 771.9 |
| **223** | δ =2.35(s, 12H), 6.82(d, 2H), 7.09(s, 4H), 7.28-7.30(m, 4H), 7.55(m, 6H), 8.15-8.24(m, 4H) | 758.0 | 756.1 |
| **259** | δ =6.46-6.52(m, 12H), 6.62(m, 4H), 7.02(m, 8H), 7.24-7.30(m, 8H), 7.56(m, 6H), 8.13(t, 2H), 8.23(t, 2H) | 1035.1 | 1034.2 |
| **283** | δ =7.30-7.36(m, 22H), 7.54-7.60(m, 26H), 8.12(m, 2H), 8.24(m, 2H) | 1219.2 | 1216.3 |
| **287** | δ =2.34(s, 6H), 6.86(m, 2H), 7.12(d, 4H), 7.57(m, 4H), 8.13-8.25(m, 4H) | 577.9 | 575.9 |
| **291** | δ =2.36(s, 12H), 6.70(s, 2H), 6.85(s, 2H), 7.55(m, 4H), 8.14-8.25(m, 4H) | 606.0 | 604.5 |
| **311** | δ =2.36(s, 6H), 7.08(s, 4H), 7.22(m, 2H), 7.32(m, 4H), 7.48(m, 8H), 8.20(m, 4H) | 730.0 | 728.4 |
| **320** | δ =7.06-7.10(m, 4H), 7.24-7.32(m, 10H), 7.48(m, 4H), 7.77(m, 2H), 8.29-8.34(m, 4H) | 702.1 | 700.1 |
| **336** | δ =7.06-7.12(m, 4H), 7.22-7.34(m, 10H), 7.48(m, 4H), 8.00(s, 2H) | 601.9 | 599.9 |

### [Preparation Example 3] Preparation of Compound (337)

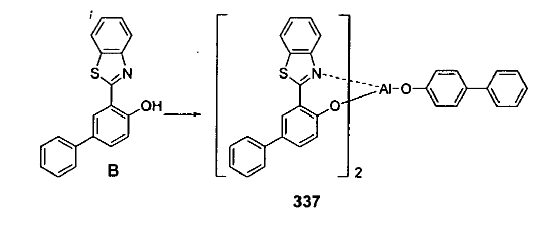

Compound (B) (4.5 g, 14.8 mmol) and aluminum isopropoxide (3.0 g, 14.8 mmol) were dissolved in chloroform (50. mL)/isopropyl alcohol (150 mL), and the solution was stirred at 60°C for 3 hours. When the solution became clear, 4-phenylphenol (3.0 g, 17.8 mmol) was added thereto, and the resultant mixture was stirred under reflux at 80°C for 3 hours. Then, Compound (B) (4.5 g, 14.8 mmol) was added thereto, and the mixture was stirred under reflux for 12 hours. When the reaction was completed, the reaction mixture was cooled to room temperature, and the solid produced was obtained by filtration under reduced pressure. The solid was then sequentially washed with isopropyl alcohol (500 mL), methanol (300 mL) and ethyl ether (250 mL), to obtain the title compound (337) (3.8 g, 7.6 mmol, 51%).

According to the same procedure as Preparation Example 21, Compounds 337 through 426 listed in Table 3 were prepared, of which the ¹H NMR and MS/FAB data are listed in Table 4. The compounds listed in Table 3 are those containing trivalent metal M.

**Table 3**

| L¹L²M(Q)_{y} | | | | | | | | | |
|---|---|---|---|---|---|---|---|---|---|
| 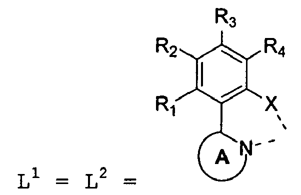 | | | | | | | M | Q | y |

| No. | R₁ | R₂ | R₃ | R₄ | 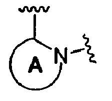 | X | | | |
|---|---|---|---|---|---|---|---|---|---|
| **337** | H | 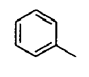 | H | H | 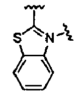 | O | Al | 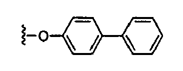 | 1 |
| **338** | 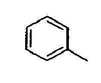 | H | H | H | 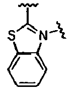 | O | Al | 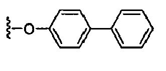 | 1 |
| **339** | H | H | 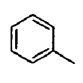 | H | 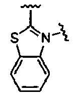 | O | Al | 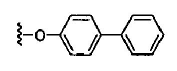 | 1 |
| **340** | H | H | H | 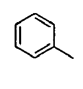 | 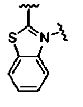 | O | Al | 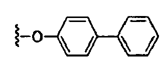 | 1 |
| **341** | H | 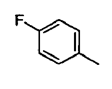 | H | H | 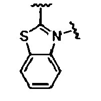 | O | Al | 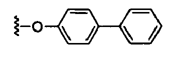 | 1 |
| **342** | H | H | 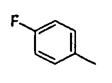 | H | 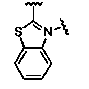 | O | Al | 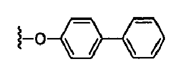 | 1 |
| **343** | H | H | H | 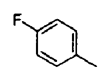 | 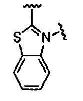 | O | Al | 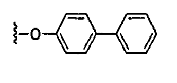 | 1 |
| **344** | 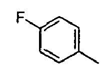 | H | H | H | 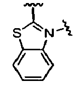 | O | Al | 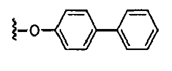 | 1 |
| **345** | H | 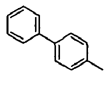 | H | H | 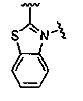 | O | Al | 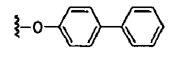 | 1 |
| **346** | 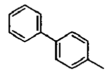 | H | H | H | 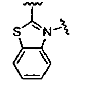 | O | Al | 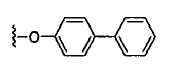 | 1 |
| **347** | H | H | 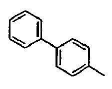 | H | 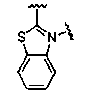 | O | Al | 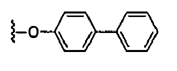 | 1 |
| **348** | H | H | H | 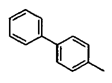 | 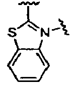 | O | Al | 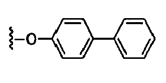 | 1 |
| **349** | H | H | 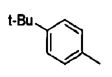 | H | 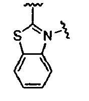 | O | Al | 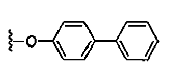 | 1 |
| **350** | H | 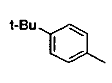 | H | H | 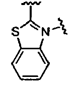 | O | Al | 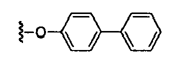 | 1 |
| **351** | H | H | 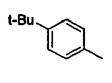 | H | 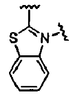 | O | Al | 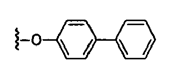 | 1 |
| **352** | 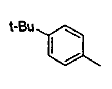 | H | H | H | 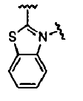 | O | Al | 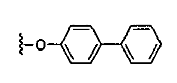 | 1 |
| **353** | H | 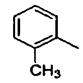 | H | H | 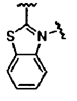 | O | Al | 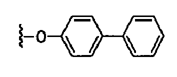 | 1 |
| **354** | H | H | 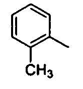 | H | 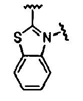 | O | Al | 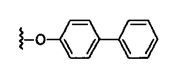 | 1 |
| **355** | 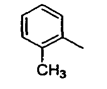 | H | H | H | 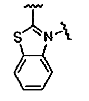 | O | Al | 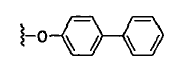 | 1 |
| **356** | H | H | H | 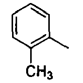 | 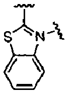 | O | Al | 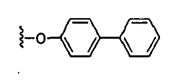 | 1 |
| **357** | H | 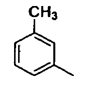 | H | H | 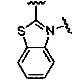 | O | Al | 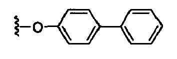 | 1 |
| **358** | H | H | 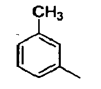 | H | 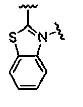 | O | Al | 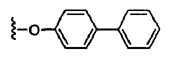 | 1 |
| **359** | H | H | H | 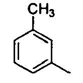 | 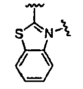 | O | Al | 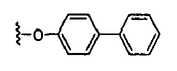 | 1 |
| **360** | 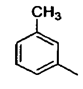 | H | H | H | 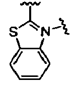 | O | Al | 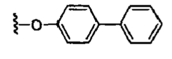 | 1 |
| **361** | 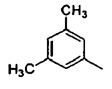 | H | H | H | 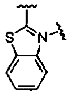 | O | Al | 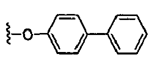 | 1 |
| **362** | H | 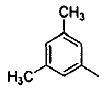 | H | H | 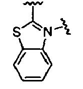 | O | Al | 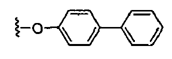 | 1 |
| **363** | H | H | 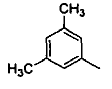 | H | 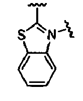 | O | Al | 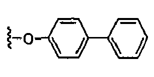 | 1 |
| **364** | H | H | H | 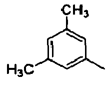 | 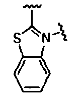 | O | Al | 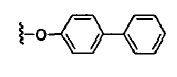 | 1 |
| **365** | H | 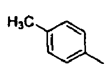 | H | H | 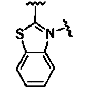 | O | Al | 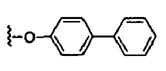 | 1 |
| **366** | H | H | 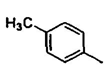 | H | 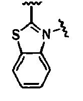 | O | Al | 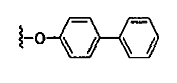 | 1 |
| **367** | 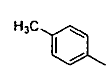 | H | H | H | 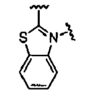 | O | Al | 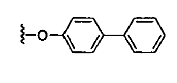 | 1 |
| **368** | H | H | H | 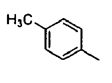 | 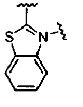 | O | Al | 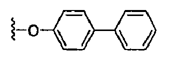 | 1 |
| **369** | H | H | 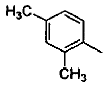 | H | 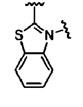 | O | Al | 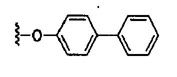 | 1 |
| **370** | H | 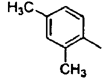 | H | H | 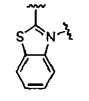 | O | Al | 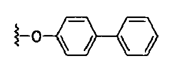 | 1 |
| **371** | 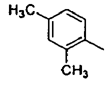 | H | H | H | 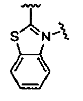 | O | Al | 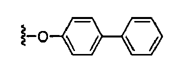 | 1 |
| **372** | H | H | H | 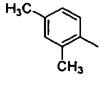 | 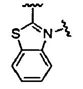 | O | Al | 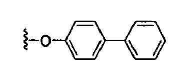 | 1 |
| **373** | H | 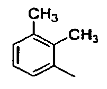 | H | H | 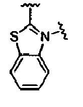 | O | Al | 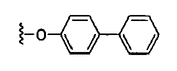 | 1 |
| **374** | H | H | 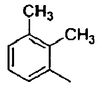 | H | 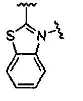 | O | Al | 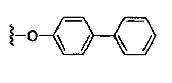 | 1 |
| **375** | 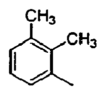 | H | H | H | 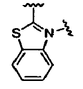 | O | Al | 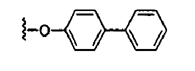 | 1 |
| **376** | H | H | H | 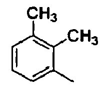 | 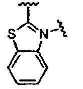 | O | Al | 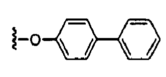 | 1 |
| **377** | H | 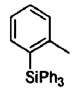 | H | H | 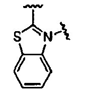 | O | Al | 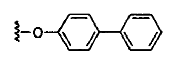 | 1 |
| **378** | H | H | 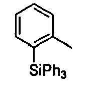 | H | 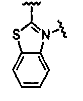 | O | Al | 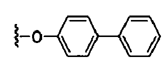 | 1 |
| **379** | 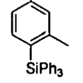 | H | H | H | 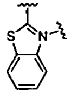 | O | Al | 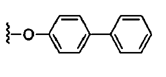 | 1 |
| **380** | H | H | H | 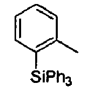 | 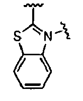 | O | Al | 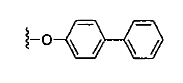 | 1 |
| **381** | H | H | 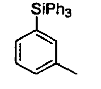 | H | 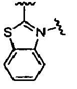 | O | Al | 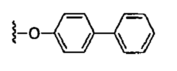 | 1 |
| **382** | H | H | H | 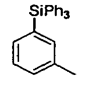 | 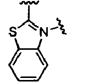 | O | Al | 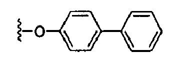 | 1 |
| **383** | H | 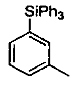 | H | H | 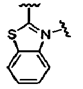 | O | Al | 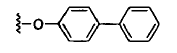 | 1 |
| **384** | 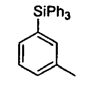 | H | H | H | 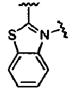 | O | Al | 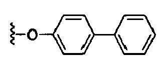 | 1 |
| **385** | 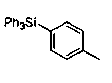 | H | H | H | 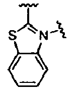 | O | Al | 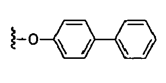 | 1 |
| **386** | H | 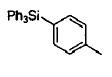 | H | H | 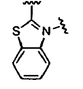 | O | Al | 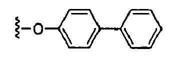 | 1 |
| **387** | H | H | 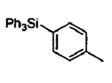 | H | 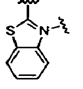 | O | Al | 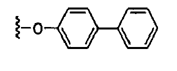 | 1 |
| **388** | H | H | H | 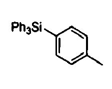 | 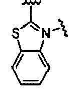 | O | Al | 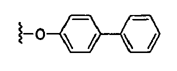 | 1 |
| **389** | H | H | 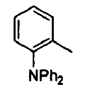 | H | 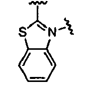 | O | Al | 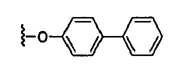 | 1 |
| **390** | H | 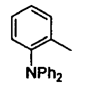 | H | H | 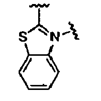 | O | Al | 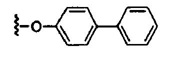 | 1 |
| **391** | H | H | H | 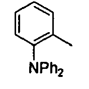 | 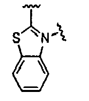 | O | Al | 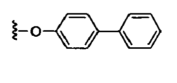 | 1 |
| **392** | 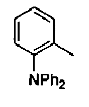 | H | H | H | 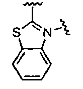 | O | Al | 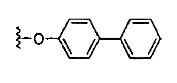 | 1 |
| **393** | 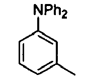 | H | 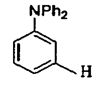 | H | 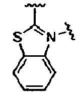 | O | Al | 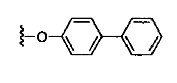 | 1 |
| **394** | H | 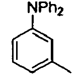 | H | H | 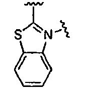 | O | Al | 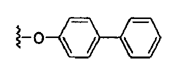 | 1 |
| **395** | H | H | 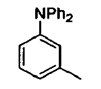 | H | 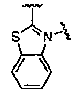 | O | Al | 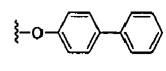 | 1 |
| **396** | H | H | H | 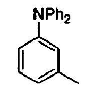 | 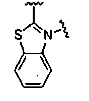 | O | Al | 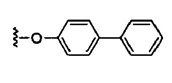 | 1 |
| **397** | H | H | 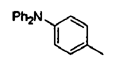 | H | 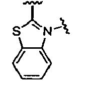 | O | Al | 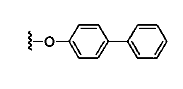 | 1 |
| **398** | H | 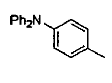 | H | H | 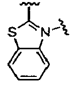 | O | Al | 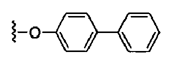 | 1 |
| **399** | H | H | H | 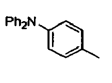 | 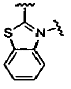 | O | Al | 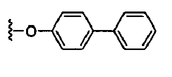 | 1 |
| **400** | 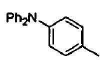 | H | H | H | 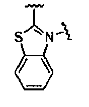 | O | Al | 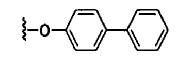 | 1 |
| **401** | H | H | H | H | 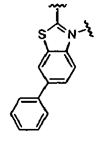 | O | Al | 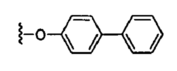 | 1 |
| **402** | H | H | H | H | 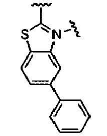 | O | Al | 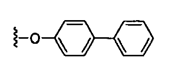 | 1 |
| **403** | H | H | H | H | 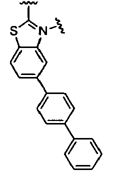 | O | Al | 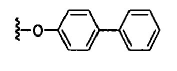 | 1 |
| **404** | H | H | H | H | 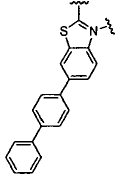 | O | Al | 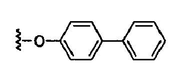 | 1 |
| **405** | H | H | H | H | 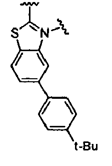 | O | Al | 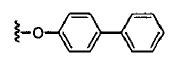 | 1 |
| **406** | H | H | H | H | 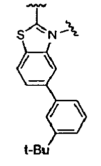 | O | Al | 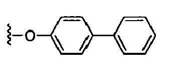 | 1 |
| **407** | H | H | H | H | 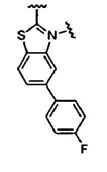 | O | Al | 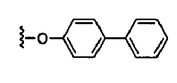 | 1 |
| **408** | H | H | H | H | 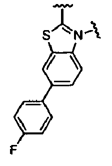 | O | Al | 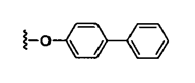 | 1 |
| **409** | H | H | H | H | 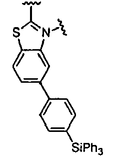 | O | Al | 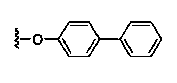 | 1 |
| **410** | H | H | H | H | 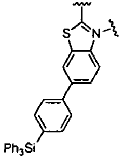 | O | Al | 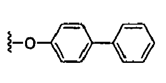 | 1 |
| **411** | H | H | H | H | 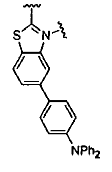 | O | Al | 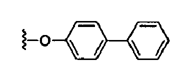 | 1 |
| **412** | H | H | H | H | 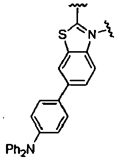 | O | Al | 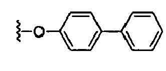 | 1 |
| **413** | H | H | H | H | 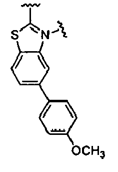 | O | Al | 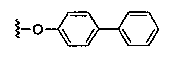 | 1 |
| **414** | H | H | H | H | 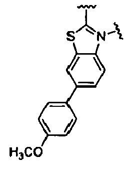 | O | Al | 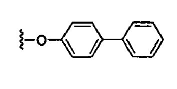 | 1 |
| **415** | H | H | H | H | 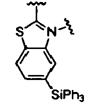 | O | Al | 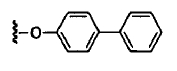 | 1 |
| **416** | H | H | H | H | 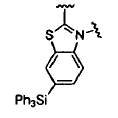 | O | Al | 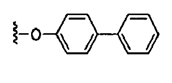 | 1 |
| **417** | H | H | H | H | 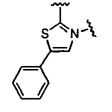 | O | Al | 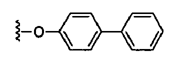 | 1 |
| **418** | H | 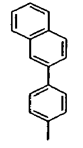 | H | H | 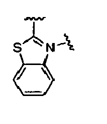 | O | Al | 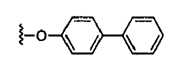 | 1 |
| **419** | H | 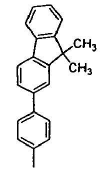 | H | H | 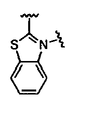 | O | Al | 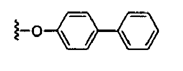 | 1 |
| **420** | H | H | 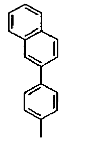 | H | 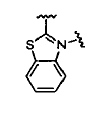 | O | Al | 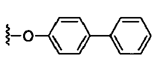 | 1 |
| **421** | H | H | 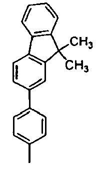 | H | 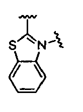 | O | Al | 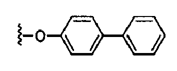 | 1 |
| **422** | H | 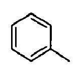 | H | H | 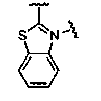 | O | Al | 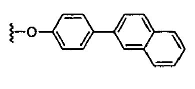 | 1 |
| **423** | H | 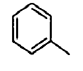 | H | H | 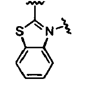 | O | Al | 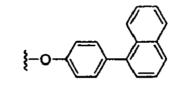 | 1 |
| **424** | H | 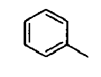 | H | H | 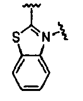 | O | Al | 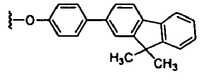 | 1 |
| **425** | H | 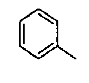 | H | H | 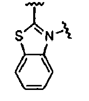 | O | Al | 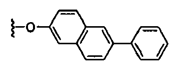 | 1 |
| **426** | H | 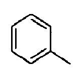 | H | H | 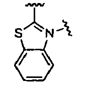 | O | Al | 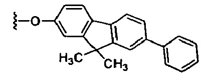 | 1 |

**Table 4**

| Comp. No. | ¹H NMR(CDCl₃, 200 MHz) | MS/FAB | |
|---|---|---|---|
| | | found | calculated |
| **337** | δ =6.79-6.85(m, 4H), 7.27-7.32(m, 18H), 7.48-7.56(m, 12H), 8.12-8.25(m, 4H) | 801.2 | 800.2 |
| **340** | δ =6.79-6.85(m, 4H), 7.03(m, 4H), 7.22-7.32(m, 7H), 7.46-7.56(m, 12H), 8.14-8.25(m, 4H) | 837.2 | 836.2 |
| **350** | δ =1.37(s, 18H), 6.79-6.90(m, 4H), 7.22-7.40(m, 15H), 7.48-7.55(m, 8H), 8.14-8.25(m, 4H) | 913.3 | 912.3 |
| **359** | δ =2.37(s, 6H), 6.79(d, 2H), 6.94-7.02(m, 4H), 7.20-7.32(m, 15H), 7.48-7.55(m, 6H), 8.15-8.23(m, 4H) | 829.2 | 828.2 |
| **362** | δ =2.38(s, 12H), 6.79-6.84(m, 6H), 7.09(s, 4H), 7.19-7.34(m, 7H), 7.48-7.54(m, 8H), 8.13-8.26(m, 4H) | 857.2 | 856.2 |
| **365** | δ =2.24(s, 6H), 6.85(m, 4H), 7.12(m, 4H), 7.28-7.32(m, 11H), 7.49-7.55(m, 8H), 8.21(m, 4H) | 829.2 | 828.2 |
| **398** | δ =6.46-6.52(m, 12H), 6.62(m, 4H), 6.80(m, 4H), 7.01(m, 8H), 7.20-7.33(m, 11H), 7.50-7.54(m, 8H), 8.10-8.20(m, 4H) | 1135.3 | 1134.3 |
| **401** | δ =6.79(m, 4H), 6.88(m, 2H), 7.05(m, 2H), 7.20-7.35(m, 13H), 7.48(m, 6H), 7.77(m, 2H), 8.29-8.34(m, 4H) | 800.9 | 800.1 |
| **416** | δ =6.79(m, 4H), 6.88(m, 2H), 7.05(m, 2H), 7.22(m, 1H), 7.31-7.36(m, 11H), 7.48-7.54(m, 14H), 7.83(m, 2H), 8.33(dd, 2H), 8.46(m, 2H) | 1165.5 | 1164.2 |
| **417** | δ =6.79(m, 4H), 6.88(m, 2H), 7.05(m, 2H), 7.22-7.32(m, 13H), 7.48(m, 6H), 8.01(s, 2H) | 700.8 | 700.1 |
| **422** | δ =6.79-6.85(m, 4H), 7.21-7.33(m, 12H), 7.50-7.55(m, 11H), 7.67-7.73(m, 3H), 7.89(s, 1H), 8.12-8.23(m, 4H) | 851.1 | 850.1 |
| **423** | δ =6.79-7.85(m, 4H), 7.25-7.38(m, 13H), 7.49-7.67(m, 14H), 8.13-8.21(m, 4H) | 851.1 | 850.1 |
| **424** | δ =1.67(s, 6H), 6.79-6.85(m, 4H), 7.22-7.38(m, 12H), 7.49-7.56(m, 12H), 7.77(d, 1H), 7.84-7.90(m, 2H), 8.12(m, 2H), 8.23(m, 2H) | 917.0 | 916.2 |
| **425** | δ =6.85(m, 2H), 6.97-6.98(m, 2H), 7.23-7.32(m, 11H), 7.48-7.62(m, 15H), 7.85(d, 1H), 8.13-8.25(m, 4H) | 850.9 | 850.1 |
| **426** | δ =1.68(s, 6H), 6.85(t, 3H), 7.02(d, 1H), 7.22-7.32(m, 11H), 7.48-7.67(m, 14H), 7.77(d, 1H), 7.90(d, 1H), 8.13-8.26(m, 4H) | 917.0 | 916.2 |

### [Example 1] Manufacture of an OLED

An OLED device was manufactured by using the red phosphorescent compounds according to the invention.

First, a transparent electrode ITO thin film (15 Ω/□) (2) prepared from glass for OLED (produced by Samsung Corning) (1) was subjected to ultrasonic washing with trichloroethylene, acetone, ethanol and distilled water, sequentially, and stored in isopropanol before use.

Then, an ITO substrate was equipped in a substrate folder of a vacuum vapor-deposit device, and 4,4',4"-tris(N,N-(2-naphthyl)-phenylamino)triphenylamine (2-TNATA) was placed in a cell of the vacuum vapor-deposit device, which was then ventilated up to 10⁻⁶ torr of vacuum in the chamber. Electric current was applied to the cell to evaporate 2-TNATA, thereby providing vapor-deposit of a hole injection layer (3) having 60 nm of thickness on the ITO substrate.

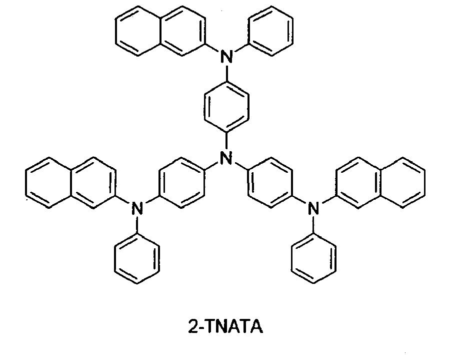

Then, to another cell of the vacuum vapor-deposit device, charged was N,N'-bis(α-naphthyl)-N,N'-diphenyl-4,4'-diamine (NPB), and electric current was applied to the cell to evaporate NPB, thereby providing vapor-deposit of a hole transport layer (4) of 20 nm of thickness on the hole injection layer.

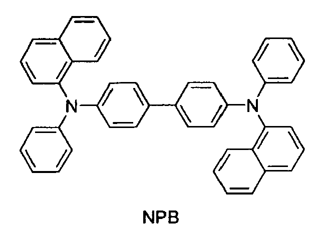

To another cell of said vacuum vapor-deposit device, charged was an electroluminescent host material according to the present invention (H-26), and a red phosphorescent compound according to the present invention (Compound D-4) was charged to still another cell. The two materials were evaporated at different rates to carry out doping, thereby vapor-depositing an electroluminescent layer (5) having 30 nm of thickness on the hole transport layer. Preferable doping concentration is from 4 to 10% by weight on the basis of the host.

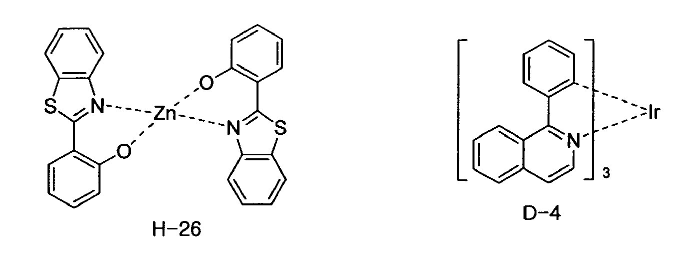

Then, tris(8-hydroxyquinoline)aluminum (III) (Alq) was vapor-deposited as an electron transport layer (6) with a thickness of 20 nm, and lithium quinolate (Liq) was vapor-deposited as an electron injection layer (7) with a thickness of 1 to 2 nm. Thereafter, an Al cathode (8) was vapor-deposited with a thickness of 150 nm by using another vacuum vapor-deposit device to manufacture an OLED.

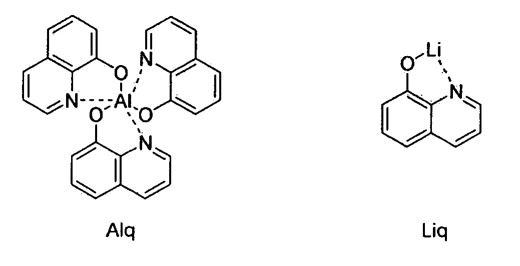

### [Comparative Example 1] Manufacture of an OLED by using conventional phosphorescent host

After forming a hole injection layer and hole transport layer according to the same procedure described in Example 1, an electroluminescent layer was vapor-deposited as follows.

To another cell of said vacuum vapor-deposit device, charged was 4,4'-N,N'-dicarbazole-biphenyl (CBP) as an electroluminescent host material, and a red phosphorescent compound according to the present invention (Compound D-4) was charged to still another cell. The two materials were evaporated at different rates to carry out doping, thereby vapor-depositing an electroluminescent layer (5) having 30 nm of thickness on the hole transport layer. Preferable doping concentration is from 4 to 10% by weight on the basis of CBP.

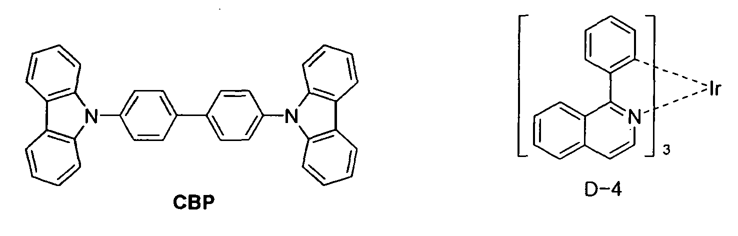

Then, bis(2-methyl-8-quinolinato)(p-phenylphenolato)aluminum (III) (BAlq) was vapor-deposited as a hole blocking layer on the electroluminescent layer, according to the same procedure for NPB, and tris(8-hydroxyquinoline)aluminum (III) (Alq) was then vapor-deposited as an electron transport layer (6) with a thickness of 20 nm. Thereafter, lithium quinolate (Liq) was vapor-deposited as an electron injection layer (7) with a thickness of 1 to 2 nm, and an Al cathode (8) was vapor-deposited thereon with a thickness of 150 nm by using another vacuum vapor-deposit device to manufacture an OLED.

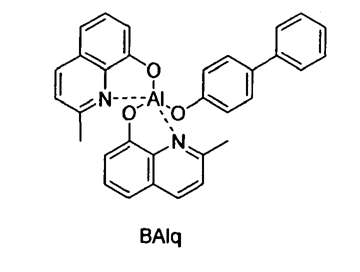

### [Experimental Example 1] Determination of properties of OLED's manufactured

In order to examine the performance of OLED's, luminous efficiencies of an OLED's of Example 1 comprising the electroluminescent compound according to the invention, and an OLED prepared from Comparative Example 1 comprising a conventional electroluminescent compound were measured at 10 mA/cm², and the results are shown in Table 5.

**Table 5**

| Material | Host | Hole blocking layer | EL color | Operation voltage | Max. luminous efficiency(cd/A) |
|---|---|---|---|---|---|
| D-4 | H-26 | - | Red | 7.5 | 7.8 |
| D-6 | H-25 | - | Red | 7.3 | 12.6 |
| D-10 | H-28 | - | Red | 7.5 | 8.4 |
| D-112 | H-30 | - | Red | 7.3 | 9.0 |
| D-113 | H-36 | - | Red | 7.1 | 11.4 |
| D-114 | H-57 | - | Red | 7.2 | 7.2 |
| D-115 | H-58 | - | Red | 7.0 | 11.6 |
| D-116 | H-59 | - | Red | 7.1 | 10.5 |
| D-117 | H-78 | - | Red | 7.4 | 13.6 |
| D-118 | Comp.19 | - | Red | 7.1 | 11.1 |
| D-119 | Comp.128 | - | Red | 7.4 | 12.3 |
| D-120 | Comp.133 | - | Red | 7.3 | 11.3 |
| D-121 | Comp.286 | - | Red | 7.1 | 11.7 |
| Comp.(D-4) | CBP | BAlq | Red | 8.3 | 6.5 |

By using the host and dopant according to the present invention, red phosphorescent EL devices having high efficiency of maximum 12.6 cd/A could be manufactured. When the host according to the present invention is used without using a hole blocking layer, the OLED manufactured shows comparable or superior efficiency to the device manufactured by using conventional phosphorescent EL host, CBP.

The device according to the invention can noticeably lower the power consumption of the OLED, with lowering the operation voltage by 0.9∼1.7 V.

If the invention is applied to mass production of OLED's, the time for mass production can be also shortened to give great benefit on the commercialization.

## Claims

1. An electroluminescent device comprised of a first electrode; a second electrode; and at least one organic layer(s) interposed between the first electrode and the second electrode;
wherein the organic layer comprises one or more host compound(s) represented by Chemical Formula (1):
Chemical Formula 1 L¹L²M(Q)_{y}
wherein, the ligands, L¹ and L² are independently selected from the following structures: 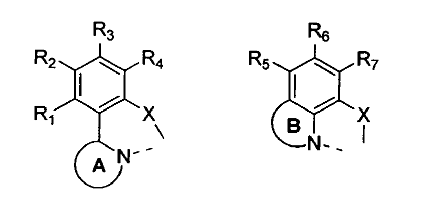 wherein, M represents a divalent or trivalent metal;
y is 0 when M is a divalent metal, while y is 1 when M is a trivalent metal;
Q represents (C6-C60)aryloxy or tri(C6-C60)arylsilyl, and the aryloxy or triarylsilyl of Q may be further substituted by (C1-C60)alkyl or (C6-C60)aryl;
X represents O, S or Se;
ring A and ring B independently represent a 5- or 6-membered heteroaromatic ring, or a 5- or 6-membered heteroaromatic ring with a (C6-C60)aromatic ring fused; ring A may form a chemical bond with R₁ to form a fused ring, and ring A or ring B may be further substituted by one or more substituent(s) selected from (C1-C60)alkyl, halogen, (C1-C60)alkyl substituted by halogen, (C6-C60)aryl, (C4-C60)heteroaryl, tri(C1-C30)alkylsilyl, di(C1-C30)alkyl(C6-C30)arylsilyl, tri(C6-C30)arylsilyl, di(C1-C30)alkylamino and di(C6-C30)arylamino;
R₁ through R₇ independently represent hydrogen, (C1-C60)alkyl, halogen, (C1-C60)alkyl with halogen substituent(s), tri(C1-C30)alkylsilyl, di(C1-C30)alkyl(C6-C30)arylsilyl, tri(C6-C30)arylsilyl, (C6-C60)aryl, (C4-C60)heteroaryl, di(C1-C30)alkylamino and di(C6-C30)arylamino; or each of them may be linked to an adjacent substituent via alkylene or alkenylene to form a fused ring; and
the aryl or heteroaryl to be substituted on ring A or ring B, or the aryl, heteroaryl of R₁ through R₇, or the fused ring formed by linkage to an adjacent substituent via alkylene or alkenylene may be further substituted by one or more substituent(s) selected from (C1-C60)alkyl, halogen, cyano, (C1-C60)alkyl with halogen substituent(s), (C3-C60)cycloalkyl, (C1-C30)alkoxy, (C6-C60)aryl, (C4-C60)heteroaryl, tri(C1-C30)alkylsilyl, di(C1-C30)alkyl(C6-C30)arylsilyl, tri(C6-C30)arylsilyl, di(C1-C30)alkylamino and di(C6-C30)arylamino.

2. The electroluminescent device according to claim 1, wherein the ligands L¹ and L² are independently selected from the following structures: 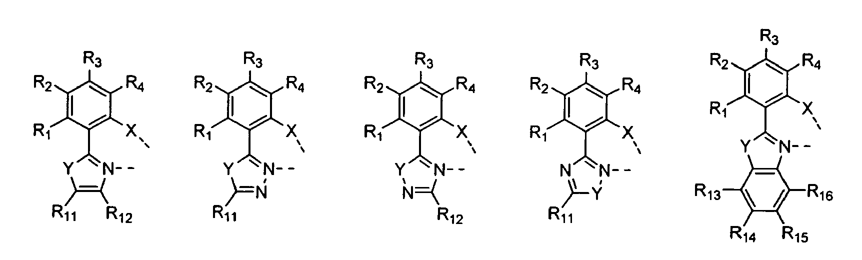 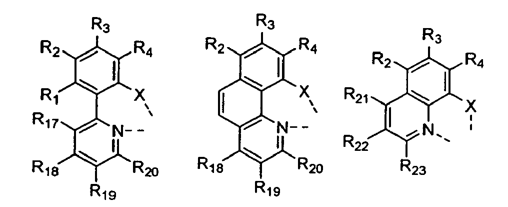 wherein, X, R₁, R₂, R₃ and R₄ are defined as in claim 1;
Y represents O, S or NR₂₄;
R₁₁ through R₂₃ independently represent hydrogen, (C1-C60)alkyl, halogen, (C1-C60)alkyl with halogen substituent(s), (C6-C60)aryl, (C4-C60)heteroaryl, tri(C1-C30)alkylsilyl, di(C1-C30)alkyl(C6-C30)arylsilyl, tri(C6-C30)arylsilyl, di(C1-C30)alkylamino or di(C6-C30)arylamino; or each of R₁₃ through R₁₆ and R₁₇ through R₂₀ may be linked to an adjacent substituent via alkylene or alkenylene to form a fused ring; and the fused ring may be substituted by one or more substituent(s) selected from (C1-C60)alkyl, halogen, cyano, (C1-C60)alkyl with halogen substituent(s), (C3-C60)cycloalkyl, (C1-C30)alkoxy, (C6-C60)aryl, (C4-C60)heteroaryl, tri(C1-C30)alkylsilyl, di(C1-C30)alkyl(C6-C30)arylsilyl, tri(C6-C30)arylsilyl, di(C1-C30)alkylamino and di(C6-C30)arylamino;
R₂₄ represents (C1-C60)alkyl or (C6-C60)aryl; and
the aryl or heteroaryl of R₁₁ through R₂₄ may be further substituted by one or more substituent(s) selected from (C1-C60)alkyl, halogen, cyano, (C1-C60)alkyl with halogen substituent(s), (C3-C60)cycloalkyl, (C1-C30)alkoxy, (C6-C60)aryl, (C4-C60)heteroaryl, tri(C1-C30)alkylsilyl, di(C1-C30)alkyl(C6-C30)arylsilyl, tri(C6-C30)arylsilyl, di(C1-C30)alkylamino and di(C6-C30)arylamino.

3. The electroluminescent device according to claim 2, wherein the ligands, L¹ and L² are independently selected from the following structures: 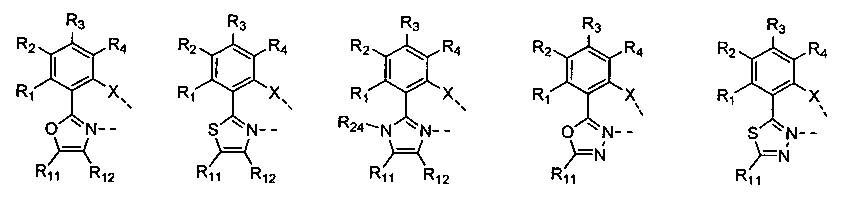 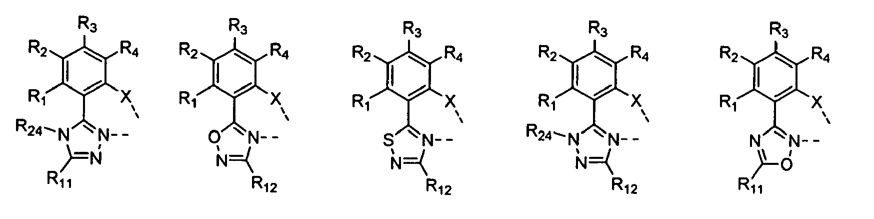 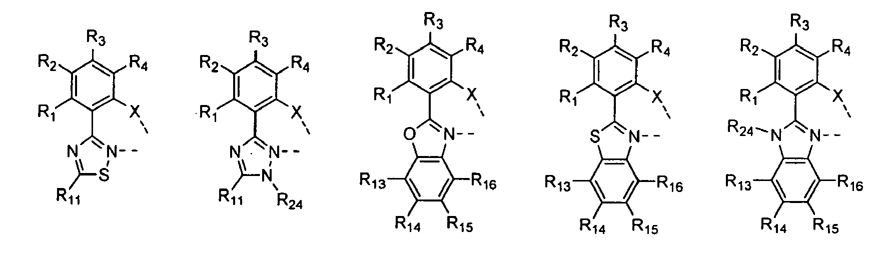 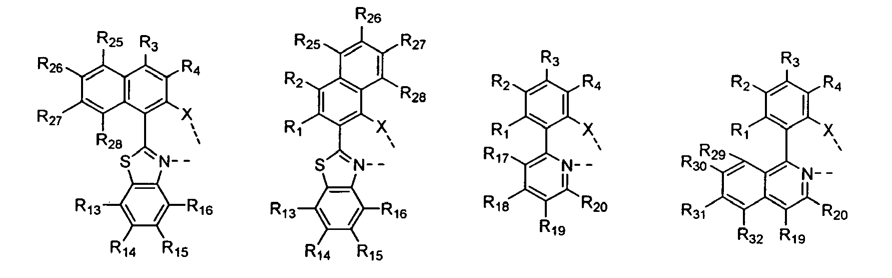 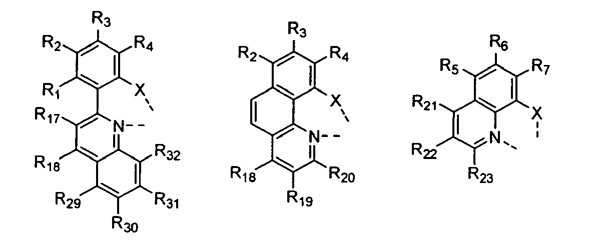 wherein, X is defined as in claim 1;
R₁ through R₇ independently represent hydrogen, (C1-C60)alkyl, halogen, (C1-C60)alkyl with halogen substituent(s), tri(C1-C30)alkylsilyl, di(C1-C30)alkyl(C6-C30)arylsilyl, tri(C6-C30)arylsilyl, (C6-C60)aryl, (C4-C60)heteroaryl, di(C1-C30)alkylamino or di(C6-C30)arylamino;
R₁₁ through R₂₃ independently represents hydrogen, (C1-C60)alkyl, halogen, (C1-C60)alkyl with halogen substituent(s), (C6-C60)aryl, (C4-C60)heteroaryl, tri(C1-C30)alkylsilyl, di(C1-C30)alkyl(C6-C30)arylsilyl, tri(C6-C30)arylsilyl, di(C1-C30)alkylamino or di(C6-C30)arylamino;
R₂₄ represents (C1-C60)alkyl, (C6-C60)aryl or (C4-C60)heteroaryl;
R₂₅ through R₃₂ independently represent hydrogen, (C1-C60)alkyl, halogen, cyano, (C1-C60)alkyl with halogen substituent(s), (C3-C60)cycloalkyl, (C1-C30)alkoxy, (C6-C60)aryl, (C4-C60)heteroaryl, tri(C1-C30)alkylsilyl, di(C1-C30)alkyl(C6-C30)arylsilyl, tri(C6-C30)arylsilyl, di(C1-C30)alkylamino or di(C6-C30)arylamino;
the aryl or heteroaryl of R₁ through R₇, R₁₁ through R₂₃, R₂₄ and R₂₅ through R₃₂ may be further substituted by one or more substituent(s) selected from (C1-C60)alkyl, halogen, cyano, (C1-C60)alkyl with halogen substituent(s), (C3-C60)cycloalkyl, (C1-C30)alkoxy, (C6-C60)aryl, (C4-C60)heteroaryl, tri(C1-C30)alkylsilyl, di(C1-C30)alkyl(C6-C30)arylsilyl, tri(C6-C30)arylsilyl, di(C1-C30)alkylamino and di(C6-C30)arylamino.

4. The electroluminescent device according to claim 1, wherein M is a bivalent metal selected from Be, Zn, Mg, Cu and Ni, or a trivalent metal selected from Al, Ga, In and B.

5. The electroluminescent device according to claim 1,
wherein Q is selected from the following structures:

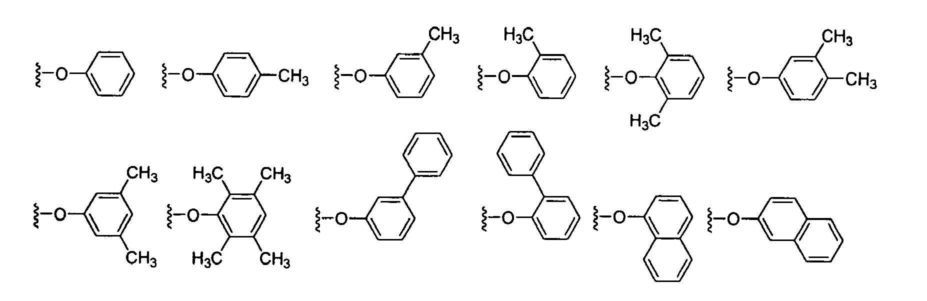

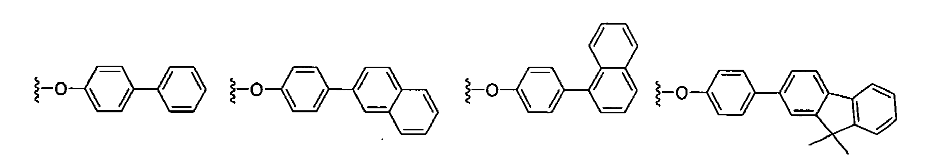

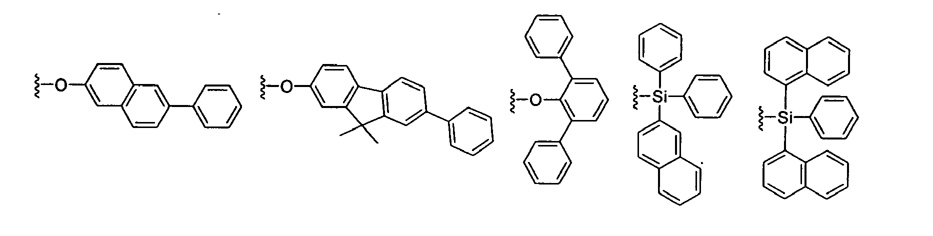

6. The electroluminescent device according to claim 1, wherein the organic layer comprises an electroluminescent region, which comprises one or more host compound(s) represented by Chemical Formula (1) in claim 1, and one or more electroluminescent dopant(s) represented by Chemical Formula (2):
Chemical Formula 2 M¹L³L⁴L⁵
wherein, M¹ is selected from a group consisting of Group 7, 8, 9, 10, 11, 13, 14, 15 and 16 in the Periodic Table, and ligands L³, L⁴ and L⁵ are independently selected from the following structures: 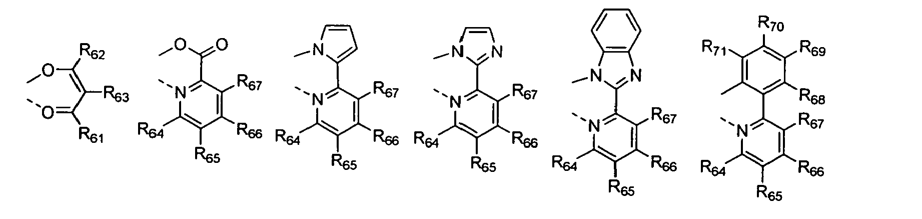 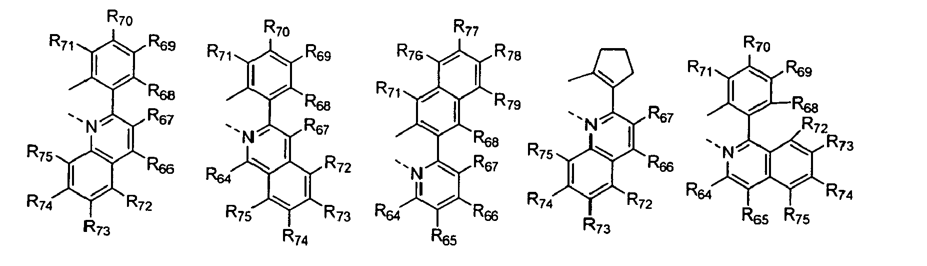 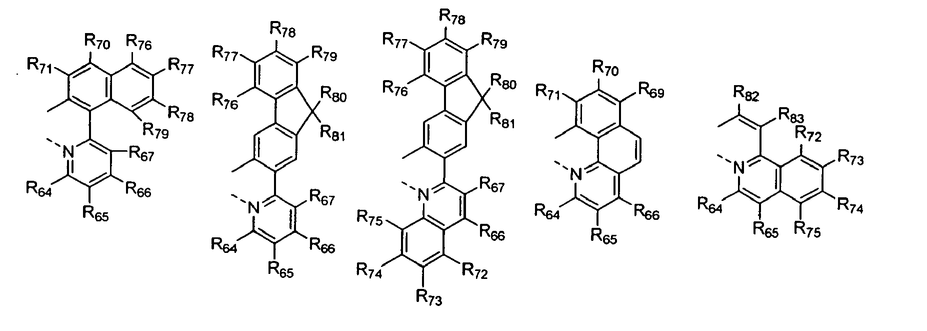 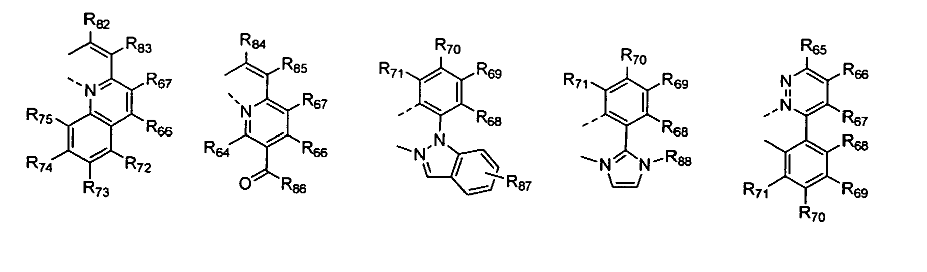 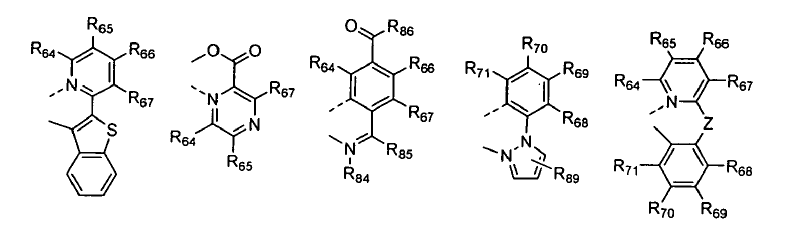 wherein, R₆₁ through R₆₃ independently represent hydrogen, (C1-C60)alkyl with or without halogen substituent(s), (C6-C60)aryl with or without (C1-C60)alkyl substituent(s), or halogen;
R₆₄ through R₇₉ independently represent hydrogen, (C1-C60)alkyl, (C1-C30)alkoxy, (C3-C60)cycloalkyl, (C2-C30)alkenyl, (C6-C60)aryl, mono or di(C1-C30)alkylamino, mono or di(C6-C30)arylamino, SF₅, tri(C1-C30)alkylsilyl, di(C1-C30)alkyl(C6-C30)arylsilyl, tri(C6-C30)arylsilyl, cyano or halogen; or each of R₇₀ through R₇₆ may be linked to an adjacent substituent via (C2-C12)alkylene or (C2-C12)alkenylene to form a fused ring or a multi-fused ring; and the alkyl, cycloalkyl, alkenyl or aryl of R₆₄ through R₇₉, or the fused ring or multi-fused ring formed from R₇₀ and R₇₆ by linkage via alkylene or alkenylene may be further substituted by one or more substituent(s) selected from (C1-C60)alkyl, (C6-C60)aryl and halogen;
R₈₀ through R₈₃ independently represent hydrogen, (C1-C60)alkyl with or without halogen substituent(s), or (C6-C60)aryl with or without (C1-C60)alkyl substituent(s);
R₈₄ and R₈₅ independently represents hydrogen, linear or branched (C1-C60)alkyl, (C6-C60)aryl or halogen, or R₈₄ and R₈₅ may be linked via (C3-C12)alkylene or (C3-C12)alkenylene with or without a fused ring to form an alicyclic ring or a monocyclic or polycyclic aromatic ring; and the alkyl, aryl or the alicyclic ring or the monocyclic or polycyclic aromatic ring formed therefrom by linkage via (C3-C12)alkylene or (C3-C12)alkenylene may be further substituted by one or more substituent(s) selected from linear or branched (C1-C60)alkyl with or without halogen substituent(s), (C1-C30)alkoxy, halogen, tri(C1-C30)alkylsilyl, tri(C6-C30)arylsilyl and (C6-C60)aryl;
R₈₆ represents (C1-C60)alkyl, (C6-C60)aryl, (C5-C60)heteroaryl or halogen;
R₈₇ through R₈₉ independently represent hydrogen, (C1-C60)alkyl, (C6-C60)aryl or halogen, and the alkyl or aryl of R₈₆ through R₈₉ may be further substituted by halogen or (C1-C60)alkyl; and
Z represents 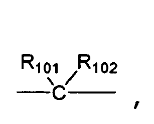 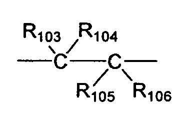 or 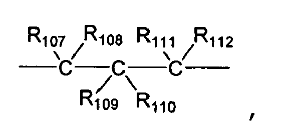 wherein R₁₀₁ through R₁₁₂ independently represent hydrogen, (C1-C60)alkyl with or without halogen substituent(s), (C1-C30)alkoxy, halogen, (C6-C60)aryl, cyano or (C5-C60) cycloalkyl, or each of R₁₀₁ through R₁₁₂ may be linked to an adjacent substituent via alkylene or alkenylene to form a (C5-C7) spiro ring or a (C5-C9) fused ring, or they may be linked to R₆₇ or R₆₈ via alkylene or alkenylene to form a (C5-C7) fused ring.

7. The electroluminescent device according to claim 6, wherein the organic layer comprises one or more compound(s) selected from a group consisting of arylamine compounds and styrylarylamine compounds.

8. The electroluminescent device according to claim 6, wherein the organic layer comprises one or more metal(s) selected from a group consisting of organic metals of Group 1, Group 2, 4^{th} period and 5^{th} period transition metals, lanthanide metals and d-transition elements.

9. The electroluminescent device according to claim 6, which is an organic display which further comprises a compound having the electroluminescent peak with wavelength of not more than 560 nm, in the organic layer.

10. The electroluminescent device according to claim 6, wherein the organic layer comprises an electroluminescent layer and a charge generating layer.

11. The electroluminescent device according to claim 6, wherein a mixed region of reductive dopant and organic substance, or a mixed region of oxidative dopant and organic substance is placed on the inner surface of one or both electrode(s) among the pair of electrodes.

12. The electroluminescent device according to claim 6, wherein the doping concentration of the electroluminescent dopant to the host in said electroluminescent region is from 1 to 20% by weight.

13. An organic solar cell which comprises an organic electroluminescent compound represented by Chemical Formula (1) :
Chemical Formula 1 L¹L²M(Q)_{y}
wherein, the ligands, L¹ and L² are independently selected from the following structures: 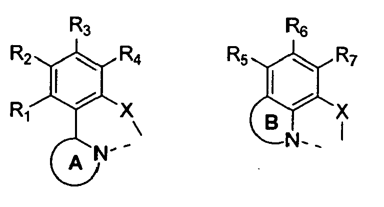 wherein, M represents a divalent or trivalent metal;
y is 0 when M is a divalent metal, while y is 1 when M is a trivalent metal;
Q represents (C6-C60)aryloxy or tri(C6-C60)arylsilyl, and the aryloxy or triarylsilyl of Q may be further substituted by (C1-C60)alkyl or (C6-C60)aryl;
X represents O, S or Se;
ring A and ring B independently represent a 5- or 6-membered heteroaromatic ring, or a 5- or 6-membered heteroaromatic ring with a (C6-C60)aromatic ring fused; ring A may form a chemical bond with R₁ to form a fused ring, and ring A or ring B may be further substituted by one or more substituent(s) selected from (C1-C60)alkyl, halogen, (C1-C60)alkyl substituted by halogen, (C6-C60)aryl, (C4-C60)heteroaryl, tri(C1-C30)alkylsilyl, di(C1-C30)alkyl(C6-C30)arylsilyl, tri(C6-C30)arylsilyl, di(C1-C30)alkylamino and di(C6-C30)arylamino;
R₁ through R₇ independently represent hydrogen, (C1-C60)alkyl, halogen, (C1-C60)alkyl with halogen substituent(s), tri(C1-C30)alkylsilyl, di(C1-C30)alkyl(C6-C30)arylsilyl, tri(C6-C30)arylsilyl, (C6-C60)aryl, (C4-C60)heteroaryl, di(C1-C30)alkylamino and di(C6-C30)arylamino; or each of them may be linked to an adjacent substituent via alkylene or alkenylene to form a fused ring; and
the aryl or heteroaryl to be substituted on ring A or ring B, or the aryl, heteroaryl of R₁ through R₇, or the fused ring formed by linkage to an adjacent substituent via alkylene or alkenylene may be further substituted by one or more substituent(s) selected from (C1-C60)alkyl, halogen, cyano, (C1-C60)alkyl with halogen substituent(s), (C3-C60)cycloalkyl, (C1-C30)alkoxy, (C6-C60)aryl, (C4-C60)heteroaryl, tri(C1-C30)alkylsilyl, di(C1-C30)alkyl(C6-C30)arylsilyl, tri(C6-C30)arylsilyl, di(C1-C30)alkylamino and di(C6-C30)arylamino.
